# EUROPEAN PATENT APPLICATION

(11) **EP 4 807 994 A1**
(43) Date of publication of application: **16.09.2026**
(21) Application number: 24888606.1
(22) Date of filing: 30.10.2024
(51) Int. Cl.: H03M 7/30, H03M 7/40, H03M 7/42

(54) **DATA COMPRESSION DEVICE, DATA DECOMPRESSION DEVICE, DATA COMPRESSION AND DECOMPRESSION SYSTEM, DATA COMPRESSION METHOD, AND DATA DECOMPRESSION METHOD**

(30) Priority: 10.11.2023 JP 2023192534
(71) Applicant: University of Tsukuba, Ibaraki 305-8577 (JP)
(72) Inventor: YAMAGIWA, Shinichi, Tsukuba-shi, Ibaraki 305-8577 (JP)
(74) Representative: Novagraaf International SA
(86) International application number: PCT/JP2024/038621
(87) International publication number: WO 2025/100309

(57) **Abstract**

A data compression device includes a first pipeline through which an original symbol string flows, first and second compression units each having a table, an adjustment unit, and an output unit. The first and second compression units convert an original symbol string into a compressed symbol using a table search, the compressed symbol is sent out to a second pipeline, the output unit can select and output one of an original symbol from the first pipeline and a compressed symbol from the second pipeline, and the adjustment unit adjusts the selection according to the output unit.

## Description

### [Technical Field]

The present invention relates to a data compression device, a data decompression device, a data compression and decompression system, a data compression method, and a data decompression method.

### [Background Art]

Conventionally, there is a compression device that performs a process of registering a symbol in a predetermined entry among a plurality of entries and outputting indicator data that represents non-compression and the symbol described above in a case in which an input symbol is unregistered in a first table having the plurality of entries, a process of outputting indicator data that represents compression and position information that represents the position of an entry at which a symbol is registered and has a smaller size than the size of the symbol in a case in which the symbol has already been registered in the table described above, and a process of changing the size of the position information according to the usage status of the plurality of entries.

### [Citation List]

### [Patent Literature]

[PTL 1] Japanese Patent Application Publication No. 2014-236449
[PTL 2] Japanese Patent Application Publication No. 2016-184830
[PTL 3] Japanese Patent Application Publication No. 2020-184672

### [Non Patent Literature]

[NPL 1] Koichi Marumo, Shinichi Yamagiwa, Ryuta Morita, Hiroshi Sakamoto. Lazy Management for Frequency Table on Hardware-Based Stream Lossless Data Compression, Information, 63, (2016-10-31), DOI:10. 3390/info7040063
[NPL 2] Shinichi Yamagiwa, Hiroshi Sakamoto. A reconfigurable stream compression hardware based on static symbol-lookup table, 2013 IEEE International Conference on Big Data, (2013-10-06), DOI:10. 1109/bigdata, 2013.6691702
[NPL 3] Shinichi Yamagiwa, Eisaku Hayakawa, Koichi Marumo, Stream-Based Lossless Data Compression Applying Adaptive Entropy Coding for Hardware-Based Implementation, Algorithms, 159, (2020-06-30), DOI:10. 3390/a13070159

### [Summary of Invention]

### [Technical Problem]

An object of the present disclosure is to provide a data compression device capable of compressing one or two or more symbols into a bit string of a number of bits or less, a data decompression device capable of restoring the bit string obtained through the compression to the original, a data compression and decompression system, a data compression method, and a data decompression method.

### [Solution to Problem]

One aspect of the present disclosure is a compression device including:
a first pipeline having a plurality of stages in which each of a plurality of original symbols forming an original symbol string shifts to a next stage in a predetermined cycle while maintaining an input order;
a second pipeline in which a compressed symbol into which an original symbol is compressed shifts to a next stage in synchronization with the original symbol flowing through the first pipeline;
a first compression unit arranged at a first stage or a preceding stage of the plurality of stages;
one or two or more second compression units arranged at a subsequent stage to the first compression unit;
an adjustment unit arranged at two or more stages present at a subsequent stage to the second compression units; and
an output unit arranged at a subsequent stage to the adjustment unit, in which
the first compression unit has a first table having a predetermined number of entries in each of which one symbol is registered and executes:
   searching the first table using each of the plurality of original symbols input to the first pipeline one by one at a predetermined timing as a search target;
   converting an identical original symbol into the compressed symbol in a case in which the identical original symbol has been found from the first table;
   outputting the compressed symbol obtained by searching the first table and position information indicating a position at which compression information has been obtained; and
   performing an update of the first table including registration of the original symbol that is a search target for each search of the first table, each of the one or two or more second compression units includes:
      a second table having a predetermined number of entries in which two or more symbols are registered;
      a first latch taking in an original symbol from a preceding stage;
      a second latch capable of taking in the compressed symbol and the position information indicating the compression position of the compressed symbol; and
      a register capable of maintaining a predetermined number of consecutive original symbols taken into the first latch,
      each of the one or two or more second compression units, in each cycle, executes:
         controlling a maintained content or a state of the second latch in accordance with a control instruction for the second latch;
         searching the second table using a symbol string formed using the predetermined number of original symbols as a search target in a case in which the predetermined number of original symbols are stored in the register;
         converting the symbol string of the search target into the compressed symbol in a case in which the symbol string of the search target has been found;
         outputting the compressed symbol obtained by searching the second table and position information of the compressed symbol; and
         updating registered contents of the second table in a case in which the search of the second table is performed,
         the number of the two or more symbols registered in the second table included in the one or two or more second compression units is a number obtained by adding a predetermined offset number to the number of symbols registered in the first table in a case in which the number of the second compression units is one and is in a state of increasing by a predetermined offset number or decreasing by a predetermined offset number as the stage advances in a case in which the number of the second compression units is two or more,
         the adjustment unit at least has the first latch and the second latch arranged at each stage of a number of stages equal to or greater than the number of symbols registered in each entry of the second table included in the second compression unit positioned at a final stage among the one or two or more second compression units and controls the maintained content of each of the second latches included in the adjustment unit in accordance with the control instruction in each cycle, and
         the output unit outputs the original symbol and information indicating non-compression or the compressed symbol and the position information in accordance with the maintained content of each of the first latch and the second latch included in the adjustment unit arranged at a final stage of the plurality of stages.

In addition, another aspect of the present disclosure is a decompression device to which a pair of an original symbol and information indicating non-compression or a pair of a compressed symbol obtained by compressing one or two or more original symbols and position information indicating a position at which the compressed symbol has been obtained is input, the data decompression device including:
a first bus through which the compressed symbol flows;
a second bus through which the original symbol flows; and
a plurality of decompression units of the same number as a maximum number of original symbols compressed into a compressed symbol, in which
each of the one or two or more decompression units:
   has a plurality of entries and includes:
   one table in which the number of symbols registered in each entry is selected from among one to the maximum number in different states among the plurality of decompression units;
   a first register and a second register;
   in a case in which an original symbol forming a pair on the basis of non-compression information is sent out to the second bus, registers the original symbol in the first register;
   in a case in which the number of original symbols maintained in the register reaches the number of symbols registered in each entry, registers the one or two or more original symbols maintained in the register in a predetermined entry of the table; and
   in a case in which a compressed symbol forming a pair on the basis of the position information is sent out to the first bus and in a case in which the position information designates itself, specifies an entry using the compressed symbol flowing through the first bus as an index of the table, maintains one or two or more original symbols registered in the specified entry in the second register, and sends out the one or two or more original symbols maintained in the second register to the second bus one by one in an order of registration to the first register,
   the decompression unit not designated by the position information registers an original symbol sent out to the second bus from the designated decompression unit in the first register, and
   the original symbol sent out to the second bus becomes an output of the decompression device.

The aspect of the present disclosure includes a data compression and decompression system including the data compression device and the data decompression device described above and a data compression method and a data decompression method having features equivalent to those of the data compression device and the data decompression device. In addition, a computer program causing a computer to operate as a data compression device or a data decompression device and a non-transitory storage medium recording this program are also included in the aspect of the present disclosure.

### [Advantageous Effects of Invention]

According to the present disclosure, one or two or more symbols can be compressed into a bit string of the number of bits or less. In addition, according to the present disclosure, the bit string obtained through compression can be restored to the original.

### [Brief Description of Drawings]

[Fig. 1]

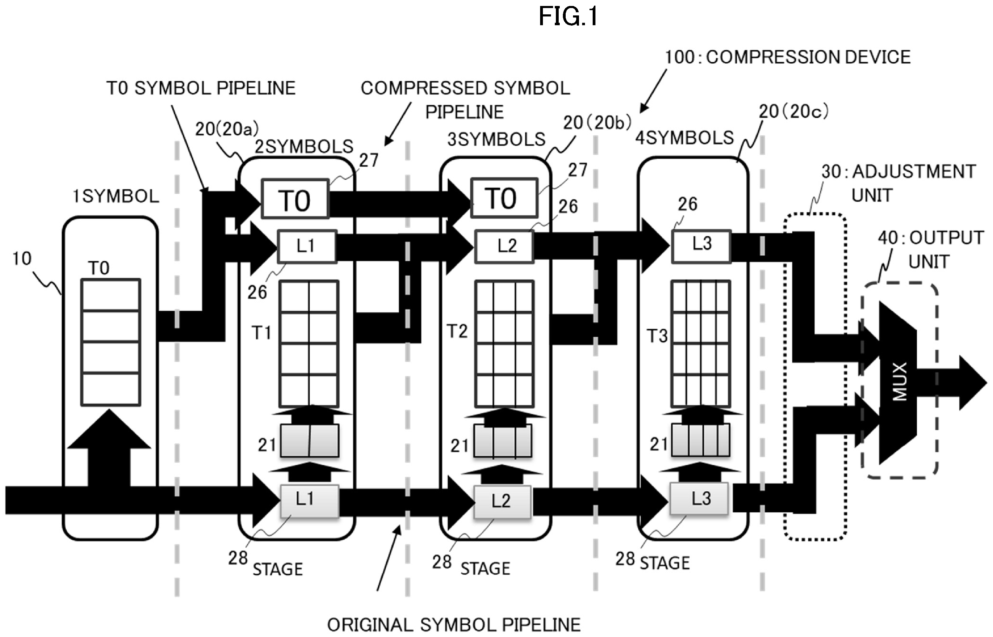

   Fig. 1 is a diagram illustrating a configuration example of a compression device.
[Fig. 2]

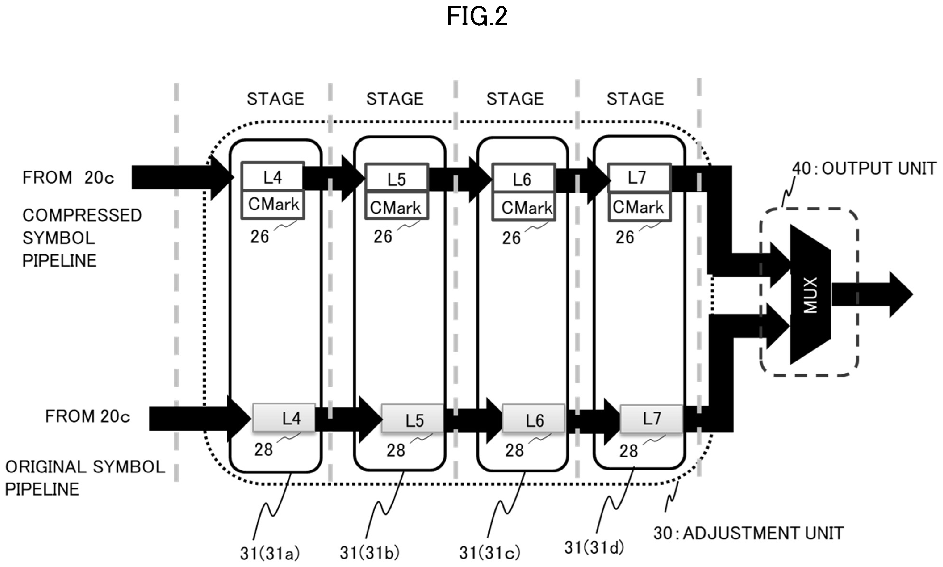

   Fig. 2 is a diagram illustrating a configuration example of a compression device.
[Fig. 3]

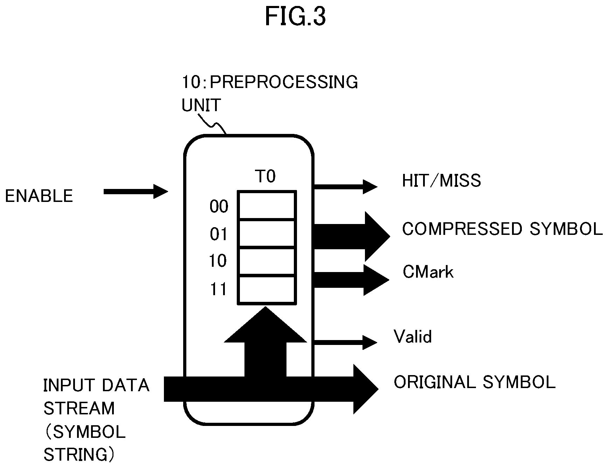

   Fig. 3 is a diagram illustrating a configuration example of a compression unit 10.
[Fig. 4]

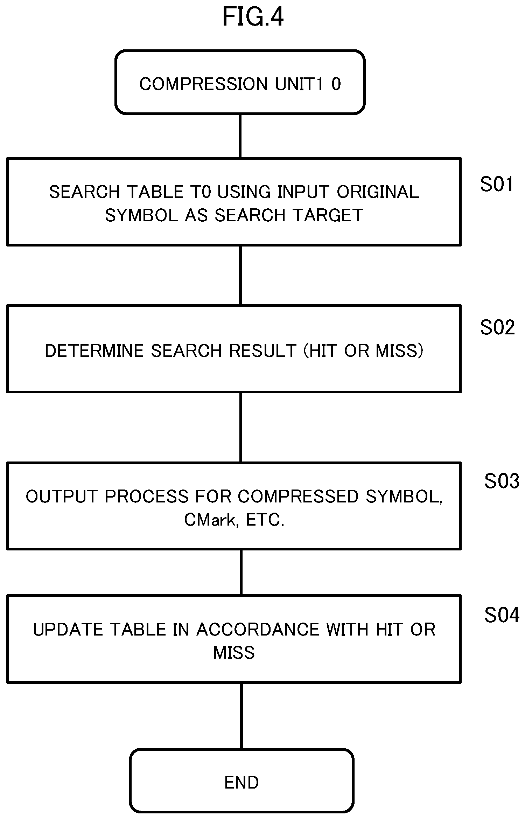

   Fig. 4 is a flowchart illustrating a process example of the compression unit 10.
[Fig. 5]

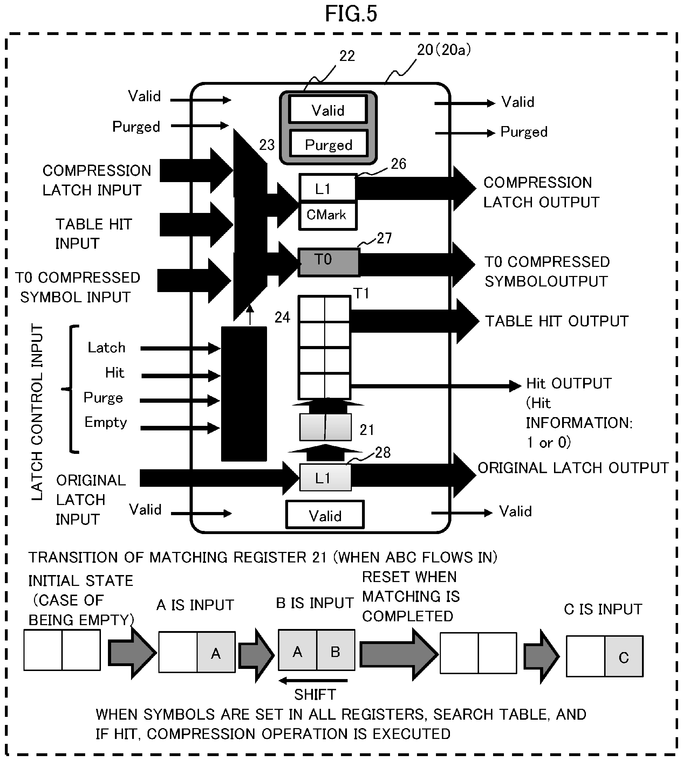

   Fig. 5 is a diagram illustrating a configuration example of a compression unit 20.
[Fig. 6]

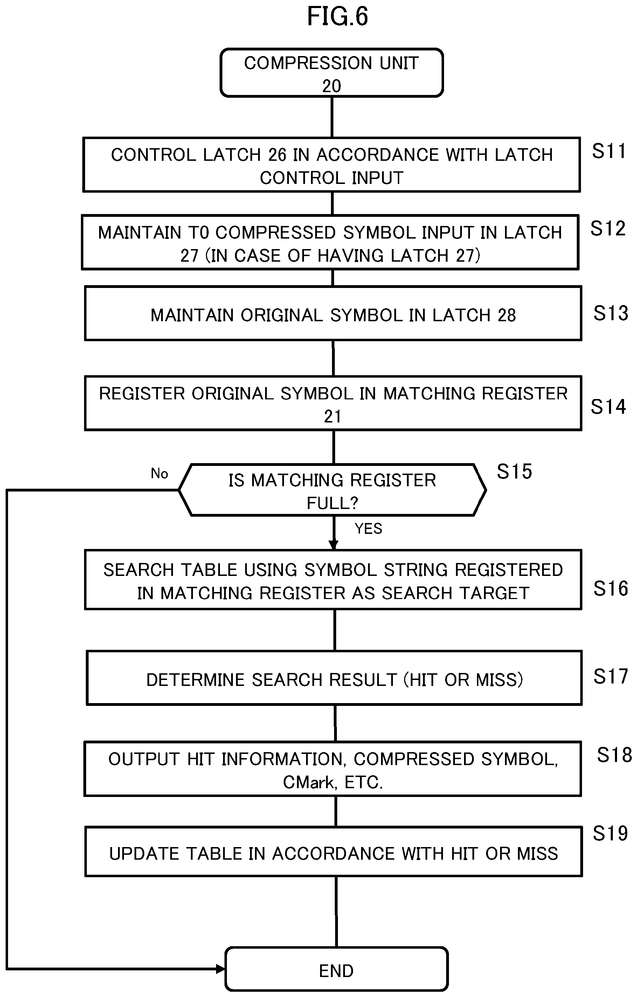

   Fig. 6 is a flowchart illustrating a process example of the compression unit 20.
[Fig. 7]

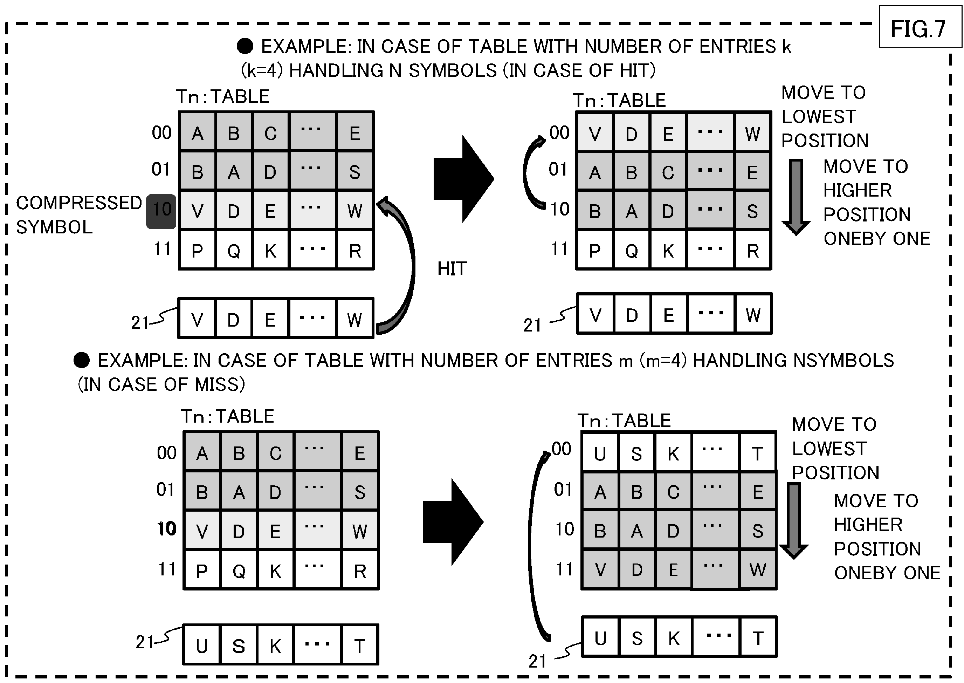

   Fig. 7 is an explanatory diagram of a table operation.
[Fig. 8]

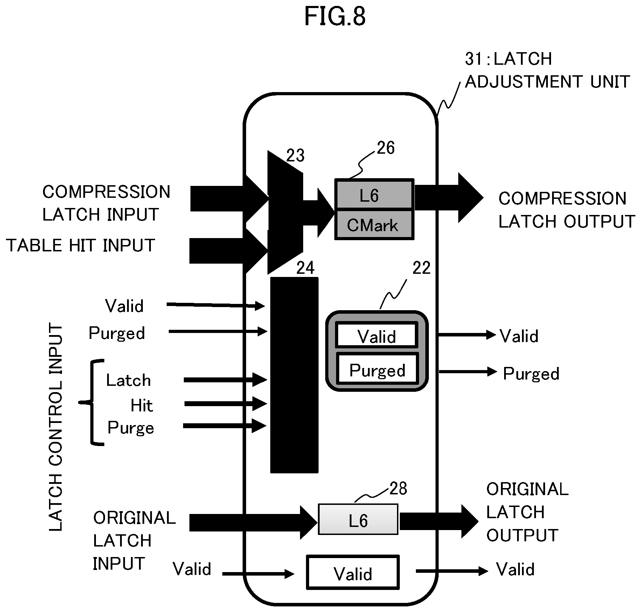

   Fig. 8 is a diagram illustrating a configuration example of a latch adjustment unit.
[Fig. 9]

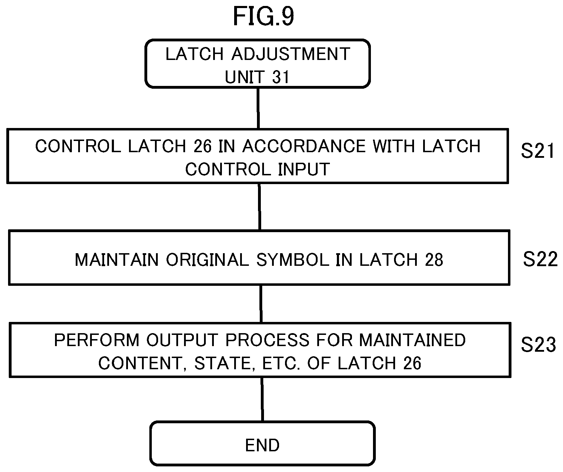

   Fig. 9 is a flowchart illustrating a process example of the latch adjustment unit.
[Fig. 10]

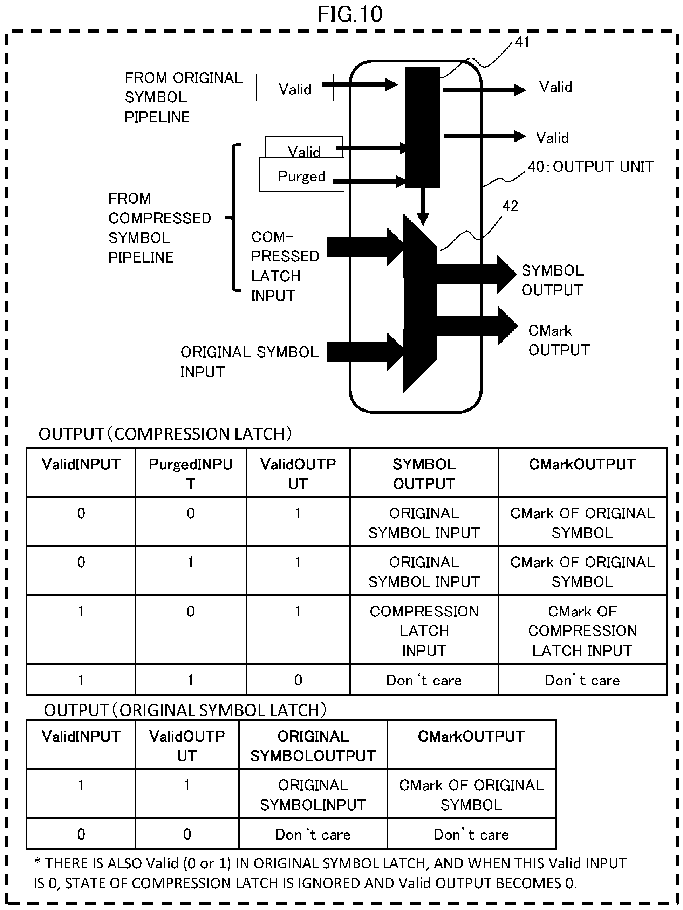

   Fig. 10 is a diagram illustrating a configuration example of an output unit.
[Fig. 11]

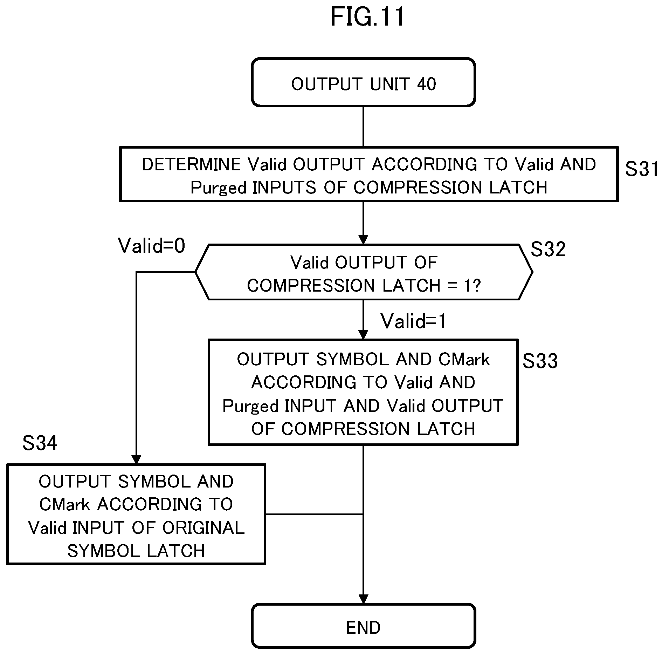

   Fig. 11 is a flowchart illustrating a process example of the output unit.
[Fig. 12]

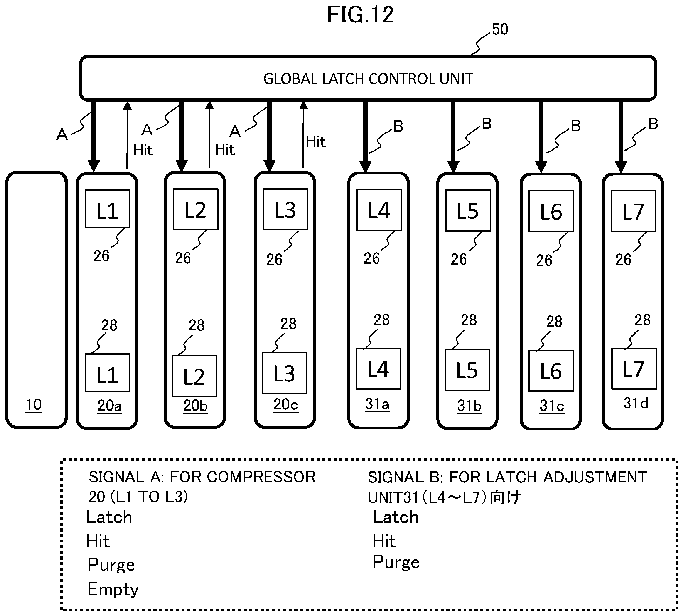

   Fig. 12 is an explanatory diagram of a global latch control unit.
[Fig. 13]

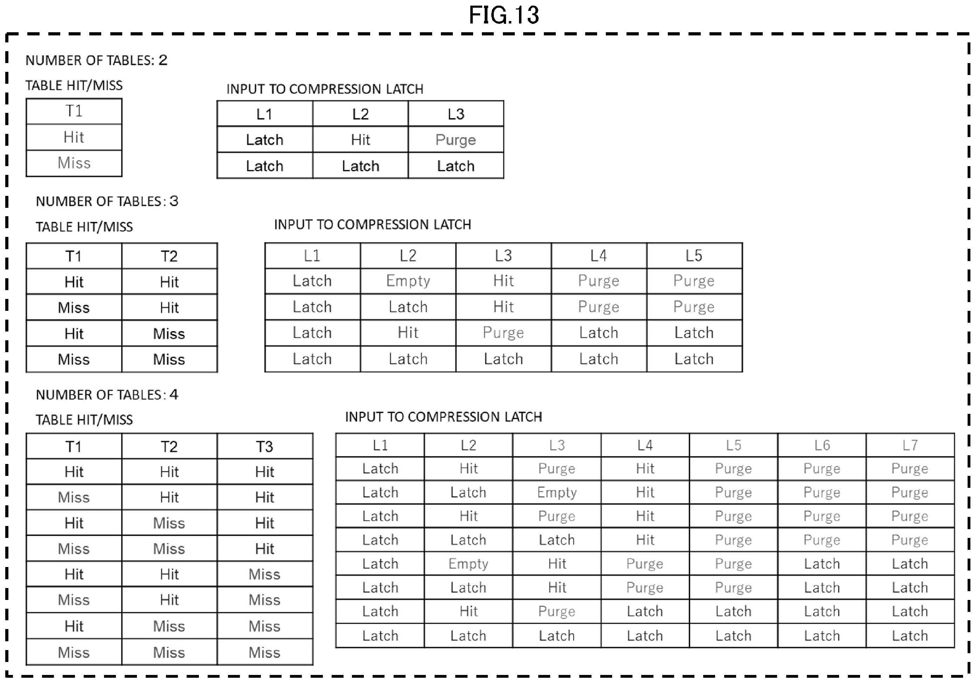

   Fig. 13 is a table illustrating hit/miss patterns of each table and patterns of control signals.
[Fig. 14]

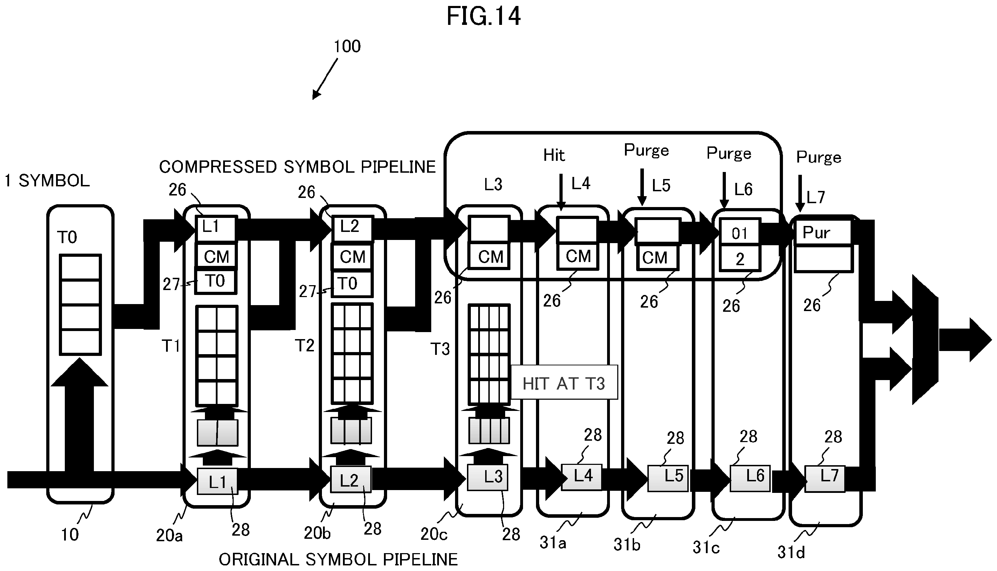

   Fig. 14 is an explanatory diagram of resolving a conflict in latch control.
[Fig. 15]

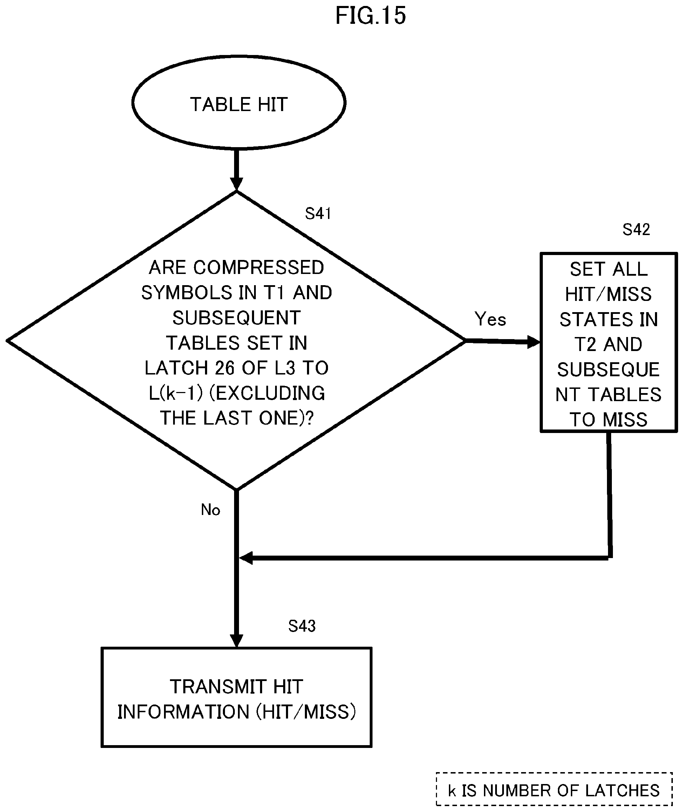

   Fig. 15 is a flowchart illustrating a process example for resolving a conflict.
[Fig. 16]

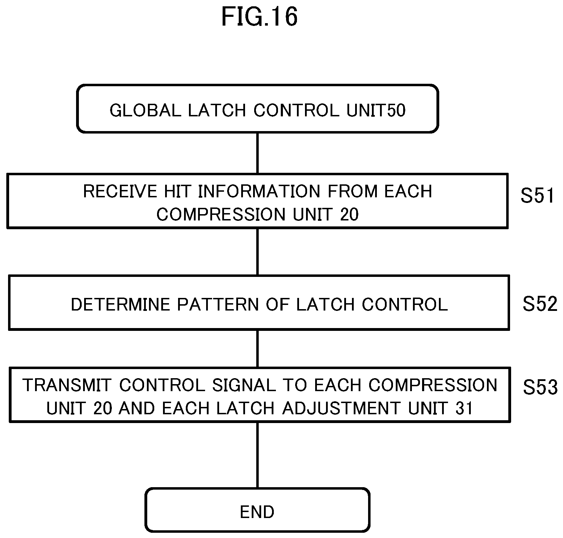

   Fig. 16 is a flowchart illustrating a process example of the global latch control unit 50.
[Fig. 17]

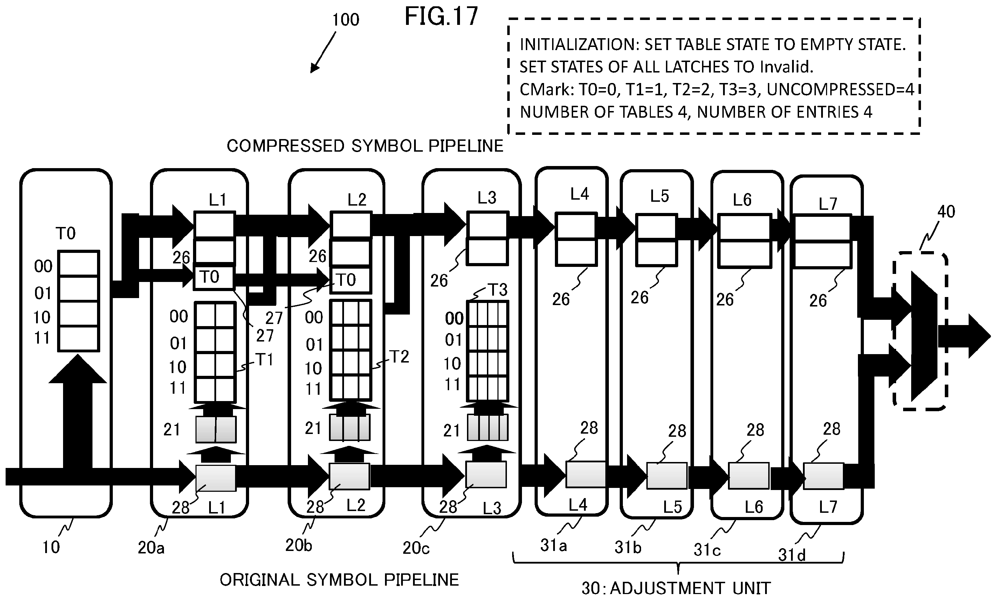

   Fig. 17 is an explanatory diagram of an operation example of the compression device.
[Fig. 18]

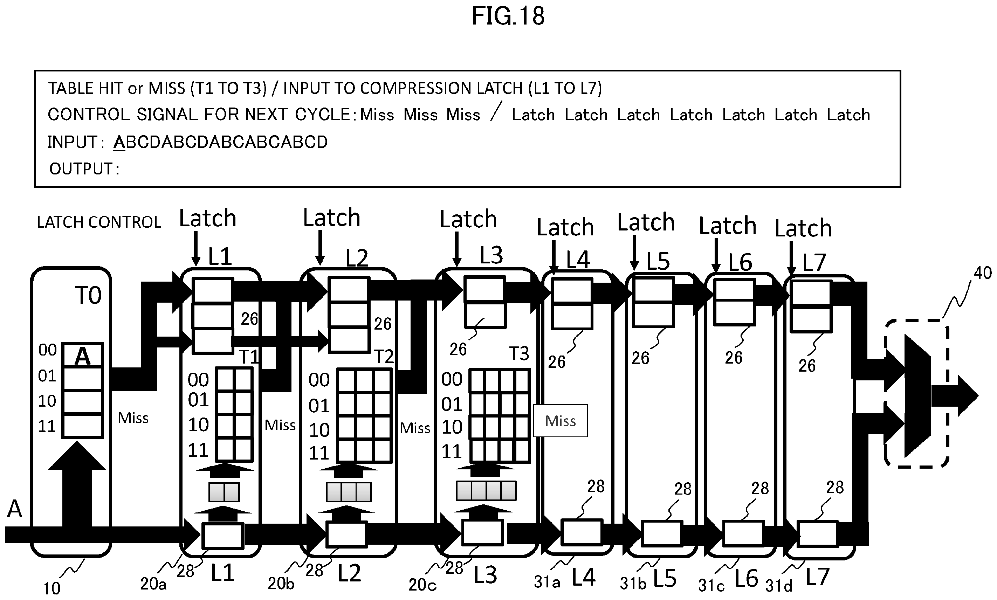

   Fig. 18 is an explanatory diagram of an operation example of the compression device.
[Fig. 19]

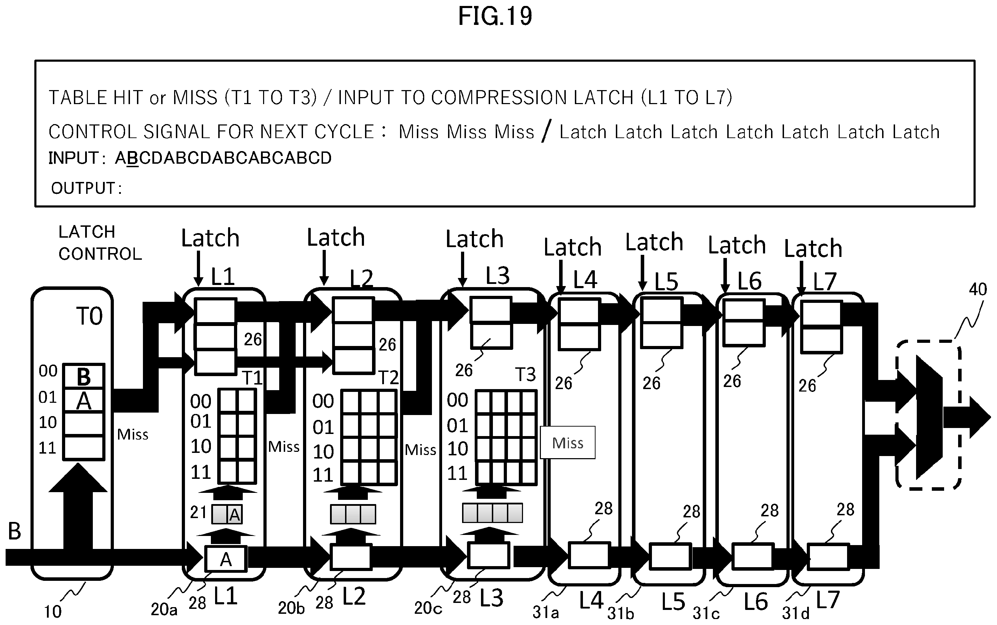

   Fig. 19 is an explanatory diagram of an operation example of the compression device.
[Fig. 20]

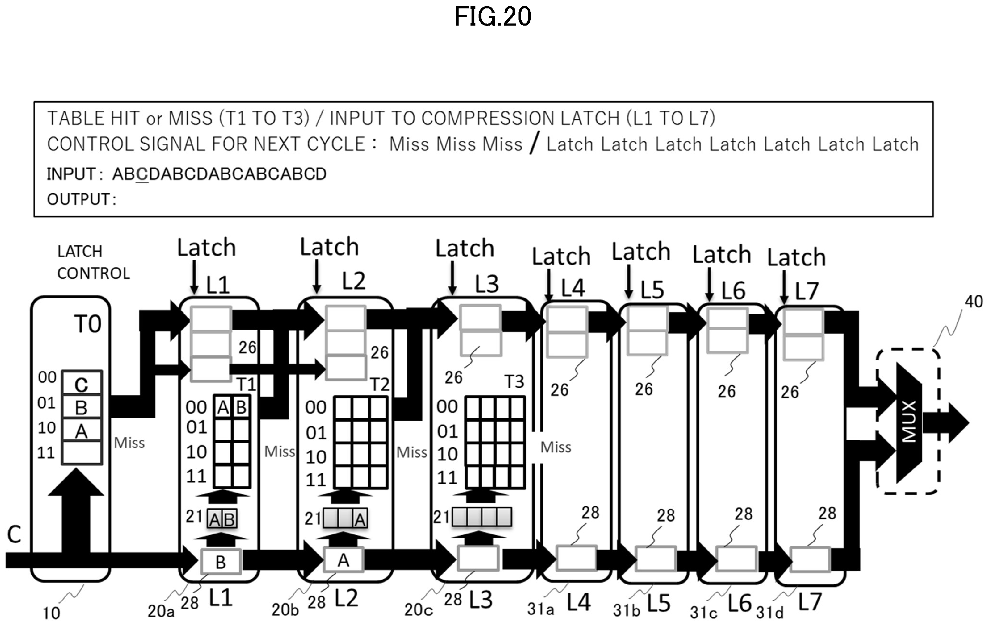

   Fig. 20 is an explanatory diagram of an operation example of the compression device.
[Fig. 21]

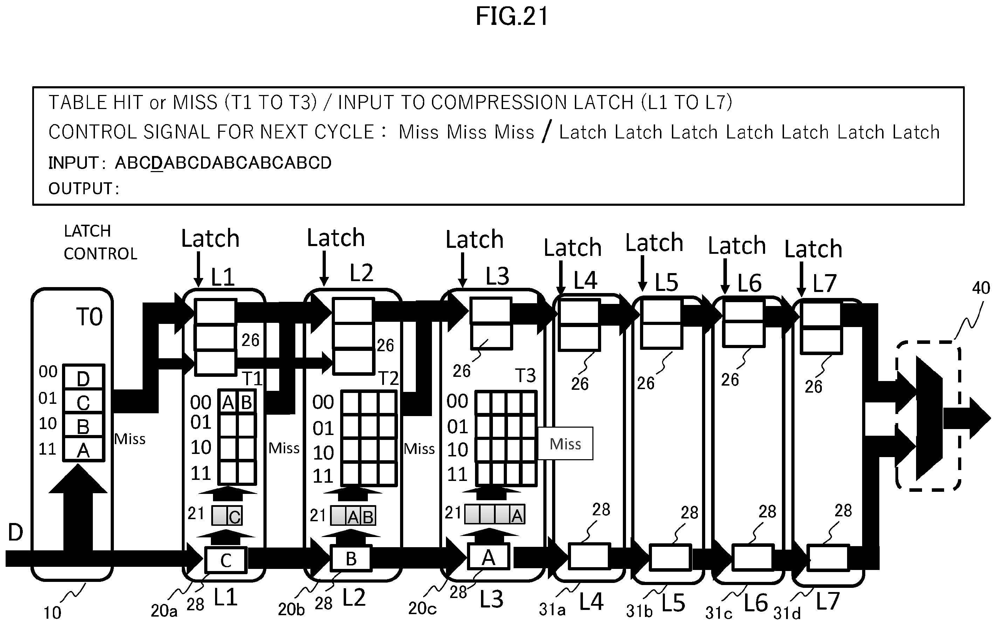

   Fig. 21 is an explanatory diagram of an operation example of the compression device.
[Fig. 22]

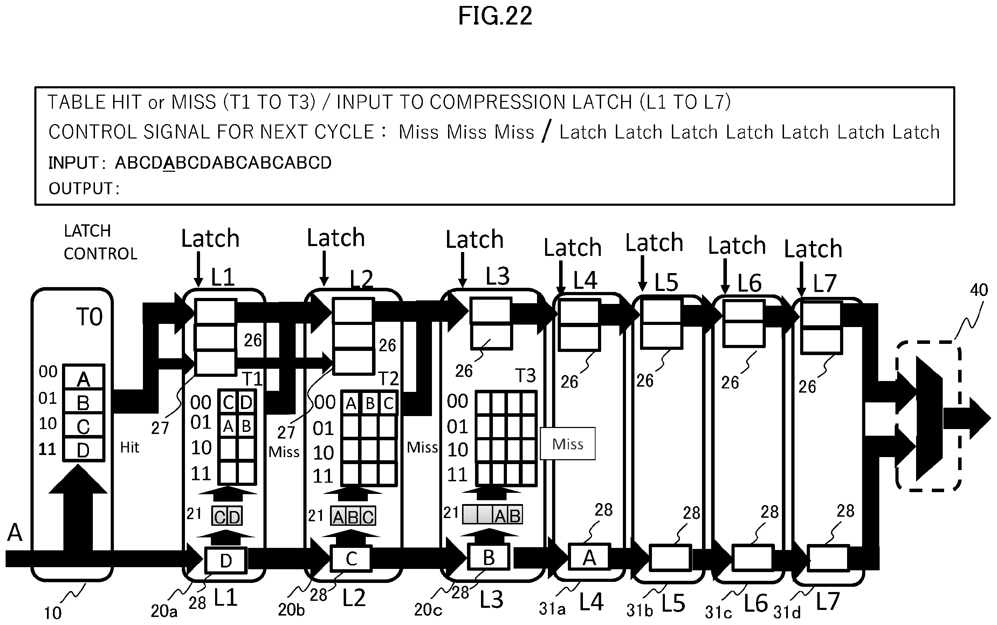

   Fig. 22 is an explanatory diagram of an operation example of the compression device.
[Fig. 23]

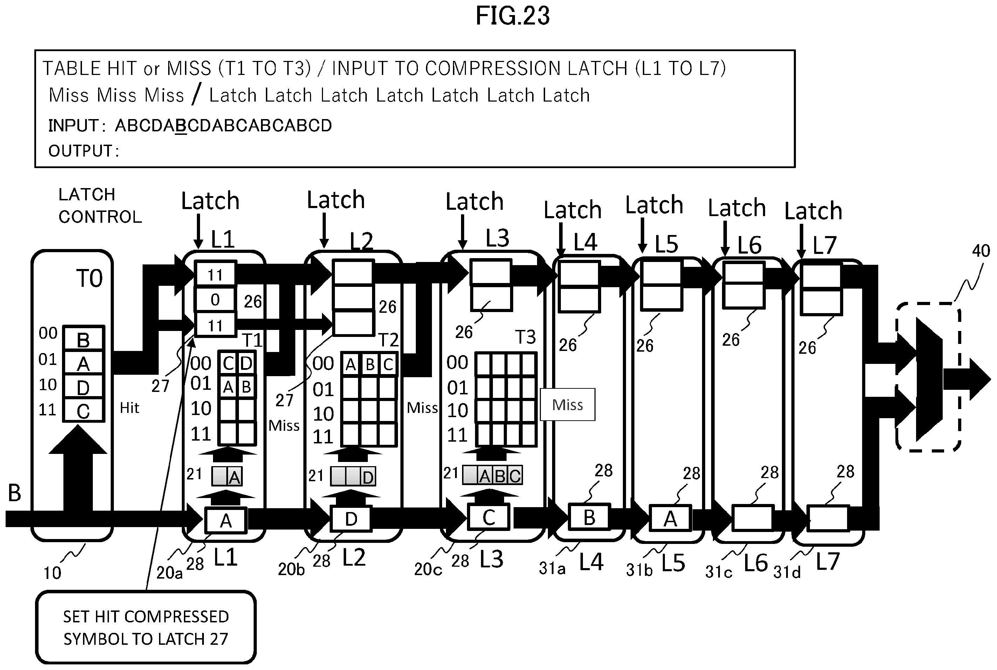

   Fig. 23 is an explanatory diagram of an operation example of the compression device.
[Fig. 24]

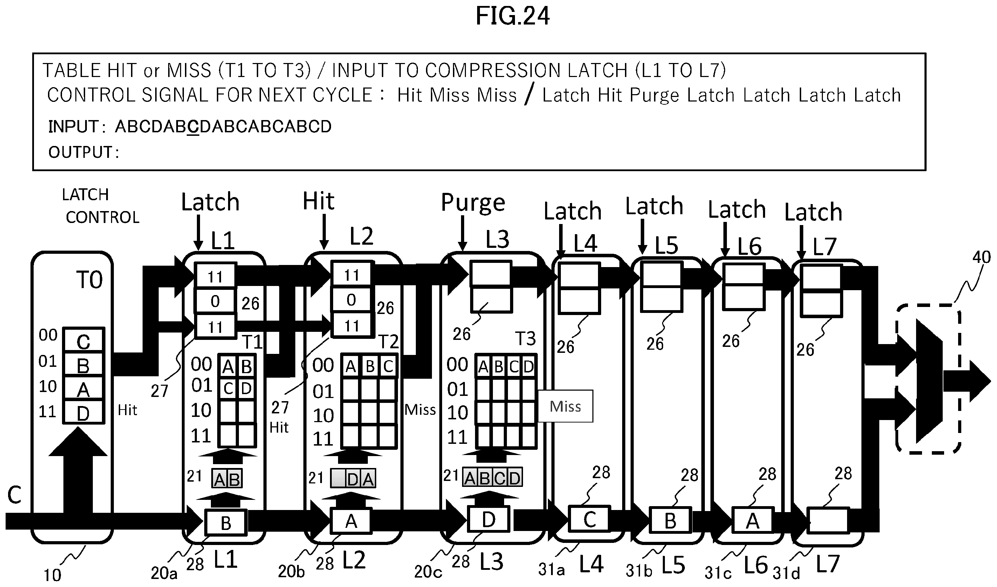

   Fig. 24 is an explanatory diagram of an operation example of the compression device.
[Fig. 25]

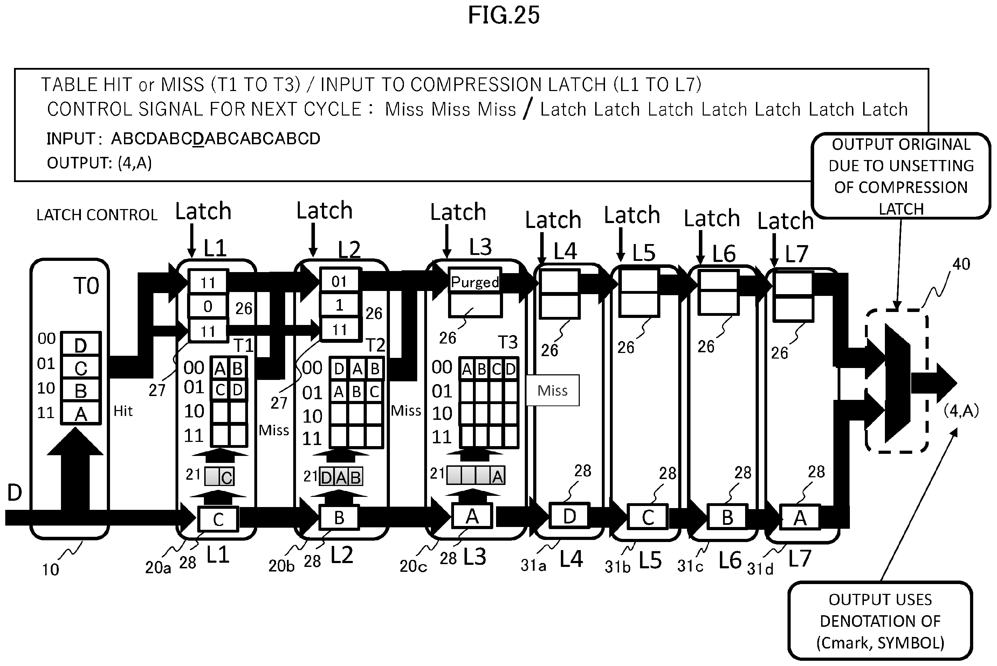

   Fig. 25 is an explanatory diagram of an operation example of the compression device.
[Fig. 26]

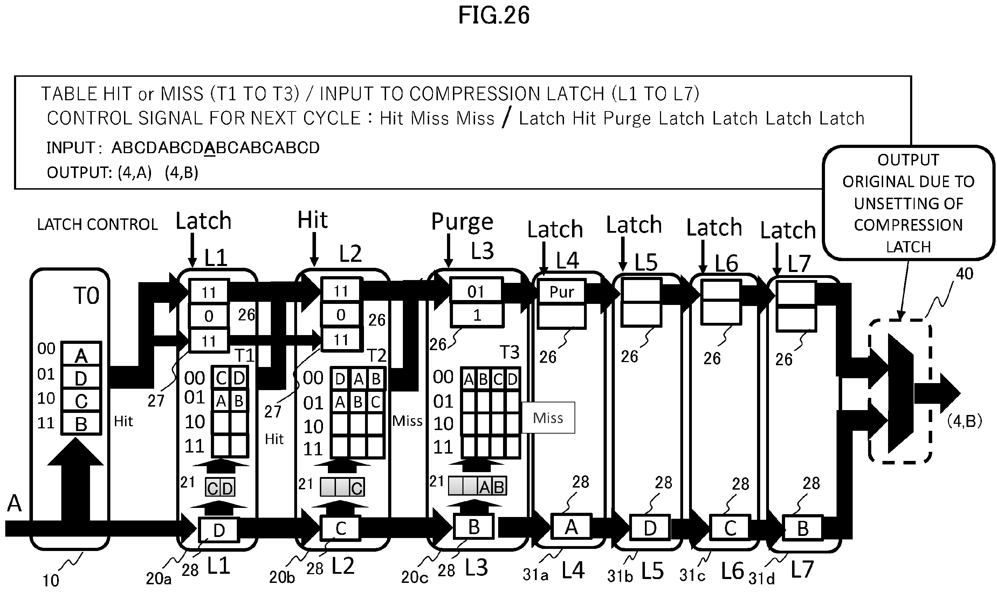

   Fig. 26 is an explanatory diagram of an operation example of the compression device.
[Fig. 27]

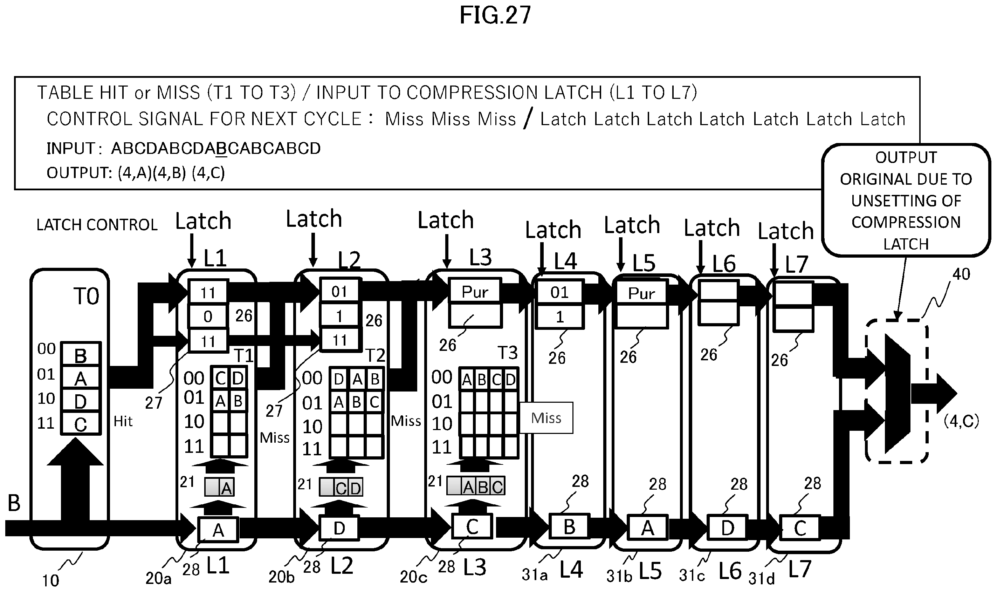

   Fig. 27 is an explanatory diagram of an operation example of the compression device.
[Fig. 28]

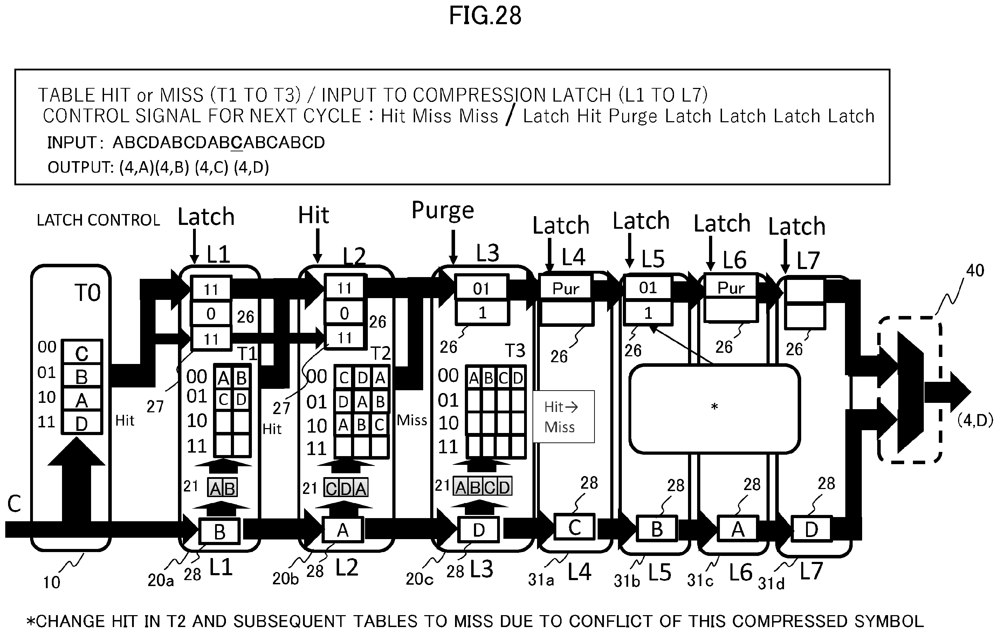

   Fig. 28 is an explanatory diagram of an operation example of the compression device.
[Fig. 29]

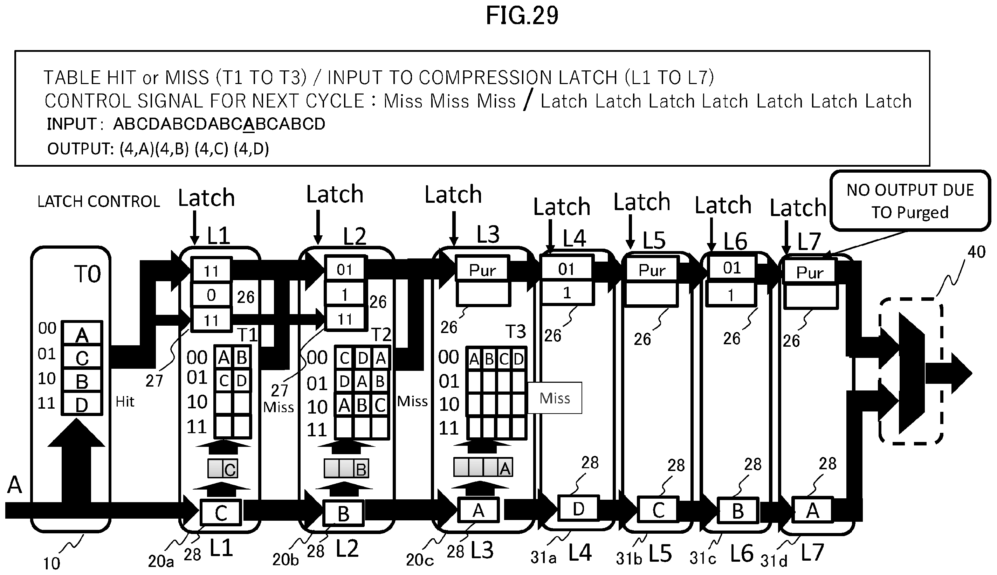

   Fig. 29 is an explanatory diagram of an operation example of the compression device.
[Fig. 30]

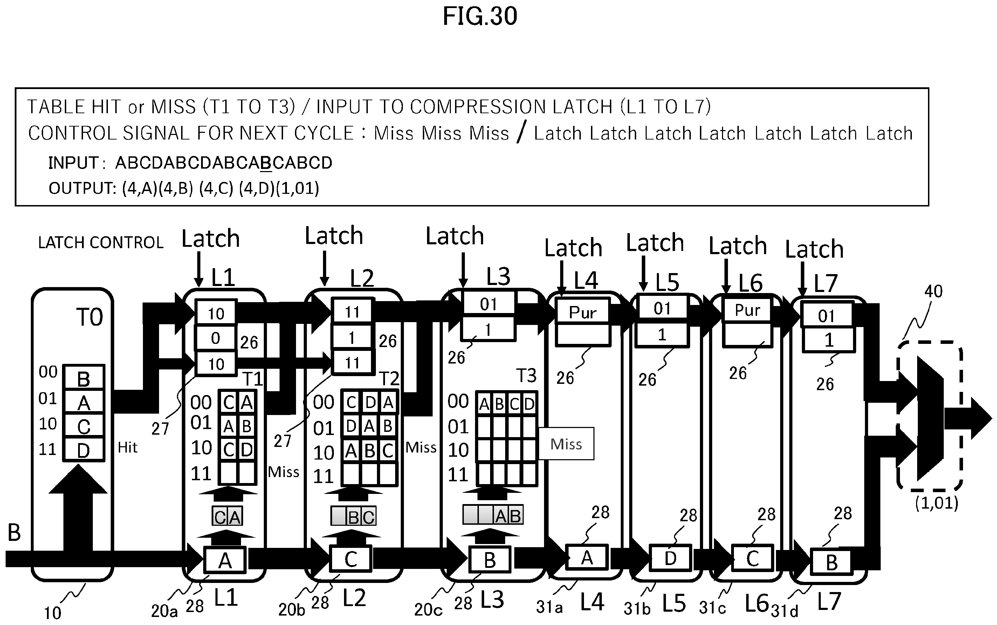

   Fig. 30 is an explanatory diagram of an operation example of the compression device.
[Fig. 31]

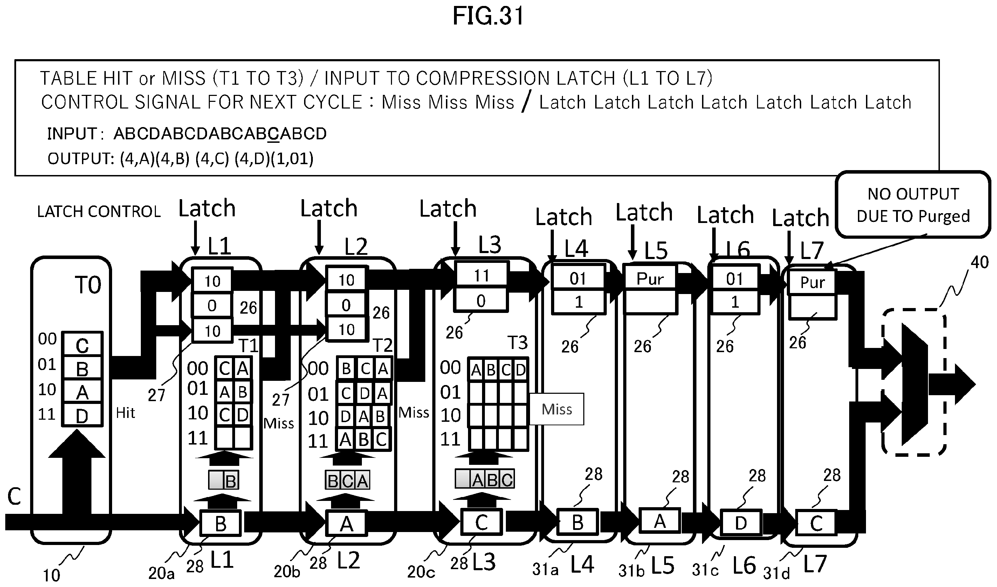

   Fig. 31 is an explanatory diagram of an operation example of the compression device.
[Fig. 32]

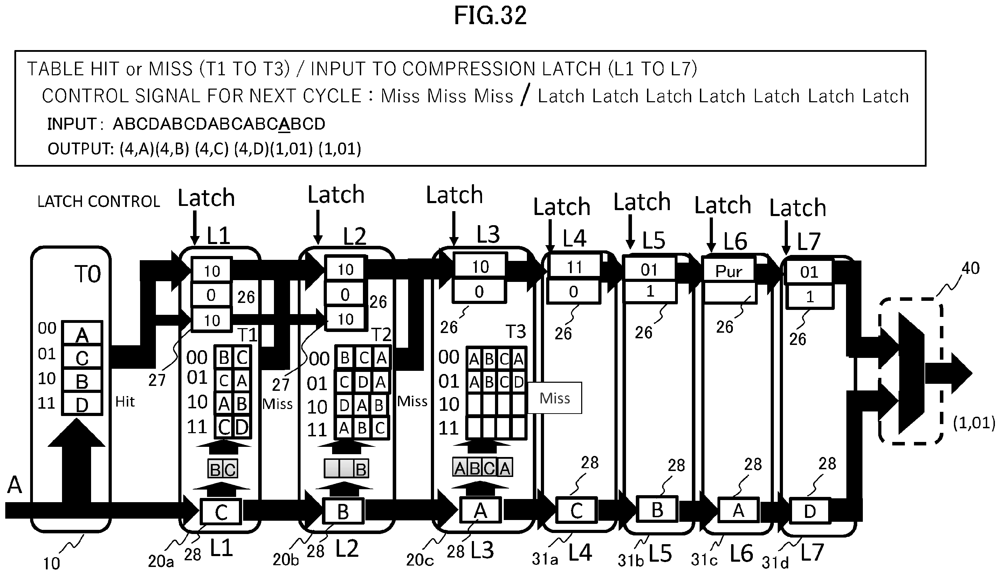

   Fig. 32 is an explanatory diagram of an operation example of the compression device.
[Fig. 33]

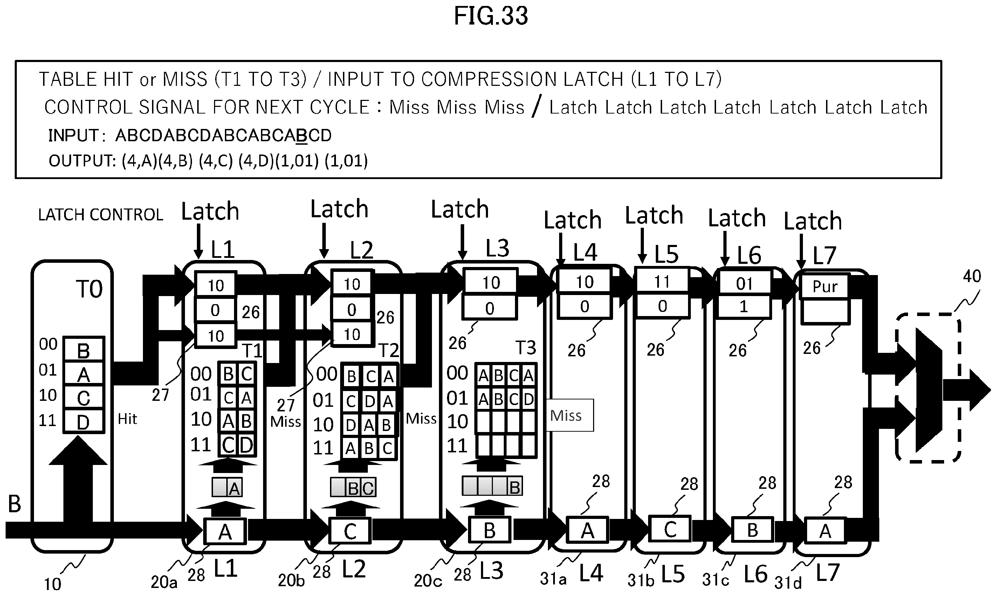

   Fig. 33 is an explanatory diagram of an operation example of the compression device.
[Fig. 34]

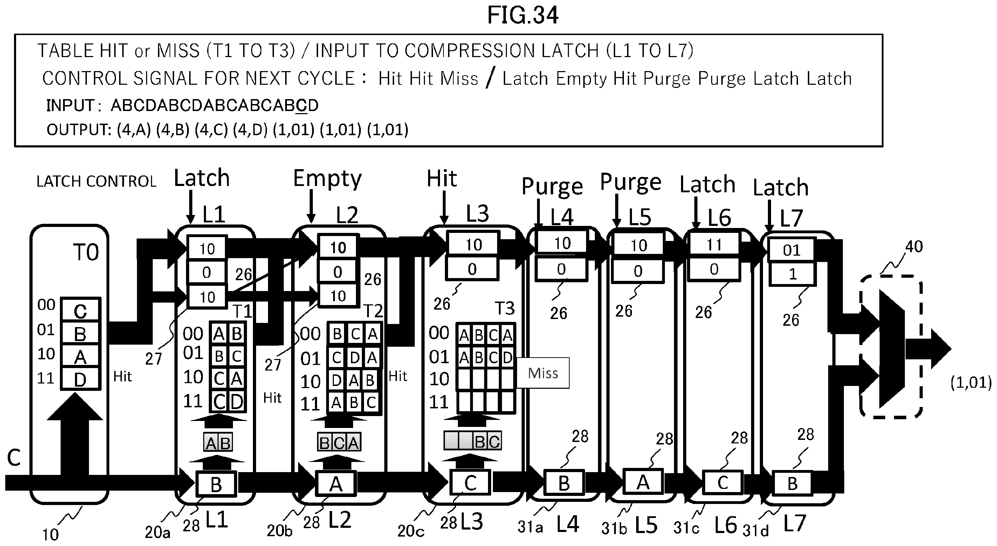

   Fig. 34 is an explanatory diagram of an operation example of the compression device.
[Fig. 35]

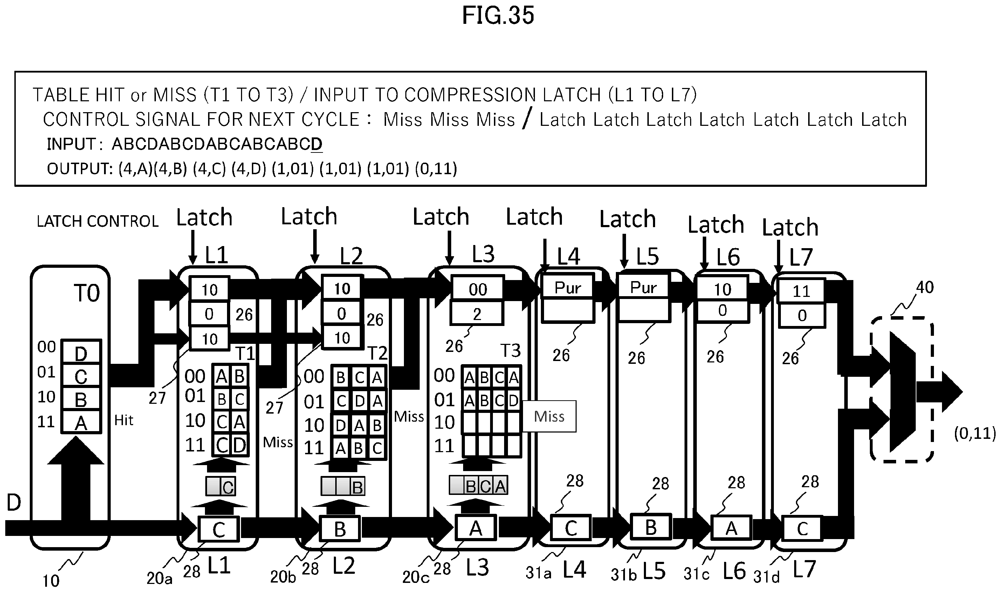

   Fig. 35 is an explanatory diagram of an operation example of the compression device.
[Fig. 36]

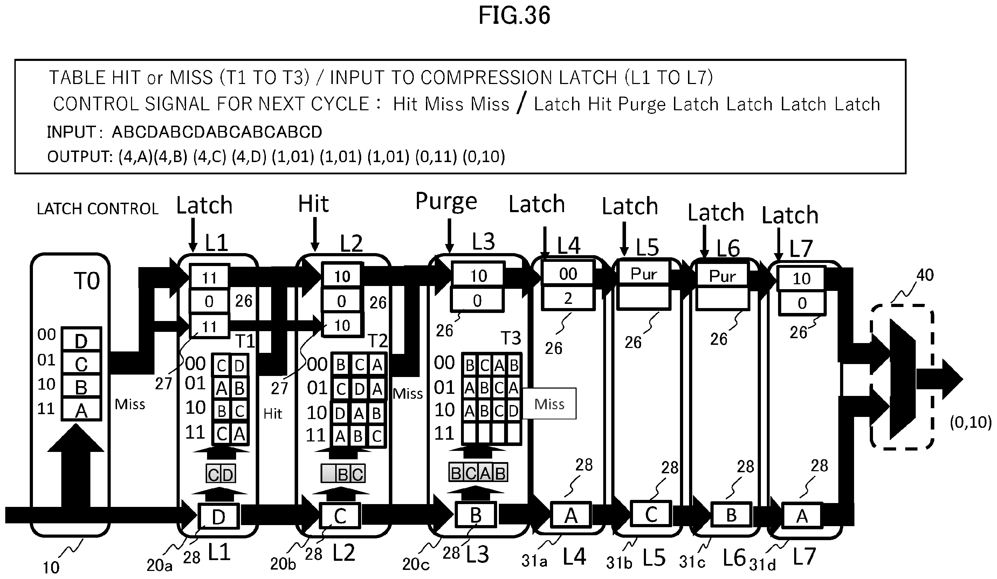

   Fig. 36 is an explanatory diagram of an operation example of the compression device.
[Fig. 37]

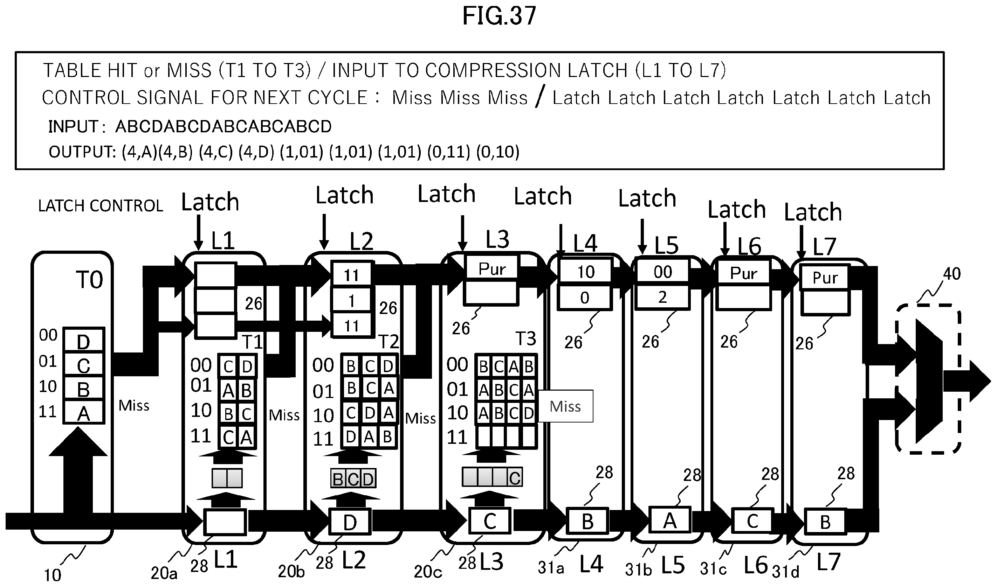

   Fig. 37 is an explanatory diagram of an operation example of the compression device.
[Fig. 38]

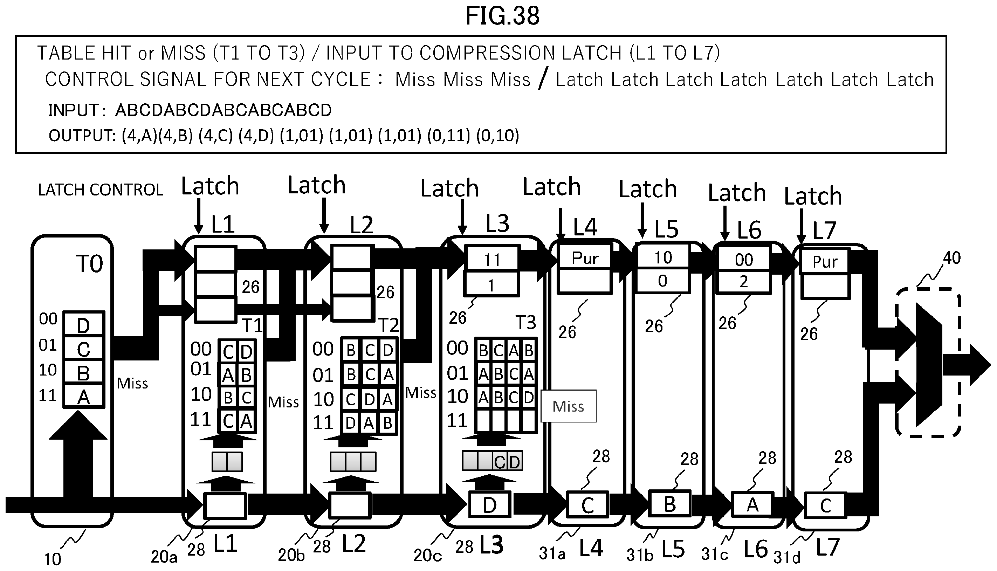

   Fig. 38 is an explanatory diagram of an operation example of the compression device.
[Fig. 39]

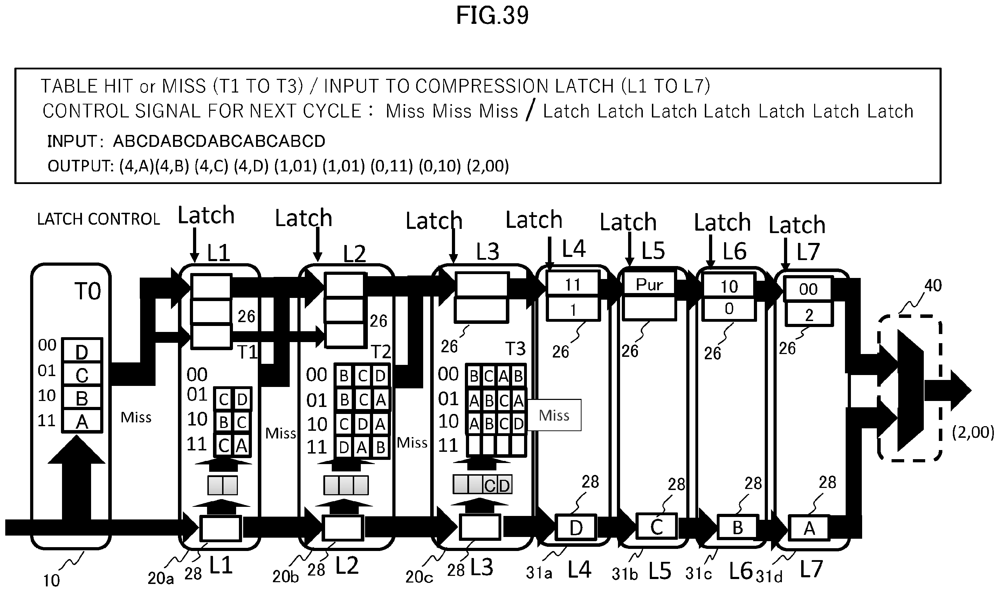

   Fig. 39 is an explanatory diagram of an operation example of the compression device.
[Fig. 40]

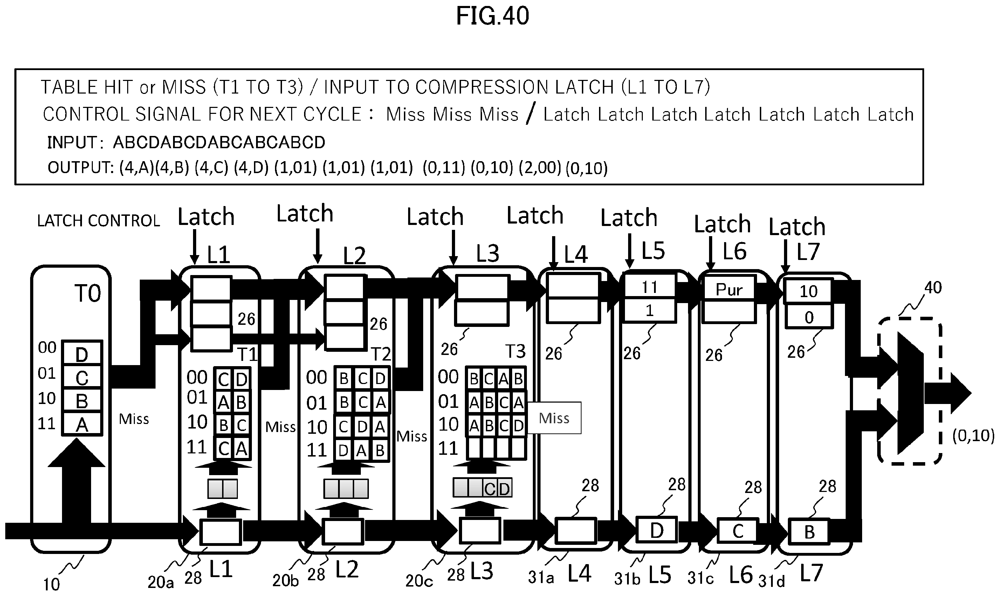

   Fig. 40 is an explanatory diagram of an operation example of the compression device.
[Fig. 41]

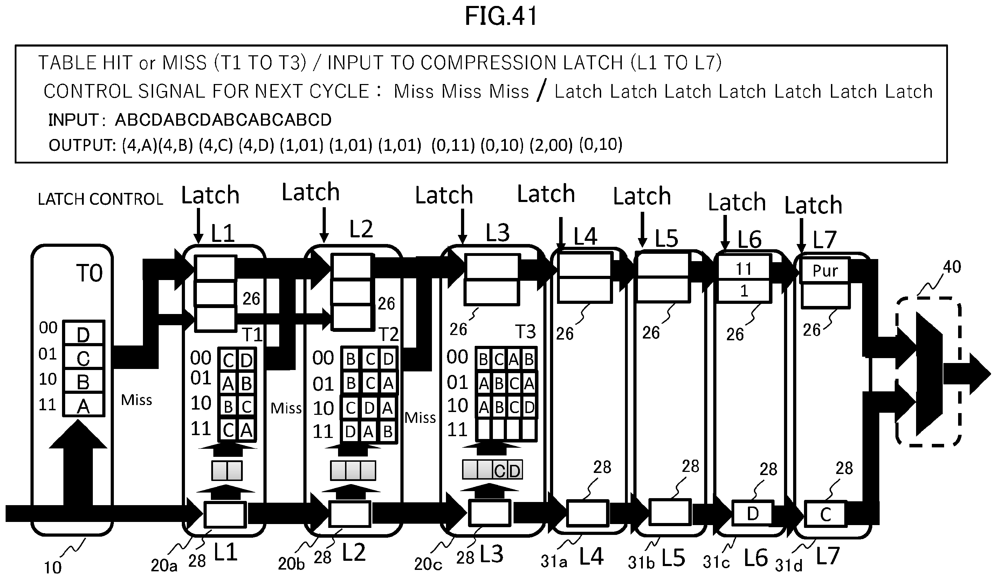

   Fig. 41 is an explanatory diagram of an operation example of the compression device.
[Fig. 42]

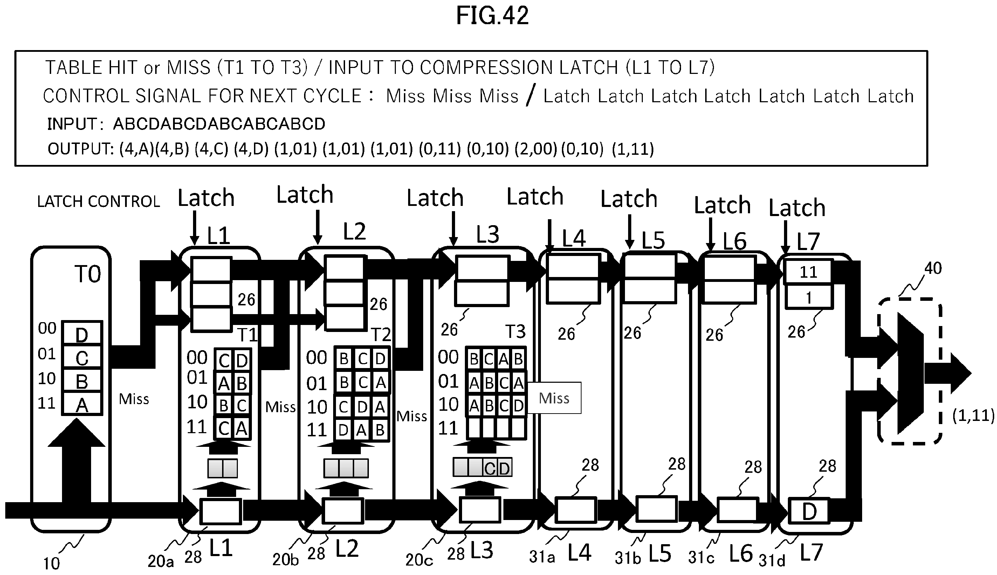

   Fig. 42 is an explanatory diagram of an operation example of the compression device.
[Fig. 43]

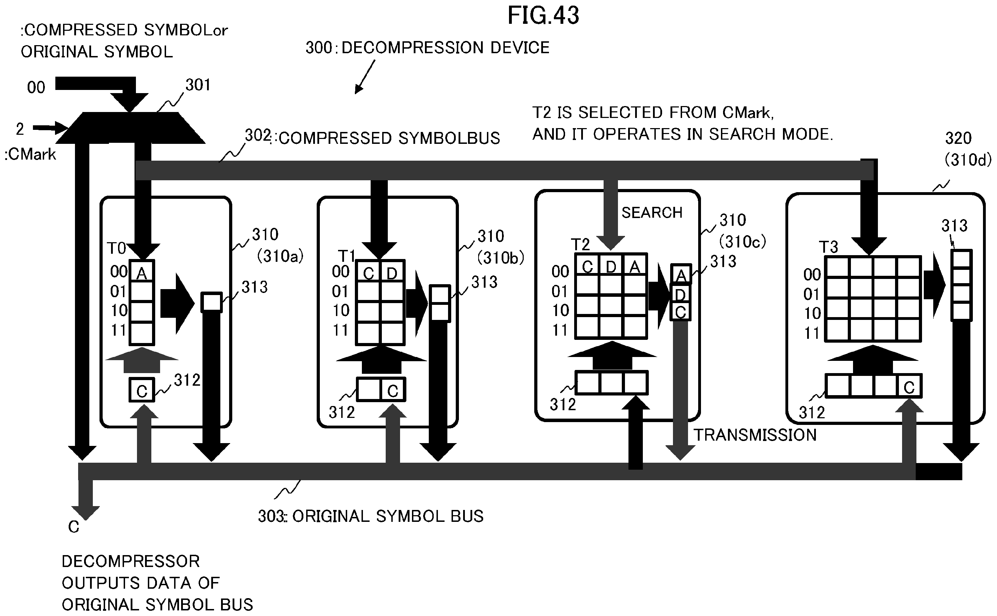

   Fig. 43 is a diagram illustrating a configuration example of a decompression device.
[Fig. 44]

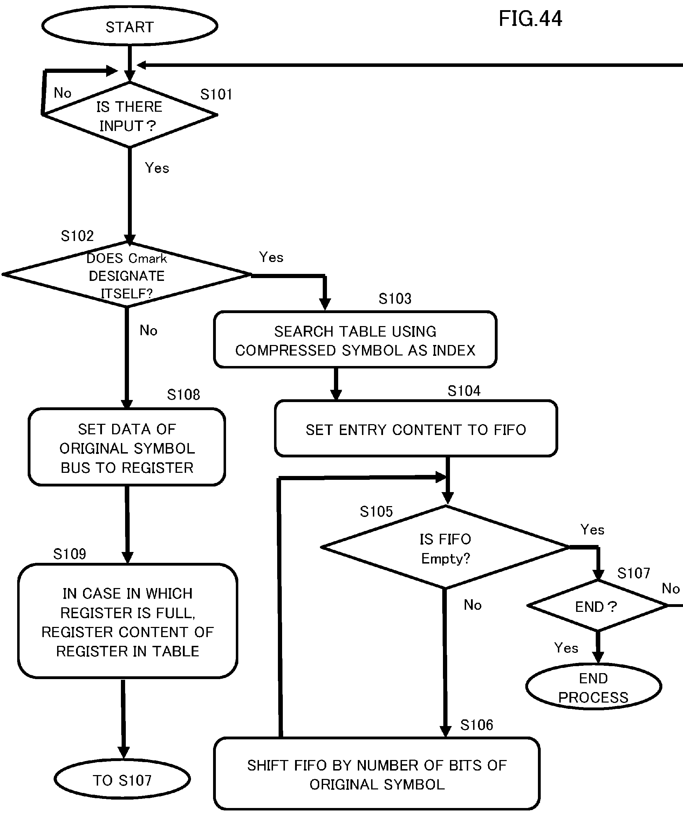

   Fig. 44 is a flowchart illustrating a process example of a decompression unit.
[Fig. 45]

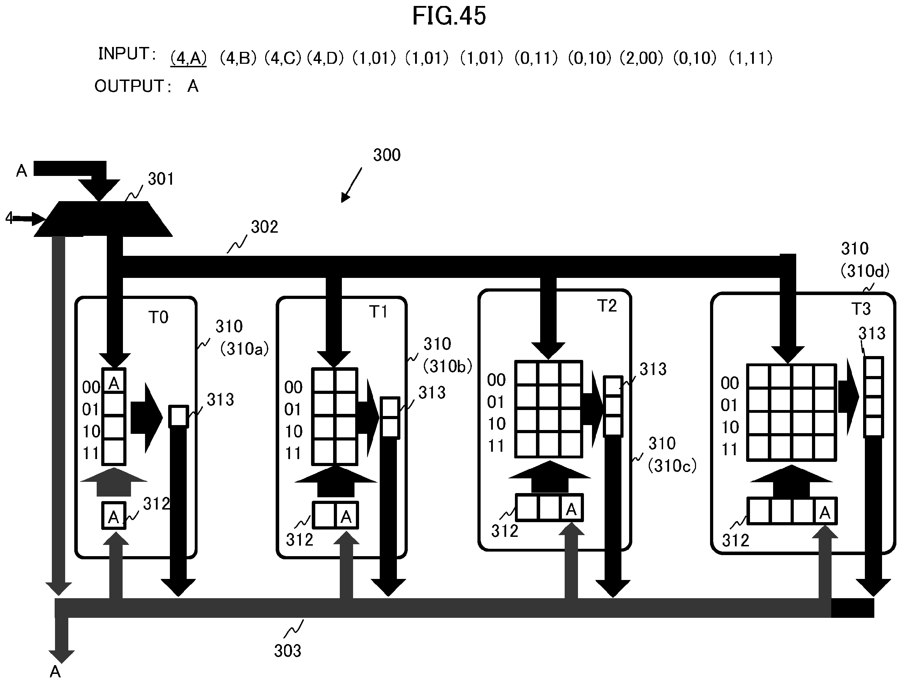

   Fig. 45 is a diagram illustrating an operation example of the decompression device.
[Fig. 46]

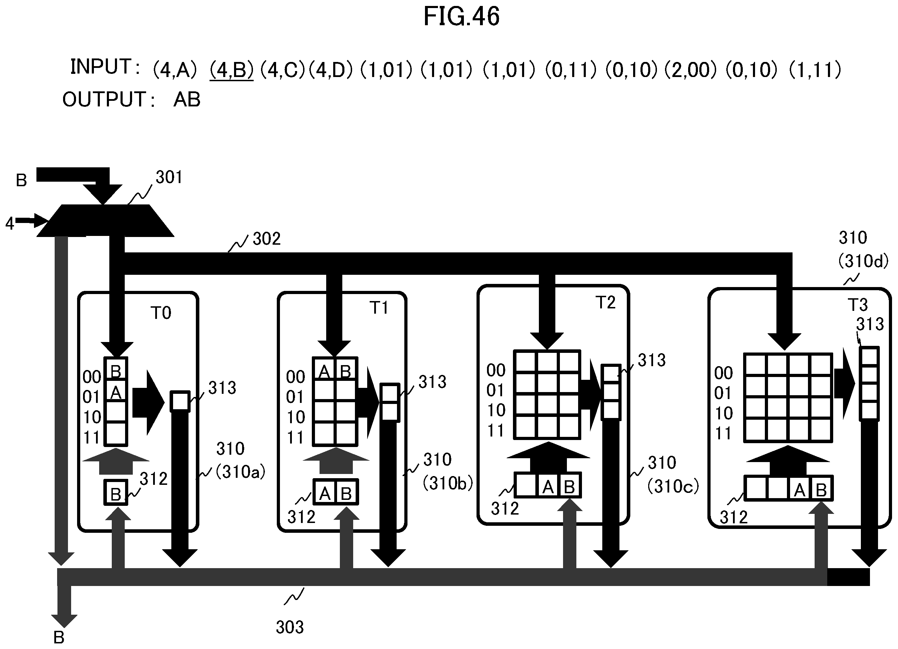

   Fig. 46 is a diagram illustrating an operation example of the decompression device.
[Fig. 47]

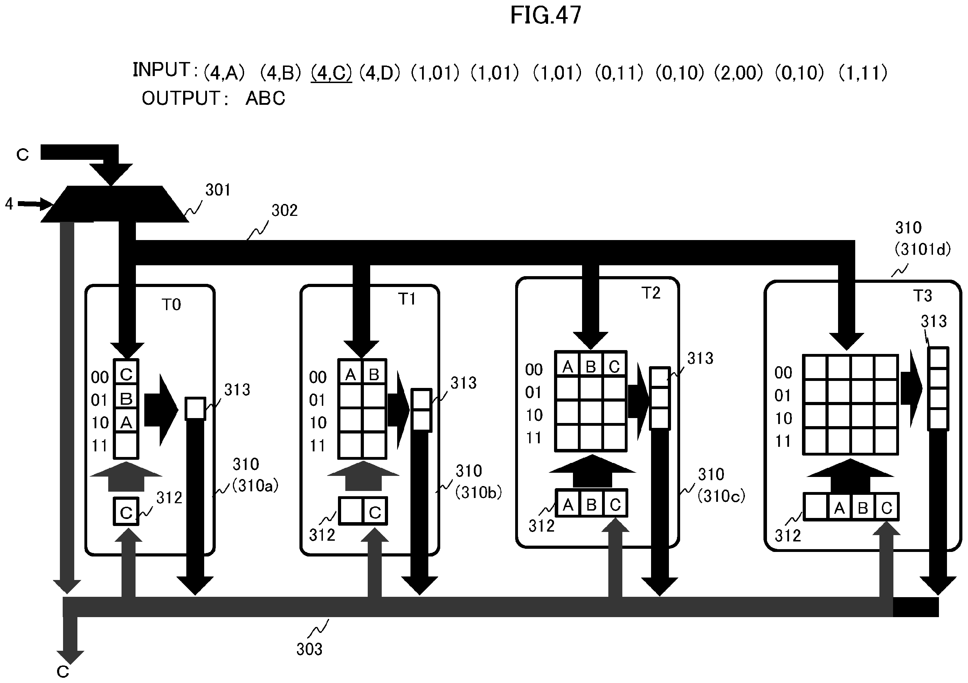

   Fig. 47 is a diagram illustrating an operation example of the decompression device.
[Fig. 48]

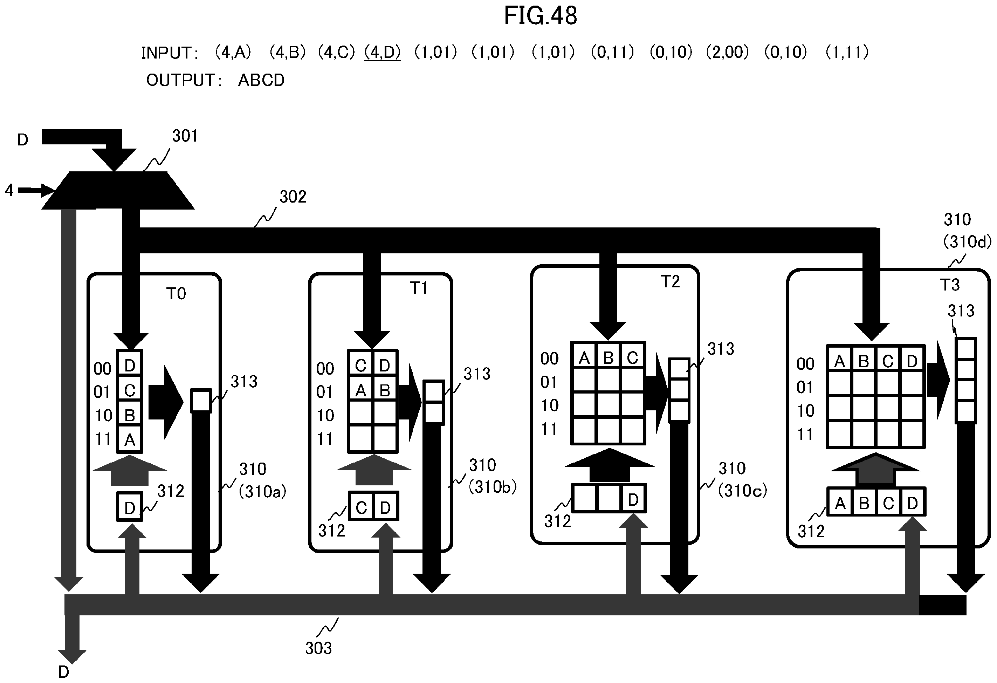

   Fig. 48 is a diagram illustrating an operation example of the decompression device.
[Fig. 49]

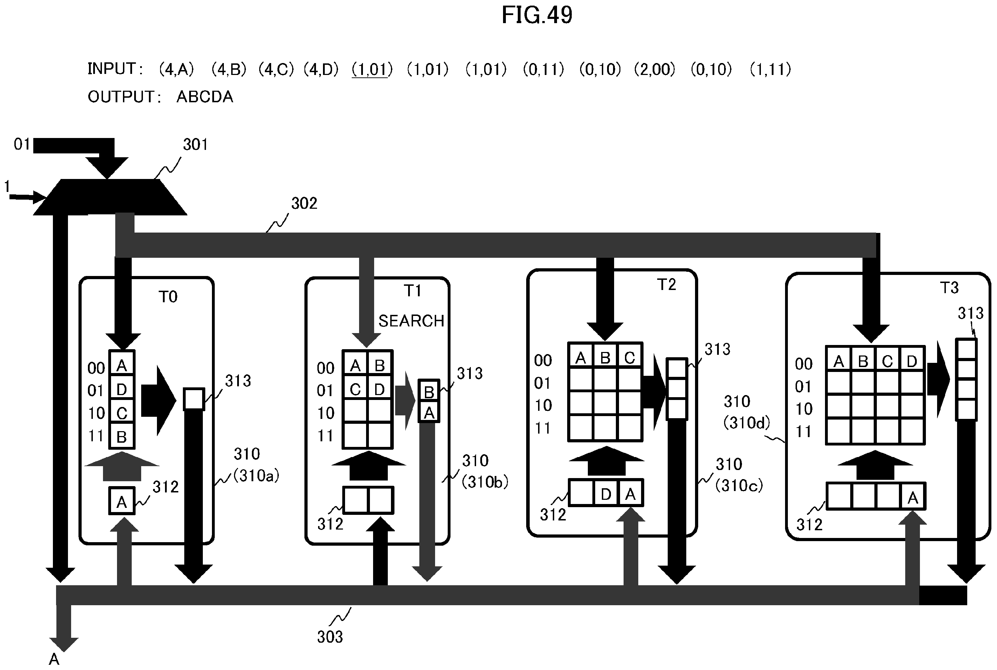

   Fig. 49 is a diagram illustrating an operation example of the decompression device.
[Fig. 50]

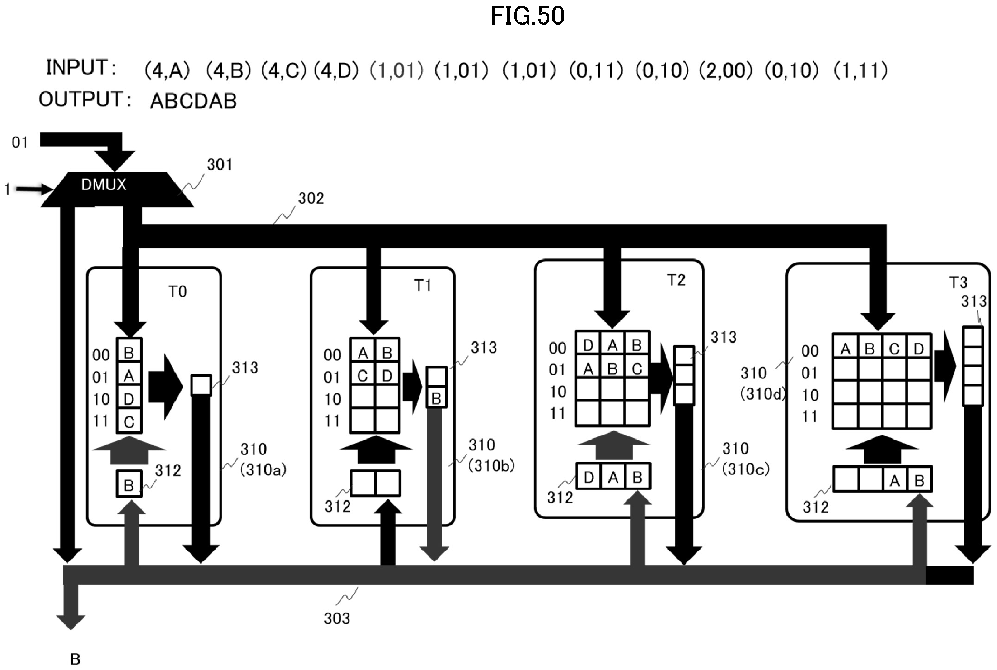

   Fig. 50 is a diagram illustrating an operation example of the decompression device.
[Fig. 51]

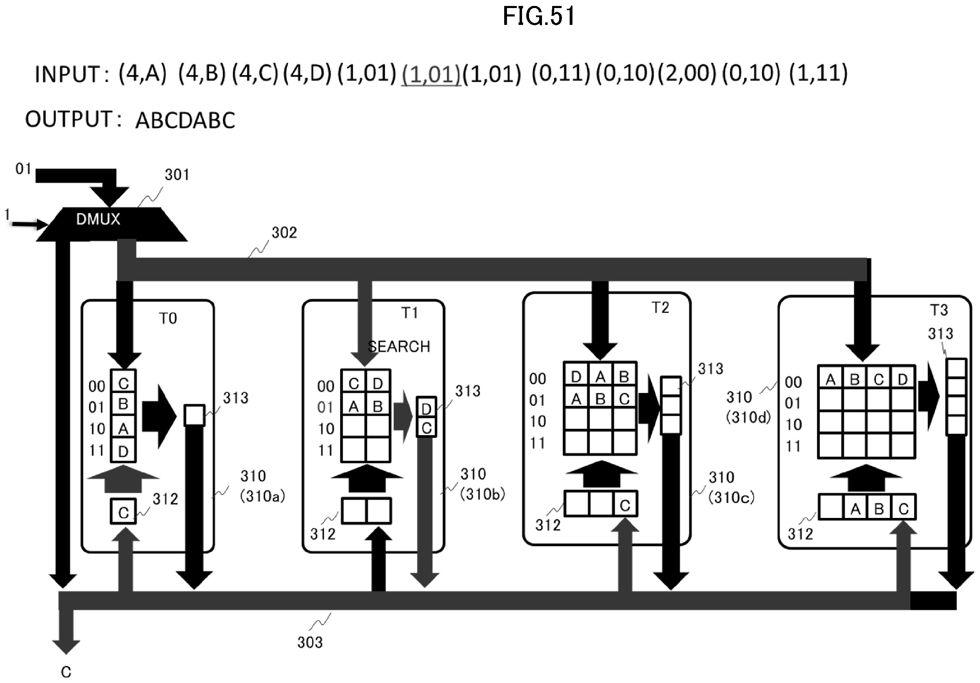

   Fig. 51 is a diagram illustrating an operation example of the decompression device.
[Fig. 52]

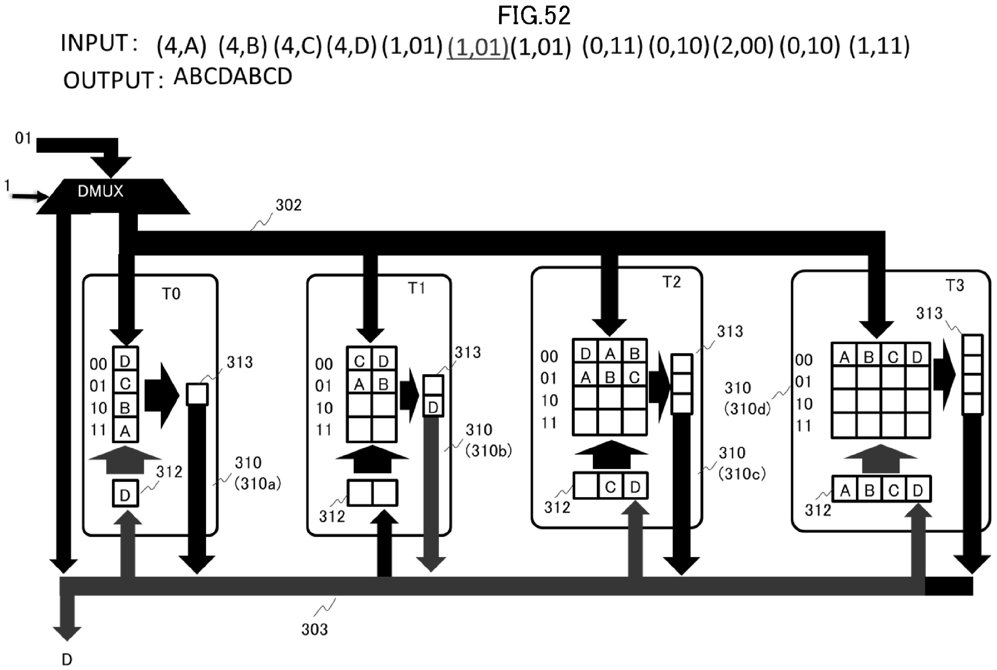

   Fig. 52 is a diagram illustrating an operation example of the decompression device.
[Fig. 53]

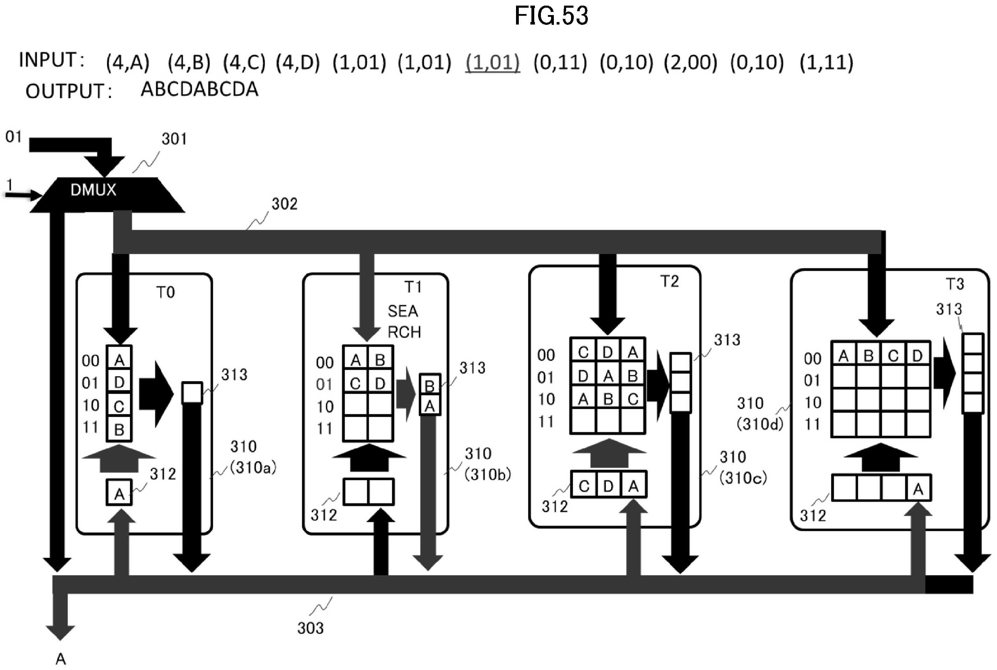

   Fig. 53 is a diagram illustrating an operation example of the decompression device.
[Fig. 54]

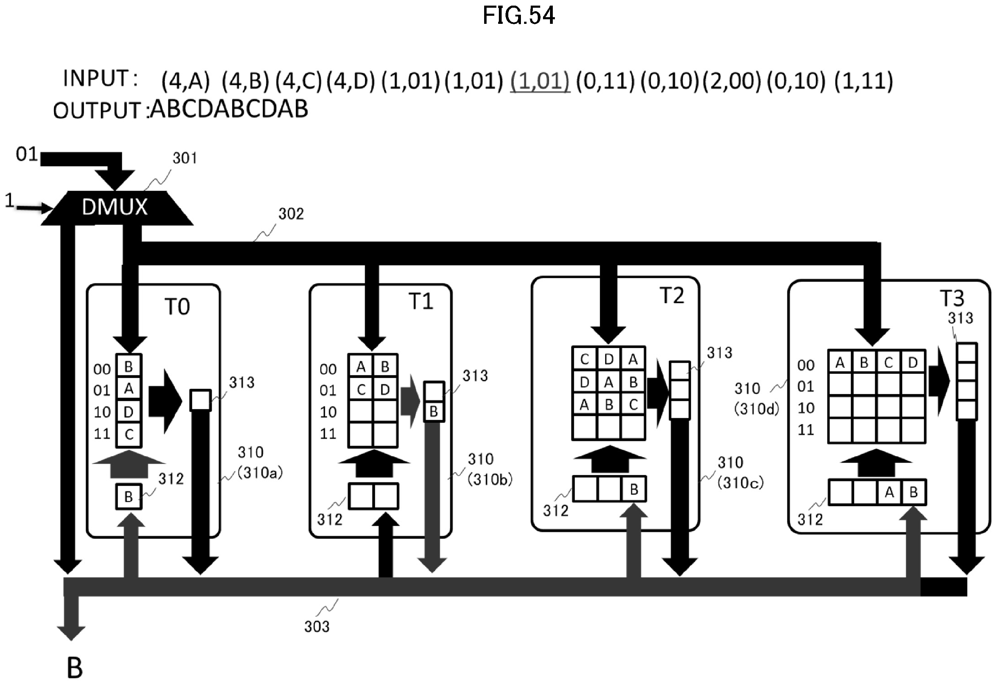

   Fig. 54 is a diagram illustrating an operation example of the decompression device.
[Fig. 55]

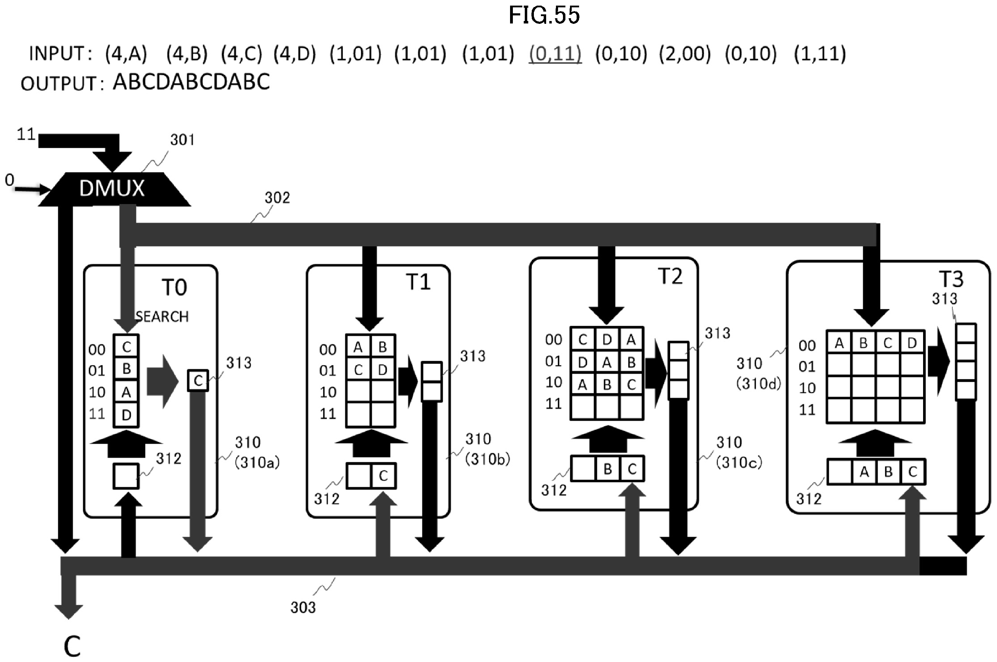

   Fig. 55 is a diagram illustrating an operation example of the decompression device.
[Fig. 56]

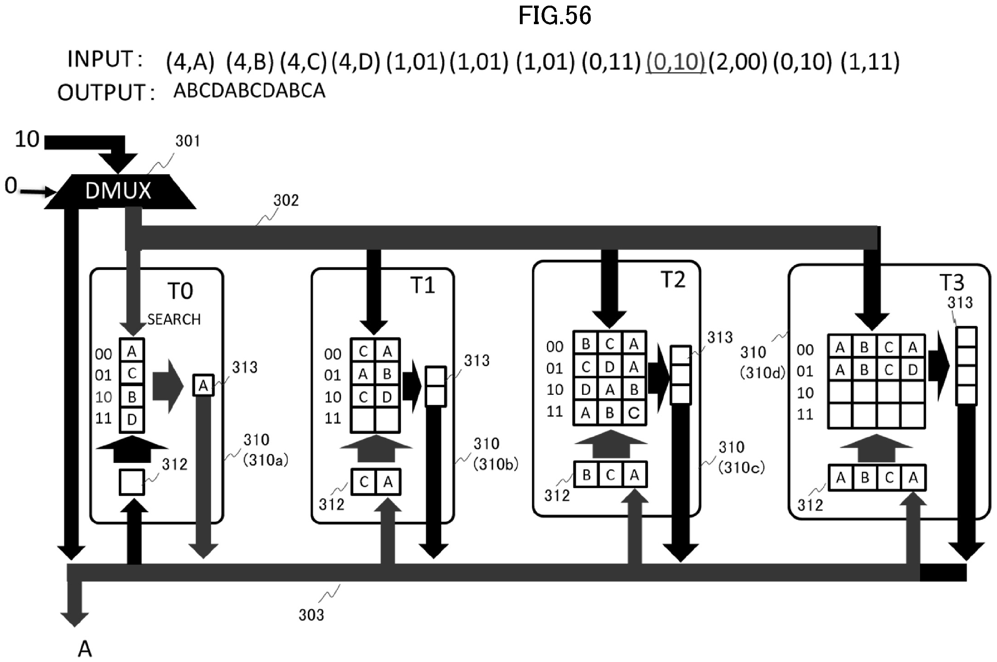

   Fig. 56 is a diagram illustrating an operation example of the decompression device.
[Fig. 57]

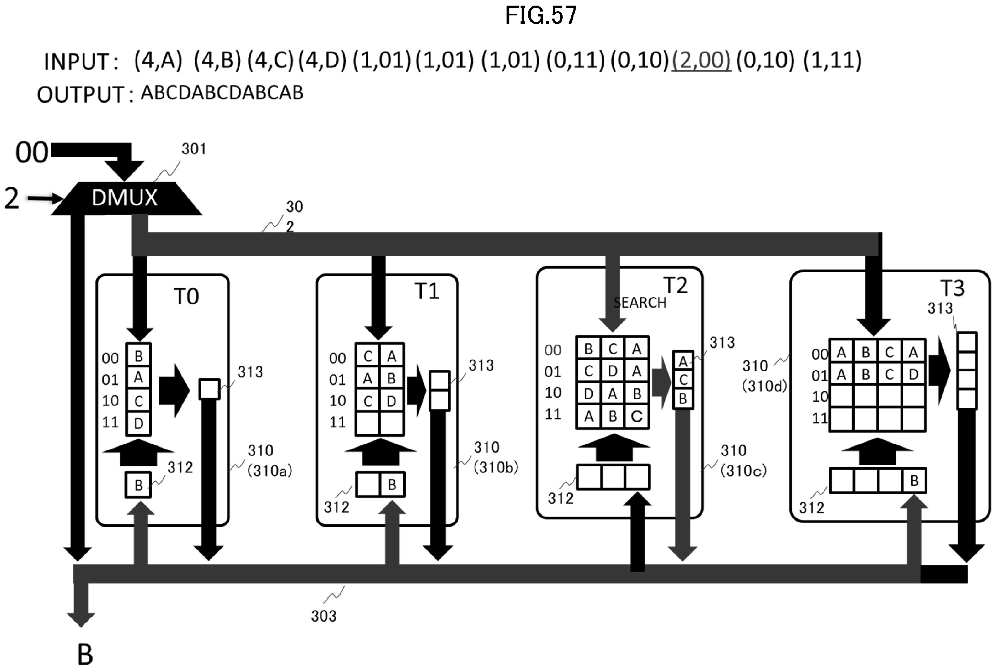

   Fig. 57 is a diagram illustrating an operation example of the decompression device.
[Fig. 58]

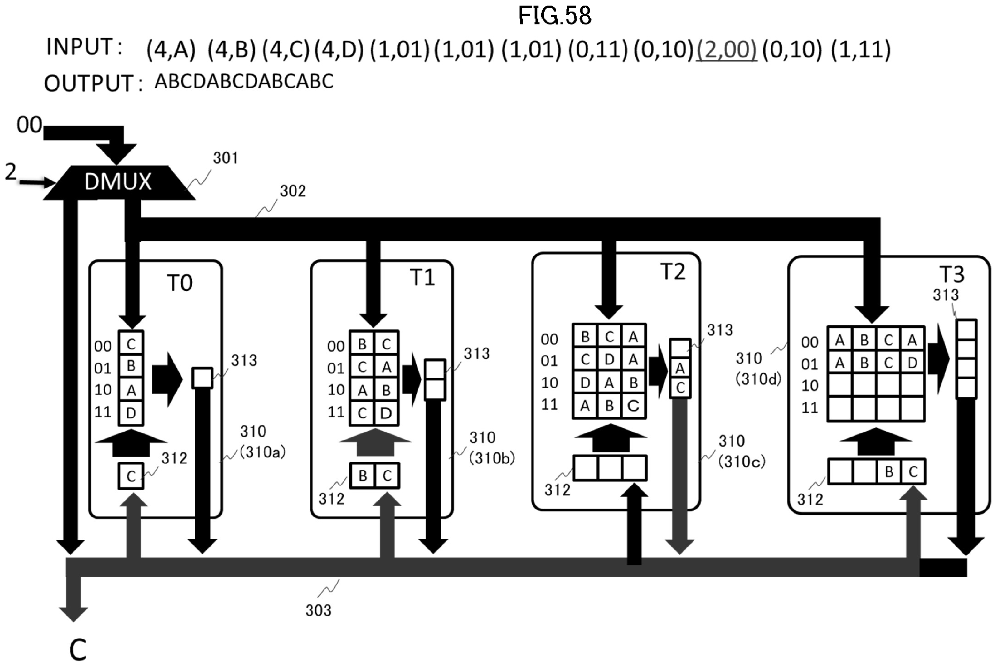

   Fig. 58 is a diagram illustrating an operation example of the decompression device.
[Fig. 59]

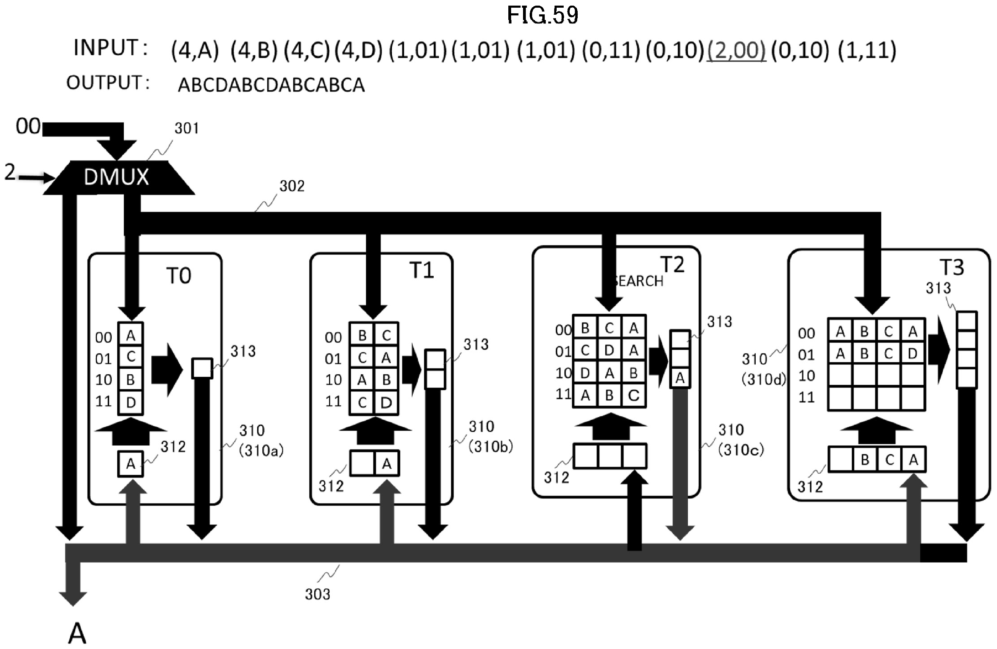

   Fig. 59 is a diagram illustrating an operation example of the decompression device.
[Fig. 60]

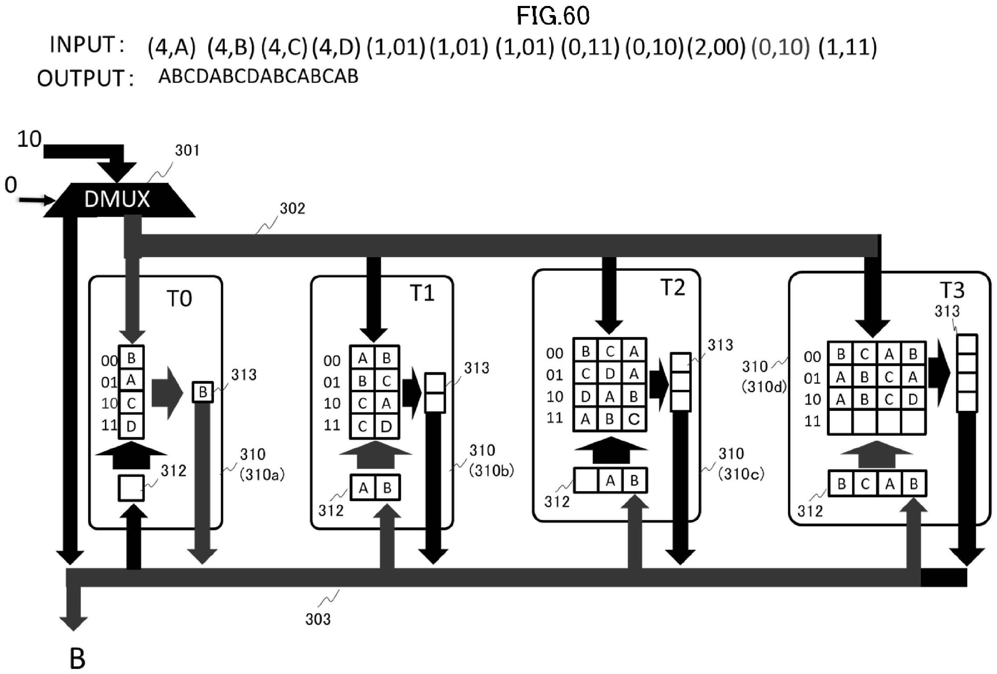

   Fig. 60 is a diagram illustrating an operation example of the decompression device.
[Fig. 61]

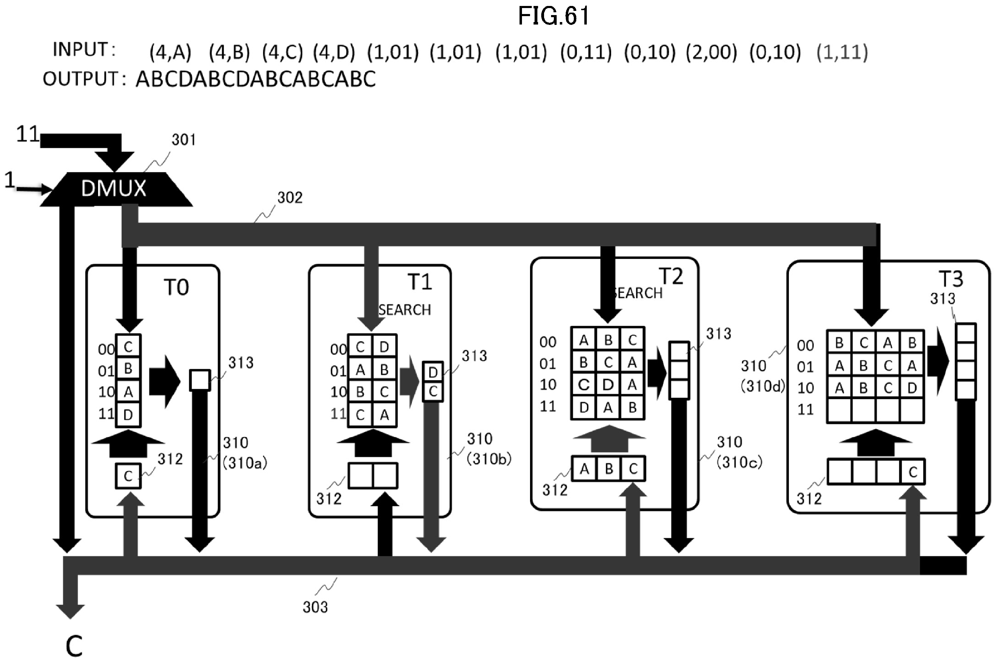

   Fig. 61 is a diagram illustrating an operation example of the decompression device.
[Fig. 62]

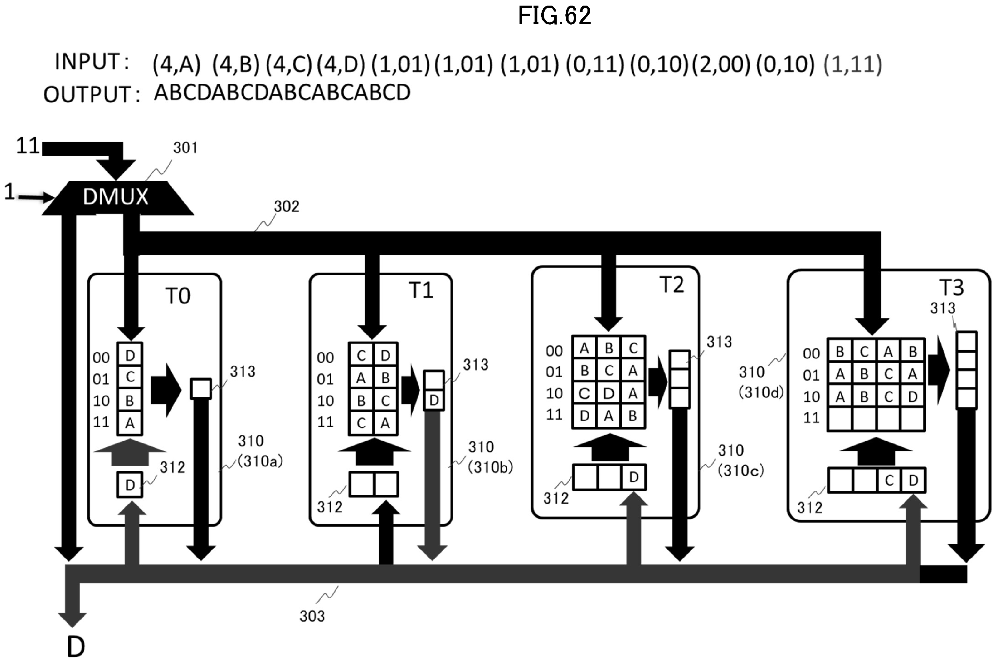

   Fig. 62 is a diagram illustrating an operation example of the decompression device.
[Fig. 63]

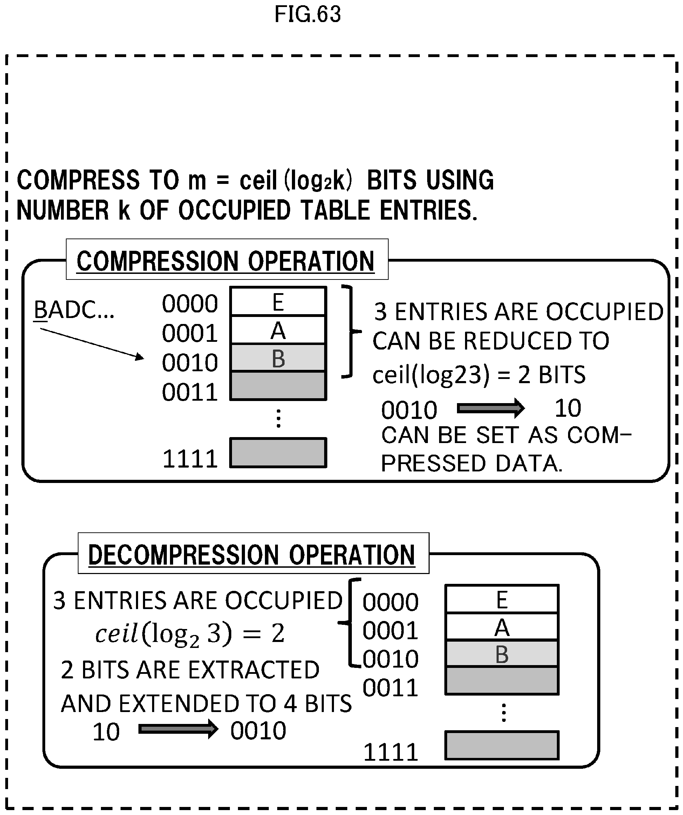

   Fig. 63 is an explanatory diagram of entropy calculation.
[Fig. 64]

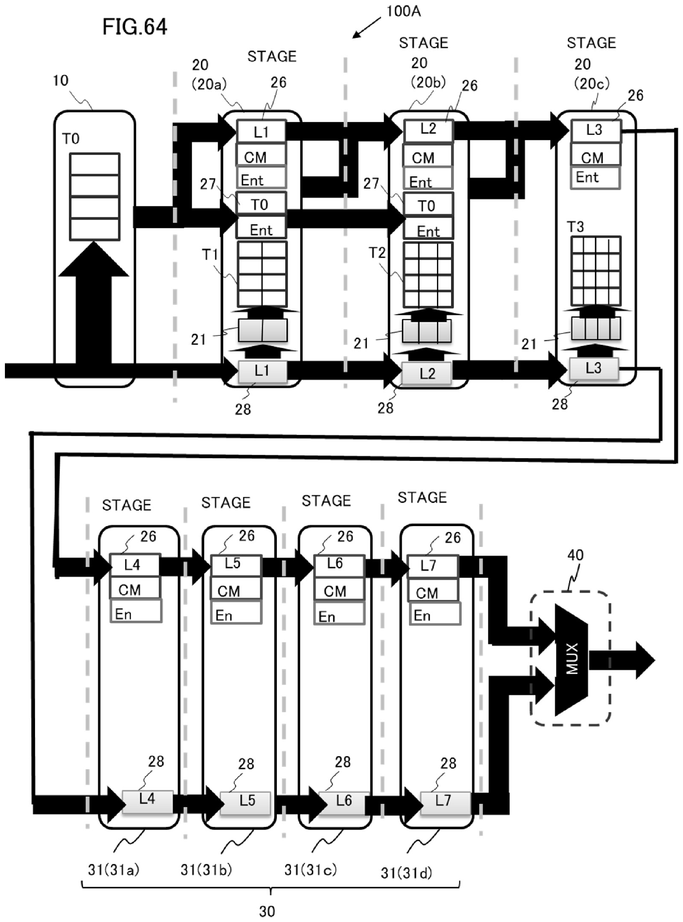

   Fig. 64 is a diagram illustrating a configuration example of a compression device according to a second embodiment.
[Fig. 65]

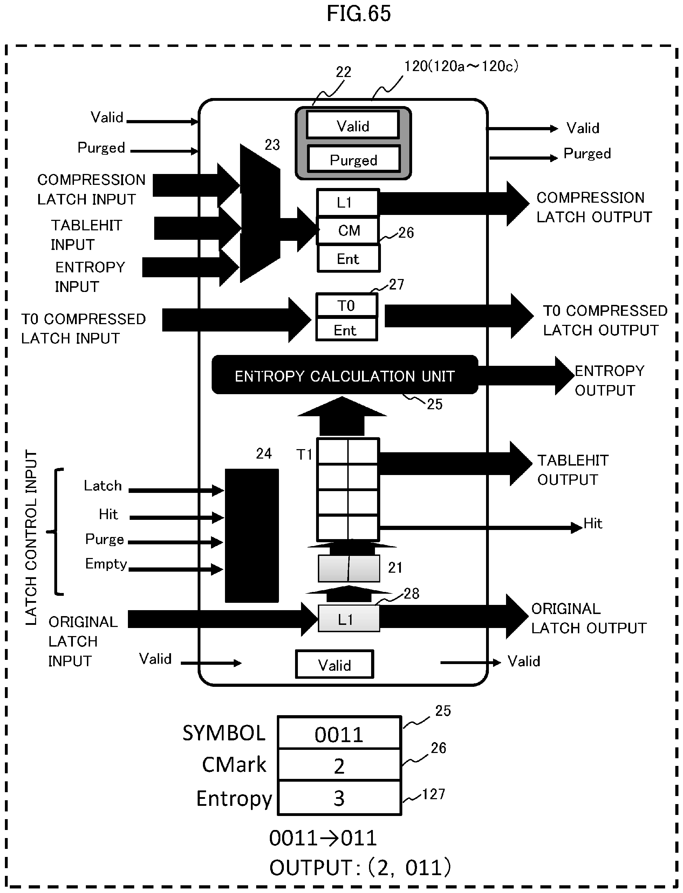

   Fig. 65 is a diagram illustrating a configuration example of a compression unit according to the second embodiment.
[Fig. 66]

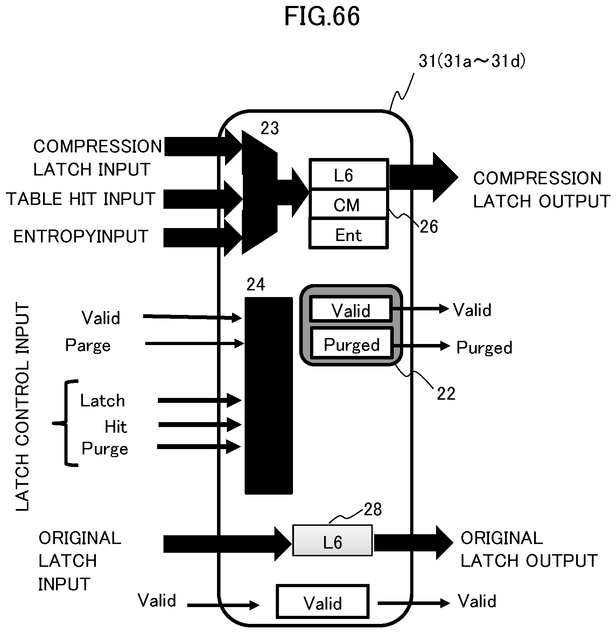

   Fig. 66 is a diagram illustrating a configuration example of a latch adjustment unit according to the second embodiment.
[Fig. 67]

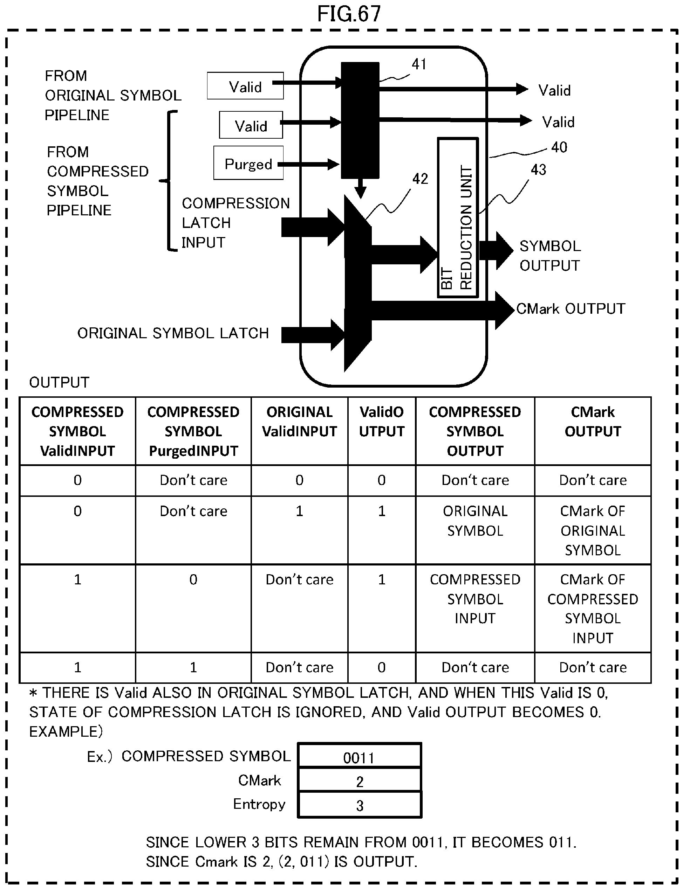

   Fig. 67 is a diagram illustrating a configuration example of an output unit according to the second embodiment.
[Fig. 68]

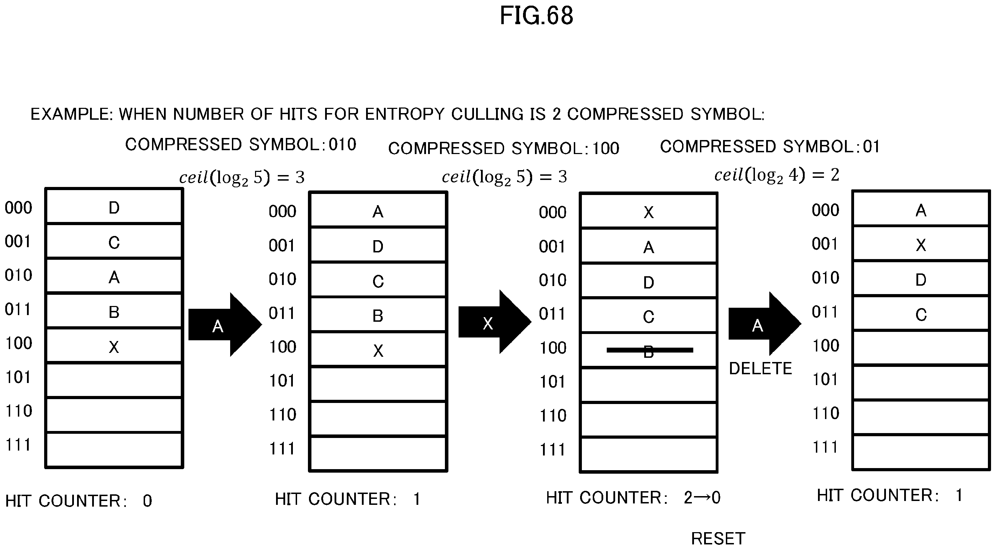

   Fig. 68 is an explanatory diagram of entropy culling.
[Fig. 69]

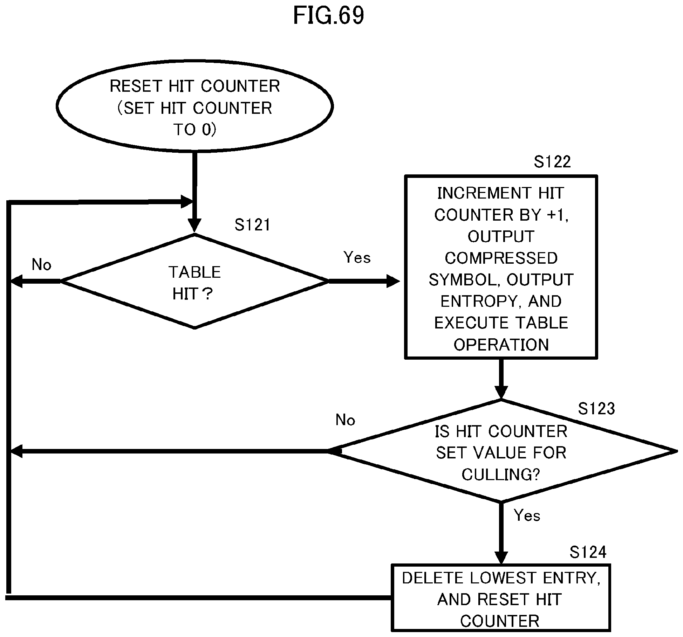

   Fig. 69 is a flowchart illustrating a process example of entropy culling.
[Fig. 70]

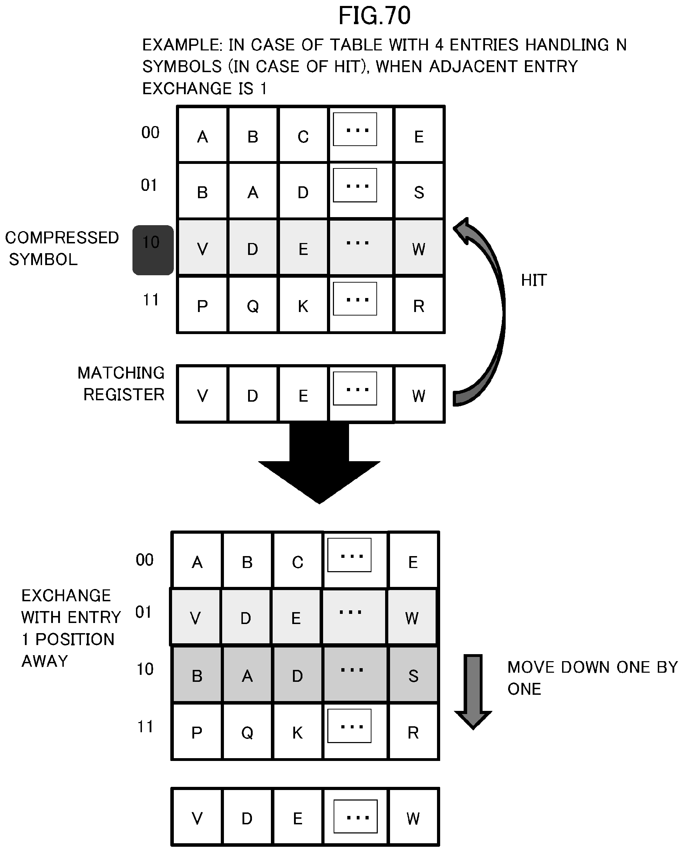

   Fig. 70 is an explanatory diagram of adjacent entry exchange.
[Fig. 71]

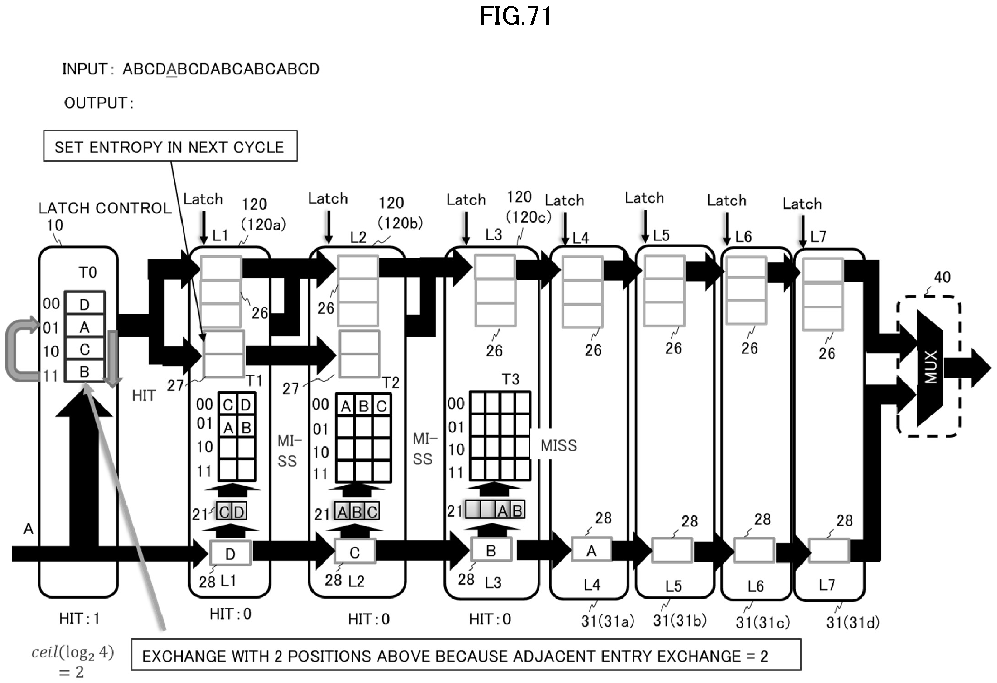

   Fig. 71 is a diagram illustrating an operation example of the compression device according to the second embodiment.
[Fig. 72]

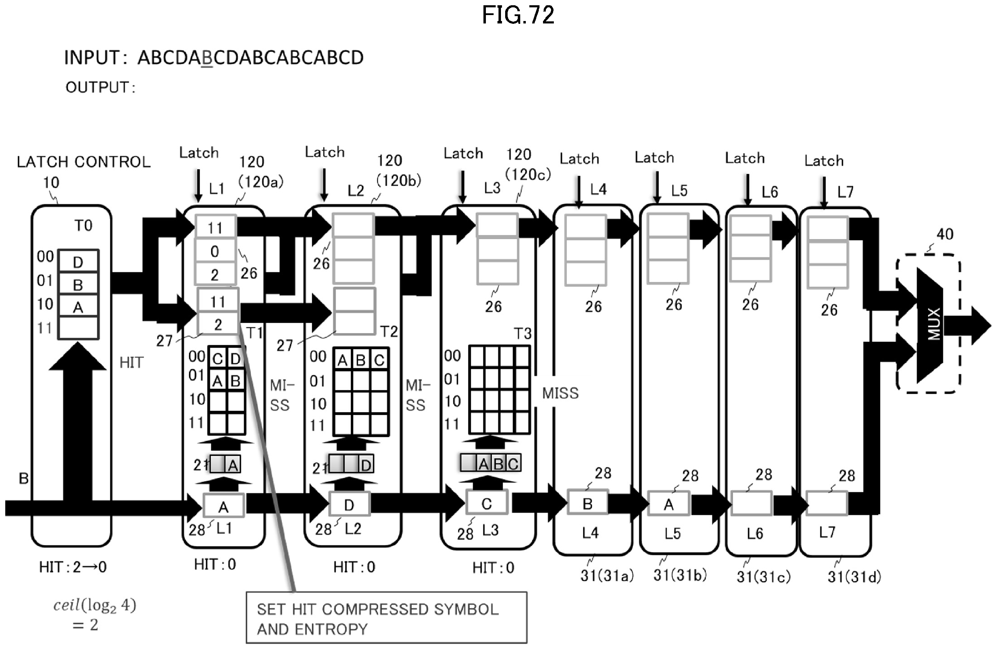

   Fig. 72 is a diagram illustrating an operation example of the compression device according to the second embodiment.
[Fig. 73]

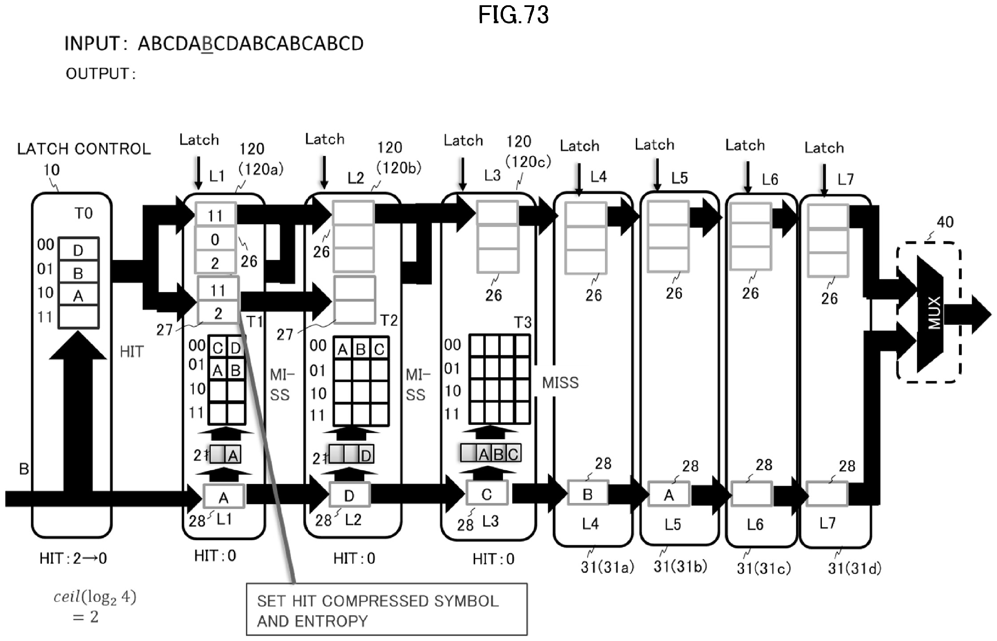

   Fig. 73 is a diagram illustrating an operation example of the compression device according to the second embodiment.
[Fig. 74A]

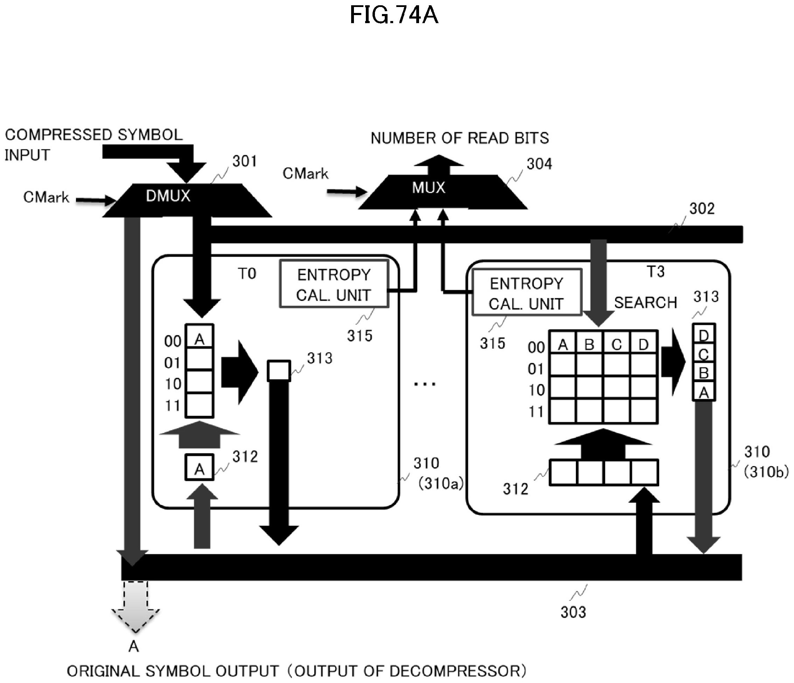

   Fig. 74A is a diagram illustrating a configuration example of a decompression device according to the second embodiment.
[Fig. 74B]

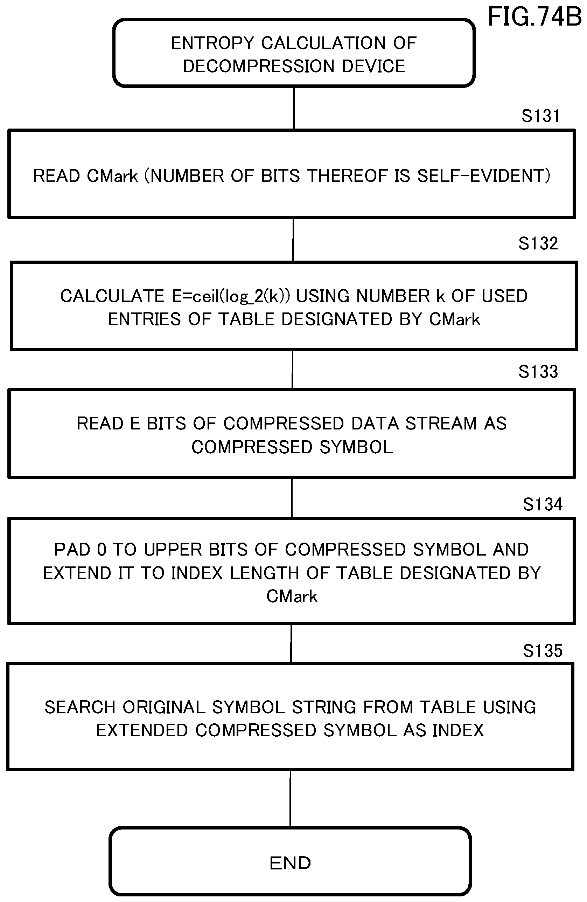

   Fig. 74B is a flowchart illustrating a process example of the decompression device according to the second embodiment.
[Fig. 75]

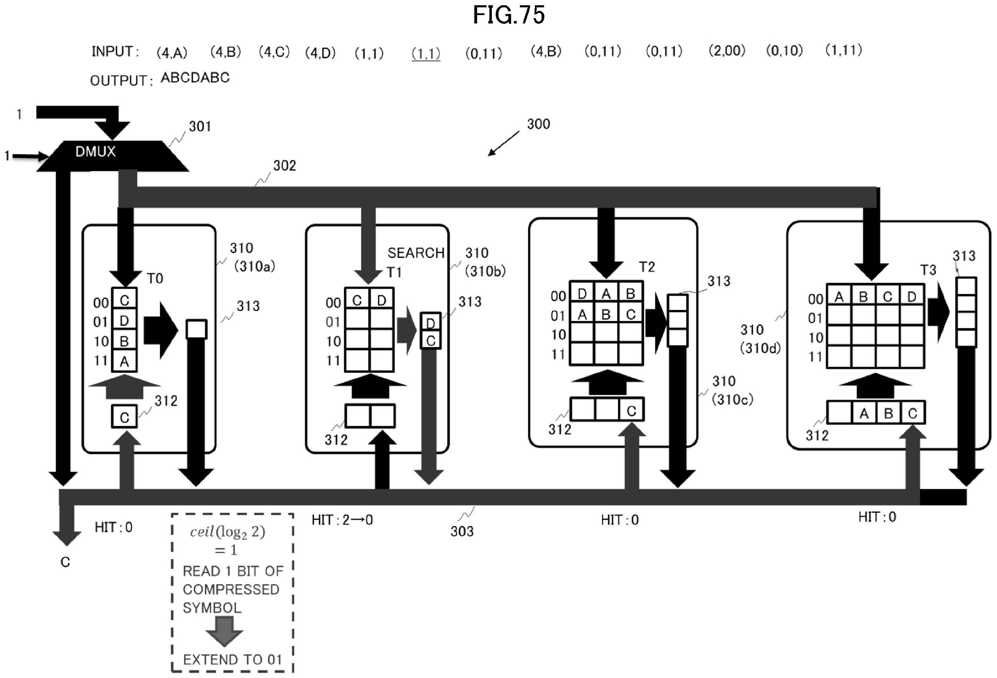

   Fig. 75 is a diagram explaining an operation example of the decompression device according to the second embodiment.
[Fig. 76]

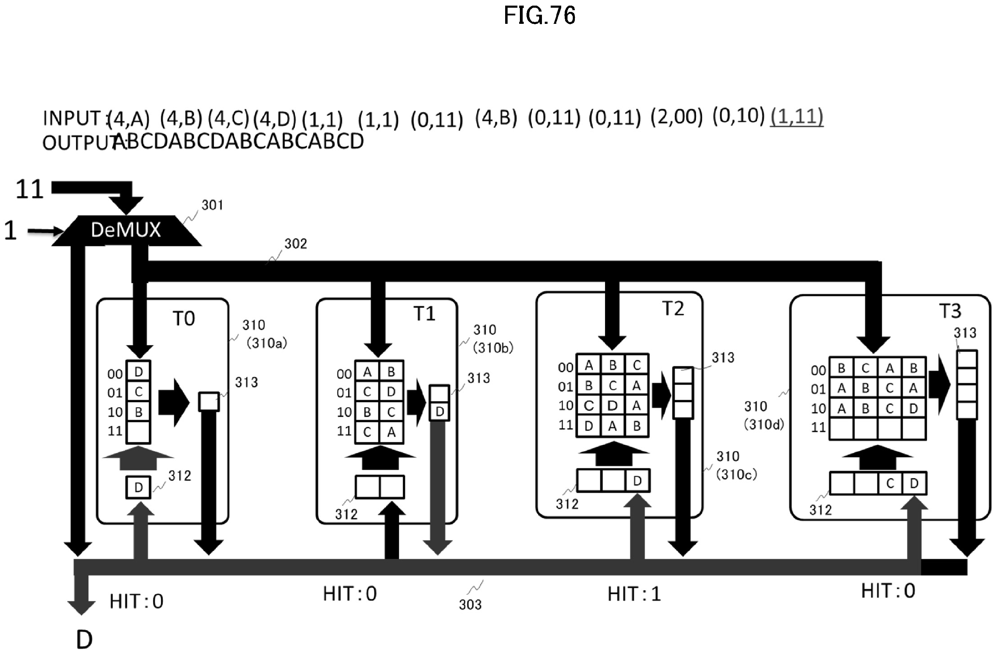

   Fig. 76 is a diagram explaining an operation example of the decompression device according to the second embodiment.
[Fig. 77]

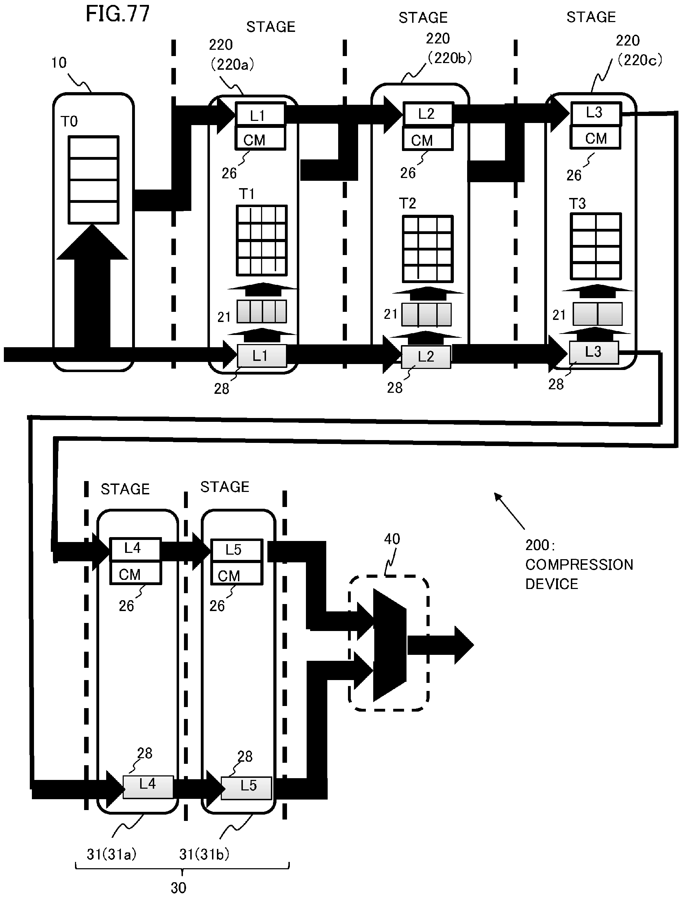

   Fig. 77 is a diagram illustrating a configuration example of a compression device according to a third embodiment.
[Fig. 78]

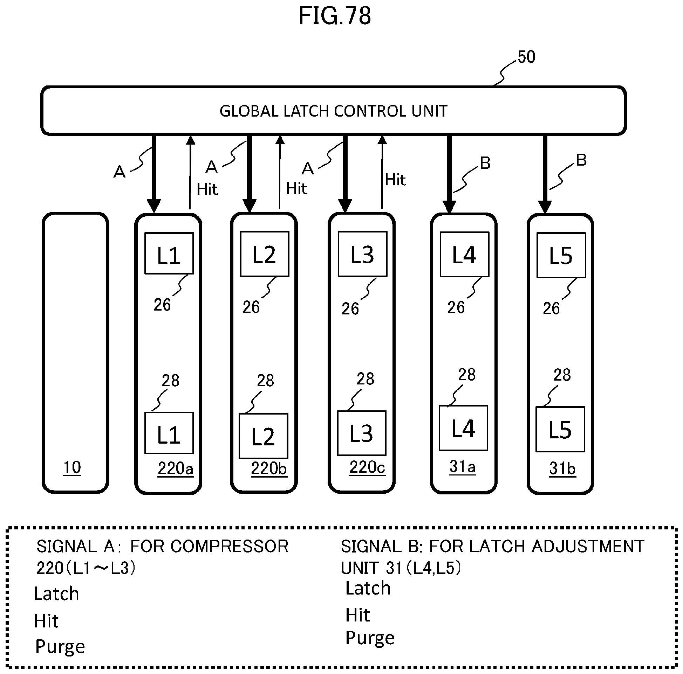

   Fig. 78 is a diagram illustrating a configuration example of a compression device according to the third embodiment.
[Fig. 79]

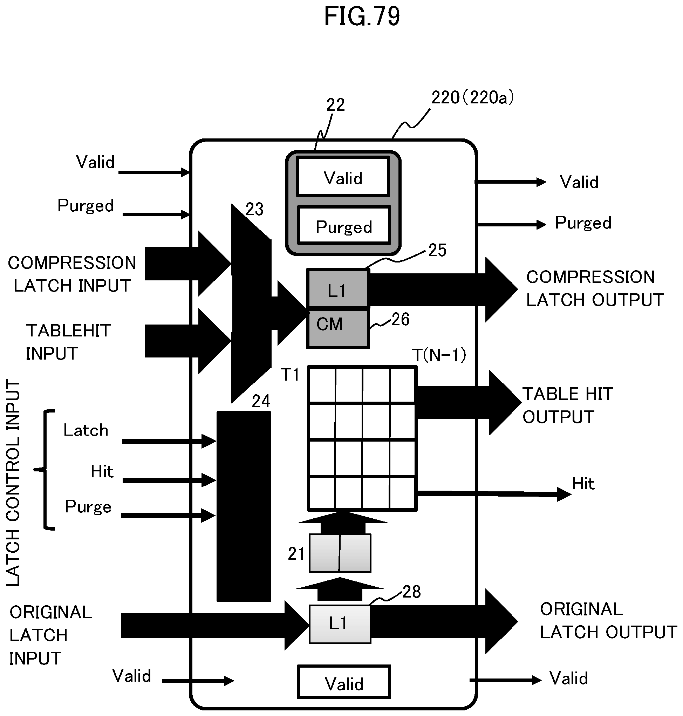

   Fig. 79 is a diagram illustrating a configuration example of a compression unit according to the third embodiment.
[Fig. 80]

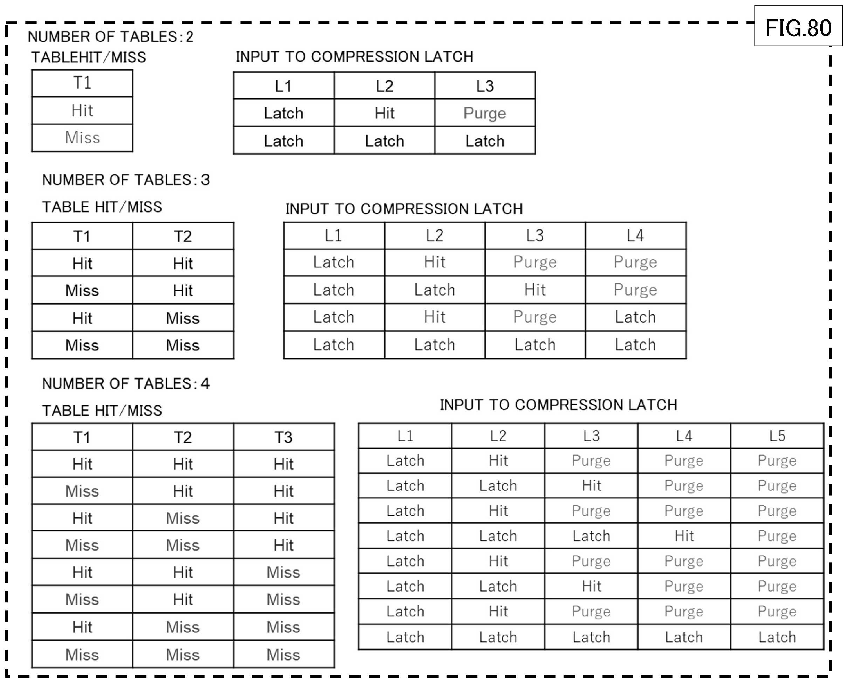

   Fig. 80 is a table illustrating hit/miss patterns of each table and patterns of control signals according to the third embodiment.
[Fig. 81]

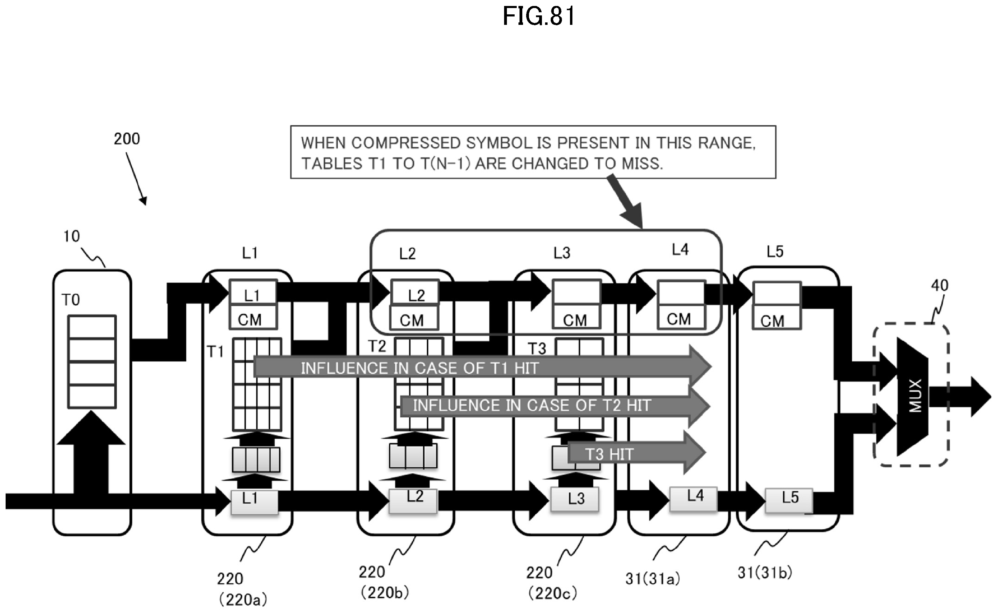

   Fig. 81 is an explanatory diagram of a method for resolving a conflict in latch control in a decrement scheme.
[Fig. 82]

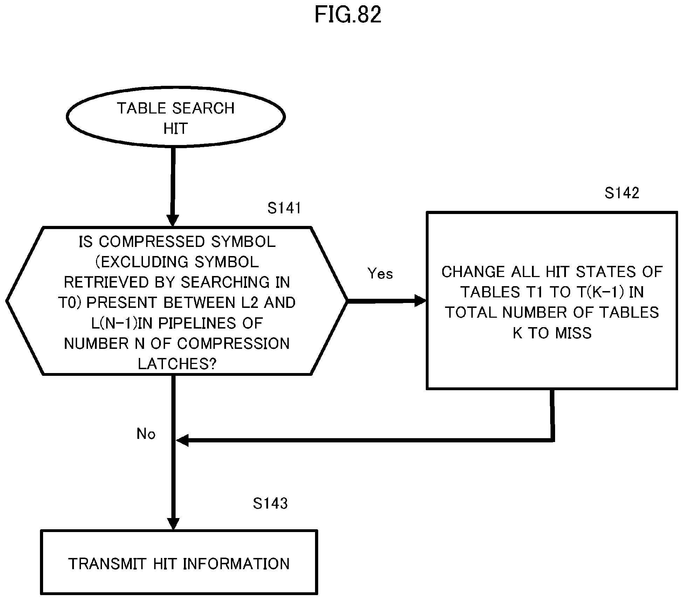

   Fig. 82 is a flowchart illustrating a process example for resolving a conflict.
[Fig. 83]

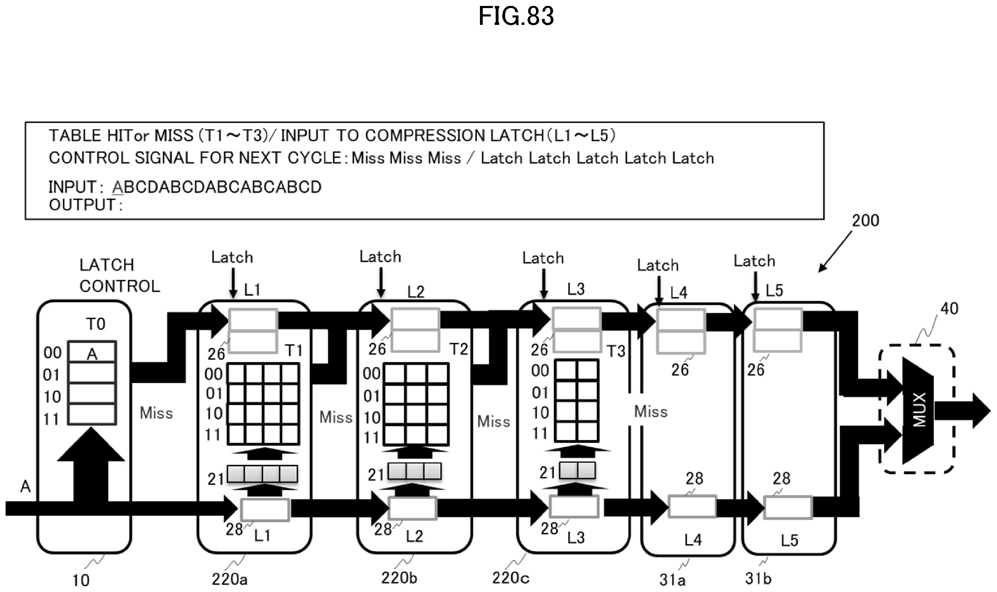

   Fig. 83 is a diagram explaining an operation example of the compression device according to the third embodiment.
[Fig. 84]

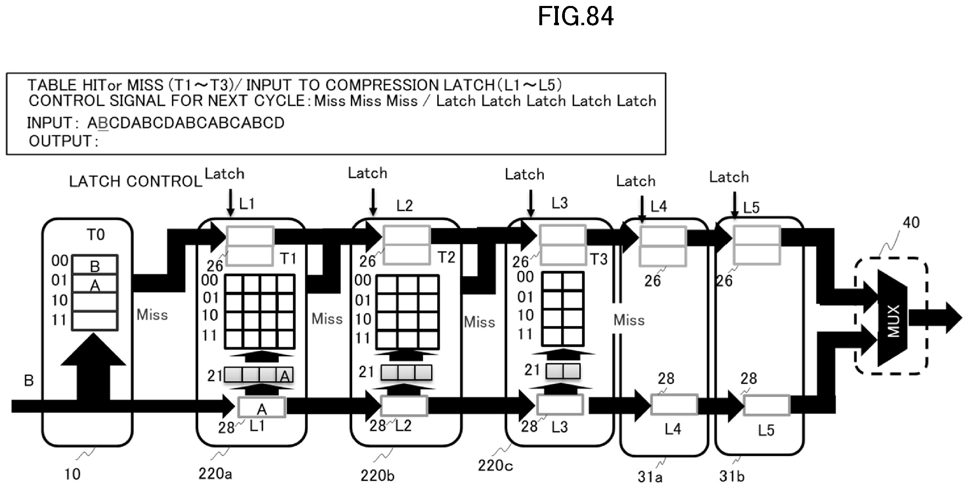

   Fig. 84 is a diagram explaining an operation example of the compression device according to the third embodiment.
[Fig. 85]

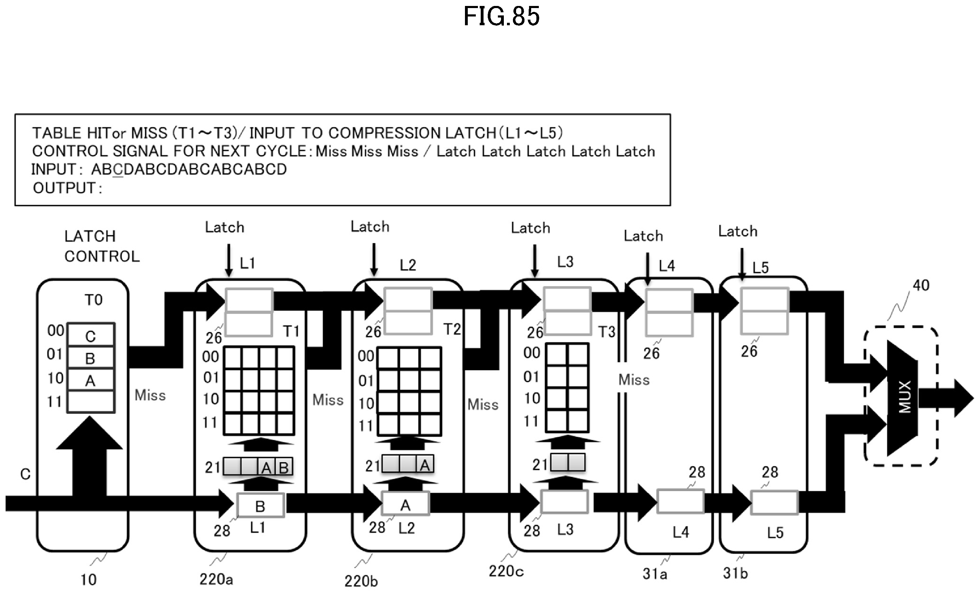

   Fig. 85 is a diagram explaining an operation example of the compression device according to the third embodiment.
[Fig. 86]

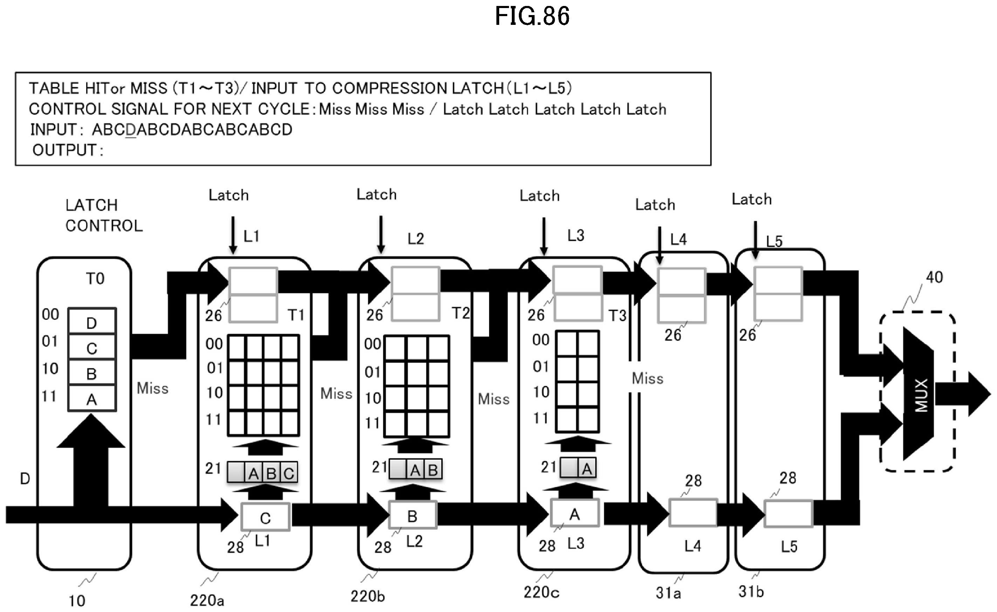

   Fig. 86 is a diagram explaining an operation example of the compression device according to the third embodiment.
[Fig. 87]

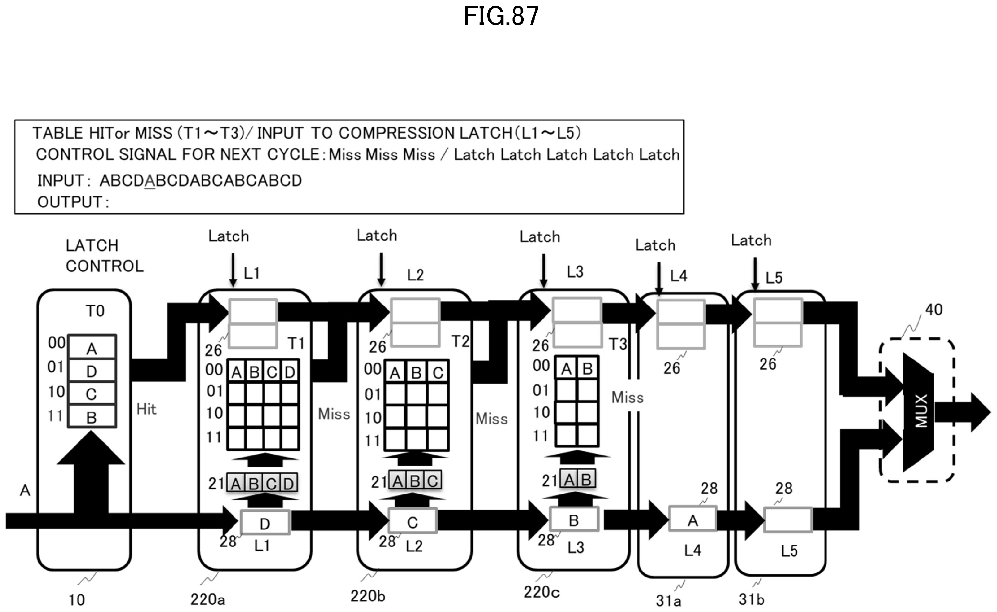

   Fig. 87 is a diagram explaining an operation example of the compression device according to the third embodiment.
[Fig. 88]

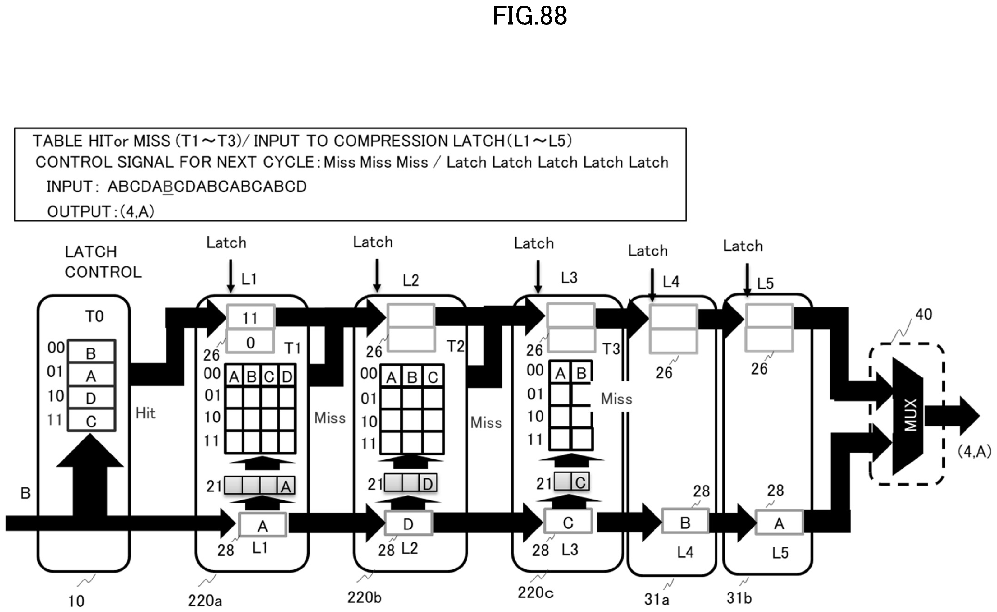

   Fig. 88 is a diagram explaining an operation example of the compression device according to the third embodiment.
[Fig. 89]

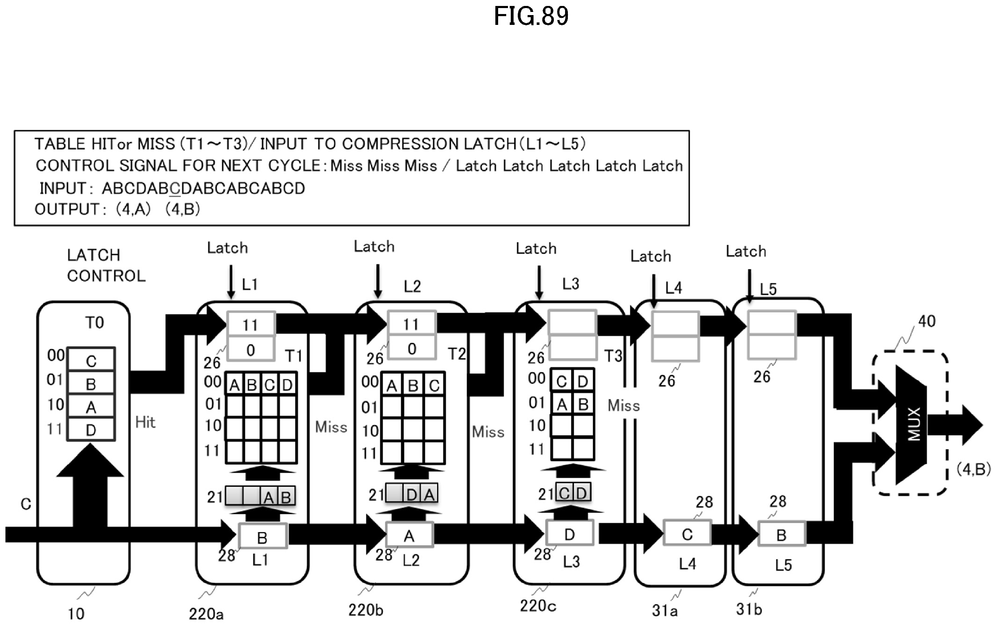

   Fig. 89 is a diagram explaining an operation example of the compression device according to the third embodiment.
[Fig. 90]

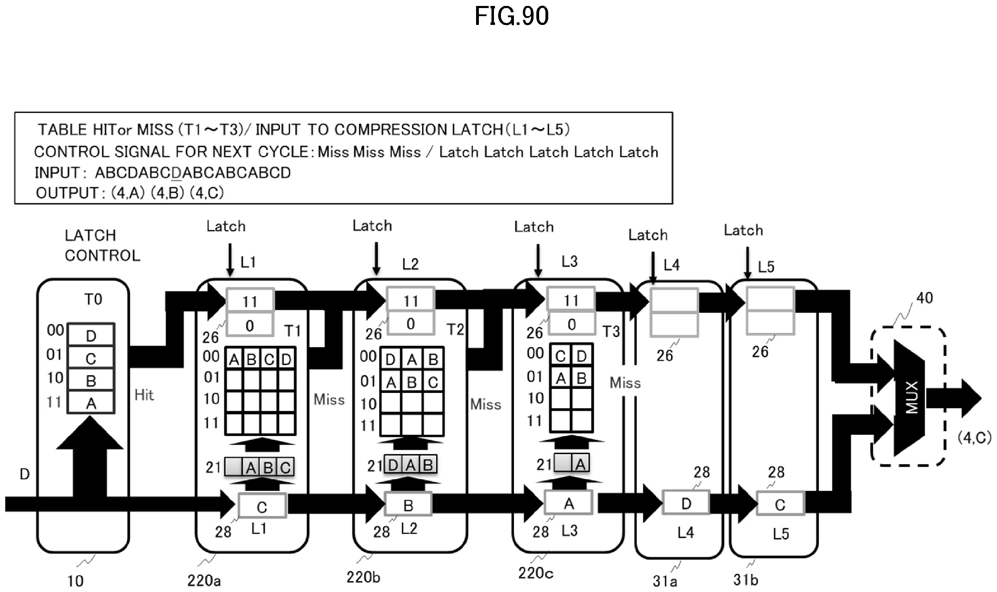

   Fig. 90 is a diagram explaining an operation example of the compression device according to the third embodiment.
[Fig. 91]

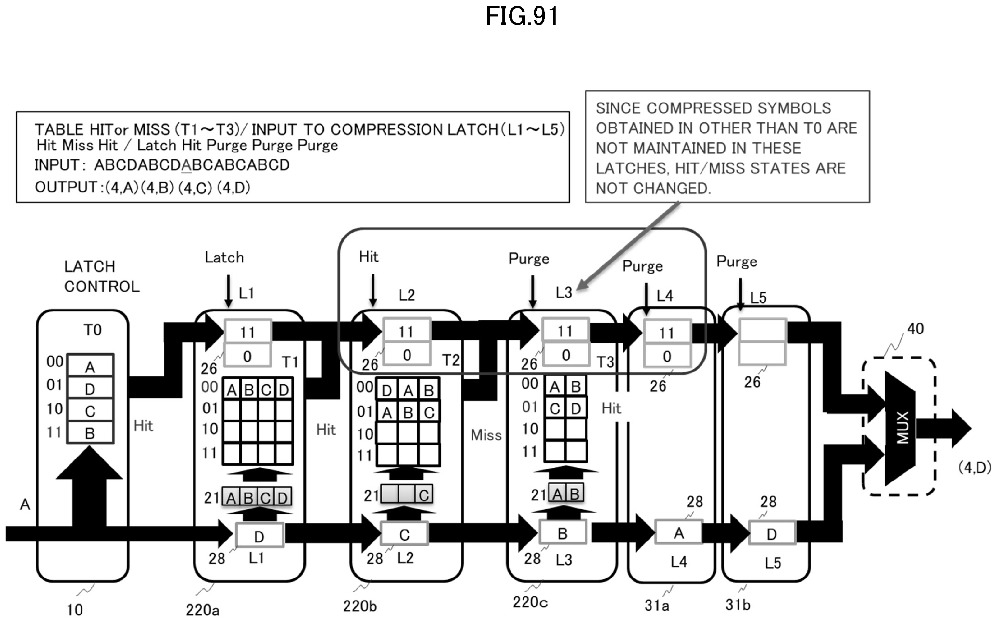

   Fig. 91 is a diagram explaining an operation example of the compression device according to the third embodiment.
[Fig. 92]

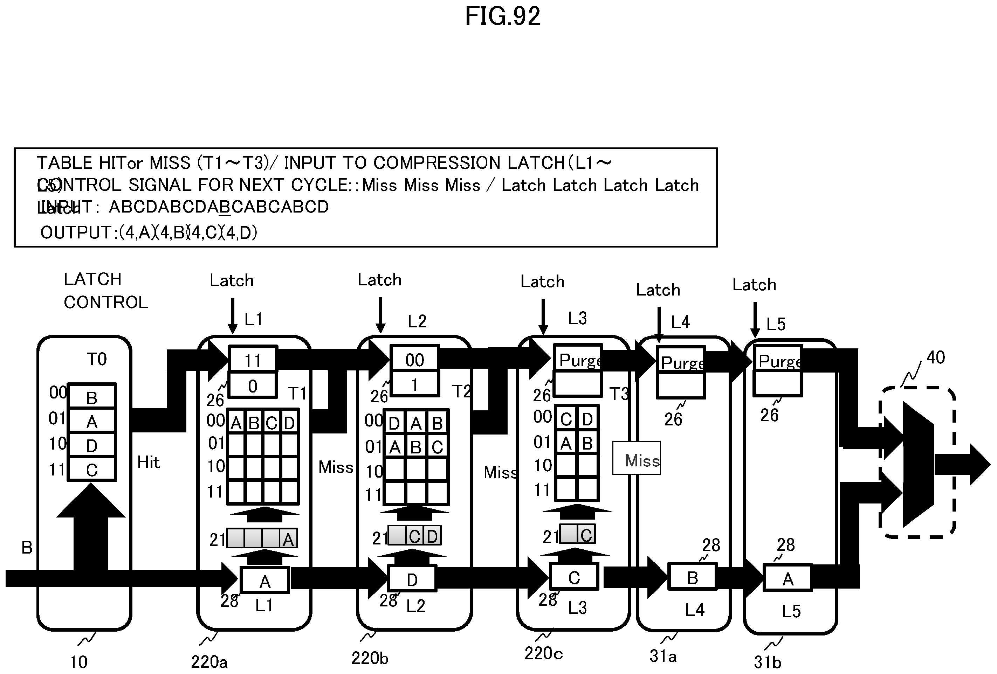

   Fig. 92 is a diagram explaining an operation example of the compression device according to the third embodiment.
[Fig. 93]

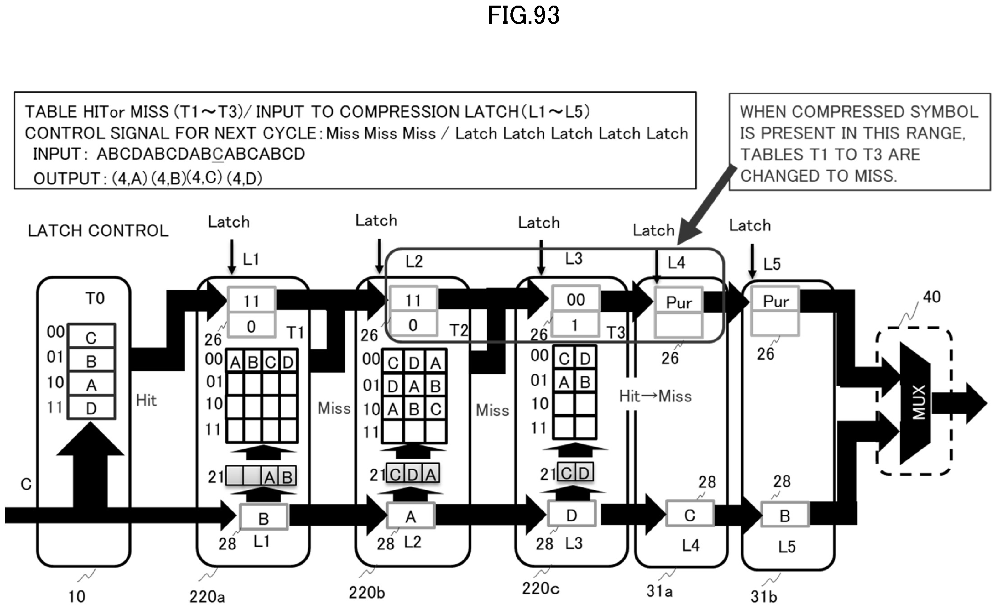

   Fig. 93 is a diagram explaining an operation example of the compression device according to the third embodiment.
[Fig. 94]

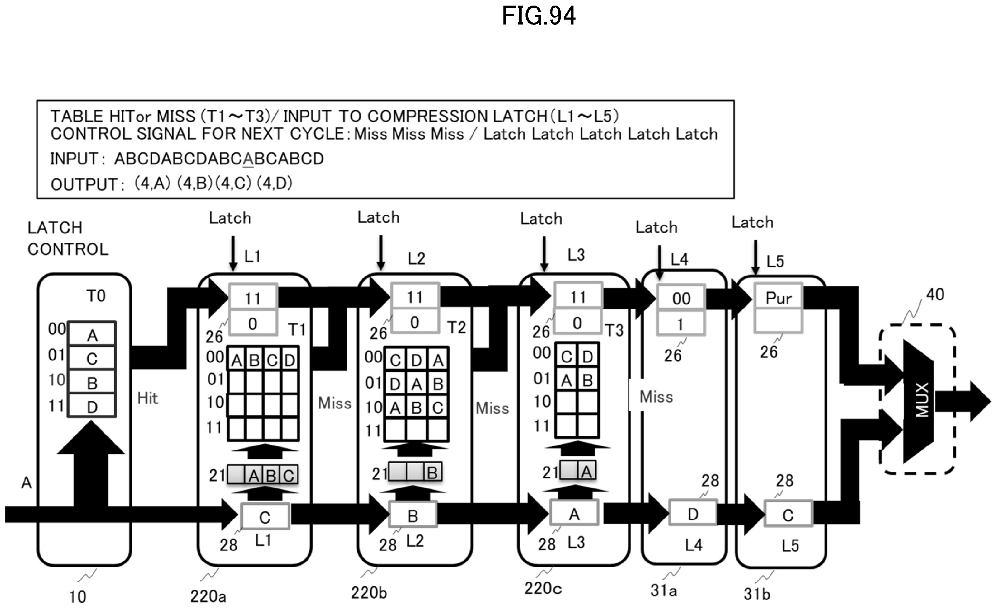

   Fig. 94 is a diagram explaining an operation example of the compression device according to the third embodiment.
[Fig. 95]

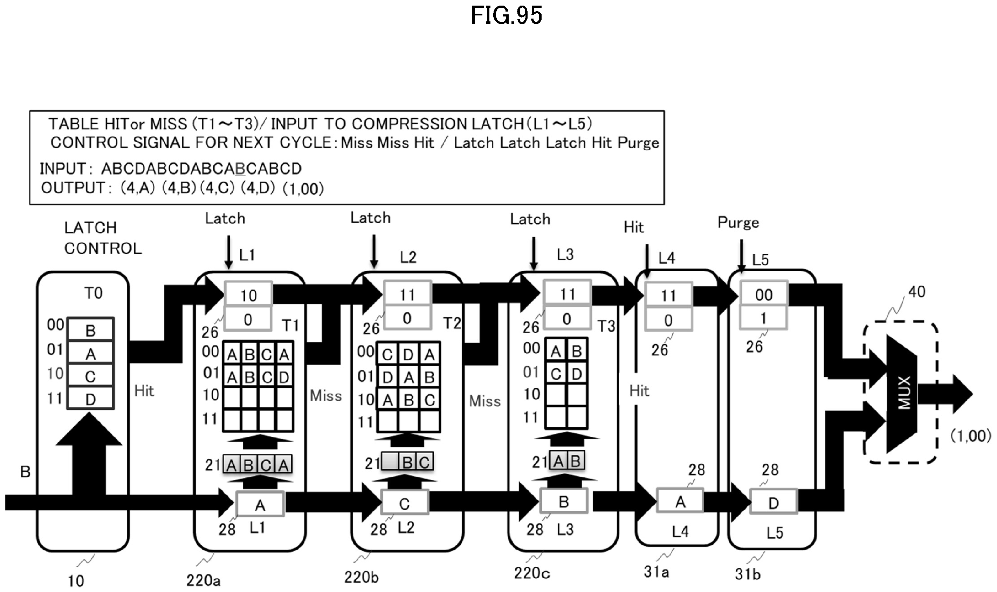

   Fig. 95 is a diagram explaining an operation example of the compression device according to the third embodiment.
[Fig. 96]

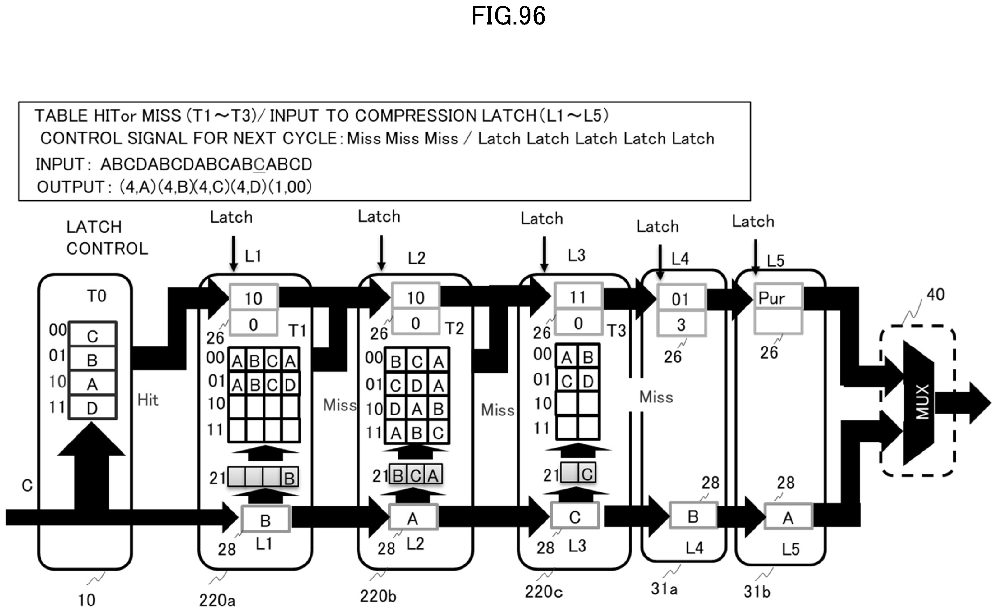

   Fig. 96 is a diagram explaining an operation example of the compression device according to the third embodiment.
[Fig. 97]

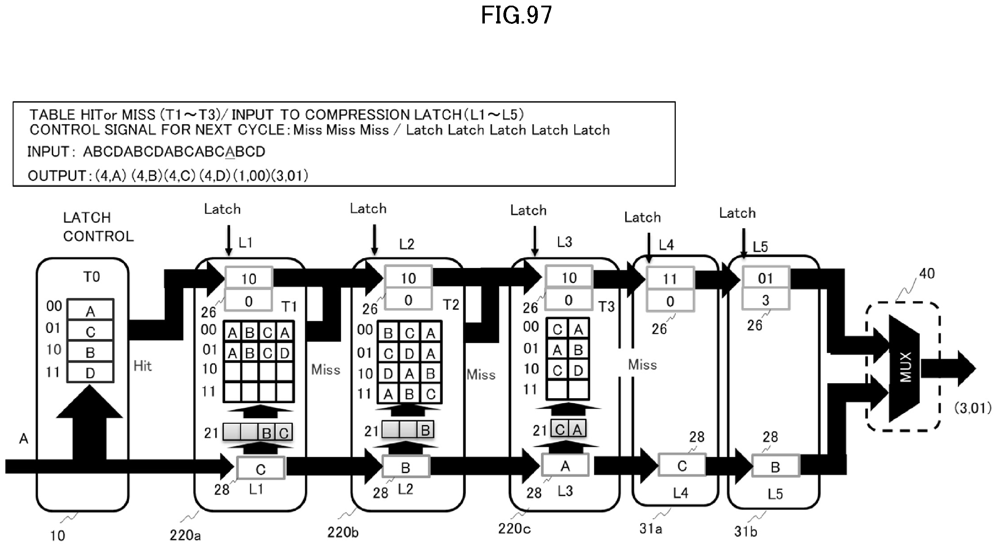

   Fig. 97 is a diagram explaining an operation example of the compression device according to the third embodiment.
[Fig. 98]

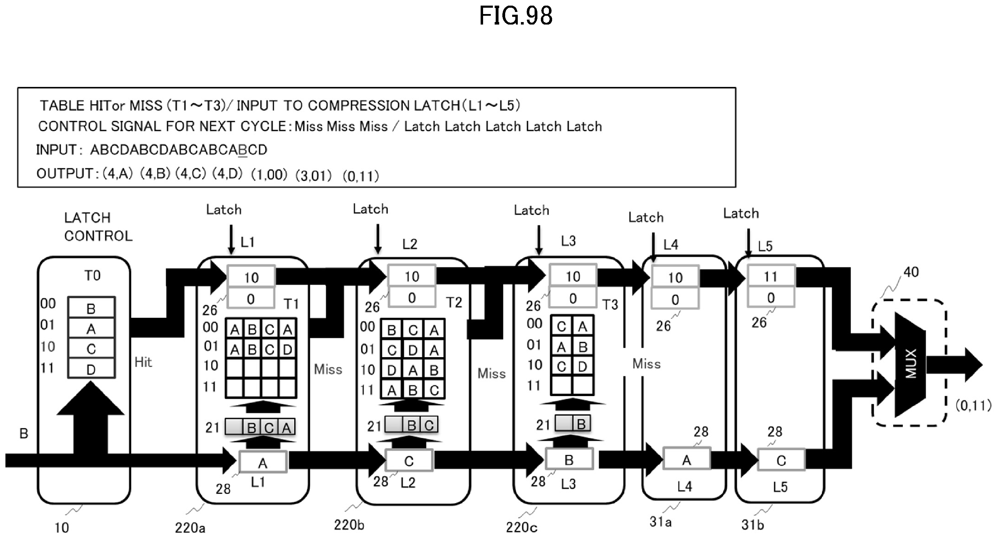

   Fig. 98 is a diagram explaining an operation example of the compression device according to the third embodiment.
[Fig. 99]

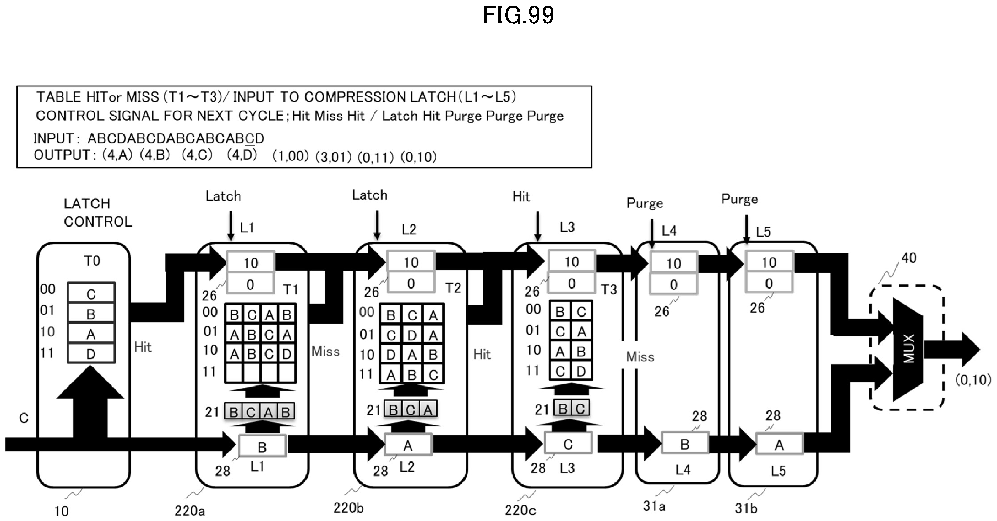

   Fig. 99 is a diagram explaining an operation example of the compression device according to the third embodiment.
[Fig. 100]

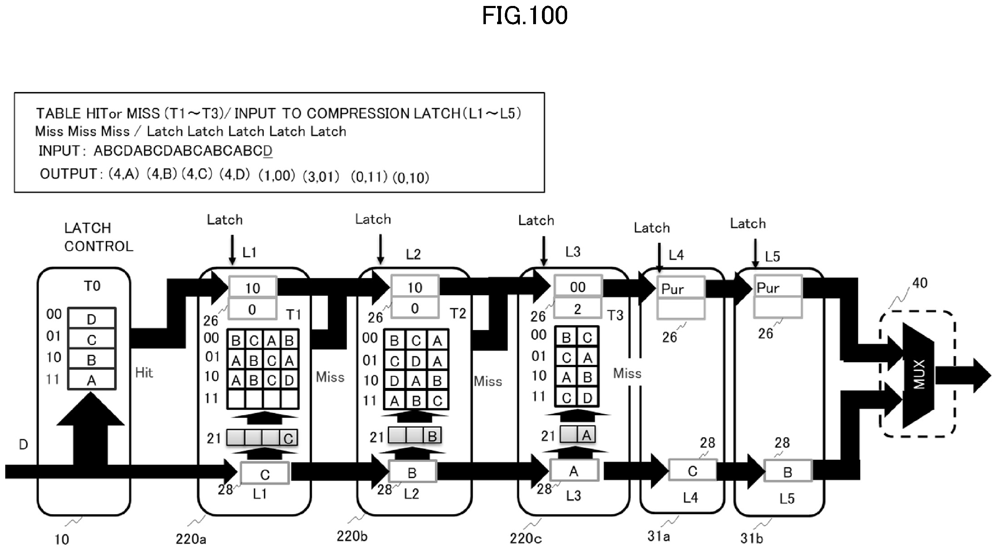

   Fig. 100 is a diagram explaining an operation example of the compression device according to the third embodiment.
[Fig. 101]

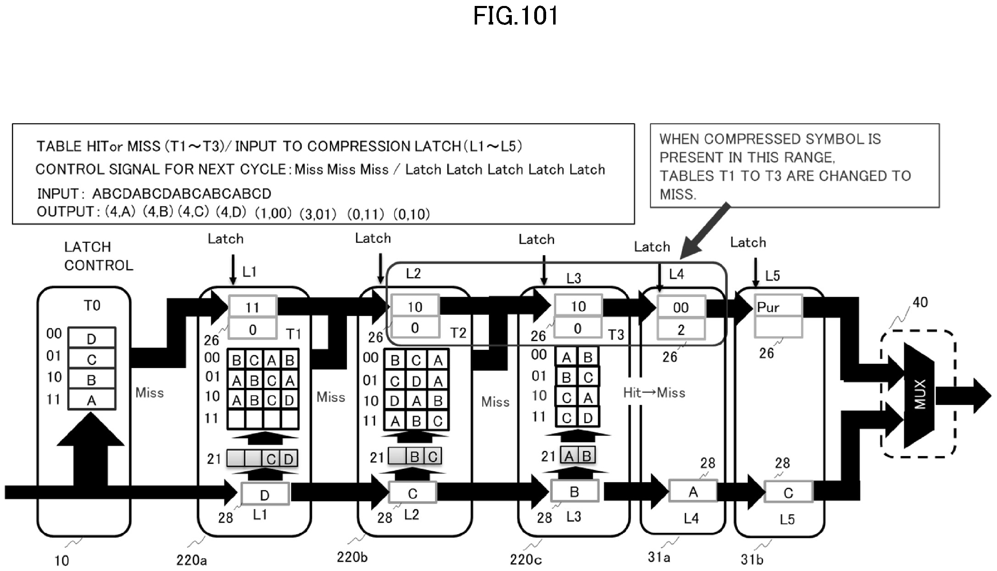

   Fig. 101 is a diagram explaining an operation example of the compression device according to the third embodiment.
[Fig. 102]

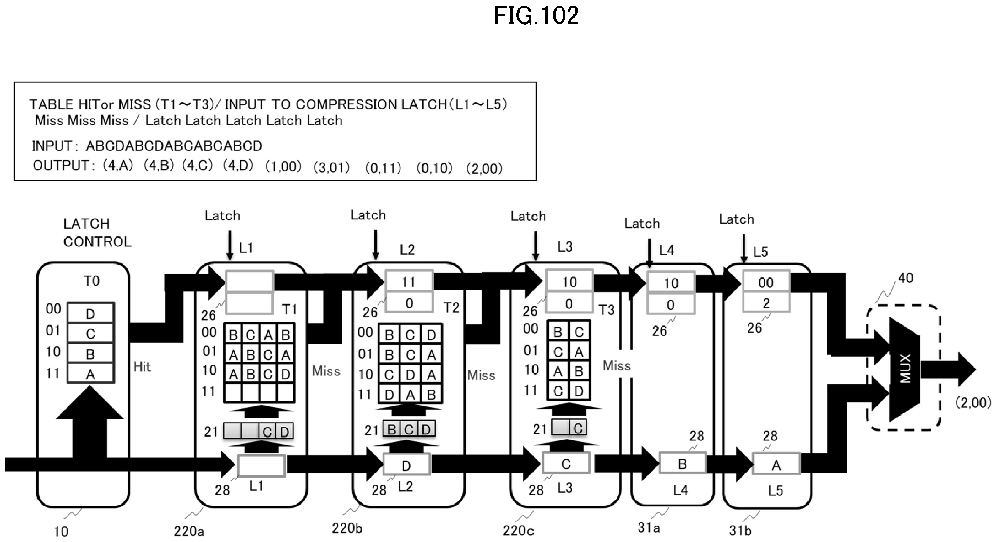

   Fig. 102 is a diagram explaining an operation example of the compression device according to the third embodiment.
[Fig. 103]

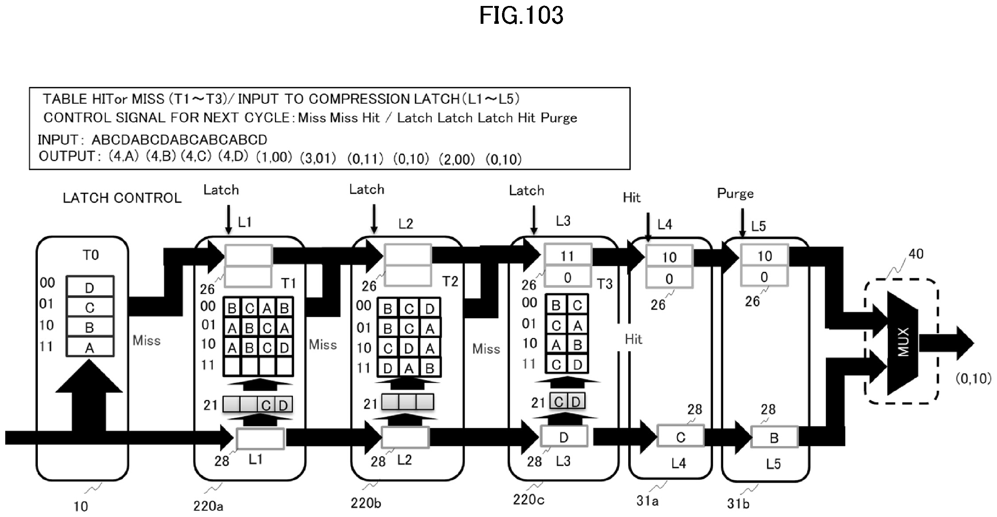

   Fig. 103 is a diagram explaining an operation example of the compression device according to the third embodiment.
[Fig. 104]

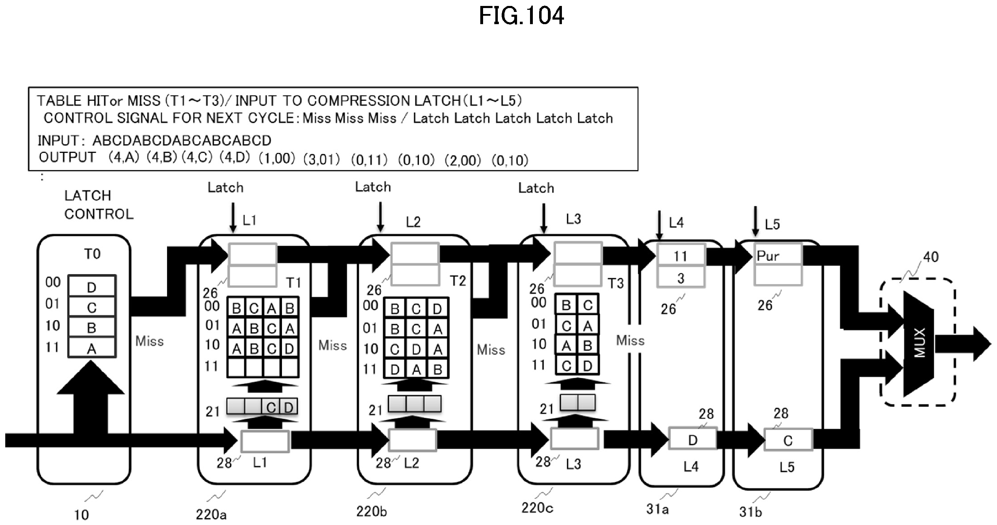

   Fig. 104 is a diagram explaining an operation example of the compression device according to the third embodiment.
[Fig. 105]

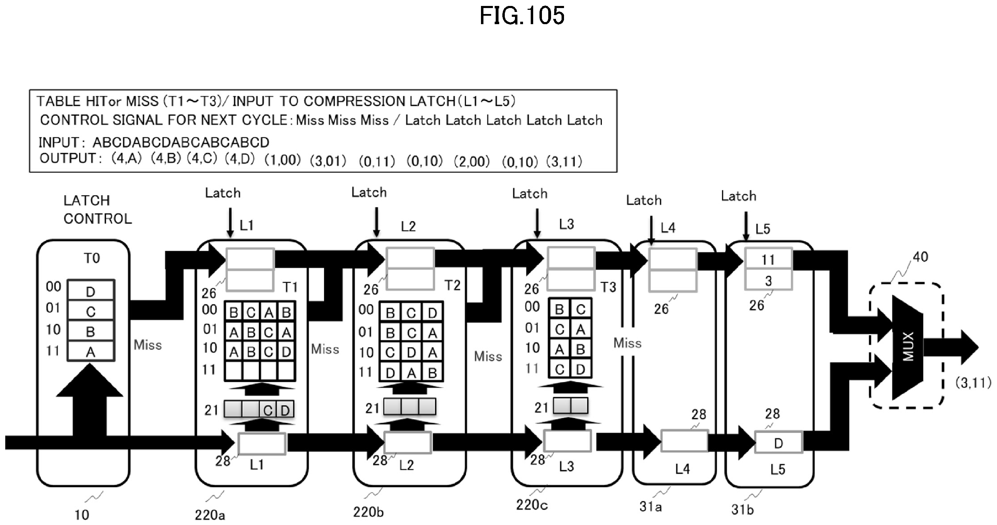

   Fig. 105 is a diagram explaining an operation example of the compression device according to the third embodiment.
[Fig. 106]

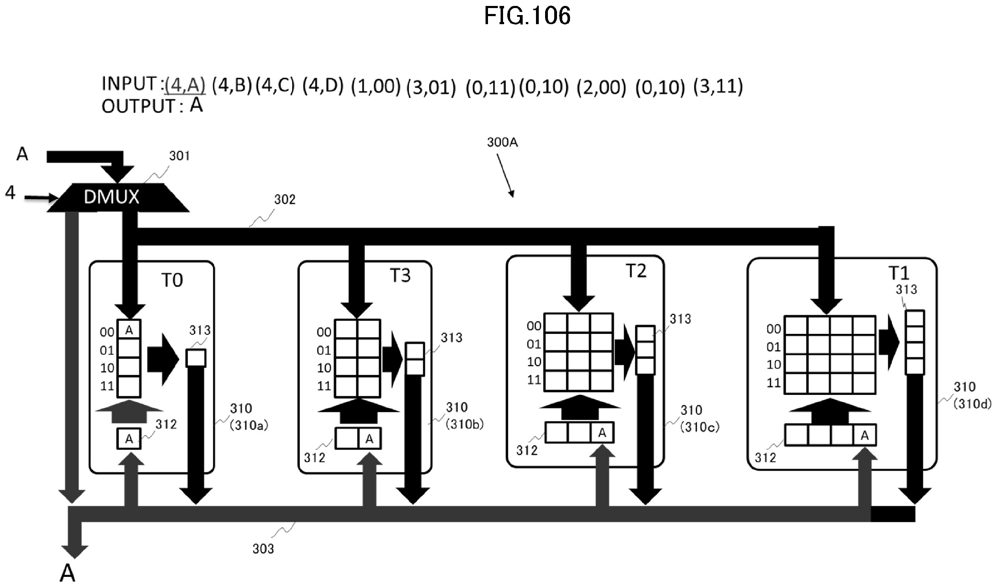

   Fig. 106 is a diagram explaining a configuration example and an operation example of a decompression device according to the third embodiment.
[Fig. 107]

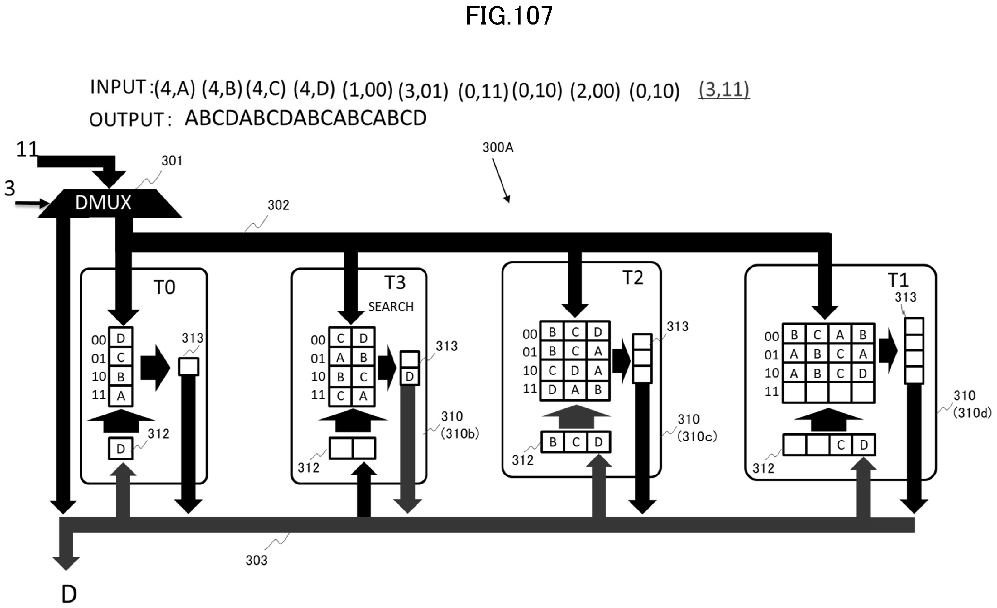

   Fig. 107 is a diagram explaining a configuration example and an operation example of a decompression device according to the third embodiment.
[Fig. 108]

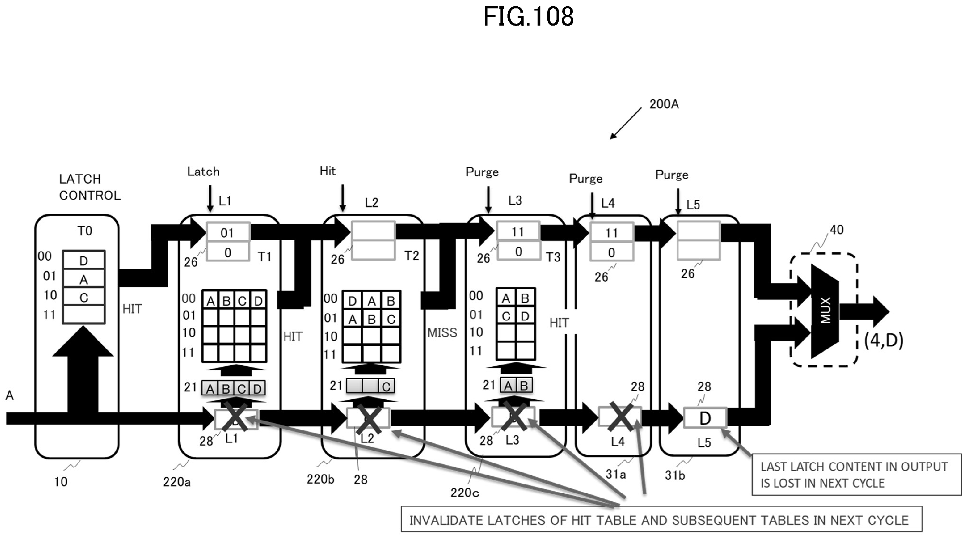

   Fig. 108 is a diagram illustrating a configuration example of a compression device according to a fourth embodiment.
[Fig. 109]

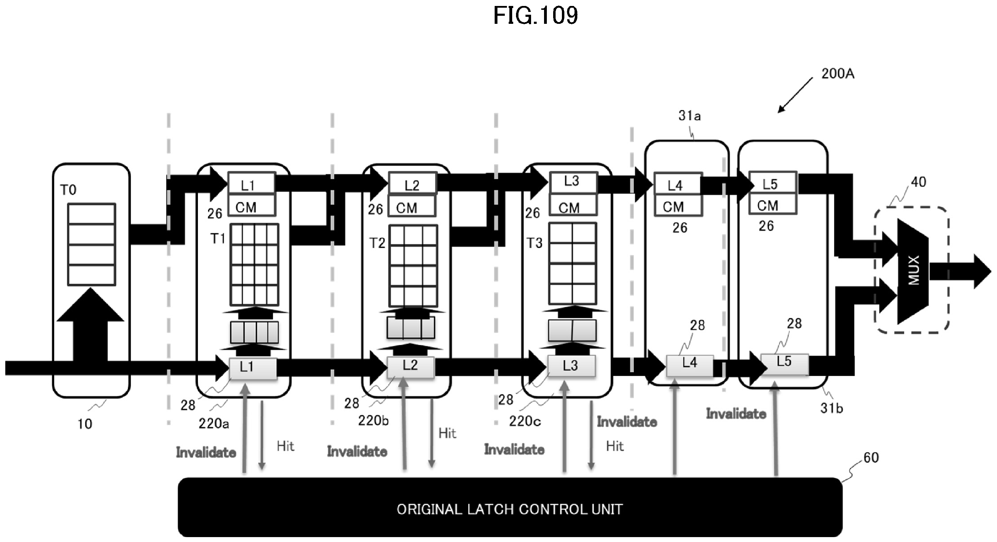

   Fig. 109 is a diagram illustrating a configuration example of a compression device according to the fourth embodiment.
[Fig. 110]

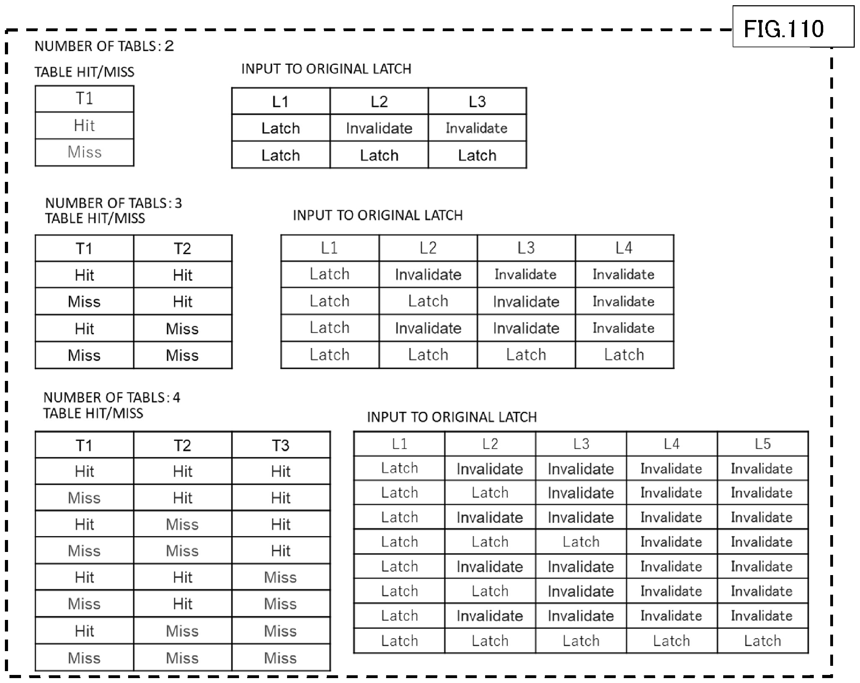

   Fig. 110 is a table illustrating a correspondence relation between table hit/miss patterns and inputs to original latches.
[Fig. 111A]

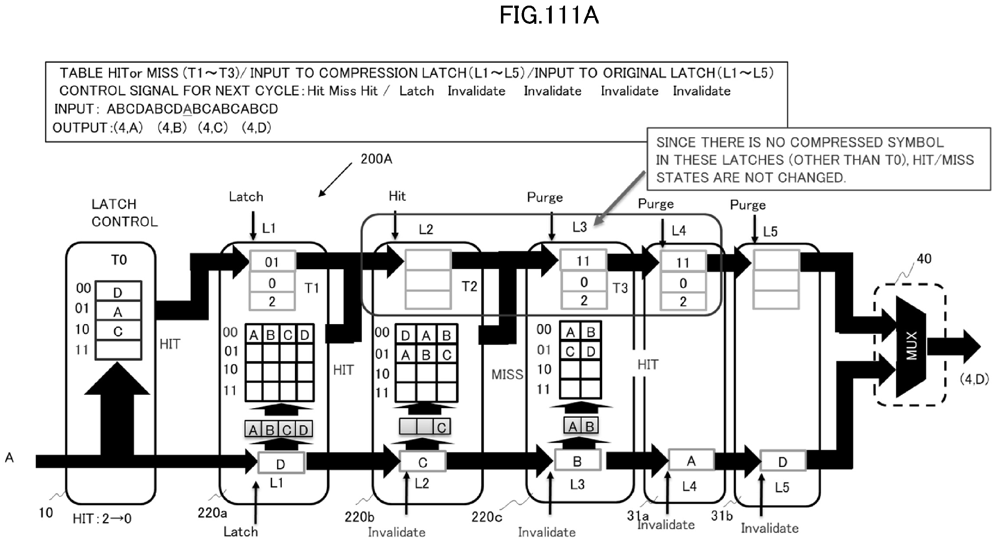

   Fig. 111A is a diagram illustrating an operation example of the compression device according to the fourth embodiment.
[Fig. 111B]

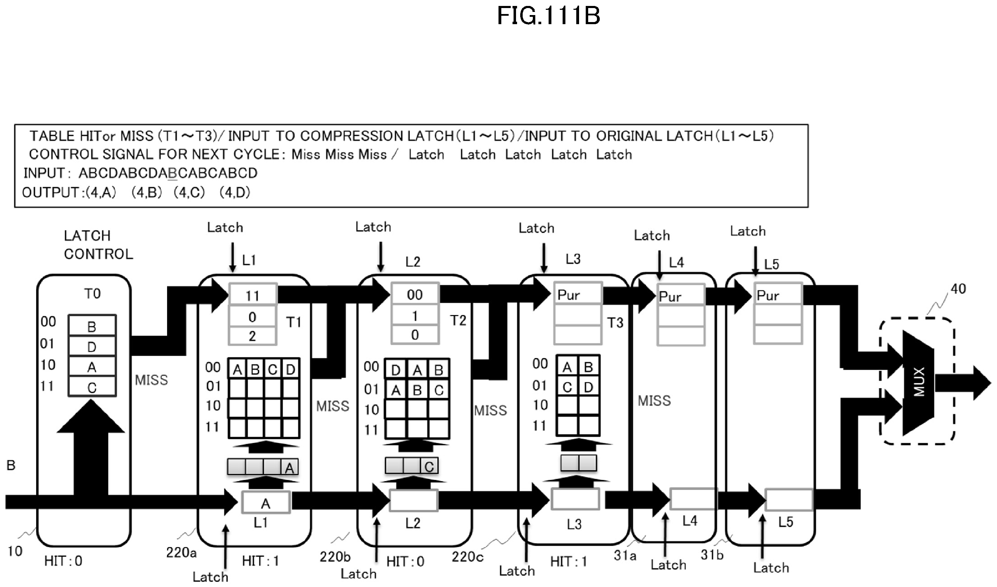

   Fig. 111B is a diagram illustrating an operation example of the compression device according to the fourth embodiment.
[Fig. 112]

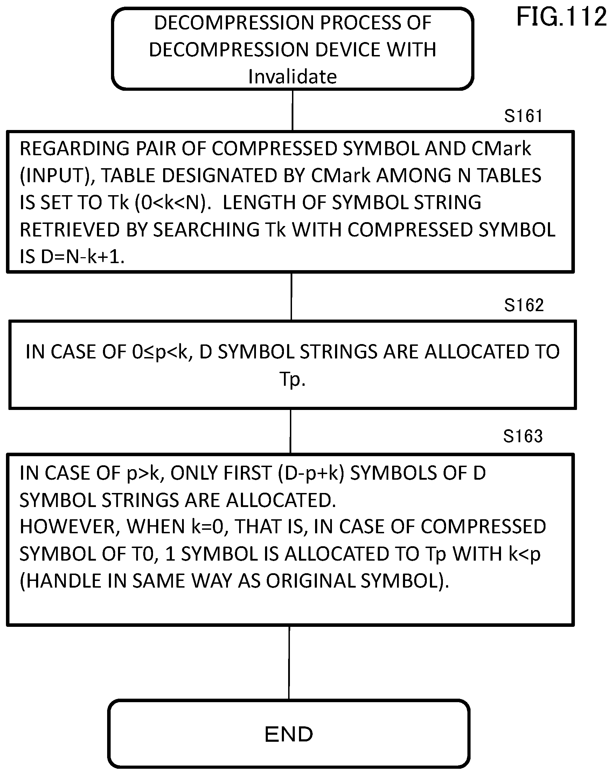

   Fig. 112 is a flowchart illustrating a process example of a decompression device according to the fourth embodiment.
[Fig. 113]

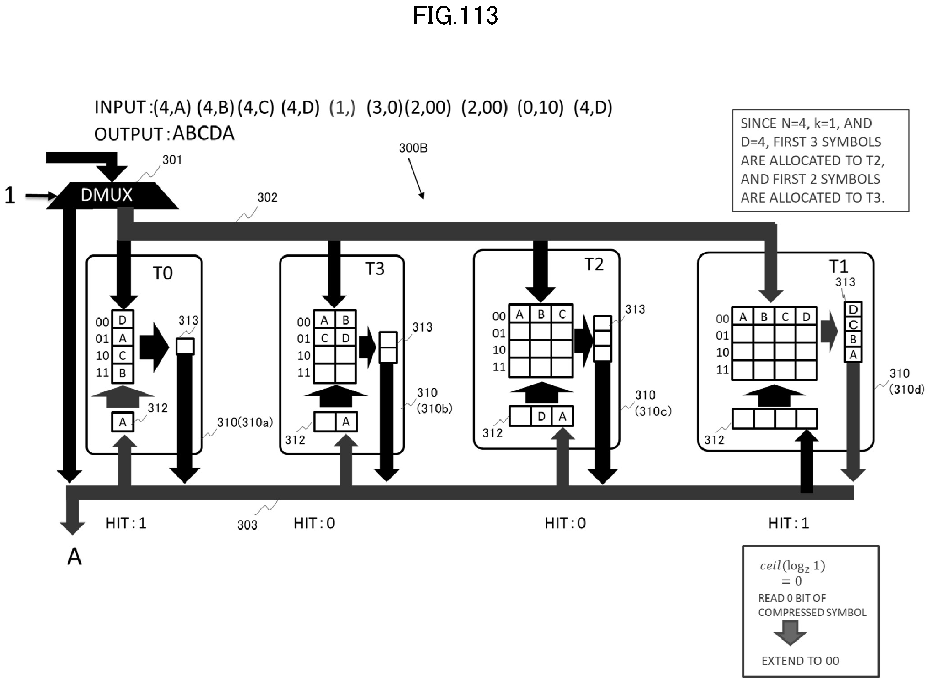

   Fig. 113 is a diagram illustrating a configuration example and an operation example of the decompression device according to the fourth embodiment.
[Fig. 114]

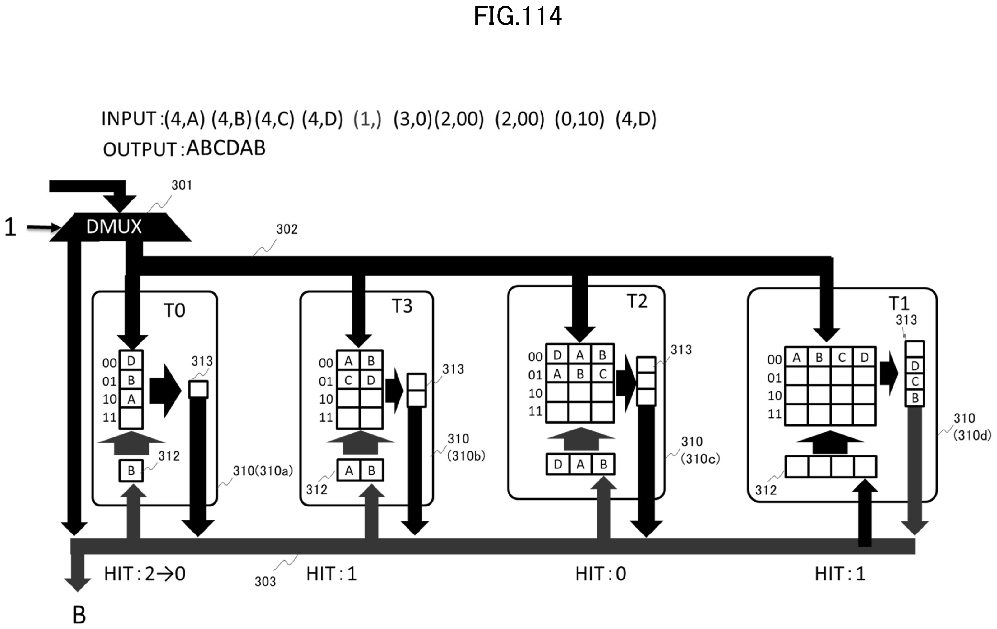

   Fig. 114 is a diagram illustrating an operation example of the decompression device according to the fourth embodiment.
[Fig. 115]

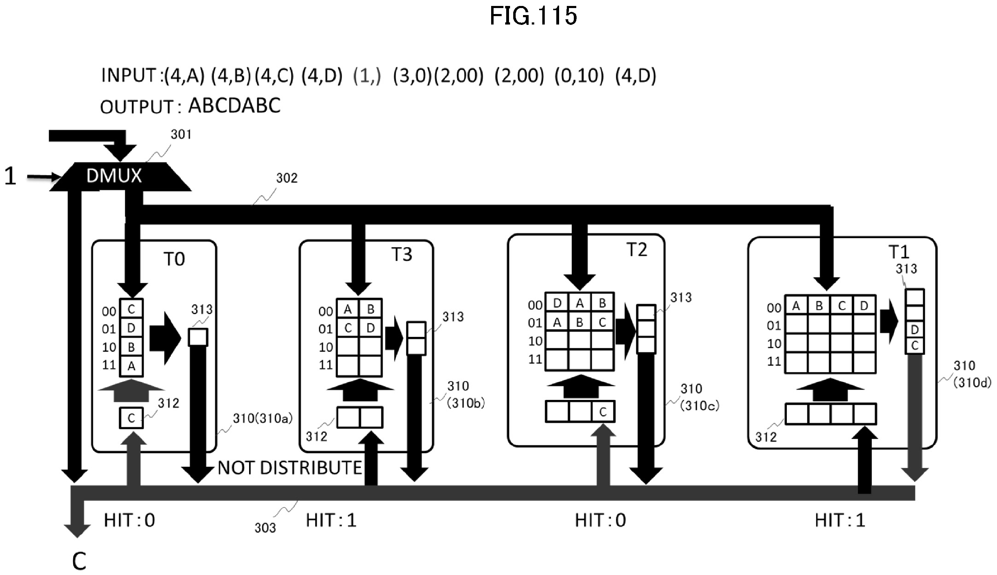

   Fig. 115 is a diagram illustrating an operation example of the decompression device according to the fourth embodiment.
[Fig. 116]

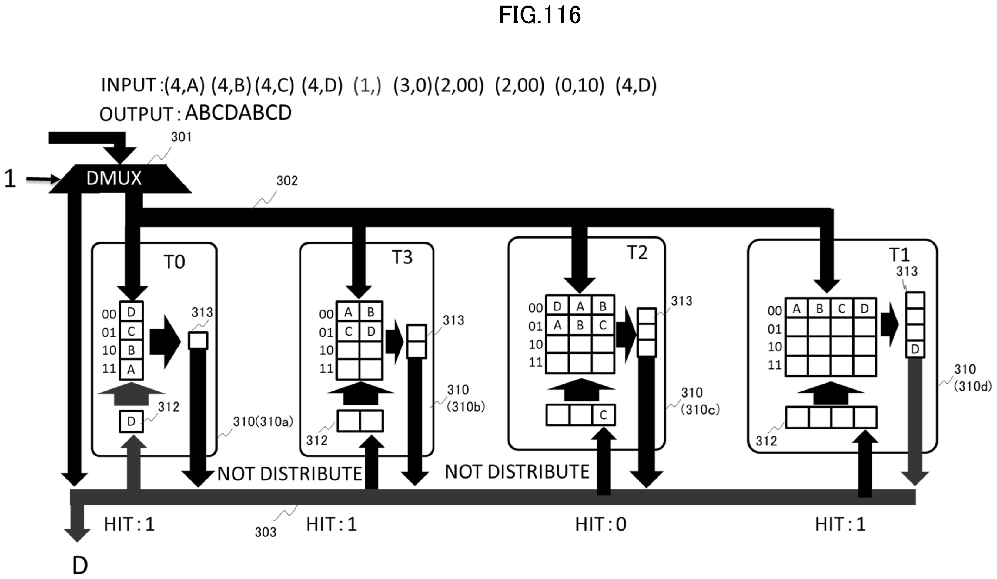

   Fig. 116 is a diagram illustrating an operation example of the decompression device according to the fourth embodiment.
[Fig. 117]

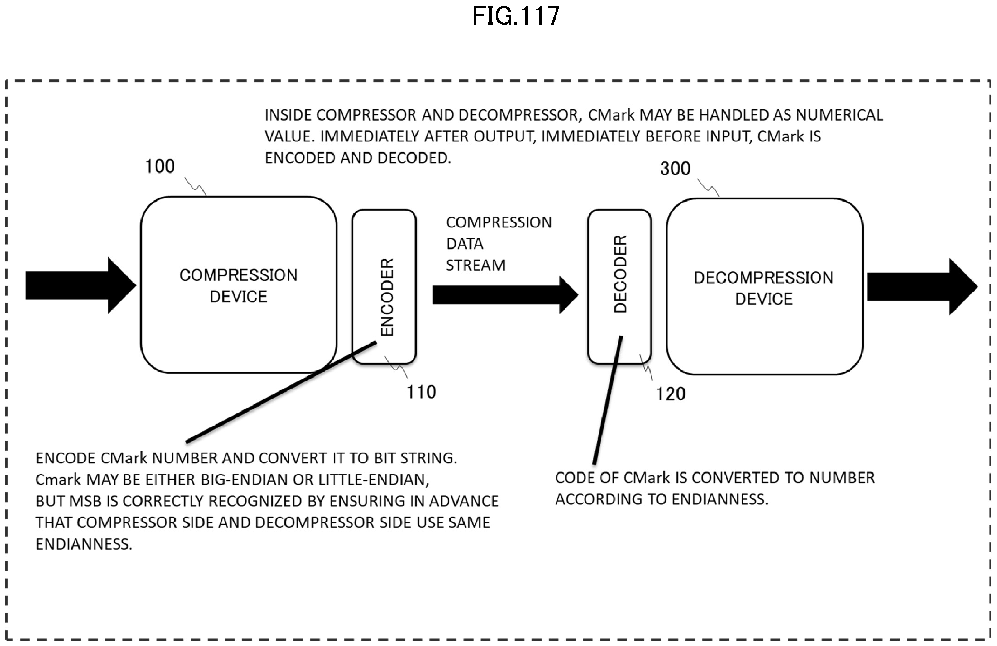

   Fig. 117 illustrates a configuration example of a compression and decompression system according to a fifth embodiment.
[Fig. 118]

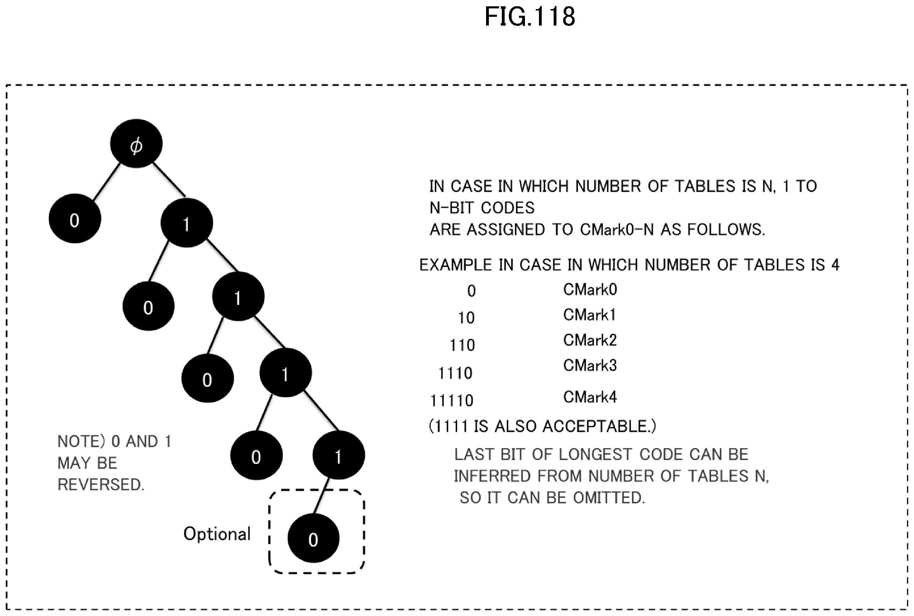

   Fig. 118 is an explanatory diagram of a method for reducing the number of bits of CMark.
[Fig. 119]

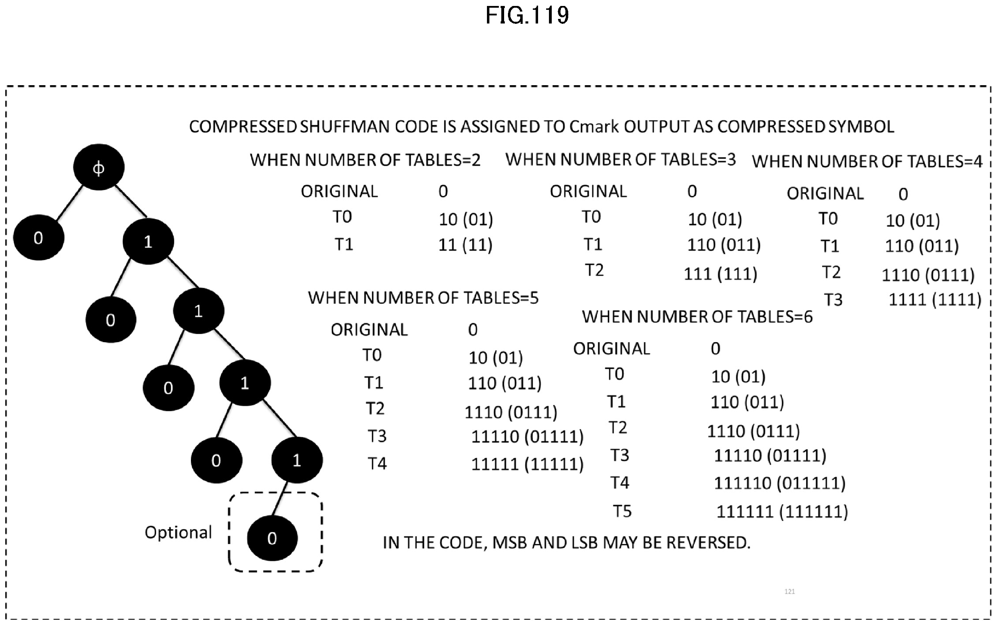

   Fig. 119 is an explanatory diagram of a method (sequential allocation) for statically allocating codes to CMark.
[Fig. 120]

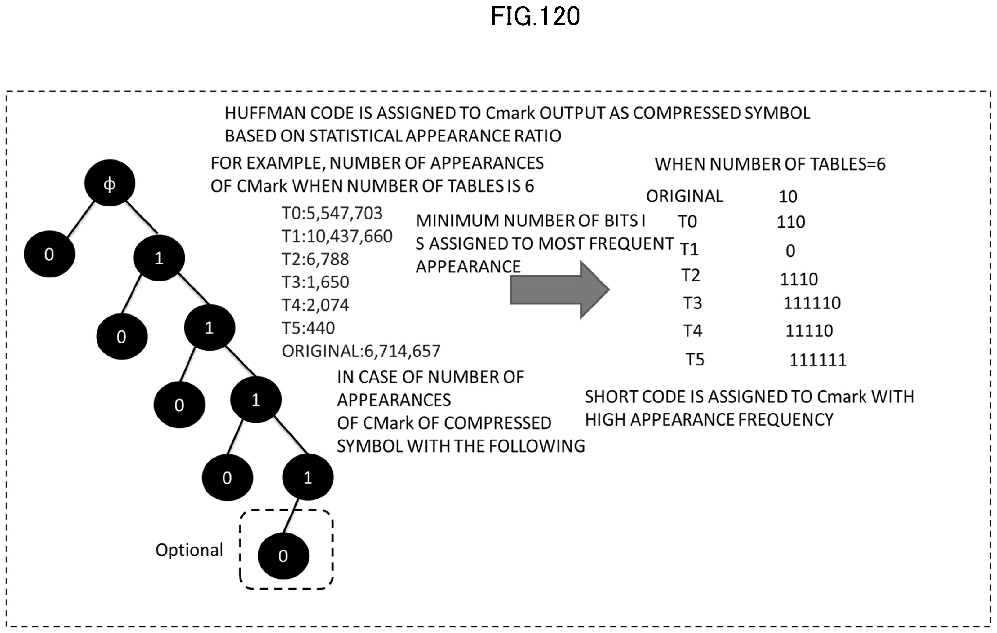

   Fig. 120 is an explanatory diagram of a method (on the basis of statistics) for statically allocating codes to CMark.
[Fig. 121]

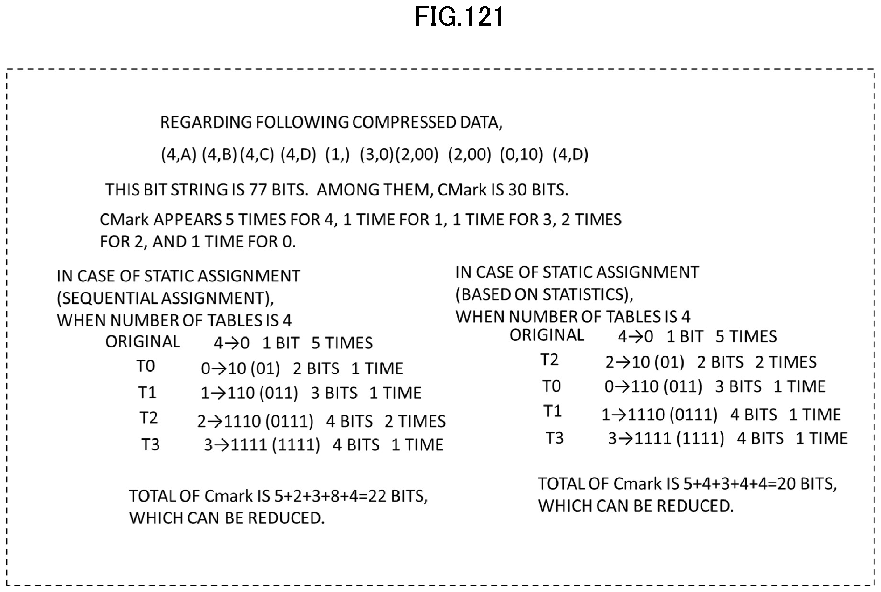

   Fig. 121 is a diagram illustrating an example of static CMark code allocation.
[Fig. 122]

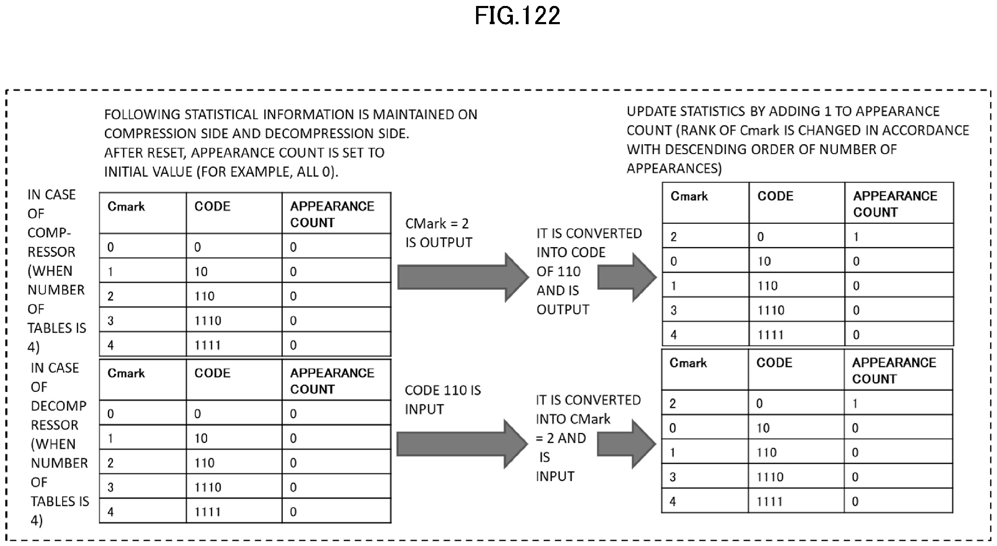

   Fig. 122 is a diagram illustrating a method (first method) for dynamically allocating codes to CMark.
[Fig. 123]

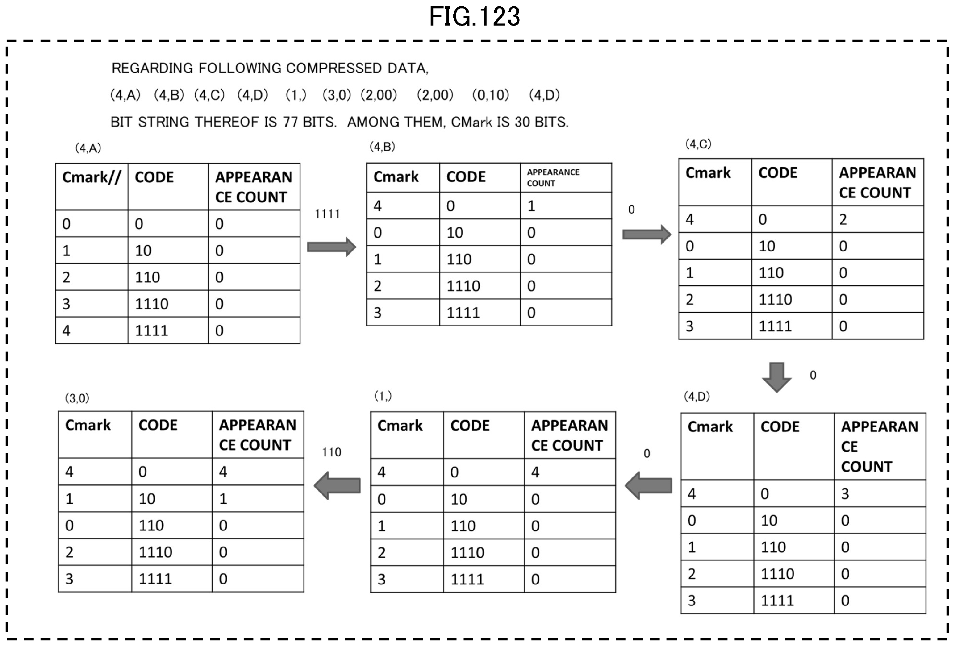

   Fig. 123 is a diagram illustrating an example of the first method.
[Fig. 124]

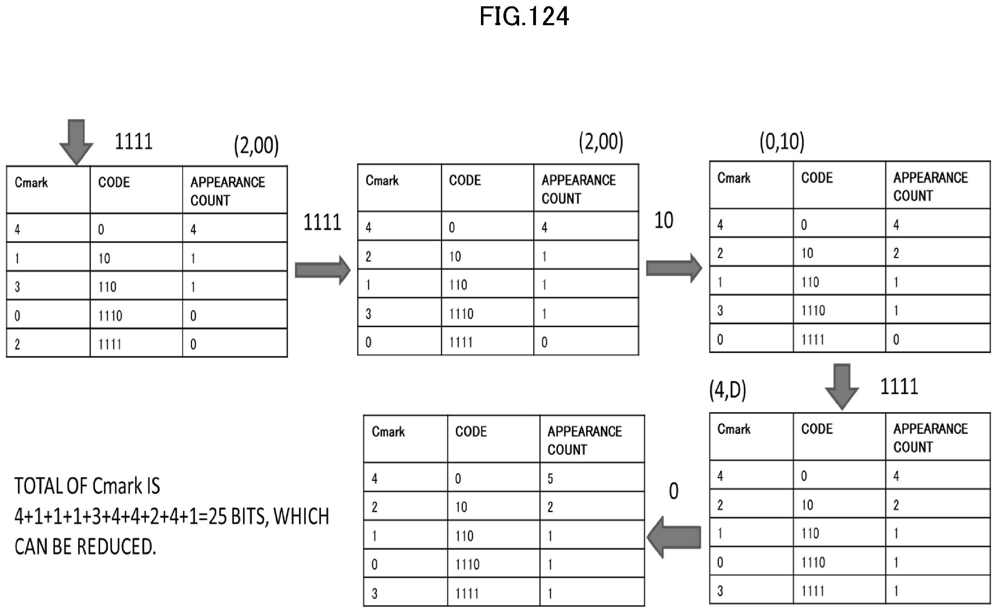

   Fig. 124 is a diagram illustrating an example of the first method.
[Fig. 125]

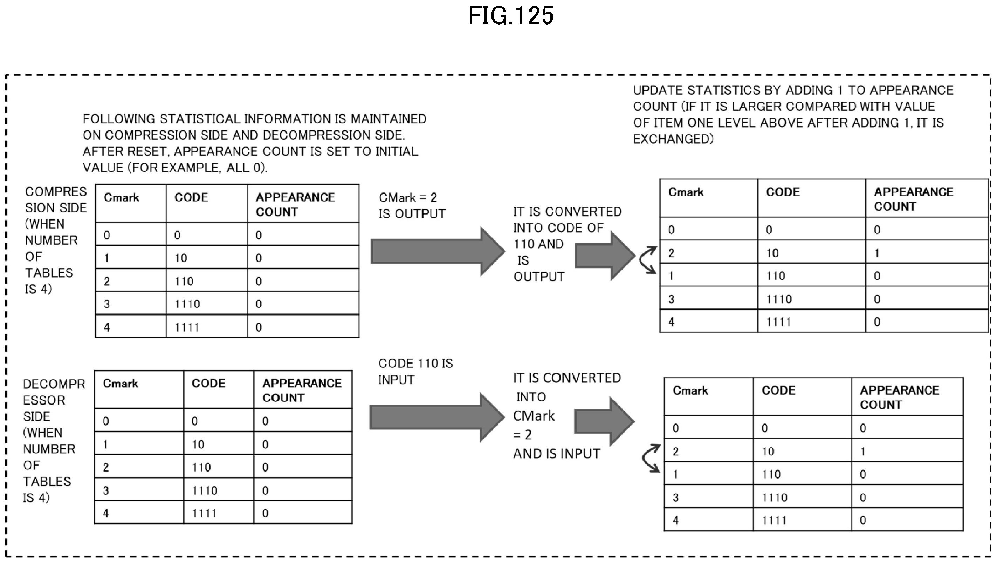

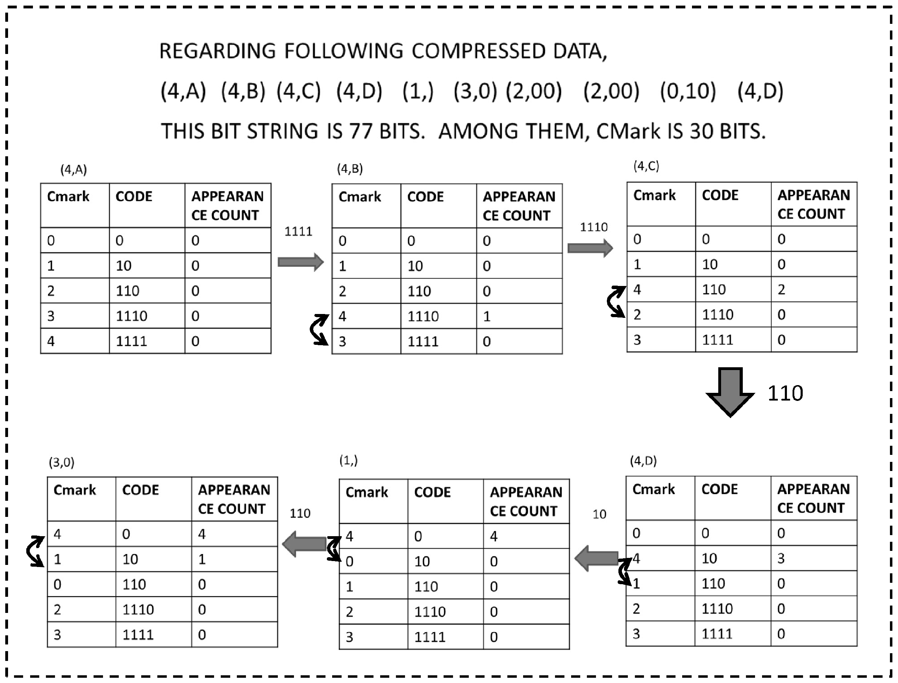

   Fig. 125 is a diagram illustrating a method (second method) for dynamically allocating codes to CMark.
[Fig. 126]
   Fig. 126 is a diagram illustrating an example of the second method.
[Fig. 127]

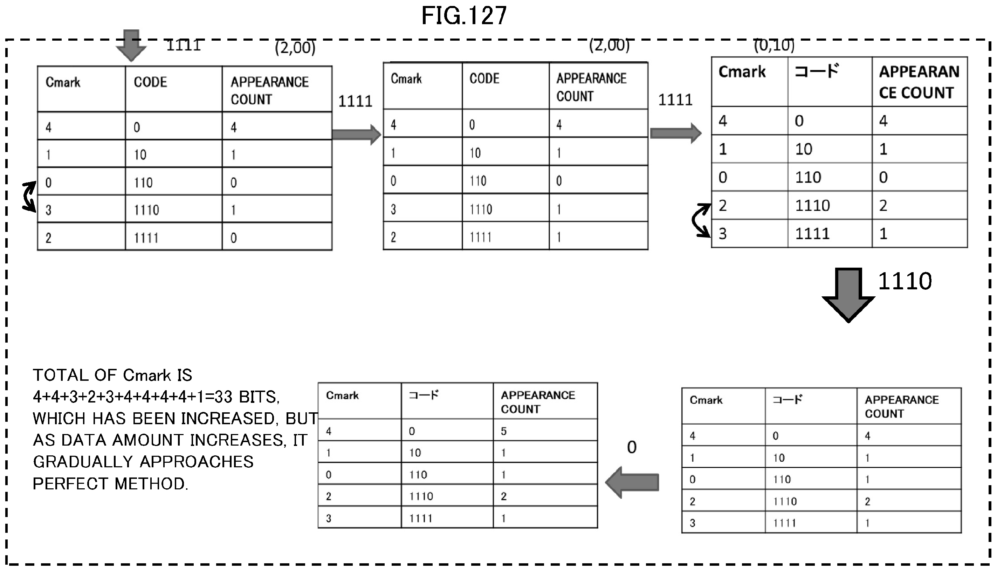

   Fig. 127 is a diagram illustrating an example of the second method.
[Fig. 128]

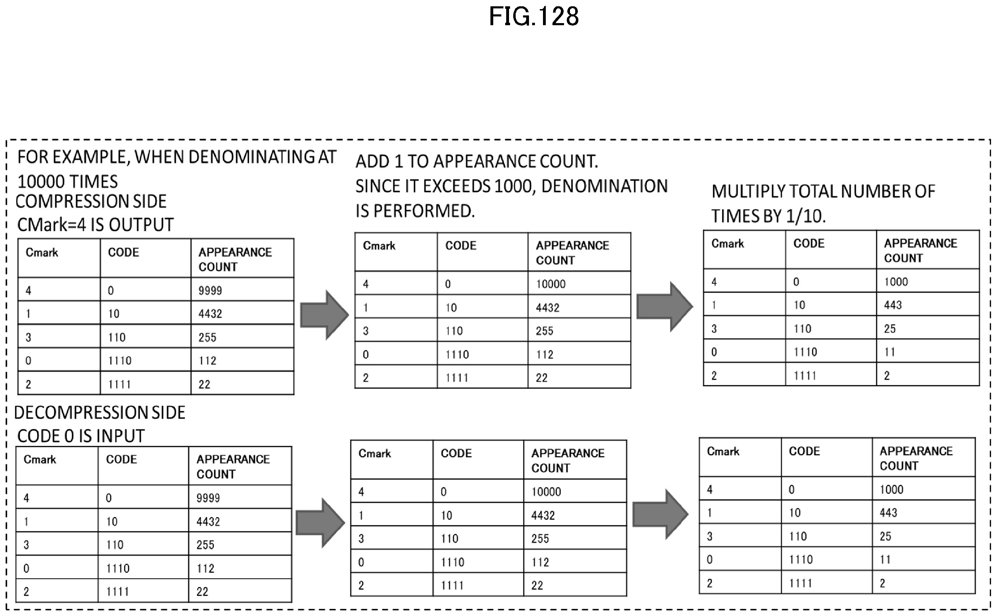

   Fig. 128 is an explanatory diagram of denomination of an appearance count number.
[Fig. 129]

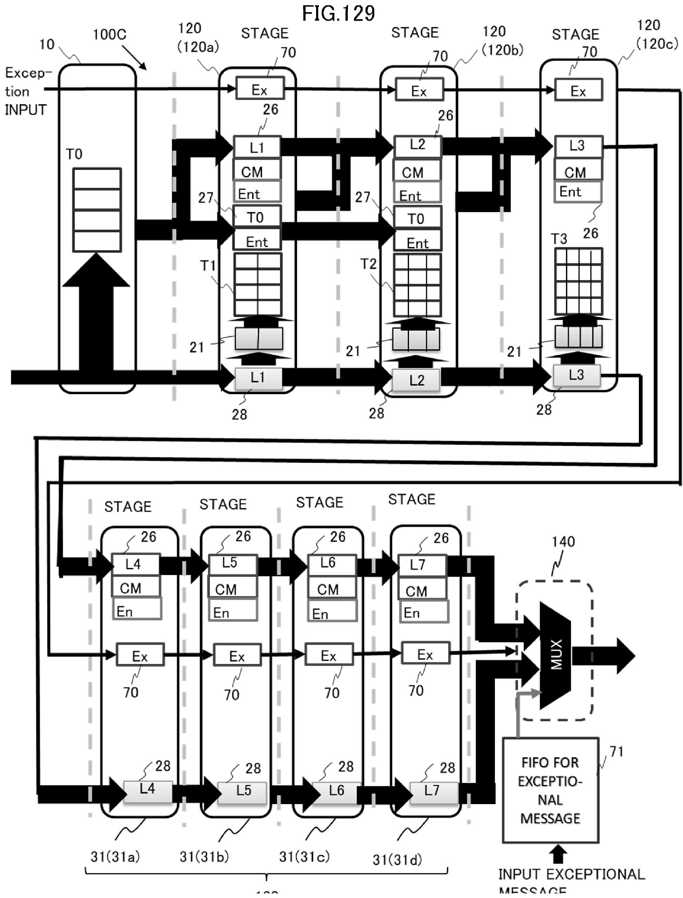

   Fig. 129 is an explanatory diagram of a sixth embodiment.
[Fig. 130]

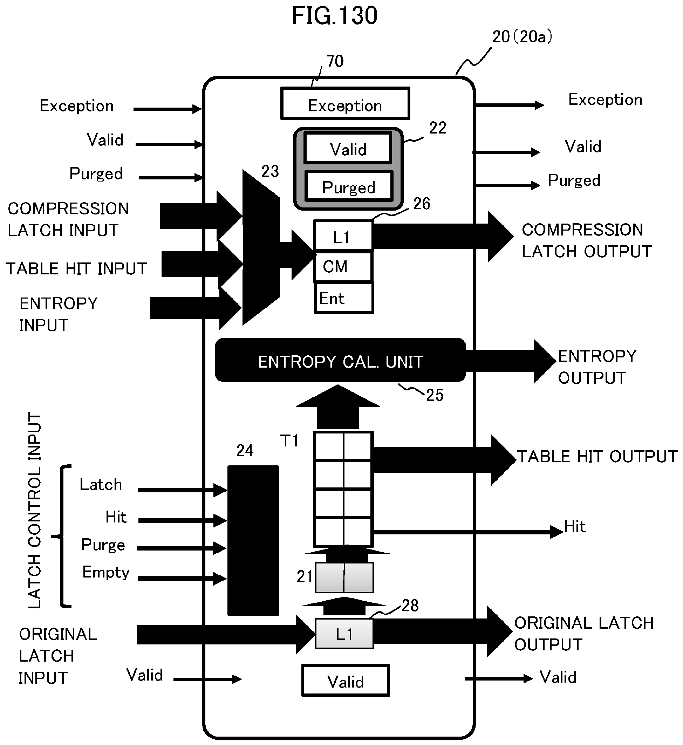

   Fig. 130 is an explanatory diagram of the sixth embodiment.
[Fig. 131]

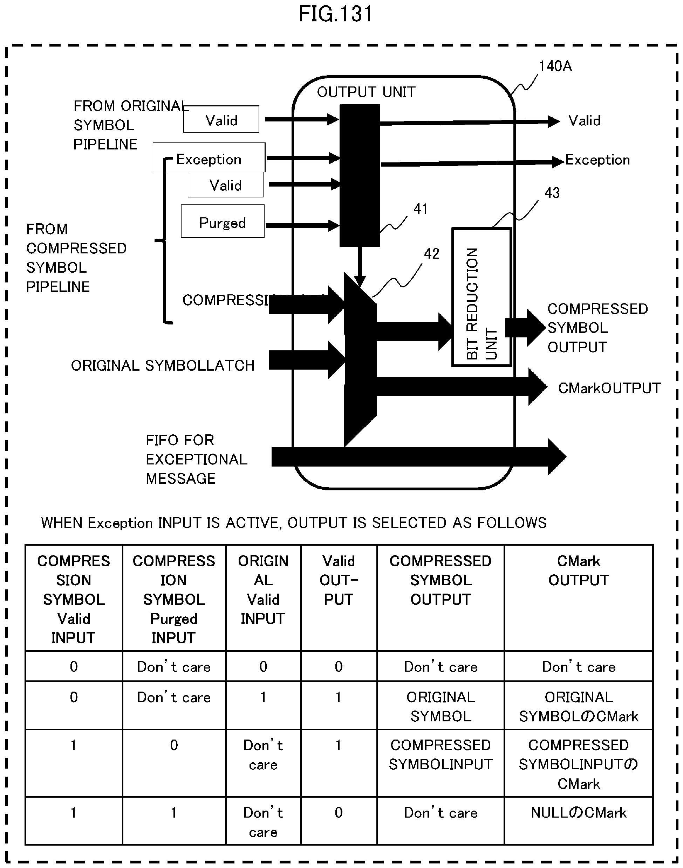

   Fig. 131 is an explanatory diagram of the sixth embodiment.
[Fig. 132]

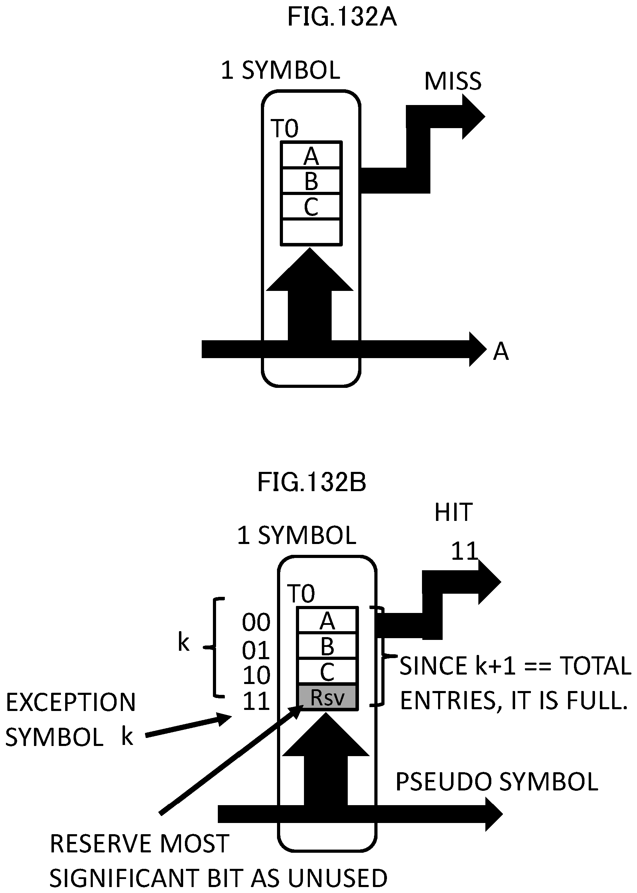

   Figs. 132A and 132B are explanatory diagrams of the sixth embodiment.
[Fig. 133]

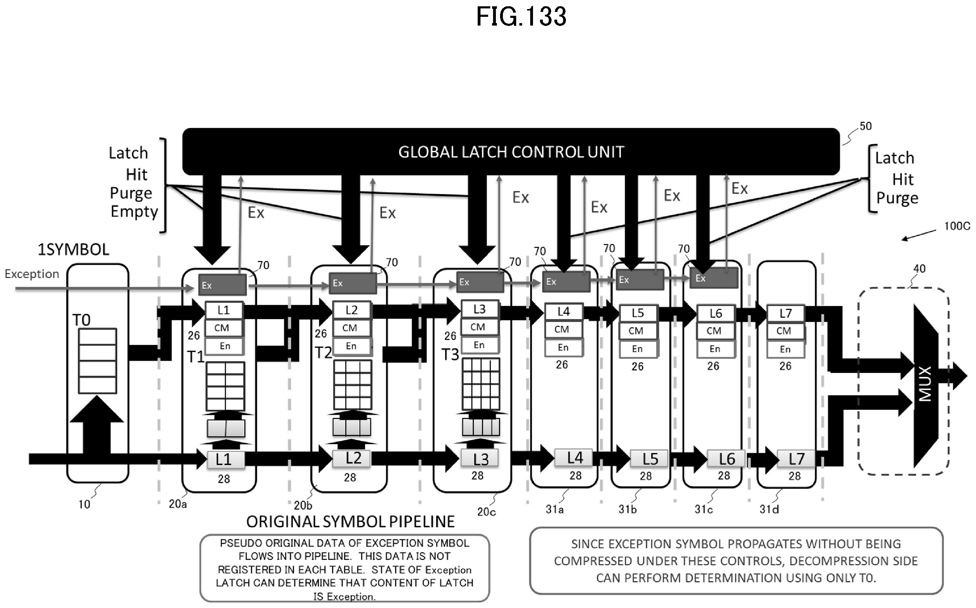

   Fig. 133 is an explanatory diagram of the sixth embodiment.
[Fig. 134]

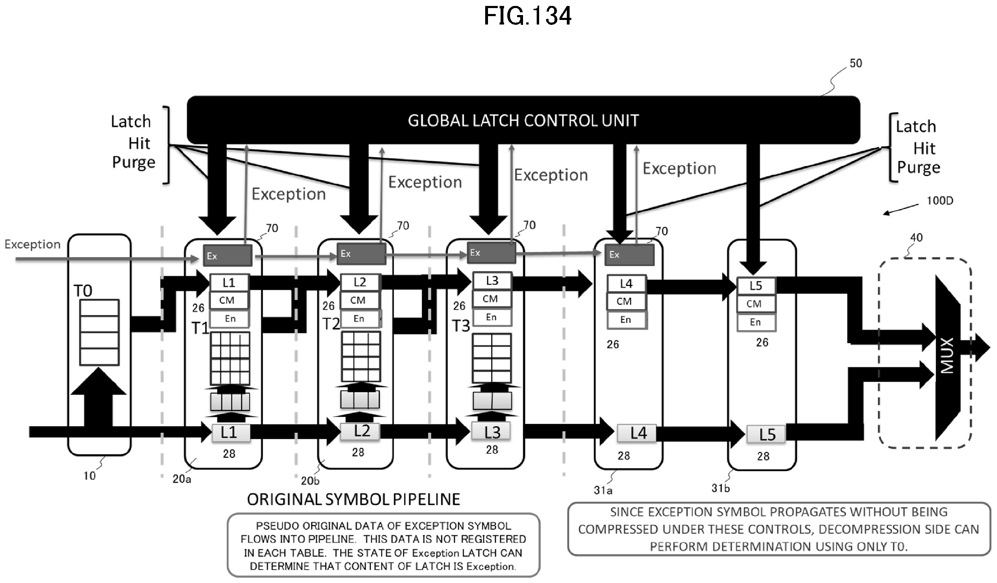

   Fig. 134 is an explanatory diagram of the sixth embodiment.
[Fig. 135]

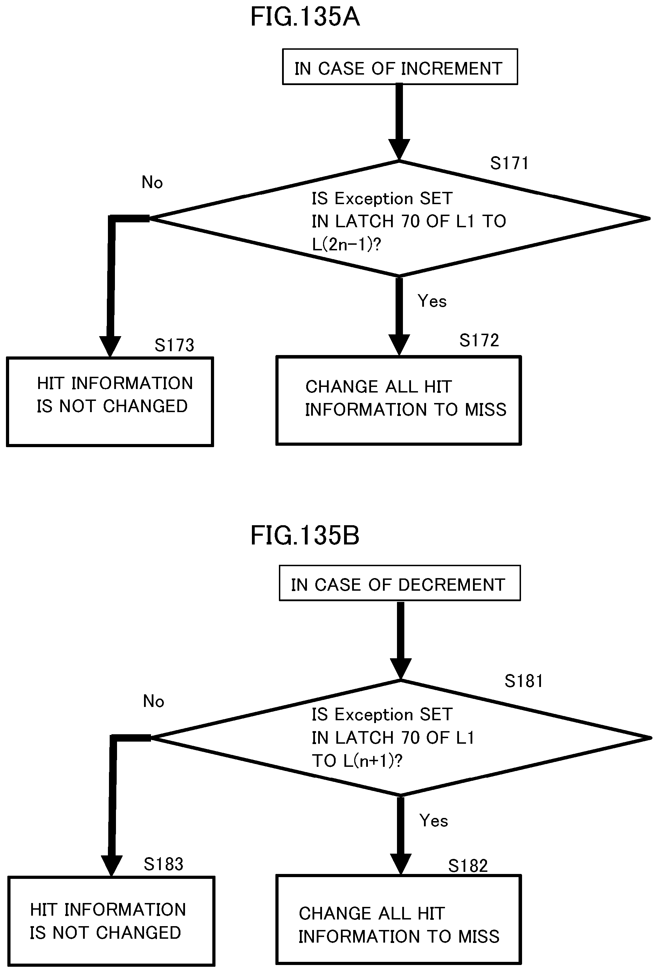

   Figs. 135A and 135B are explanatory diagrams of the sixth embodiment.
[Fig. 136]

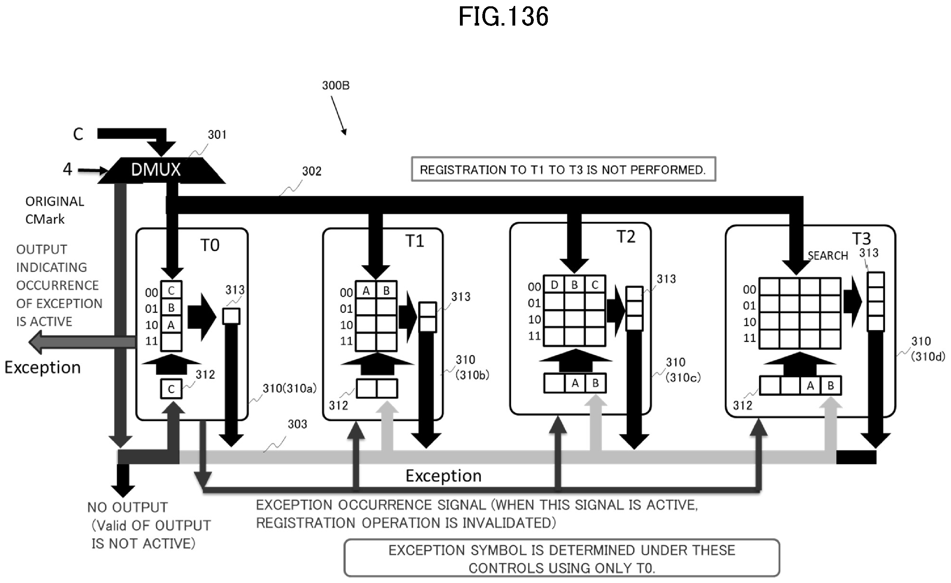

   Fig. 136 is an explanatory diagram of the sixth embodiment.
[Fig. 137]

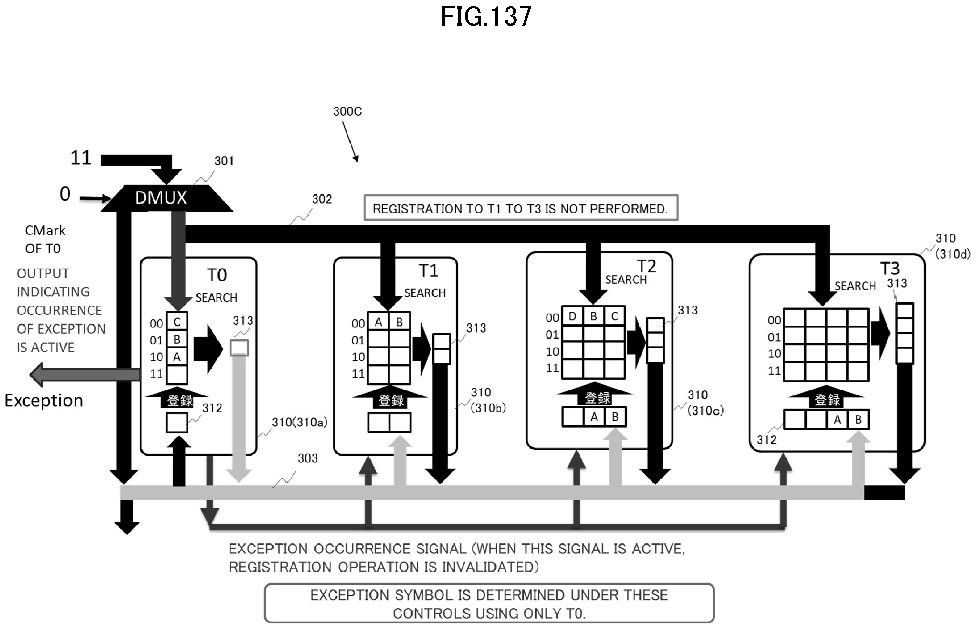

   Fig. 137 is an explanatory diagram of the sixth embodiment.
[Fig. 138]

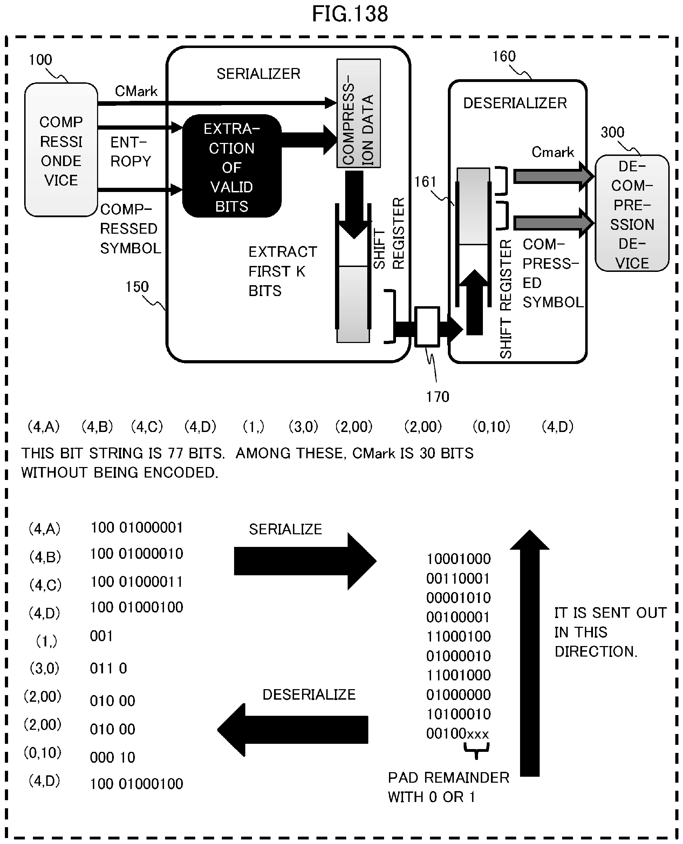

   Fig. 138 is an explanatory diagram of a seventh embodiment.
[Fig. 139]

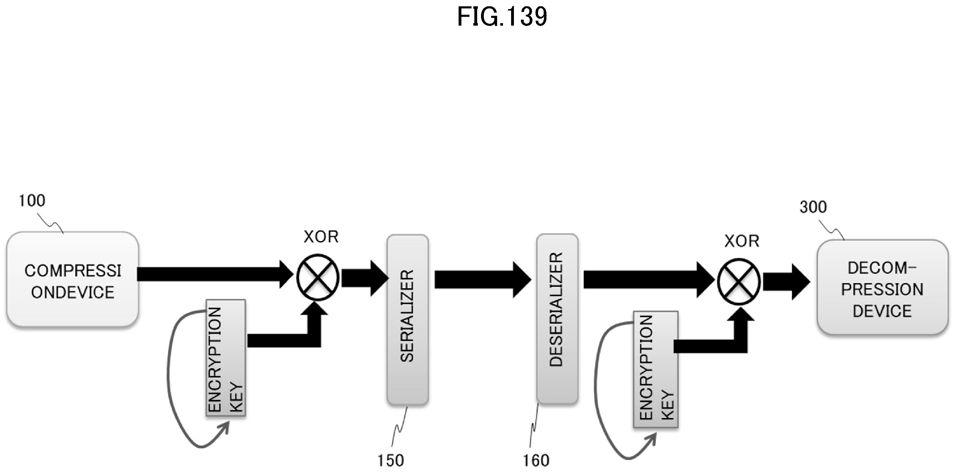

   Fig. 139 is an explanatory diagram of the seventh embodiment.
[Fig. 140]

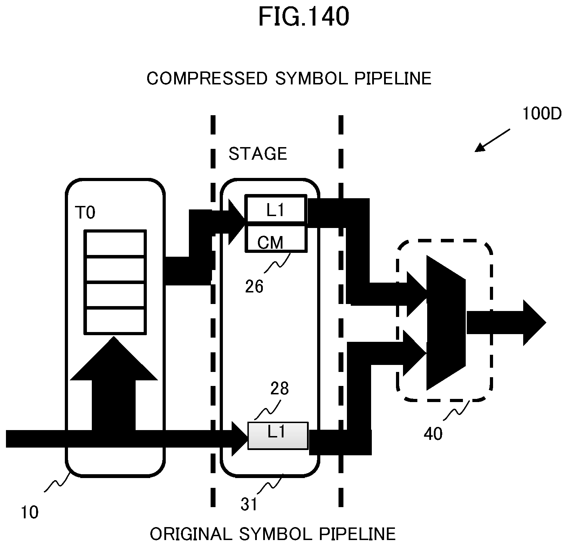

   Fig. 140 is an explanatory diagram of an eighth embodiment.
[Fig. 141]

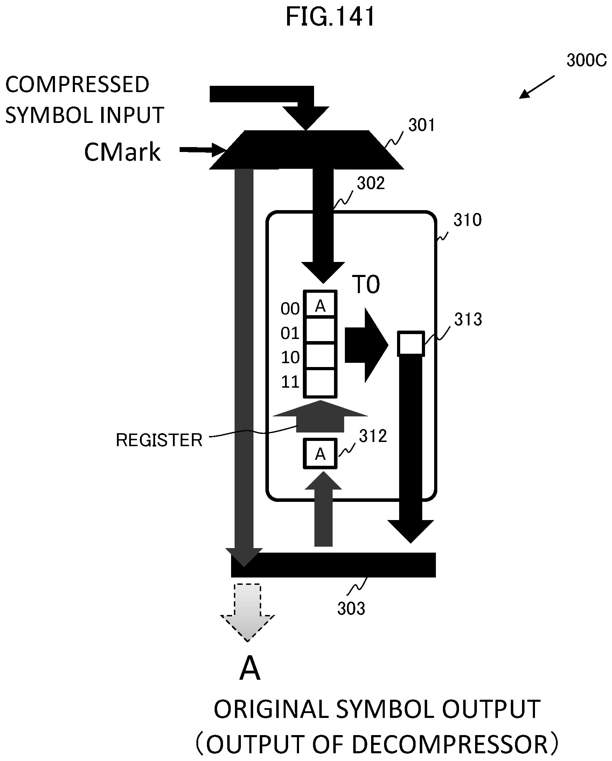

   Fig. 141 is an explanatory diagram of the eighth embodiment.

[Description of Embodiments]

In this specification, a "symbol" is a single data unit that becomes a target for data compression. For example, it refers to data per sample in a case in which the output data width per sample is fixed by hardware like a sensor. In other words, a symbol has a fixed length (fixed size). In this specification, unit data before compression is simply referred to as a symbol. In addition, an "original symbol" is an uncompressed symbol. In this specification, an "original symbol" refers to a symbol that is output in an uncompressed state without being compressed even after passing through a compression unit. In addition, a "compressed symbol" is a symbol compressed by a compression unit (compression module). In this specification, the compressed symbol refers to unit data after a symbol input to the compression unit has been converted through a compression operation.

In this specification, "universal" is defined as follows. In a case in which the longest symbol string formed using a plurality of symbols is compressed while converting it into a single compressed symbol within a set S of symbols, which are handled by the compression unit, included in data, it is referred to as "universal".

For example, in a case in which symbol string "AABBABABAABB..." is compressed, the longest symbol string "AABB" and symbol string "AB" are repeated to be the longest symbol string. For this reason, in a case in which the symbol string "AABB" is converted into compressed symbol "X", and the symbol string "AB" is converted into compressed symbol "Y", "AABBABABAABB" is compressed into "XYYX". In the case of this method, "AABB" may not necessarily be compressed into X and may be converted into compressed symbol "Z". In addition, "AB" that appears second may be converted into compressed symbol "P". In other words, there is a possibility that it will be converted into "XYPZ". Even in that case, since the longest symbol string is adaptively converted into a single symbol, it applies to the definition of "universal" described above.

A compression and decompression system according to the embodiment is intended as follows.
- A data stream is caused to propagate to a pipeline latch of a compression unit, and while checking for hits in tables handling different numbers of symbols at the time of that propagation, compression of the longest symbol string within tables, which are included in the compression unit, that handle strings formed using one or more symbols is attempted.
- An algorithm that can be implemented without using memory elements that temporarily save data is used.
- An algorithm that is easy to implement in hardware is used and can also be implemented in software.
- A compression unit that allows the number of tables included in the compression pipeline to be freely changed and enables free selection of hardware resources and compression performance in compression is configured.
- Also for the decompression device, the configuration is the same as the configuration of the tables included in the compression unit. This also serves as a factor in selecting the amount of hardware resources.
- The entropy of a symbol string appearing locally in a data stream is acquired, and the symbol string is adaptively compressed by converting it into a compressed symbol of at least one bit.
- An infinite data stream can be handled.

### [First Embodiment]

Hereinafter, a data compression device and a data decompression device according to a first embodiment will be described with reference to the drawings. In the following description, the data compression device and the data decompression device are simply referred to as a compression device and a decompression device. In addition, a pair of the compression device and the decompression device is referred to as a compression and decompression system. A symbol string is input to the compression device, and the compression device converts the symbol string into pairs of some compressed symbols and CMarks and outputs the pairs. The output of the compression device is input to the decompression device, and the decompression device restores the original symbol string. A configuration in which the compression device and the decompression device are connected through a communication line, and the output of the compression device is input to the decompression device through the communication line can be employed. However, the output of the compression device can also be input to the decompression device offline (for example, reading from a storage medium).

### <Compression Device>

Figs. 1 and 2 are diagrams illustrating configuration examples of the compression device. The compression device 100 includes an original symbol pipeline (an example of a first pipeline) and a compressed symbol pipeline (an example of a second pipeline). These pipelines are formed using a plurality of stages.

In the examples illustrated in Figs. 1 and 2, the compression device 100 includes a compression unit (compression module) 10 corresponding to a first compression unit, a compression unit (compression module) 20 corresponding to a second compression unit, an adjustment unit 30, and an output unit 40. The compression unit 20 is arranged at a subsequent stage (output side) to the compression unit 10, the adjustment unit 30 (a latch adjustment unit 31) is arranged at a subsequent stage (output side) to the compression unit 20, and the output unit 40 is arranged at a subsequent stage (output side) of the adjustment unit 30.

The compression unit 10, the compression unit 20, the adjustment unit 30, and the output unit 40 are circuits (hardware) using semiconductor devices such as an Application Specific Integrated Circuit (ASIC), a Field Programmable Gate Array (FPGA), a Complex Programmable Logic Device (CPLD), and the like. However, a part or all of the operations of the compression unit 10, the compression unit 20, the adjustment unit 30, and the output unit 40 may be realized by a software process by a processor (a Central Processing Unit (CPU), a Graphics Processing Unit (GPU), a Digital Signal Processor (DSP), or the like) executing a computer program stored in a memory (storage device). In addition, the compression unit 10, the compression unit 20, the adjustment unit 30, and the output unit 40 may be configured by a combination of hardware and software processes (a System on Chip (SoC) or the like). The memory is a non-transitory storage medium capable of storing a computer program and is a Read Only Memory (ROM), a Random Access Memory (RAM), a hard disk, a Solid State Drive (SSD), an Electrically Erasable Programmable Read-Only Memory (EEPROM), a flash memory, or the like. This similarly applies also to a global latch control unit, a compression device, a decompression device, an original latch control unit, and the like to be described below.

The compression device 100 can have a number of tables equal to a maximum value of the number of compressible symbols. In the present embodiment, the number of tables is 4, and the compression device 100 has conversion tables T0 to T3 (hereinafter simply referred to as tables T0 to T3) used for converting original symbols into compressed symbols. The number of tables is determined by an upper limit (a maximum value) of the number of symbols that can be registered (are registered) in entries of the tables. In the present embodiment, the maximum value of the number of symbols that can be registered in an entry is 4, and the tables T0 to T3 corresponding the same number (=4) as this are prepared. The Table T0 corresponds to a first table, and the tables T1 to T3 correspond to second tables. Each of the tables T0 to T3 has a plurality of entries. The number of entries is arbitrary and may differ among the tables. In the present embodiment, a case in which the number of entries is 4 in common will be described. The number of symbols registered in one entry of the table T0 is 1. The number of symbols registered in one entry of the table T1 is 2. The number of symbols registered in one entry of the table T2 is 3. The number of symbols registered in one entry of the table T3 is 4. In this way, a format in which the number of symbols that can be registered in the tables T1 to T3 increases by an offset number as the number of stages progresses (moves further to the inner side) is called an increment scheme. In the present embodiment, an example in which the offset number is 1, and the number of symbols registered in the entry increases by 1 each time in the tables T1 to T2 is illustrated. However, the offset number may be 2 or more.

The compression unit 10 has a table T0 (corresponding to the first table). One or two or more (a plurality of) compression units 20 are provided in accordance with the number of tables. In the present embodiment, compression units 20a, 20b, and 20c each having tables T1 to T3 (corresponding to the second tables) are provided. In the following description, in a case in which the compression units 20a, 20b, and 20c are not to be distinguished from each other, they are simply referred to as the compression unit 20.

The compression unit 10 is arranged at the first stage or the preceding stage among the plurality of stages. Fig. 1 illustrates an example in which the compression unit is arranged at the preceding stage of the stages. The compression units 20a to 20c are arranged at each stage subsequent to the compression unit 10. In other words, among the compression units 20a to 20c, the compression unit 20a is provided at the first stage, the compression unit 20b is provided the second stage, and the compression unit 20c is provided at the third stage. In addition, as illustrated in Fig. 2, the adjustment unit 30, at least, has latch adjustment units (latch modules) 31 corresponding to the number of symbols (=4) registered in one entry of the table T3 arranged on the innermost side among the plurality of tables. In Fig. 2, a view in which four latch adjustment units 31 (31a to 31d) are prepared and arranged at respective stages is illustrated.

Each of the compression units 20a to 20c and the latch adjustment units 31a to 31d has a latch 28 (L1 to L7) capable of maintaining (storing) one original symbol. The latch 28 corresponds to a first latch. The original symbol pipeline is configured by connecting original symbol latches L1 to L7 in series. The original symbol output from the compression unit 10 is input to the first latch L1. The original symbol input to the original symbol pipeline shifts to the next stage every predetermined cycle in a state in which its input order is maintained.

Similar to the original symbol pipeline, the compressed symbol pipeline has a latch 26 (L1 to L7) capable of maintaining one compressed symbol, which is provided in the compression units 20a to 20c and the latch adjustment units 31a to 31d. The latch 26 corresponds to a second latch. The latch 26 forming the first latch L1 maintains (stores) the compressed symbol output from the compression unit 10 to the compressed symbol pipeline. The content maintained by each latch 26 shifts every predetermined cycle in synchronization with the content maintained by the latch 28 (original symbol). In the present embodiment, the contents maintained by the latch 28 and the latch 26 shift to the next stage every one cycle.

Each of the compression units 20a, 20b, and 20c has a matching register 21 (an example of a "register"). The matching register 21 stores original symbols propagated through the original symbol pipeline while shifting them. The content maintained by the matching register 21 is used for matching with the entries of the corresponding table. The adjustment unit 30 is used to adjust the symbols flowing in each pipeline. In the compression device 100, the output timing (delay of the number of clocks) of data at each stage is set to be the same.

### <<Compression Unit 10 (First Compression Unit)>>

Fig. 3 is a diagram illustrating a configuration example of the compression unit 10. The compression unit 10 has tables T0 each capable of registering one original symbol. To the compression unit 10, original symbols constituting a data stream (symbol string) are input one by one to the original symbol pipeline. The compression unit 10 performs a search (matching) of the table T0 using the input original symbol as a search target. Each entry has an index ("00", "01") and the like, and the index is a bit string having a size smaller than the size of the original symbol. In the table search, in a case in which the search target has been found, the search result becomes a "hit", and in a case in which it is not found, the search result becomes a "miss". In a case in which the search result is a hit, the compression unit 10 can obtain the index of the entry storing the search target as a compressed symbol. The compression unit 10 outputs the compressed symbol and a CMark (to be described below).

More specifically, the compression unit 10 outputs the following information or data at the same timing.
- Original symbol (the input symbol itself)
- State of hit or miss
- Compressed symbol in a case in which there is a hit (the index of the hit entry)
- A numerical value allocated to the CMark of the table T0. The CMark (CM) represents a value (number) indicating the table (stage) in which the compressed symbol was generated or a value (number) indicating that the symbol is non-compressed. For example, when the number of tables is n (n is a positive integer), 0 to (n-1) respectively correspond to T0 to T(n-1), and n is set for a non-compressed symbol.
- "Valid" that represents whether the output is valid or not

The control input of the compression unit 10 includes an enable value that determines whether or not to take in an input data stream (symbol string). In a case in which the enable value is "0", the output of Valid becomes "0" (invalid), and in a case in which the value of the enable is "1", the output of Valid becomes "1" (valid). The meaning of valid and invalid, and the values of "0" and "1" may be reversed combinations.

Fig. 4 is a flowchart illustrating a process example of the compression unit 10. The process illustrated in Fig. 3 is started, for example, at the same timing as the start of one cycle or at a timing delayed by a predetermined offset time from that timing. The state of the compression unit 10 is "enabled".

In Step S01, the compression unit 10 searches the table T0 using the original symbol input to the original symbol pipeline as a search target. In Step S02, the compression unit 10 determines the search result of the table T0. In Step S03, the compression device 100 performs an output process of outputting the compressed symbol, the CMark, and the like to the compressed symbol pipeline. In a case in which the search result is a hit, the compressed symbol and CMark are output, and otherwise, the compressed symbol and CMark are not output. In Step S04, the compression unit 10 outputs the hit/miss, Valid (0 or 1), and the original symbol illustrated in Fig. 3.

### <<Compression Unit 20 (Second Compression Unit)>>

Referring back to Fig. 1, the compression unit 20 has a single or two or more multi-stage configuration. In the example illustrated in Fig. 1, the compression units 20a to 20c have a three-stage configuration of latches L1 to L3, and an example in which they are arranged in respective stages is illustrated.

Fig. 5 is a diagram illustrating a configuration example of the compression unit 20. In Fig. 5, a configuration of the compression unit 20a is illustrated as an example. The compression unit 20a includes a matching register 21, a latch state management unit 22, a multiplexing unit (multiplexer: MUX) 23, a latch control unit 24, a latch 26 (L1) that maintains the compressed symbol and the CMark, a latch 27 (latch T0) that maintains the compressed symbol obtained in the table T0 (referred to as a T0 compressed symbol), a table T1, and a latch 28 (latch L1) that maintains the original symbol.

In the compression unit 20a, the matching register 21 can maintain a maximum of two original symbols. In addition, the table T1 has a predetermined number (4 in this embodiment) of entries. Each entry can register the same number of symbols as the maximum number of symbols maintained in the matching register 21. Two continuous original symbols are registered in the entry of the table T1. The matching register 21 of the compression unit 20b can maintain a maximum of three original symbols, and three continuous original symbols are registered in the entry of the table T2. In addition, the matching register 21 of the compression unit 20c can maintain a maximum of four original symbols, and four continuous original symbols are registered in the entry of the table T3.

The matching register 21 latches the original symbols while shifting the maintained contents. When original symbols are set in all the registers that the matching register 21 has (when the state of the matching register 21 becomes full), a table search is performed. A miss is output while original symbols are not set in all the registers constituting the matching register 21. In a case in which original symbols are set in all the registers, it is reset when the table search is completed, and all the registers fall into an empty state. As a result of the table search, in the case of a hit, "1" is set to the Hit output, and in the case of a miss, "0" is set. The relation between the value of "1" or "0" and a hit or a miss may be reversed.

The transition of the matching register 21 is illustrated in the lower part of Fig. 5. A case in which three symbols "A", "B", and "C" are input to the latch 28 in the order of ABC is illustrated. When the symbol "A" is input to the latch 28 in a state in which the matching register 21 is empty, the symbol "A" is stored in the matching register 21. In the maintaining state of the symbol "A", when the symbol "B" is input to the latch 28, the symbol "B" is input to the matching register 21, and the symbol "A" shifts to the upper side. In a case in which the matching register 21 becomes a full state (the number of maintained symbols becomes a maximum), a table search (matching) is performed to search for the same symbol string as the symbol string maintained in the matching register 21 from the table T1. When matching is performed, the content maintained by the matching register 21 is reset. Then, the original symbol (symbol "C") input next is maintained.

In this way, a configuration in which the number of symbols registered in the entries of the plurality of tables included in the plurality of compression units 20 increases by the offset number every time the stage progresses further inward is called an "increment scheme". However, the number of symbols registered in the entry of the table T0 included in the compression unit 10 is necessarily 1. The offset number is 1 or an arbitrary number of 2 or more.

To the contrary, in a case in which the number of symbols registered in the entries of the plurality of tables included in the plurality of compression units 20 decreases by the offset number every time the stage progresses further inside, the configuration is called a "decrement scheme". However, even in the decrement scheme, the number of symbols registered in the entry of the table T0 included in the compression unit 10 is necessarily 1.

The latch state management unit 22 maintains the "Valid (valid)" or "Purged (invalid)" state input to the compression unit 20 and outputs the maintained content ("Valid" or "Purged"). Input/output of "Valid" and "Purge" is exchanged between the immediately preceding and immediately succeeding compression units.

Inputs to the MUX 23 are a compression latch input, a table hit input, and a T0 compressed symbol input. The compression latch inputs are outputs (a compressed symbol and a CMark) from the latch 26 in the immediately preceding stage. The table hit input is a compressed symbol and a CMark obtained in a case in which the table search result in the immediately preceding compression unit 20 is a hit. In addition, in a case in which the immediately preceding stage is the compression unit 10 (table T0), there is no compression latch input. The T0 compressed symbol input is a compressed symbol (T0 compressed symbol) obtained in a case in which the search result of the table T0 of the compression unit 10 is a hit. The compression latch input or the table hit input is maintained in the latch 26 via the MUX 23. The T0 compressed symbol input is maintained in the latch 27 via the MUX 23. Contents maintained in the latch 26 and the latch 27 are output in synchronization with the output timing of the latch 28.

One of "Latch", "Hit", "Purge", and "Empty" is input to the latch control unit 24 as a latch control input. The latch control input is a control signal (control instruction) for controlling the maintained content or state of the latch 26, and the maintained content of the latch 26 and the content of the compression latch output change in accordance with the latch control input.

The T0 compressed symbol pipeline (see Fig. 1) is used to propagate the compressed symbol in a case in which the original symbol is compressed in the table T0. When the number of tables including T0 is n (n is a positive integer), the compression unit 20 having tables from T1 to T(n-2) maintains the latch 27 of the T0 compressed symbol pipeline. In the present embodiment, the compression units 20a and 20b have the latches 27. The latch 27 in the compression unit 20a (table T1) latches the compression result in the table T0, and the compression unit 20 in a stage subsequent to the compression unit 20a receives the value of the latch 27 in the preceding stage. The content maintained by the latch 27 is used for Empty control described below. The compression unit 20c does not have the T0 compressed symbol pipeline and thus does not have the latch 27.

The latch 26 of the compression pipeline is accompanied by a CMark. The CMark is a number representing the compression unit of a certain stage at which compression was performed (corresponding to position information or information representing non-compression). For example, when the number of tables is n, the values 0 to (n-1) respectively correspond to tables T0 to T(n-1). A value of n is set for a non-compressed symbol. However, since it is sufficient for the CMark to be able to actually recognize in which table the compression was performed, any numerical value may be assigned as long as it is a different value.

When the number of tables including the table T0 of the compression unit 10 is n, the number of all latches including the adjustment latch (the latch adjustment unit 31) constituting the original symbol pipeline and the compressed symbol pipeline is 2(n-1)+1 = 2n-1. In other words, the number of adjustment latches is 2n-1-(n-1) = n. In the examples illustrated in Figs. 1 and 2, the total number of latches is 7 (L1 to L7), and the number of adjustment latches is 4 (L4 to L7).

It is sufficient that the delay of each stage described above (including the adjustment unit 30) is equal, and only the output timing needs to match. In this specification, it is assumed that each stage can output with a delay of 1 clock.

The latch 27 of the T0 compressed symbol pipeline has the following two states.
- Valid: A valid compressed symbol in table T0 is maintained in the latch 27.
- Invalid: The latch 27 is empty. In other words, compression was not performed in table T0.

The latch 28 of the original symbol pipeline has the following two states.
- Valid: A valid original symbol is maintained in the latch 28.
- Invalid: The latch 28 is empty. In other words, input was performed in the cycle when Enable was "0".

The latch 26 of the compressed symbol pipeline can have the following three states. However, in the present embodiment, a combination of two states including Valid and Purged is used.
- Invalid: Nothing is set in the latch 26.
- Valid: A compressed symbol is set.
- Purged: This cycle is invalidated (purged).

There are following four control signals for controlling the above-described latch control inputs, that is, the maintained content of the latch 26. These control signals are input to the latch control unit 24 of the compression unit 20, and the latch control unit 24 performs the following processes according to the control signals by controlling the MUX 23 and the like.
- Latch: The MUX 23 is caused to output the content of the latch 26 in the immediately preceding stage (including a CMark), that is, the compression latch input toward the latch 26 to cause the compressed latch input to be maintained in the latch 26.
- Hit: The MUX 23 is caused to output the compressed symbol and CMark obtained in the immediately preceding stage due to a hit, in other words, outputs the table hit input toward the latch 26 to cause the compressed latch input to be maintained in the latch 26.
- Purge: The state of the latch 26 is brought into a Purged (invalidated) state.
- Empty: The state of the latch 26 is changed in accordance with the state of the latch 27 for the T0 compressed symbol in the immediately preceding compression unit 20. When the state of this latch 27 is Valid, the content is set in the latch 26 of the compressed symbol. Otherwise, the latch 26 of the compressed symbol is set to Invalid.

Fig. 6 is a flowchart illustrating a process example of the compression unit 20. The process illustrated in Fig. 6 is performed in synchronization with the compression unit 10. In Step S11, the compression unit 20 causes the latch 26 to maintain the content corresponding to the latch control input (control signal).

In Step S12, the compression unit 20 causes the latch 27 to maintain the T0 compressed symbol input. However, the process of Step S12 is performed only in a case in which the compression unit 20 has the latch 27.

In Step S13, the compression unit 20 causes the latch 28 to maintain the original symbol. In addition, the order of the processes of Steps S11 to S13 can be arbitrarily changed. Furthermore, the processes of Steps S11 to S13 may be started simultaneously.

In Step S14, the original symbol is registered in the matching register 21. In Step S15, the compression unit 20 determines whether or not the matching register 21 is full. In a case in which it is determined that the matching register 21 is full, the process proceeds to Step S16, and otherwise, the process of Fig. 6 ends.

In Step S16, the compression unit 20 performs a table search (matching) using two or more original symbols (a symbol string) registered in the matching register 21 as a search target. In Step S17, the compression unit 20 determines whether the table search result is a hit or a miss.

In Step S18, in a case in which the search result is a hit, the compression unit 20 performs processes relating to each output illustrated in Fig. 5 such as hit information representing a hit "1", a compressed symbol, a CMark, and the like. In a case in which the search result is a miss, hit information representing a miss "0" is output, and the compressed symbol and the CMark are not output. In Step S19, the compression unit 20 updates the table in accordance with a hit or a miss. Thereafter, the process of Fig. 6 ends.

Fig. 7 is an explanatory diagram of table operations and illustrates operations at the time of updating the table in Step S03 of Fig. 4 and Step S19 of Fig. 6. However, the registered contents of the entries illustrated in Fig. 7 are different from those in the present embodiment. In a case in which the table search result is a hit, the entry in which the search target is registered (a hit entry) moves to the highest level of the table. In the present embodiment, the highest-level entry is an entry with a smallest index value (index value "00"). At this time, all the entries that were at higher positions than the position of the hit entry move to respective one-lower positions. The table search is performed in ascending order of index values for the entries in use. However, the search order may be performed in descending order of index values. Furthermore, an entry with the smallest index value may be defined as the highest-level entry.

On the other hand, in the case of a miss, an operation of adding the content of the matching register 21 to the highest-level entry (a push operation) is performed. In the push operation, the entries after the highest level are shifted to respective one-lower positions, and a missed symbol is added to the highest-level entry. At this time, the registered content of the entry protruding from the highest-level entry (in the case of index: 11 and number of entries 4) is erased.

### <<Adjustment Unit 30>>

Fig. 8 is a diagram illustrating a configuration example of the latch adjustment unit 31. As illustrated in Figs. 1 and 2, the adjustment unit 30 is arranged at the subsequent stage to the compression unit 20c. The adjustment unit 30 includes latch adjustment units 31 (L4 to L7) each having latches 26 corresponding to the number of tables including the table T0. In the present embodiment, since the number of symbols registered in the entry of table T3 is four, the adjustment unit 30 has a four-stage configuration formed using latch adjustment units 31a to 31d, and the latch adjustment units 31a to 31d are arranged at respective stages subsequent to a stage at which the compression unit 20c is present.

In Fig. 8, the latch adjustment unit 31 differs from the compression unit 20 in the following points. The latch adjustment unit 31 does not have the matching register 21, the table, and the latch 27. In addition, the latch adjustment unit 31 has no T0 compressed symbol input to the MUX 23. The latch adjustment unit 31 has a latch state management unit 22, an MUX 23, a latch control unit 24, a latch 26 for compressed symbols, and a latch 28 for original symbols.

The latch adjustment unit 31 configuring the adjustment unit 30 has the following inputs.
- Compression latch input: the output from the immediately preceding latch 26 (including the CMark) and is maintained in the latch 26 through the MUX 23.
- Table hit input: the compressed symbol and the CMark in the immediately preceding compression unit 20 and is selectively maintained in the latch 26 together with the compression latch input through the MUX 23.

Control signals input to the latch control unit 24 include the following, and the latch control unit 24 performs processes according to these control signals.
- Latch: The output from the immediately preceding latch 26, which is the compression latch input, is maintained in the latch 26.
- Hit: The compressed symbol and the CMark, which are the table hit inputs, are maintained in the latch 26.
- Purge: The latch 26 is brought into a Purged (invalid) state.

Furthermore, inputs of Valid and Purged are inputs representing the state of the immediately preceding latch 26 and are maintained in the latch state management unit 22.

The output of the latch adjustment unit 31 is as follows:
- Compression latch output: Outputs the compressed symbol and the CMark maintained in the latch 26.
- Original latch output: Outputs the original symbol maintained in the latch 28.
- Valid and Purge: State outputs of the latch 26.

Fig. 9 is a flowchart illustrating a process example of the latch adjustment unit 31. The process illustrated in Fig. 9 is performed in synchronization with the compression units 10 and 20 and latch adjustment units 31 other than itself. In Step S21, the latch adjustment unit 31 causes the latch 26 to maintain the content according to the latch control input (control signal).

In Step S22, the latch adjustment unit 31 causes the latch 28 to maintain the original symbol. In addition, the order of the processes of Steps S21 and S22 can be arbitrarily changed. Furthermore, the processes of Steps S21 and S22 may be started simultaneously. In Step S23, the latch adjustment unit 31 performs processes relating to each output illustrated in Fig. 8. Thereafter, the process of Fig. 9 ends.

### <<Output Unit 40>>

Fig. 10 is a diagram illustrating a configuration example of the output unit 40. The output unit 40 receives an output from the latch adjustment unit 31 arranged at the final stage. The output unit 40 includes an output control unit 41 and a multiplexing unit (MUX) 42. The output control unit 41 controls the operation of the MUX 42 in accordance with the values of Valid and Purged. The MUX 42 performs output control according to an instruction from the output control unit 41.

As inputs to the output unit 40, there are the following.
- Valid and Purged of the compression latch: Represents the state of the immediately preceding latch 26.
- Compression latch: Input from the immediately preceding compression latch (the latch 26) (including the CMark).
- Original symbol latch: Input from the immediately preceding original symbol latch (the latch 28).
- Valid of the original symbol latch: Represents the state of the immediately preceding latch 28. Valid input = 0 represents invalidity of the content maintained by the latch 28, and Valid output = 1 represents validity of the content maintained by the latch 28. The compression unit 20 and the latch adjustment unit 31 also have an input and an output of states (Valid = 0 or 1) according to contents maintained by the original symbol latch (the latch 28) (see Figs. 5 and 8), and the Valid state set by any one of the latches L1 to L7 propagates to the latch L7.

As outputs of the output unit 40, there are the following.
- Symbol output: An original symbol or a compressed symbol.
- CMark output: A CMark accompanying (forming a pair with) the original symbol or the compressed symbol.
- Valid output of the compression latch: Represents Valid = 1 (valid) and Valid = 0 (invalid).
- Valid output of the original symbol latch: Represents Valid = 1 (valid) and Valid = 0 (invalid).

The output unit 40 determines whether or not to output a pair of the original symbol and the CMark or a pair of the compressed symbol and the CMark on the basis of the contents maintained by the latch 26 and the latch 28 and the states thereof (Valid, Purged) for each cycle and operates in accordance with the determination.

Fig. 11 is a flowchart illustrating a process example of the output unit 40. The process of Fig. 11 is performed in synchronization with the compression unit 10, the compression unit 20, and the adjustment unit 30. In Step S31, the output unit 40 determines a Valid output (whether or not the output is valid) according to each value of the Valid input and the Purged input of the compression latch. In Step S32, the output unit 40 determines whether or not the Valid output of the compression latch = 1. In a case in which it is determined that the Valid output = 1, the process proceeds to Step S33, and otherwise (in a case in which it is determined that the Valid output = 0), the process proceeds to Step S34.

In Step S33, the output unit 40 outputs a pair of the symbol and the CMark (the original symbol and the CMark or the compressed symbol and the CMark) according to values of the Valid input and the Purged input of the compression latch and the Valid output of the compression latch in accordance with the table illustrated in Fig. 10. For example, CMark values "0 to 3" respectively represent the tables T0 to T3 from which the symbol output (the compressed symbol) has been obtained (corresponding to position information), and CMark value "4" represents that the symbol output (the original symbol) is non-compressed.

In Step S33, the output unit 40 outputs a pair of the symbol and the CMark according to the Valid input of the original symbol latch. In other words, as illustrated in Fig. 10, when the Valid input of the original symbol latch is "1", the Valid output thereof becomes "1", and the output unit 40 outputs a pair of the original symbol and the CMark. On the other hand, when the Valid input of the original symbol latch is "0", the Valid output thereof becomes "0", and the output unit 40 does not perform output in this cycle.

### <<Global Latch Control Unit>>

Fig. 12 is an explanatory diagram of the global latch control unit 50. The global latch control unit 50 can receive a Hit output (Hit information) output from each compression unit 20. The global latch control unit 50 performs control using the received Hit information.

In other words, the input to the global latch control unit 50 is the Hit information (hit: 1, miss: 0) from the compression unit 20. However, as long as the global latch control unit 50 can identify a hit or a miss, a configuration in which the hit information is transmitted only in a case in which the result of the table search is a hit (and is not transmitted in the case of a miss) may be employed.

The output (the control signal) of the global latch control unit 50 is sent to each of the compression unit 20 and the latch adjustment unit 31 as a latch control input. The types of control signals provided for the compression unit 20 are four types including Latch, Hit, Purge, and Empty, and one of these four types is provided as a latch control input every cycle. On the other hand, the types of control signals provided for the latch adjustment unit 31 are three type including Latch, Hit, and Purge, and one of these three types is provided as a latch control input every cycle. The global latch control unit 50 does not control the compression unit 10 (the table T0) and has no input from the compression unit 10.

### <<Control of Latch 26>>

Fig. 13 is a table illustrating hit/miss patterns of each table and patterns of control signals. In Fig. 13, relation between the hit/miss patterns of the table search and the control signals for the latches 26 (L1 to L7) in a case in which the number of tables including the table T0 is respectively 2, 3, and 4 is illustrated.

"Table Hit/Miss" on the left side of the table represents a Hit input (search result of each table), and "Input to Compression Latch" on the right side represents the type of control signal supplied to the latch 26 (L1 to L7). In other words, the table on the right side illustrates only control signals that enters the active state in accordance with the hit/miss pattern. In other words, it represents that any one of Latch, Hit, Purge, and Empty signals becomes "1" (valid) with respect to the latch 26 (L1 to L7), and the rest becomes "0" (invalid).

Here, a table used for matching k symbols (k is a positive integer of 2 or more) is called Tk, and the latch 26 accompanying (associated with) the table Tk is called a latch Lk. In this case, the latches 26 accompanying tables T1 to T3 are L1 to L3. The latches 26 included in the latch adjustment unit 31 are denoted as sequential numbers in ascending order from L(N) in a case in which there are N compression units 20 (N is a positive integer). For example, in a case in which there are three k tables, T1, T2, and T3, the latches 26 are latches L1 to L3 included in the compression unit 20, and latches L4 to L7 included in the latch adjustment unit 31.

### <<Conflict Avoidance>>

Fig. 14 is an explanatory diagram of resolving a conflict in latch control. In a case in which a compressed symbol obtained by compressing a plurality of preceding symbols is present in the adjustment unit 30 (up to immediately before the output unit 40), correction for changing a hit to a miss is performed. In a case in which this correction is not performed, all the original symbols for restoring the compressed symbols to originals are purged (invalidated).

For example, in the compression device 100 illustrated in Fig. 14, a case in which the compressed symbol that has generated a hit in the table T2 is maintained in the latch 26 (L6) is assumed. Then, it is assumed that table searches for the tables T1 and T2 result in misses, and a table search for the table T3 results in a hit. In this case, as illustrated in the table (the number of tables: 4) of Fig. 13, in a case in which the result of the table hit/miss is "miss, miss, hit", control signals from the global latch control unit 50 for the latches L1 to L7 become "latch, latch, latch, hit, purge, purge, purge", and invalidation for the latches L6 to L8 is instructed. As a result of this, the compressed symbol and the CMark maintained in the latch L6 are purged. In a case in which the compressed symbol maintained in the latch 26 (L6) is purged, the original symbol to be restored from the compressed symbol maintained in the latch 26 (L6) becomes unknown, and the compressed symbol cannot be restored.

Thus, in a case in which hit information is sent from the compression unit 20c to the global latch control unit 50, a process of changing the content of the hit information from hit to miss is performed. In accordance with this, the problem of the compressed symbol being purged can be avoided. The states of hits/misses after table T2 are changed as follows. The problem of conflict occurs at the time of a hit after the table T2, and thus it does not occur in a case in which the number of tables is 2 or less.

Fig. 15 is a flowchart illustrating a process example for resolving a conflict. The process illustrated in Fig. 15 is performed in a case in which the table search result is a hit. In Step S41, in the table search (matching), the compression unit 20 determines whether or not a compressed symbol obtained after the compression unit 20a (the table T1) is set in the latch 26 of L3 to L(k-1) (L3 to L6 correspond thereto, and not including the last one (L7)). In a case in which Yes is determined in Step S41, the compression unit 20 changes all the hit/miss states after the table T2 to miss (Step S42). In Step S43, hit information (hit/miss) is transmitted from each compression unit 20.

Fig. 16 is a flowchart illustrating a process example of the global latch control unit 50. In Step S51, the global latch control unit 50 receives hit information from each of the compression units 20a to 20c. In Step S52, the global latch control unit 50 determines a pattern of latch control for the latches 26 of L1 to L7, and transmits control signals (control instructions). For example, the global latch control unit 50 has a table for latch control as illustrated in Fig. 13 and can determine a pattern of latch control by reading out the pattern of latch control corresponding to the hit/miss pattern. In Step S53, the global latch control unit 50 transmits control signals according to the latch control pattern to the compression units 20a to 20c and the latch adjustment units 31a to 31d (for L1 to L7). A configuration in which the compression device 100 has the table of control signals illustrated in Fig. 13 and the compression unit 20 and the latch adjustment unit 31 receive the hit/miss pattern and recognize the control contents of the latch 26 in the next cycle by referring to the table may be employed. The table may be individually provided in the compression unit 20 and the latch adjustment unit 31 or may be referred to in common between them. In this case, the global latch control unit 50 can be omitted.

### <<Operation Example>>

Figs. 17 to 42 are explanatory diagrams of an operation example of the compression device 100. Fig. 17 illustrates the compression device 100 before the start of the operation example. The compression device 100 causes each entry of the tables T0 to T3 to be in an empty state by initialization. In addition, the compression device 100 sets the states of all the latches 26 to 28 to Invalid (empty). The value of CMark is set to T0 = 0, T1 = 1, T2 = 2, T3 = 3, and non-compression = 4 as an example. However, values other than those described above may be assigned to the tables T0 to T3 as long as the CMarks have different values. As a plurality of symbols (original symbol string) input to the compression device 100, a symbol string such as ABCDABCD... illustrated in Fig. 16 is input. Every predetermined cycle (for example, one cycle), the processes of Figs. 4, 6, 9, and 11 are performed by the compression device 100.

Fig. 18 illustrates an operation in a cycle in which the first symbol "A" in the original symbol string is input. In this cycle, the table search result in the compression unit 10 becomes a miss (because no symbol is registered in the table T0). For this reason, the symbol "A" is registered in the highest-level entry (index "00") of the table T0. In a case in which the table search result in the table T0 is a miss, the value of Valid transmitted to the compression unit 20a becomes "0" (Invalid). On the other hand, in a case in which the table search result is a hit, Valid = 1.

In the cycle illustrated in Fig. 18, table search is not performed in any one of the compression units 20a, 20b, and 20c. For this reason, each of the compression units 20a, 20b, and 20c sends hit information (miss) to the global latch control unit 50. In this case, the global latch control unit 50 sends the control signal Latch as a control signal for the latches 26 (L1 to L7) of the compressed symbols in the next cycle. In a case in which the latches 26 and 28 of L7 are empty, Valid = 0 of the latches 26 and 28 is input to the output unit 40. From this, there is no output from the output unit 40 in that cycle.

Fig. 19 illustrates an operation in the next cycle of the cycle illustrated in Fig. 18, and the next symbol "B" is input to the compression unit 10. Since the table search result is a miss in the compression unit 10, the symbol "B" is registered in the highest-level entry of the table T0, and the symbol "A" is registered in the entry one level above (index "01"). Then, the symbols are transmitted to the compression unit 20a.

In addition, the symbol "A" is shifted through the original symbol pipeline and is maintained in the latch 28 of the compression unit 20a in the next stage. In the compression unit 20a, the symbol "A" is registered in the matching register 21. In addition, also in this cycle, the same hit information (miss) as that in the previous cycle is sent to the global latch control unit 50. For this reason, the global latch control unit 50 sends the control signal Latch as a control signal for the latches 26 (L1 to L7) in the next cycle. In this cycle, there is no output from the output unit 40.

Fig. 20 illustrates an operation in the next cycle of the cycle illustrated in Fig. 19. In this cycle, the next symbol "C" is input to the compression unit 10. In the compression unit 10, the search result of the table T0 becomes a miss. For this reason, the symbol "C" is registered in the highest-level entry of the table T0, and the symbols "A" and "B" respectively move to the entry one level below. In addition, the symbol "B" is shifted through the original symbol pipeline and is maintained in the latch 28 and the matching register 21 of the compression unit 20a present at the next stage. At this time, since the matching register 21 becomes full, the compression unit 20a performs table search (matching) for the symbol string "AB". However, the table search result becomes a miss. As a result, the symbol string "AB" is registered in the highest-level entry of the table T1. In addition, the symbol "A" is shifted to the latch 28 of the compression unit 20b and is maintained in the matching register 21 of the compression unit 20b. Hit information (miss) is sent from the compression units 20a to 20c to the global latch control unit 50. For this reason, the global latch control unit 50 gives the control signal Latch to the latches 26 (L1 to L7) as the control signal of the next cycle. In this cycle, there is no output from the output unit 40.

Fig. 21 illustrates an operation in the next cycle of the cycle illustrated in Fig. 20. In this cycle, the next symbol "D" is input to the compression unit 10. As a result of the table search in the compression unit 10, the symbol "D" is registered in the highest-level entry of the table T0, and the symbols "A", "B", and "C" are registered in the respective entries one level below. In addition, the symbol "C" is shifted to the compression unit 20a as an original symbol and is maintained in the latch 28 and the matching register 21 thereof. In addition, the symbol "B" is shifted from the compression unit 20a to the compression unit 20b and is maintained in the latch 28 and the matching register 21 of the compression unit 20b. Furthermore, the symbol "A" is shifted from the compression unit 20b to the compression unit 20c, and is maintained in the latch 28 and the matching register 21 of the compression unit 20c. Also in this cycle, each compression unit 20 sends hit information (miss) to the global latch control unit 50. For this reason, the global latch control unit 50 gives the control signal Latch to the latches 26 (L1 to L7) as the control signal of the next cycle. In this cycle, there is no output from the output unit 40.

Fig. 22 illustrates an operation in the next cycle of the cycle illustrated in Fig. 21. In this cycle, the next symbol "A" is input to the compression unit 10. The result of the table search in the compression unit 10 becomes a hit. As a result, the symbol "A" is registered in the highest-level entry of the table T0. In addition, from the compression unit 10, Valid = 1, the compressed symbol "11" that is the index of the entry in which the symbol "A" has been registered, and CMark = 0 indicating the conversion in the table T0 are sent as the table hit input to the compression unit 20a in the next stage.

Due to the shift of the symbol in the original symbol pipeline, the matching register 21 becomes full in the compression unit 20a, and table search is performed, but the result becomes a miss. For this reason, a symbol string "CD" that is a search target is registered in the highest-level entry of the table T1. In addition, the matching register 21 becomes full also in the compression unit 20b, the table search result becomes a miss, and a symbol string "ABC" that is a search target is registered in the highest-level entry of the table T2. In this cycle, there is no output from the output unit 40.

Fig. 23 illustrates an operation in the next cycle of the cycle illustrated in Fig. 22. In this cycle, the next symbol "B" is input to the compression unit 10. Since the table search result in the compression unit 10 is a hit, the symbol "B" that was the search target is registered in the highest-level entry of the table T0. The compression unit 20a takes the table hit input (a compressed symbol "11" and CMark = 0) into the latch 26 of the compressed symbol in accordance with the control signal Latch sent from the global latch control unit 50 in the previous cycle. In addition, the compression unit 20a takes the compressed symbol "11" in the table T0 that has been transmitted from the compression unit 10 into the latch 27 of the T0 compressed symbol. In this cycle, there is no output from the output unit 40.

Fig. 24 illustrates an operation in the next cycle of the cycle illustrated in Fig. 23. In this cycle, the next symbol "C" is input to the compression unit 10. In the original symbol pipeline, the original symbol string "ABCDAB (in the order of input)" is maintained in respective latches 28 of L1 to L6. The table search result of symbol "C" in the compression unit 10 becomes a hit. For this reason, the symbol "C" is registered in the highest-level entry of the table T0.

The compression unit 20a takes the compressed symbol "11" and CMark = 0, which have been sent from the compression unit 10, into the latch 26 of the compressed symbol in accordance with the control signal Latch received in the previous cycle. In addition, the compression unit 20a takes the compressed symbol "11" in the table T0, which has been sent from the compression unit 10, into the latch 27 of the T0 compressed symbol. Furthermore, in the compression unit 20a, the matching register 21 becomes full, and the symbol string "AB" is searched from the table T1. At this time, since the symbol string "AB" is registered in the entry of the index "01", the search result becomes a hit. As a result, the compressed symbol "01", CMark = 1, and the T0 compressed symbol 11 are sent to the compression unit 20b present at the next stage. In addition, hit information (hit) of the table T1 is transmitted to the global latch control unit 50.

The compression unit 20b takes the compressed symbol "11" and CMark = 0 from the compression unit 20a into the latch 26 of the compressed symbol in accordance with the control signal Latch received in the previous cycle. In addition, the compression unit 20b takes the compressed symbol "11" in the table T0 into the latch 27 of the T0 compressed symbol. Furthermore, the compression unit 20b causes the matching register 21 to maintain the original symbol "A", which is maintained by the latch 28, in the matching register 21, and since the matching register 21 is not full, the table search result (hit information) becomes a miss.

The compression unit 20c takes the original symbol "D" maintained by the latch 28 into the matching register 21 and receives that the matching register 21 becomes full, and the table search (matching) of the symbol string "ABCD" is executed. However, the table search result (hit information) becomes a miss (because there is no entry in which the symbol string is registered). As a result, the symbol string "ABCD" is registered in the highest-level entry of the table T3.

The global latch control unit 50 that has received the hit information from the compression unit 20a receives the hit information of the table T1 (T1 is hit, and T2 and T3 are misses) and sends control signals for the next cycle as follows. In other words, the global latch control unit 50 sends the control signal Hit to the compression unit 20b (L2) and sends the control signal Purge to the compression unit 20c (L3). The control signal Latch is sent to the remaining latches 28. The control signal Hit is an instruction to take the table hit input of the table T1 into the latch 26 in the next cycle. In addition, the control signal Purge is an instruction to change the latch 26 of the compression unit 20c to Purged (invalidated) in the next cycle. There is no output from the output unit 40 in this cycle.

Fig. 25 illustrates an operation in the next cycle of the cycle illustrated in Fig. 24. In this cycle, the next symbol "D" is input to the compression unit 10. In the original symbol pipeline, the original symbol string "ABCDABC (in the order of input)" is maintained in respective latches 28 of L1 to L7. In the compression unit 10, since the table search result of the symbol "D" is a hit, the symbol "D" is registered in the highest-level entry of the table T0.

The compression unit 20a takes the compressed symbol "11" and CMark = 0 sent from the compression unit 10 into the latch 26 of the compressed symbol in accordance with the control signal Latch received in the previous cycle. In addition, the compression unit 20a takes the compressed symbol "11" in the table T0 into the latch 27. In this cycle, the table search of the table T1 is not performed, and the table search result becomes a miss.

The compression unit 20b takes the content of the latch 26 of the previous stage (compressed symbol "11" and CMark = 1), which is the compression latch input, into the latch 26 in accordance with the control signal Latch received in the previous cycle. In the compression unit 20b in this cycle, the matching register 21 becomes full, and table search of the table T2 with the symbol string "DAB" as a search target is performed, but the table search result becomes a miss. The symbol string "DAB" is registered in the highest-level entry of the table T2.

The compression unit 20c invalidates the latch 26 in accordance with the control signal Purge received in the previous cycle. In other words, the compression unit 20c sets the Purged state (Valid = 1 and Purged = 1) in the latch state management unit 22. The Purged state is transmitted to the subsequent stage together with the shift of the contents of the latches 26 and 28 and is eventually input to the output unit 40. In the cycle in which the Purged state is input, the output unit 40 does not perform output. The maintained content of the latch 26 in the Purged state is invalidated regardless of the content thereof. In the drawing, the Purged state of the latch 26 is expressed by the notation "Purged" or "Pur" represented in the block of the latch 26. In the example illustrated in Fig. 25, the symbol "A" maintained in the latch 28 (L3) forms a pair with the latch 26 that is in the Purged state. This symbol "A" is shifted in the state of forming the pair with the Purged state.

The compression unit 20c does not perform table search of the table T3, and the table search result becomes a miss. As a result, hit information (miss) is sent from each compression unit 20 to the global latch control unit 50. For this reason, all the control signals for the next cycle, which are sent from the global latch control unit 50, become Latch.

In the cycle illustrated in Fig. 25, the original symbol "A" is maintained in the latch 28 at the tail end of the original symbol pipeline (Valid = 1 of the latch 28). On the other hand, the latch 26 at the tail end of the compressed symbol pipeline is empty (Valid and Purged = 0 of the latch 26). In this case, the output unit 40 selects the original symbol "A" as an output and outputs (4, A), that is, the symbol "A" and CMark = 4 representing that this symbol is non-compressed as the output of the compression device 100.

Fig. 26 is a diagram illustrating an operation in the next cycle of the cycle illustrated in Fig. 25. In this cycle, the next symbol "A" is input to the compression unit 10. In the pipeline of the original symbol, an original symbol string "BCDABCD (in the order of input)" is maintained in respective latches 28 of L1 to L7. In the compression unit 10, the table search result of the symbol "A" becomes a hit. As a result, the symbol "A" is registered in the highest-level entry of the table T0.

The compression unit 20a takes the compressed symbol 11 and CMark = 0 of the table T0 into the latch 26 in accordance with the control signal Latch received in the previous cycle. In addition, the compression unit 20a takes the T0 compressed symbol "11" into the latch 27. The compression unit 20a performs table search for a symbol string "CD". The table search result becomes a hit, and the symbol "CD" is registered in the highest-level entry of the table T1.

The compression unit 20b takes the compressed symbol "11" and CMark = 0 from the compression unit 20a into the latch 26 in accordance with the control signal Latch received in the previous cycle. In addition, the compression unit 20b takes the table T0 compressed symbol "11" into the latch 27. Furthermore, in the compression unit 20b, since the matching register 21 does not become full, a table search is not performed, and the table search result becomes a miss.

The compression unit 20c takes the compressed symbol "01" and CMark = 1 from the compression unit 20b into the latch 26 in accordance with the control signal Latch received in the previous cycle. As a result, the compressed symbol "01" and CMark = 1 maintained in the latch 26 (L2) are brought into a state of forming a pair with the original symbol "C" maintained in the latch 28 (L2). Since the contents maintained in the latches 26 and 28 are shifted to the output side by one in one cycle, they are eventually maintained in the latches 26 and 28 of L7. In a case in which the compressed symbol is maintained in the latch 26 (Valid = 1 and Purged = 0 of the latch 26), the output unit 40 outputs the content of the latch 26, and thus the compressed symbol "01" and CMark = 1 are output, while the output of the original symbol "C" that is the origin of the compressed symbol is blocked.

By using the control signal Hit, the compressed symbol obtained in the previous stage is taken into the compressed symbol pipeline, and the output of the compressed symbol and the output blocking of the corresponding original symbol can be performed in the same cycle. In this cycle, since the matching register 21 of the compression unit 20c does not become full, the table search result of the table T3 becomes a miss.

The latch adjustment unit 31a (L4) takes in the Purged state of the previous stage (L3). As a result, the Purged state of the latch 26 is brought into a state of forming a pair with the original symbol "A" maintained in the latch 28 (L4), and this pair is finally input to the output unit 40. The output unit 40 does not perform an output in a cycle in which the Purged state is set. Thus, the output of the original symbol "A" that is the origin of the compressed symbol "01" is blocked. Purged is used to block the output of a symbol that is the origin of a compressed symbol.

In the cycle illustrated in Fig. 26, the original symbol "B" (Valid = 1 of the original symbol latch) is maintained in the latch 28 at the tail end of the original symbol pipeline. On the other hand, the latch 26 at the tail end of the compressed symbol pipeline is empty (Valid and Purged = 0). In this case, the output unit 40 outputs the original symbol "B" and CMark = 4 representing non-compression as outputs of the compression device 100.

Fig. 27 is a diagram illustrating an operation in the next cycle of the cycle illustrated in Fig. 26. In this cycle, the next symbol "B" is input to the compression unit 10. In the pipeline of the original symbol, the original symbol string "CDABCDA (in the order of input)" is maintained in respective latches 28 of L1 to L7 by shift. The compression unit 10 performs a table search for the symbol "B", and the result becomes a hit. In accordance with this, the symbol "B" is registered in the highest-level entry of the table T0.

The compression unit 20a takes the compressed symbol 11 and CMark = 0 into the latch 26 in accordance with the control signal Latch received in the previous cycle. In addition, the compression unit 20a takes the T0 compressed symbol "11" into the latch 27. In the compression unit 20a, since the matching register 21 does not become full, the table search result becomes a miss.

The compression unit 20b takes the table hit input (the compressed symbol "01" and CMark = 1 of the table T1) into the latch 26 in accordance with the control signal Hit received in the previous cycle. In addition, the compression unit 20b takes the table T0 compressed symbol "11" into the latch 27. Furthermore, in the compression unit 20b, since the matching register 21 does not become full, the table search result becomes a miss.

The compression unit 20c sets the state Purged of the latch 26 in accordance with the control signal Purge of the previous cycle. In addition, in the compression unit 20c, since the matching register 21 does not become full, the table search result becomes a miss.

The latch adjustment units 31a to 31d take the contents (including the Purged state) of the latch 26 of the previous stage into the latch 26. The output unit 40 outputs the original symbol "C" and CMark = 4 representing non-compression as outputs of the compression device 100.

Fig. 28 is a diagram illustrating an operation in the next cycle of the cycle illustrated in Fig. 27. In this cycle, the next symbol "C" is input to the compression unit 10. In the original symbol pipeline, the original symbol string "DABCDAB (in the order of input)" is brought into a state of being maintained in the latches 28 of L1 to L7 by shift. The table search result of the symbol "C" in the compression unit 10 becomes a hit. For this reason, the symbol "C" is registered in the highest-level entry of the table T0.

The compression unit 20a takes the compressed symbol 11 and CMark = 0 into the latch 26 in accordance with the control signal Latch received in the previous cycle. In addition, the compression unit 20a takes the T0 compressed symbol "11" into the latch 27. In the compression unit 20a, the matching register 21 becomes full, a table search for the symbol string "AB" is performed, and the table search result becomes a hit.

The compression unit 20b takes the compressed symbol "11" and CMark = 0 of the table T1 into the latch 26 in accordance with the control signal Latch received in the previous cycle. In addition, the compression unit 20b takes the table T0 compressed symbol "11" into the latch 27. Furthermore, in the compression unit 20b, the matching register 21 becomes full, and a table search for the symbol string "CDA" is performed, but the table search result becomes a miss. The symbol string "CDA" is registered in the highest-level entry of the table T1.

The compression unit 20c takes the compressed symbol "01" and CMark = 1 into the latch 26 in accordance with the control signal Latch received in the previous cycle. In the compression unit 20c, the matching register 21 becomes full, a table search for the symbol string "ABCD" is performed, and the result becomes a hit. At this time, the process illustrated in Fig. 15 is performed, and as a result, in order to avoid the purge of the compressed symbol stored in the latch 26 (L5), the result of the hit is changed to a miss.

The latch adjustment unit 31 having the latches 26 (L4 to L7) of the compressed symbol pipeline takes the maintained content of the latch 26 of the previous stage into the latch 26 in accordance with the control signal Latch received in the previous cycle. In addition, the output unit 40 outputs the original symbol "D" and CMark = 4 representing non-compression as outputs of the compression device 100.

Fig. 29 is a diagram illustrating an operation in the next cycle of the cycle illustrated in Fig. 28. In this cycle, the next symbol "A" is input to the compression unit 10. In the previous cycle, the symbol "A" is registered in the entry of the index "10" of the table T0 (Fig. 28). For this reason, the search result of the table T0 becomes a hit, and the symbol "A" is registered in the highest-level entry of the table T0.

In the original symbol pipeline, by shift, the original symbol string "(ABCDABC (in the order of input)" is brought into a state of being maintained in respective latches 28 of L1 to L7. As a result, all the search results (hit information) of the tables T1, T2, and T3 in the compression units 20a, 20b, and 20c become a miss, and all the control signals for the next cycle supplied from the global latch control unit 50 become Latch.

The symbol "A" is maintained in the latch 28 (L7) at the tail end of the original symbol pipeline, but the state of the latch 26 (L7) at the tail end of the compressed symbol pipeline is the Purged state. For this reason, the output unit 40 does not perform an output in this cycle.

Fig. 30 is a diagram illustrating an operation in the next cycle of the cycle illustrated in Fig. 29. In this cycle, the next symbol "B" is input to the compression unit 10. The search result of the table T0 in the compression unit 10 becomes a hit, and the symbol "B" that is a search target is registered in the highest-level entry of the table T0.

In the original symbol pipeline, the original symbol string "BCDABCA (in the order of input)" is brought into a state of being maintained in the latches 28 (L1 to L7). As a result, all the table search results (hit information) in the compression units 20a, 20b, and 20c (tables T1, T2, and T3) become a miss, and all the control signals for the next cycle for the compression latches L1 to L7 supplied from the global latch control unit 50 become Latch.

The symbol "B" is maintained in the latch 28 (L7) at the tail end of the original symbol pipeline, and the compressed symbol "01" and CMark = 1 are maintained in the latch 26 (L7) at the tail end of the compressed symbol pipeline. The output unit 40 outputs the compressed symbol "01" and CMark = 1.

Fig. 31 is a diagram illustrating an operation in the next cycle of the cycle illustrated in Fig. 30. The operation in this cycle is substantially the same as the operation in the previous cycle. However, since the state of the latch 26 (L7) is the Purged state, the output unit 40 does not perform an output.

Fig. 32 is a diagram illustrating an operation in the next cycle of the cycle illustrated in Fig. 31. The operation in this cycle is substantially the same as the operation in the previous cycle. The output unit 40 outputs the compressed symbol "01" and CMark = 1.

Fig. 33 is a diagram illustrating an operation in the next cycle of the cycle illustrated in Fig. 32. The operation in this cycle is substantially the same as the operation in the previous cycle. However, since the state of the latch 26 (L7) is the Purged state, the output unit 40 does not perform an output.

Fig. 34 is a diagram illustrating an operation in the next cycle of the cycle illustrated in Fig. 33. The operation of the compression unit 20a in this cycle is substantially the same as the operation in the previous cycle. The table search results (hit information) in the compression units 20a, 20b, and 20c (tables T1, T2, and T3) respectively become a hit, a hit, and a miss. As a result, the control signals "Latch, Empty, Hit, Purge, Purge, Latch, Latch" are supplied from the global latch control unit 50 for the latches L1 to L7 in the next cycle. The control signal Empty instructs that, in a case in which the control of the latch 26 of the compressed symbol is Valid, the T0 compressed symbol in the immediately preceding compression unit 20 is set. In the example illustrated in Fig. 34, it means that the maintained content "10" of the latch 27 of the compression unit 20a is taken into the latch 26 of the compression unit 20b in the next cycle. The output unit 40 outputs the compressed symbol "01" and CMark = 1.

Fig. 35 is a diagram illustrating an operation in the next cycle of the cycle illustrated in Fig. 34. In this cycle, the symbol "D" is input to the compression unit 10. The search result of the table T0 in the compression unit 10 becomes a hit, and the symbol "D" that is a search target is registered in the highest-level entry of the table T0.

The compression unit 20b takes the T0 compressed symbol of the latch 27 in the compression unit 20a into the latch 26 in accordance with the control signal Empty. In addition, the compression unit 20c takes the compressed symbol "00" and CMark = 2 obtained by the compression unit 20b into the latch 26 in accordance with the control signal Hit. In the original symbol pipeline, the original symbol string "CABCABC" is brought into a state of being maintained in the latches 28 (L1 to L7). As a result, all the table search results (hit information) in the compression units 20a, 20b, and 20c (tables T1, T2, and T3) become a miss, and all the control signals for the compression latches L1 to L7 in the next cycle supplied from the global latch control unit 50 become Latch.

The symbol "C" is maintained in the latch 28 (L7) at the tail end of the original symbol pipeline, and the compressed symbol "11" and CMark = 0 are maintained in the latch 26 (L7) at the tail end of the compressed symbol pipeline. The output unit 40 outputs the compressed symbol "11" and CMark = 0.

Fig. 36 is a diagram illustrating an operation in the next cycle of the cycle illustrated in Fig. 35. In this cycle, since there is no input of a symbol, the table search result of the compression unit 10 becomes a miss. As a result, the value of Valid transmitted to the compression unit 20a becomes "0". The table search results (hit information) in the compression units 20a, 20b, and 20c (tables T1, T2, and T3) respectively become "hit, miss, miss", and the control signals "Latch, Hit, Purge, Latch, Latch, Latch, Latch" for the latches L1 to L7 in the next cycle in accordance with these are supplied from the global latch control unit 50. The output unit 40 outputs the compressed symbol "10" and CMark = 0.

Figs. 37 to 42 are diagrams illustrating operations in each cycle after the cycle illustrated in Fig. 36. In these cycles, the maintained contents of the latch 28 of the original symbol pipeline and the latch 26 of the compressed symbol pipeline are shifted every cycle. Then, the output unit 40 performs an output on the basis of Valid of the latch 28 (L7) and Valid and Purged of the latch 26 (L7).

In this operation example, two continuous symbols or three continuous symbols are converted into one compressed symbol (2 bits). In a case in which 18 symbols forming the input symbol string in the operation example are 8-bit ASCI codes, the input symbol string becomes 18 x 8 = 144 bits. The CMark can be composed of 3 bits.

As for the output of the compression device 100 in this operation example, the output of non-compression (the original symbol) is 4 times, and the number of bits of these and the number of bits of CMark become (3 + 8) x 4 = 44 bits. On the other hand, the output of the compressed symbol is 8 times, and the number of bits of the compressed symbol (2 bits) and the CMark becomes (3 + 2) x 8 = 40 bits, and the sum of these is 84 bits. Thus, a compression ratio of 84/144 = 58% is achieved.

The information in the table of latch control illustrated in Fig. 13 may be stored in advance, or may be generated in real time on the basis of a certain algorithm. In addition, in a case in which the number of tables is 6 or more, there are a plurality of patterns of latch control outputs, but any one of them may be used. According to the compression device 100, one or two or more symbols can be compressed into a bit string (compressed symbol) equal to or less than the number of bits thereof.

Here, the relation between the number of tables in the compression device based on the increment scheme, the number of symbols handled by each table (the number of symbols registered in one entry), and an offset number will be described. An offset of the number of symbols handled by each table in accompaniment of an increase in the number of tables is defined as an offset. In addition, a sum of all the tables including the table T0 is defined as N. Parameters of the increment scheme in this case are as follows.

The number of symbols S(n) handled by the table Tn (n=0, 1, 2, 3 ..., N-1) = 1+n×offset

As for the total number Na of adjustment latches (the number of latches 26 and 28 included in the adjustment unit 30), since the last table T(N-1) handles the longest symbol string, the number of adjustment latches equal to the length of the symbol string is required (in order to detect a conflict, it is necessary to maintain preceding symbols corresponding to the length of the symbol string handled by the table T(N-1)). In other words, the total number Na is obtained using the following equation. $Na = 1 + \left(N-1\right) \times offset$

### <Decompression Device>

Next, an embodiment of a decompression device that decompresses the output from the compression device 100 will be described. Fig. 43 is a diagram illustrating a configuration example of the decompression device 300. In Fig. 43, the decompression device 300 includes a separation unit (also denoted as demultiplexer: DMUX) 301, and decompression units 310a, 310b, 310c, and 310d. The decompression unit 310a has a restoration table T0 corresponding to the table T0 that the compression device 100 has. The decompression unit 310b has a restoration table T1 corresponding to the table T1 that the compression device 100 has. The decompression unit 310c has a restoration table T2 corresponding to the table T2 that the compression device 100 has. The decompression unit 310d has a restoration table T3 corresponding to the table T3 that the compression device 100 has. In the following description, in a case in which the decompression units 310a, 310b, 310c, and 310d are not to be distinguished from each other, they are referred to as the decompression unit 310. The decompression unit 310a corresponds to a first decompression unit, and the decompression units 310b to 310d correspond to second decompression units.

A compressed data stream that is an output from the compression device 100 is input to the decompression device 300. The compressed data stream is a data stream (bit string) in which each output (a symbol and a CMark) of the compression device 100 is serially connected. In the decompression device 300, the CMark and the number of bits are self-evident (known), and the CMark can be cut out from the compressed data stream. The decompression device 300 can distribute the CMark to each decompression unit 310. Each decompression unit 310 determines an operation mode in accordance with the value of the CMark (to be described below). In addition, since the numbers of bits of the original symbol and the compressed symbol are also known in the decompression device 300, the decompression device 300 can cut out the original symbol or the compressed symbol from the compressed data stream on the basis of the value of CMark. In other words, in a case in which CMark = 4, bits corresponding to the number of bits of the original symbol are cut out from the compressed data stream. On the other hand, in a case in which CMark = 0 to 3, bits corresponding to the number of bits of the compressed symbol are cut out from the compressed data stream. The original symbol and the compressed symbol that have been cut out become inputs to the DMUX 301.

A symbol (a compressed symbol or an original symbol) is input to an input terminal of the DMUX 301, and the CMark corresponding to the symbol is input to a control terminal of the DMUX 301. The DMUX 301 has two output terminals, one output terminal is connected to a compressed symbol bus 302, and the other output terminal is connected to an original symbol bus 303 (corresponding to the second bus; hereinafter, denoted as bus 303). In a case in which the value of the CMark is 1 to 3, the DMUX 301 outputs the compressed symbol to the compressed symbol bus 302 (corresponding to a first bus; hereinafter, denoted as bus 302). The CMark is given to the decompression units 310a to 310d, and is handled as information representing the decompression unit 310 of the destination. However, a configuration in which information other than the CMark is output from the DMUX 301 and the decompression unit 310 of the destination is identified may be employed. On the other hand, in a case in which the value of the CMark is 4, in other words, in a case in which it is information representing non-compression, the original symbol is sent out from the DMUX 301 to the bus 303. In addition, CMark = 4 is given to the decompression units 310a to 310d.

The decompression unit 310 includes a non-compressed symbol register 312 (hereinafter, simply referred to as a register 312) and a First-In-First-Out (FIFO) 313 that operates as a hit symbol register. The register 312 corresponds to a first register, and the FIFO 313 corresponds to a second register. The register 312 takes in an original symbol flowing through the bus 303 and registers it in the restoration table. Registration to the table is performed using the same method as the method illustrated in Fig. 7. The registration is performed sequentially from the highest-level entry (an entry with the smallest index value) of the restoration table. The decompression unit 310 performs a table search (matching) of the compressed symbol flowing through the bus 302. In the table search, the compressed symbol is used as an index of the restoration table. In a case in which a symbol or a symbol string is registered in the entry specified by the index, it becomes a hit, and in a case in which it is not registered, it becomes a miss. However, unless the compressed symbol (data) is corrupted, the table search result always becomes a hit. In a case in which the table search result is a hit, the symbol or the symbol string registered in the hit entry is output to the FIFO 313.

The decompression unit 310 operates in two operation modes. One of the operation modes (a first mode) is a table search mode in a case of decompressing a compressed symbol. The other operation mode (a second mode) is a mode in which an original symbol is sent out to the bus 303, or an original symbol is received from the bus 303. In a case in which the CMark is received, the decompression unit 310 determines to operate in the first mode in a case in which the value of the CMark matches the table included therein and determines to operate in the second mode otherwise. The tables T0 to T3 respectively match values 0 to 3 of the CMark, and for example, in a case in which the CMark = 1, the decompression unit 310b having the table T1 operates in the first mode.

Each of the decompression units 310a to 310d is connected to the bus 302 and the bus 303 and includes a restoration table, a register 312, and a FIFO 312. In the restoration table T0 that the decompression unit 310a has, a single symbol is registered in an entry. In the restoration table T1 that the decompression unit 310b has, a symbol string formed using two symbols is registered in an entry. In the restoration table T2 that the decompression unit 310c has, a symbol string formed using three symbols is registered in an entry. In the restoration table T3 that the decompression unit 310d has, a symbol string formed using four symbols is registered in an entry. In the example illustrated in Fig. 46, the number N of restoration tables is 4, and the restoration tables T0 to T(N-1) are included. In addition, although the number of entries of each restoration table is 4, the number of entries is arbitrary.

In a cycle in which the original symbol is output from the DMUX 301 to the bus 303, the original symbol output from the DMUX 301 becomes the output of the decompression device 300. In addition, in this cycle, each of the decompression units 310a to 310d operates in the second mode and takes the original symbol from the original symbol bus 303 into the register 312. When the register 312 becomes full, the maintained content of the register 312 is registered in the restoration table.

On the other hand, in a cycle in which the compressed symbol is output from the DMUX 301 to the bus 302, any one of the decompression units 310a to 310d designated by the CMark operates in the first mode (a table search mode), and the remaining decompression units 310 operate in the second mode. In the first mode, the decompression unit 310 uses the compressed symbol as an index of the restoration table and takes out one or two or more original symbols registered in the entry specified by the index as original symbols or an original symbol string, thereby restoring the compressed symbol to the original symbol. The one or two or more original symbols obtained through restoration are written to the FIFO 312 and are sent out to the bus 303 one symbol by one symbol in each cycle. The original symbol sent out from the decompression unit 310 to the bus 303 becomes the output of the decompression device 300 in that cycle. In addition, the original symbol sent out from the decompression unit 310 to the bus 303 is taken (distributed) into the decompression unit 310 operating in the second mode in the cycle in which the sending out is performed and is finally registered in the restoration table.

Fig. 43 illustrates, as an example, a cycle in which the compressed symbol "00" is input to the input terminal of the DMUX 301, and CMark = 2 is input to the control terminal. In this case, the compressed symbol "00" is output to the compressed symbol bus 302 with the decompression unit 310c (the restoration table T2) specified by the CMark = 2 as a destination. In accordance with this, the decompression unit 310c operates in the first mode, and the remaining decompression units 310 operate in the second mode. The decompression unit 310 takes out "CDA" registered in the entry of the index "00" as an original symbol string by using the compressed symbol "00" as an index value. Of the original symbol string "CDA", the leading "C" is output to the FIFO 313 and is sent out to the original symbol bus 303. As a result, the output of the decompression device 300 in this cycle becomes the symbol "C".

Fig. 44 is a flowchart illustrating a process example of the decompression unit 310 configuring the decompression device 300. At a time point of the start of the process illustrated in Fig. 44, the decompression device 300 is in an enable state in which the input of the symbol and the CMark can be made, and a Busy output becomes active during the operation (in use) of the decompression device 300.

In Step S101, the decompression unit 310 determines whether or not there is an input to the bus 302 (an output from the DMUX 301). In a case in which it is determined that there is an input, the process proceeds to Step S102, and otherwise, the process returns to Step S101.

In Step S102, the decompression unit 310 receives CMark input to the decompression device 300 and determines whether or not the CMark designates itself or the restoration table that it has. More specifically, when CMark = 1, the decompression unit 310b (the restoration table T1) is designated. When CMark = 2, the decompression unit 310c (the restoration table T2) is designated. When CMark = 3, the decompression unit 310d (the restoration table T3) is designated. In a case in which CMark = 4, it means that none of the decompression units 310a to 310d are designated.

In a case in which it is determined that the CMark designates itself (Yes in S102), the decompression unit 310 causes the process to proceed to Step S103, and otherwise, causes the process to proceed to Step S108.

In a case in which the process proceeds to Step S103, the decompression unit 310 operates in the first mode. In other words, the decompression unit 310 performs a table search using the compressed symbol taken from the compressed symbol bus 302 as an index of the restoration table. In accordance with the table search, the entry corresponding to the index is hit.

In Step S104, the decompression unit 310 sets the content (two or more original symbols) registered in the hit entry to the FIFO 313.

In Step S105, the decompression unit 310 determines whether or not the FIFO 313 is empty. In a case in which it is determined that the FIFO 313 is empty, the process proceeds to Step S107, and otherwise, the process proceeds to Step S106.

In Step S106, the decompression unit 310 performs shifting by the number of bits set in the FIFO 313, that is, by the number of bits of two or more original symbols read from the restoration table. In accordance with the shift, two or more original symbols read from the restoration table are sent out to the original symbol bus 303. Then, when the FIFO 13 becomes empty (Yes in S105), the process proceeds to Step S107.

In Step S107, it is determined whether or not the operation of the decompression unit 310 needs to be ended in accordance with an end operation or the like. In a case in which it is determined that the operation needs to be ended, an end process of the process such as changing the decompression unit 310 to an inactive state is performed. On the other hand, in a case in which it is not determined that the operation needs to be ended, the process returns to Step S101 and enters a state of waiting for the next input.

Figs. 45 to 62 are diagrams illustrating an operation example of the decompression device 300. The output from the compression device 100 is input to the decompression device 300. Fig. 45 is a diagram illustrating an operation in a case in which a first input (4, A), that is, CMark = 4 and the symbol "A" are input to the DMUX 301. Since CMark = 4, the DMAX 301 outputs the symbol "A" to the original symbol bus 303 (hereinafter, denoted as the bus 303). The symbol "A" becomes the output of the decompression device 300.

Each of the decompression units 310a to 310d takes the symbol "A" flowing through the bus 303 into the register 312. Here, each decompression unit 310, for example, has a configuration of monitoring the bus 303, detecting the symbol flowing through the bus 303, and taking the detected symbol into the register 312.

In the decompression unit 310a, since the register 312 becomes full, the content of the register 312 is registered in the restoration table T0. At this time, the decompression unit 310a performs a table update of the restoration table using a technique similar to that of the compression unit 20 (see Fig. 7). In other words, the decompression unit 310a performs a table search of the restoration table with the maintained content of the register 312 as a search target and, in a case in which the table search result is a hit, registers the content in the highest-level entry (index "00") and, in the case of a miss, registers the content in the highest-level entry. The decompression units 310b to 310d also perform processes similar thereto. Thus, the symbol "A" is registered in the highest-level entry of the restoration table T0 of the decompression unit 310a. On the other hand, the decompression units 310b to 310d are also in a state of having taken the symbol "A" into the register 312.

Fig. 46 is a diagram illustrating an operation in a case in which an output (4, B) of the next compression device 100 is input to the decompression device 300. The DMAX 301 and the decompression units 310a to 310d perform substantially the same operations as those at the time of the previous input. In other words, the decompression units 310a to 310d take a symbol "B" flowing through the bus 303 into the register 312. The symbol "B" becomes the output of the decompression device 300.

In the decompression unit 310a, since the register 312 becomes full, a table search is performed, and the result becomes a miss. For this reason, the decompression unit 310a registers the symbol "B" in the highest-level entry of the restoration table T0 and registers the symbol "A" in the entry one level below from the highest level. Since the register 312 becomes full also in the decompression unit 310b, a table search is performed, and the result becomes a miss. As a result, the symbol string "AB" is registered in the highest-level entry of the restoration table T1.

Fig. 47 is a diagram illustrating an operation in a case in which an output (4, C) of the next compression device 100 is input to the decompression device 300. The DMAX 301 and the decompression units 310a to 310d perform substantially the same operations as those at the time of the previous input. In other words, the decompression units 310a to 310d take a symbol "C" flowing through the bus 303 into the register 312. The symbol "C" becomes the output of the decompression device 300.

In the decompression unit 310a, since the register 312 becomes full, a table search is performed, but the result becomes a miss. The decompression unit 310a registers the symbol "C" in the highest-level entry of the restoration table T0 and registers symbols "B" and "A" in respective entries one level below. Since the register 312 becomes full also in the decompression unit 310c, a table search is performed, and the result becomes a miss. As a result, the symbol string "ABC" is registered in the highest-level entry of the restoration table T2.

Fig. 48 is a diagram illustrating an operation in a case in which an output (4, D) of the next compression device 100 is input to the decompression device 300. The DMAX 301 and the decompression units 310a to 310d perform substantially the same operations as those at the time of the previous input. In other words, the decompression units 310a to 310d take a symbol "D" flowing through the bus 303 into the register 312. The symbol "D" becomes the output of the decompression device 300.

In the decompression unit 310a, since the register 312 becomes full, a table search is performed, but the result becomes a miss. The decompression unit 310a registers the symbol "D" in the highest-level entry of the restoration table T0 and registers symbols "C", "B", and "A" in respective entries one level below. Since the register 312 becomes full in the decompression unit 310b, a table search is performed, and the result becomes a miss. As a result, a symbol string "CD" is registered in the highest-level entry of the restoration table T1, and a symbol string "AB" moves to the entry one level below from the highest level. In addition, since the register 312 becomes full also in the decompression unit 310d, a table search is performed, and the result becomes a miss. As a result, a symbol string "ABCD" is registered in the highest-level entry of the restoration table T3.

Figs. 49 and 50 are diagrams illustrating an operation in a case in which an output (1, 01) of the next compression device 100 is input to the decompression device 300. The DMAX 301 outputs CMark = 1 and the compressed symbol "01" to the bus 302. The decompression unit 310b determines that CMark = 1 designates the decompression unit 310b itself (the restoration table T1), and operates in the first mode. The remaining decompression units 310 operate in the second mode. The decompression unit 310b uses the compressed symbol "01" as an index of the restoration table T1, takes out a symbol string "AB" registered in the entry of the index "01", and writes it in the FIFO 313. The hit entry (the symbol "AB") moves to the highest-level entry of the restoration table T1, and the symbol "CD" moves to the entry one level below from the highest level. The FIFO 313 outputs the symbol "A" to the bus 303. In accordance with this, the symbol "A" is output as the output of the decompression device 300. In addition, the decompression units 310a, 310c, and 310d operating in the second mode take the symbol "A" from the bus 303 into the register 312. At this time, since the register 312 of the decompression unit 310a becomes full, a table search is performed, and the result becomes a hit. Thus, the symbol "A" is registered in the highest-level entry, and the symbols "D", "C", and "B" move to positions one level below.

In Fig. 50, the decompression unit 310b sends out the symbol "B" following the symbol "A" from the FIFO 313 to the bus 303. In this way, the original symbol is sent out in units of the original symbol. The decompression units 310a, 310c, and 310d operating in the second mode take the symbol "B" from the bus 303 into the register 312. At this time, since the register 312 of the decompression unit 310a becomes full, a table search is performed, and the result becomes a hit. Thus, the symbol "B" is registered in the highest-level entry, and the symbols "A", "D", and "C" move to positions one level below. In addition, since the register 312 of the decompression unit 310c becomes full, a table search is performed, and the result becomes a hit. Thus, the symbol string "DAB" is registered in the highest-level entry of the restoration table T2, and the symbol string "ABC" moves to a position one level below.

Figs. 51 and 52 are diagrams illustrating an operation in a case in which an output (1, 01) of the next compression device 100 is input to the decompression device 300. The DMAX 301 outputs CMark = 1 and the compressed symbol "01" to the bus 302. In accordance with this, the decompression unit 310b operates in the first mode. The remaining decompression units 310 operate in the second mode.

The decompression unit 310b uses the compressed symbol "01" as an index of the restoration table T1, takes out the symbol string "DC" registered in the entry of the index "01", and writes it in the FIFO 313. The hit entry (the symbol "DC") moves to the highest-level entry of the restoration table T1, and the symbol "AB" moves to the entry one level below from the highest level. The FIFO 313 outputs the symbol "C" to the bus 303. In accordance with this, the symbol "C" is output as the output of the decompression device 300. In addition, the decompression units 310a, 310c, and 310d operating in the second mode take the symbol "C" from the bus 303 into the register 312. At this time, since the register 312 of the decompression unit 310a becomes full, a table search is performed, and the result becomes a hit. Thus, the symbol "C" is registered in the highest-level entry, and the symbols "B", "A", and "D" move to positions one level below.

In Fig. 52, the decompression unit 310b sends out a symbol "D" following the symbol "C" from the FIFO 313 to the bus 303. The symbol "D" becomes the output of the decompression device 300. The decompression units 310a, 310c, and 310d operating in the second mode take the symbol "D" from the bus 303 into the register 312. At this time, since the register 312 of the decompression unit 310a becomes full, a table search is performed, and the result becomes a hit. Thus, the symbol "D" is registered in the highest-level entry, and the symbols "C", "B", and "A" move to positions one level below. In addition, since the register 312 of the decompression unit 310d becomes full, a table search is performed, and the result becomes a miss. Thus, the symbol string "ABCD" is registered in the highest-level entry of the restoration table T2.

Figs. 53 and 54 are diagrams illustrating an operation in a case in which an output (1, 01) of the next compression device 100 is input to the decompression device 300. The operation at this time is substantially the same as the operation illustrated in Figs. 46 and 47, and the symbol string "AB" hit in the restoration table T1 of the decompression unit 310b is set in the FIFO 313 and is output to the bus 303. Then, the symbols "A" and "B" become the outputs of the decompression device 300. Then, in accordance with the output of the symbol "B" to the bus 303, the registered contents of the restoration tables T0 to T3 become as illustrated in Fig. 54.

Fig. 55 is a diagram illustrating an operation in a case in which an output (0, 11) of the next compression device 100 is input to the decompression device 300. The DMAX 301 outputs CMark = 0 and the compressed symbol "11" to the bus 302. In accordance with this, the decompression unit 310a operates in the first mode. The remaining decompression units 310 operate in the second mode.

The decompression unit 310a uses the compressed symbol "11" as an index of the restoration table T0 and writes the symbol "D" registered in the entry of the index "11" in the FIFO 313. The hit entry (symbol "C") moves to the highest-level entry of the restoration table T0, and the symbol "BAD" moves to the entry one level below from the highest level. The FIFO 313 outputs the symbol "C" to the bus 303. In accordance with this, the symbol "C" is output as the output of the decompression device 300. In addition, the decompression units 310b, 310c, and 310d operating in the second mode take the symbol "C" from the bus 303 into the register 312.

Fig. 56 is a diagram illustrating an operation in a case in which an output (0, 10) of the next compression device 100 is input to the decompression device 300. The operation at this time is substantially the same as the operation illustrated in Fig. 55. The decompression unit 310a uses the compressed symbol "10" as an index of the restoration table T0 and writes the symbol "A" registered in the entry of the index "10" in the FIFO 313. The symbol "A" moves to the highest-level entry of the restoration table T0, and symbols "C", "B", and "D" move to the entry one level below. The FIFO 313 outputs the symbol "A" to the bus 303. In accordance with this, the symbol "A" is output as the output of the decompression device 300. In addition, the decompression units 310b, 310c, and 310d operating in the second mode take the symbol "A" from the bus 303 into the register 312. At this time, a table search is performed in each of the decompression units 310b, 310c, and 310d, and the result becomes a hit. For this reason, the registration contents of the restoration tables T1 to T3 become as illustrated in Fig. 56.

Figs. 57, 58, and 59 are diagrams illustrating an operation in a case in which an output (2, 00) of the next compression device 100 is input to the decompression device 300. The DMAX 301 outputs CMark = 2 and the compressed symbol "00" to the bus 302. In accordance with this, the decompression unit 310c operates in the first mode. The remaining decompression units 310 operate in the second mode.

The decompression unit 310c uses the compressed symbol "00" as an index of the restoration table T2, takes out the symbol string "BCA" registered in the entry of the index "00", and writes it in the FIFO 313. The hit symbol "BCA" moves to the highest-level entry of the restoration table T2, and symbol strings "CDA", "DAB", and "ABC" move to the entry one level below from the highest level. The FIFO 313 outputs the symbol "B" to the bus 303. In accordance with this, the symbol "B" is output as the output of the decompression device 300. In addition, the decompression units 310a, 310b, and 310d operating in the second mode take the symbol "B" from the bus 303 into the register 312. As a result, the registered content of the restoration table T0 becomes as illustrated in Fig. 57.

In Fig. 58, the symbol "C" is sent out to the bus 303 following the symbol "B" from the FIFO 313 of the decompression unit 310b. The symbol "C" becomes the output of the decompression device 300. The decompression units 310a, 310b, and 310d take the symbol "C" from the bus 303 into the register 312. At this time, the registers 312 of the decompression units 310a and 310b become full, a table search is performed, and each of the restoration tables T0 and T1 is updated.

In Fig. 59, the symbol "A" is sent out to the bus 303 following the symbol "C" from the FIFO 313 of the decompression unit 310b. The symbol "A" becomes the output of the decompression device 300. The decompression units 310a, 310b, and 310d take the symbol "A" from the bus 303 into the register 312. At this time, since the register 312 of the decompression unit 310a becomes full, a table search is performed, and the restoration table T0 is updated.

Fig. 60 is a diagram illustrating an operation in a case in which an output (0, 10) of the next compression device 100 is input to the decompression device 300. In this case, the decompression unit 310a operates in the first mode, and the remaining decompression units 310 operate in the second mode. The decompression unit 310a uses the compressed symbol "10" as an index of the restoration table T0, takes out the symbol "B" registered in the entry of the index "10", and writes it in the FIFO 313. The symbol "B" moves to the highest-level entry of the restoration table T0, and the symbols "A", "C", and "D" move to the entry one level below. The FIFO 313 outputs the symbol "B" to the bus 303. The symbol "B" becomes the output of the decompression device 300. In addition, the decompression units 310b, 310c, and 310d operating in the second mode take the symbol "B" from the bus 303 into the register 312. As a result, the registered contents of the restoration tables T1 and T3 are updated as illustrated in Fig. 60.

Figs. 61 and 62 are diagrams illustrating an operation in a case in which an output (1, 11) of the next compression device 100 is input to the decompression device 300. In this case, the decompression unit 310b operates in the first mode, and the remaining decompression units 310 operate in the second mode. The decompression unit 310b takes out a symbol string "DC" corresponding to the compressed symbol "11" from the restoration table T1 and writes it in the FIFO 313. The symbol string "DC" moves to the highest-level entry of the restoration table T1, and symbol strings "AB", "BC", and "CA" move to the entry one level below. The FIFO 313 outputs the symbol "C" to the bus 303, and the symbol "C" becomes the output of the decompression device 300. In addition, the decompression units 310a, 310c, and 310d operating in the second mode take the symbol "C" from the bus 303 into the register 312. As a result, the registered content of the restoration table T2 is updated as illustrated in Fig. 61.

In Fig. 62, the symbol "D" is sent out to the bus 303 following the symbol "C" from the FIFO 313 of the decompression unit 310b. The symbol "D" becomes the output of the decompression device 300. The decompression units 310a, 310c, and 310d take the symbol "D" from the bus 303 into the register 312. In accordance with this, the restoration table T0 is updated. The output of the decompression device 300 becomes a symbol string "ABCDABCDABCABCABCD", and the symbol string input to the compression device 100 is restored.

According to the decompression device 300, by receiving the output of the compression device 100, a compressed symbol in which two or more symbols are compressed can be restored to the two or more original symbols (a symbol string). In other words, a bit string (a compressed symbol) in which one or two or more symbols are compressed to the number of bits or less can be returned to the original one or two or more symbols.

### [Second Embodiment]

A compression device and a decompression device according to a second embodiment will be described. The description of the same configuration as the first embodiment will be omitted, and differences will be mainly described.

### <Entropy Calculation>

An entropy calculation can be applied to the compression device 100 as an option. Fig. 63 is an explanatory diagram of an entropy calculation. The number of bits of the index of the table used as a compressed symbol in the compression device 100 can be reduced by the entropy calculation described below. An entropy value m can be obtained using calculation equation "entropy value m = ceil(log₂k)" by using the number of entries k occupying the table (used for maintaining a symbol or a symbol string).

For example, as illustrated in Fig. 63, a case in which the index of the table used for a compression operation is configured by 4 bits is assumed. In a case in which a certain original symbol "B" hits in the table, when the number of entries occupying the table is 3, the entropy value becomes ceil(log₂3) = 2. From this calculation result, it can be understood that the index can be reduced to 2 bits. Thus, by sending "10" obtained by reducing the index (compressed symbol) "0010" to 2 bits to the decompression side, a reduction in the communication data amount can be achieved.

On the decompression side, the original index (the compressed symbol) can be restored by taking out 2 bits "10" from the above-described calculation of entropy and adding "00" to the sent "10" such that the same table as that of the compression side is reproduced. In addition, in the example illustrated in Fig. 63, although an example in which one symbol is registered in one entry is illustrated, the number of symbols registered in one entry may be 2 or more.

Fig. 64 is a diagram illustrating a configuration example of a compression device according to a second embodiment. Fig. 65 is a diagram illustrating a configuration example of a compression unit according to the second embodiment. Fig. 66 is a diagram illustrating a configuration example of a latch adjustment unit 31 according to the second embodiment. In a case in which the entropy calculation is applied to the compression device, a configuration (for example, a latch) for maintaining an entropy value is provided in a compressed symbol pipeline and a T0 compressed symbol pipeline.

The compression device 100A to which the entropy calculation is applied includes a compression unit 10, a compression unit 20, an adjustment unit 30 including a latch adjustment unit 31, and an output unit 40 corresponding to the output unit 40.

The compression unit 20 according to the second embodiment is different from the first embodiment as follows. In a latch 26 included in the compression unit 20, an entropy value (denoted as "Ent") obtained by the entropy calculation is maintained in addition to a compressed symbol and a CMark. In addition, in a latch 27, in addition to the compressed symbol in the compression unit 10 (a table T0), the entropy value in the table T0 is maintained.

As an input to a MUX 23, an entropy input from the previous stage is added. In addition, the compression unit 20 includes an entropy calculation unit 25. In a case in which the table search result is a hit, the entropy calculation unit 25 performs the above-described calculation of entropy and outputs the result as an entropy output. The compression unit 10 also has the entropy calculation unit 25 and calculates entropy in a case in which the search result of the table T0 is a hit. The calculation result of the entropy can be supplied to the compression unit 20 as an entropy input from the previous stage. In addition, the configurations of a latch 28, a matching register 21, tables, a latch control unit 24, and a latch state management unit 22 in the compression unit 20 are the same as those in the first embodiment.

In Fig. 66, the latch adjustment unit 31, similarly to the compression unit 20, is configured such that an entropy value as an entropy input is input to the MUX 23. In addition, the latch 26 maintains the compressed symbol, the CMark, and the entropy value. The compressed symbol, the CMark, and the entropy value maintained in the latch 26 are output as compression latch outputs. Except for the description presented above, the configuration of the latch adjustment unit 31 is similar to that of the first embodiment.

Fig. 67 is a diagram illustrating a configuration example of the output unit according to the second embodiment. In Fig. 67, the configuration of the output control unit 41 is similar to that of the first embodiment. The output unit 40 has a bit reduction unit 43. The MUX 42 outputs the original symbol or the compressed symbol and the CMark in accordance with a table illustrated in the middle stage of Fig. 67. The bit reduction unit 43 receives the compressed symbol and the entropy value in the compression latch, and reduces the number of bits of the compressed symbol in accordance with the entropy value. For the original symbol, reduction of the number of bits is not performed. For example, as illustrated in the lower stage of Fig. 67, in a case in which the compressed symbol "0011", CMark = 2, and the entropy value = 3 are output from the MUX 42 by the compression latch, the bit reduction unit 43 changes the compressed symbol to "011" and outputs it through bit reduction according to the entropy value = 3. Thus, the output of the output unit 140 becomes (2, 011). In addition, in a case in which the original symbol is output from the MUX 42, the bit reduction unit 43 passes the original symbol through.

### <Entropy Culling>

Next, an entropy culling applicable as an option to the compression devices 100 and 100A will be described. The entropy culling refers to deleting an entry registered with the largest index value (at the back end) of the table entries in accordance with the number of hits.

Fig. 68 is a diagram illustrating an example of the entropy culling, and a case in which symbols "D", "C", "A", "B", and "X" are registered in order from the leading entry of the table in the leftmost table of Fig. 68 is assumed. In this state, when it is assumed that a table search (matching) of symbol "A" is performed, and the third entry from the top (index: 010) is hit, a hit counter included in the compression device 100A is incremented (+1), and the value of the hit counter changes from 0 to 1.

In addition, the calculation and output of the entropy are performed. The value of the entropy becomes ceil(log₂5) = 3. In addition, a table operation similar to that of the first embodiment is performed. In other words, the hit symbol "A" moves to the highest-level entry of the table, and the registered contents of entries below the highest level move one level lower. Next, a table search (matching) of symbol "X" is performed, and the fifth entry from the top (index: 100) is hit. Then, the hit counter is incremented (+1), and the value of the hit counter changes from 1 to 2.

In addition, the calculation and output of the entropy are performed. The value of the entropy becomes ceil(log₂5) = 3. In addition, a table operation is performed. In other words, the hit symbol "X" moves to the highest-level entry of the table, and the registered contents of the entries below the highest level move one level lower. In a case in which the value of the hit counter is a setting value (2) of the entropy culling, the registered content (symbol "B") of the entry in use located at the highest level is deleted. In a case in which the deletion is performed, the hit counter is reset, and the counter value becomes 0. The deletion target is an entry with the last search order.

Next, a table search (matching) of symbol "A" is performed, and the second entry from the bottom (index: 001) is hit. Then, the hit counter is incremented (+1), and the value of the hit counter changes from 1 to 2. In addition, the calculation and output of the entropy are performed, and the value of the entropy becomes ceil(log₂4) = 2. In addition, a table operation is performed. In other words, the hit symbol "A" is arranged at the highest level at the head of the table, and the rest move one level lower.

Fig. 69 is a flowchart illustrating a process example of the entropy culling. The process illustrated in Fig. 69 is performed by, for example, the compression units 10 and 20. At a start time point of the process illustrated in Fig. 69, the hit counter is reset, and 0 is set to the value of the hit counter. In Step S121, the compression unit 20 determines whether or not the result of the table search is a hit. In a case in which it is determined that the search result is a hit, the process of Step S122 is performed. In Step S122, the compression unit 20 performs the increment of the value of the hit counter, the output of the compressed symbol, the calculation and output of the entropy, and the table operation.

In Step S123, the compression unit 20 determines whether or not the value of the hit counter is the setting value of the culling. In a case in which it is determined that the value of the hit counter is the setting value, the compression unit 20 deletes the registered content of the entry at the highest level of the table and resets the hit counter (Step S124). In a case in which it is determined that the value of the hit counter is not the setting value, the process returns to Step S121. According to the entropy culling, by deleting the registered content of a predetermined entry in a case in which the number of hits has reached a threshold value, the number of uses of the entry can be reduced, and the entropy value can be maintained at a low value. The predetermined entry can be arbitrarily determined, such as, for example, an entry in which a symbol with a low appearance rate (the last search order) is registered.

In addition, a lower limit value of the entropy culling can be set. In accordance with this, a situation in which all the entries are erased through the culling, and the compression becomes inefficient can be avoided. A culling restriction can be set for each table by designating a lower limit index of an entry that is not a target for culling anymore. For example, in a case in which the same symbol "A" continues for a long time such as AAAAAAAA..., a timing at which the table T0 becomes empty occurs. However, by providing the culling restriction, the symbol "A" is necessarily hit.

### <Proximity Entry Exchange>

For the compression devices 100 and 100A, proximity entry exchange can be applied as an option. Fig. 70 is an explanatory diagram of proximity entry exchange. In each of the compression devices 100 and 100A, a configuration in which a hit symbol is registered (moved) in the highest-level entry of the table in a case in which the table search result is a hit is employed. However, as illustrated in Fig. 70, in a case in which an entry of the index "10" is hit, a configuration in which an entry maintaining the index "10" is exchanged (the registered content of the entry is exchanged) with an entry with level higher by a predetermined number d of 1 or 2 or more (referred to as proximity entry exchange) may be employed. The proximity entry exchange may have a configuration in which a hit entry moves to an entry with a level lower by a predetermined number d, and the entry corresponding to the predetermined number d moves down to a lower level.

In the example illustrated in Fig. 70, the corresponding entry moves one level below (index "01"). In this case, the entry of the destination (a symbol string registered in the entry of the index "01") moves to a position one level below. In this way, the execution of the proximity entry exchange has the following advantages. In other words, in a case in which there is a rule that a hit entry moves to the head (the first search order) of the table, there are many entries in use, and an entry with a late search order is hit, it takes time for updating the table (the process of moving the hit entry to the highest-level entry of the table and moving the remaining entries one level below). In contrast, by moving the hit entry to a proximity entry, the update range of the table can be localized, and the process and time required for the table update can be reduced.

In addition, a Move to Front operation imposes a heavy burden on the hardware circuit, results in a large number of combinational circuits, and becomes a rich configuration from the aspect of the operating frequency and the circuit scale. In order to improve this, a table operation is performed by regarding an entry separated by a proximity predetermined distance d (= 1, 2, 3...) as the highest-level entry of the table (a push operation pushes to the highest-level entry). In a case in which the proximity entry exchange exceeds the highest-level entry (for example, in a case in which an entry of the index "01" is hit and the proximity entry exchange designates an entry three levels above), the entry position becomes 2 - 3 = -1. In this case, the hit entry moves to the highest-level entry. According to the proximity entry exchange, the range in which the registered content of the entry is changed can be localized, and the circuit configuration is simplified or scaled down, whereby an operation at a high frequency can be expected.

### <Operation Example of Compression Device>

Hereinafter, an operation example of the compression device 100A according to the second embodiment will be described. A case in which entropy calculation, entropy culling, and proximity entry exchange are applied as options to the compression device 100A will be described. These three options can be omitted as appropriate. In this operation example, in a case in which the hit counter value becomes 2, entropy culling (deletion of entry) is executed. In addition, an example in which, as the proximity entry exchange, registered contents are exchanged between a hit entry and an entry present at a position two positions away (present in a lower level) from the entry is illustrated. Furthermore, the number of tables included in the compression device 100A is four, which are tables T0 to T3, and the number of entries included in each table is four.

In addition, at a start time point of the operation, the entries of each table are in an empty state, and the latches 26, 27, 28 and the matching register 21 are also in an empty (Invalid) state. Furthermore, the value of the hit counter is set to 0. The value and meaning of the CMark are the same as those of the first embodiment. In addition, an original symbol string input to the compression device 100A is "ABCDABCDABCABCABCD".

Figs. 71 to 73 are diagrams representing an operation example of the compression device according to the second embodiment. Fig. 71 represents an operation in a cycle in which a symbol string "ABCD" has already been input, and a symbol "A" is newly input.

In the compression device 100A, the compression units 10 and 20, the latch adjustment unit 31, the output unit 40, and the global latch control unit 50 (having the same configuration as the first embodiment) perform operations similar to those according to the first embodiment. However, in a case in which the table search result is a hit in each compression unit 20, entropy calculation and proximity entry exchange are executed, and further, in a case in which the hit counter value has reached a setting value (threshold value), entropy culling is executed.

In Fig. 71, the compression unit 10 performs a table search of the table T0 with a symbol "A" as the search target. The table search result becomes a hit. Then, the compression unit 10 performs entropy calculation, and the result (an entropy value) becomes 2. The compression unit 10 extracts the lower 2 bits of the index "11" of the hit entry and sets it as a compressed symbol. Here, the compressed symbol becomes "11". The compression unit 10 outputs the compressed symbol "11", CMark = 0, and entropy value = 2. In addition, the compression unit 10 increments the hit counter value.

Furthermore, the compression unit 10 performs proximity entry exchange, moves a symbol "A" registered in the entry of the index "11" to a position two levels above (index "01"), and moves entries (entries corresponding to the predetermined number d) located at the positions of the indices "01" and "10" one level below. In accordance with this, the registered contents of the table T0 become "D", "A", "C", and "B".

Fig. 72 represents an operation in the next cycle illustrated in Fig. 71. An input to the compression unit 10 in the next cycle is a symbol "B". The compression unit 10 performs a table search, and the result becomes a hit. Then, the compression unit 10 performs entropy calculation and obtains entropy value = 2. The compression unit 10, similarly to the previous cycle, outputs the compressed symbol "11", CMark = 0, and the entropy value = 2.

In addition, the compression unit 10 performs proximity entry exchange, moves the symbol "B" registered in the entry of the index "11" to a position two levels above (index "01"), and moves the entries located at the positions of the indices "01" and "10" one level below. In accordance with this, the registered contents of the table T0 become "D", "B", "A", and "C". In addition, due to the increment of the hit counter value, the hit counter value reaches threshold value = 2. Then, the compression unit 10 performs entropy culling and deletes the symbol "C" registered in the lowest-level entry (index "11"). Thus, as illustrated in Fig. 72, the number of entries registered in the table T0 is three including "D", "B", and "A".

The latch 26 of the compression unit 20a maintains the compression symbol "11", CMark = 0, and entropy value = 2. Further, the latch 27 maintains the compression symbol "11" and the entropy value = 2. The T0 compressed symbol and the entropy value maintained in the latch 27 are used in a case in which the control signal Empty is supplied.

The content maintained in the latch 26 of the compression unit 20a flows through the compressed symbol pipeline and finally reaches the latch 27 (L7). The output unit 40 determines the output of the compressed symbol "11" from the Valid and Purged values (1, 0). At this time, the bit reduction unit 43 (Fig. 67) takes 2 bits from the lower level from the compressed symbol "11" on the basis of entropy value = 2. In this result, the compressed symbol is "11", and the reduction in the number of bits does not occur in this cycle. However, for example, in a case in which the entropy value is 1, the bit reduction unit 43 takes the lower 1 bit of the compressed symbol (reduces the upper 1 bit). As a result, for example, the compressed symbol "01" is changed to "1", or the compressed symbol "00" becomes "0".

Fig. 73 represents a cycle in which the final symbol "D" of the original symbol string is maintained in the latch 28 (L7). In this cycle, the output from the compression device 100A has already ended.

According to the compression device 100A, in addition to the operations and the effects of the compression device 100, advantages according to the entropy calculation, the entropy culling, and the proximity entry exchange can be achieved. For example, by performing bit reduction on the basis of entropy calculation, the amount of data sent to the decompression side can be reduced. In addition, in accordance with the entropy culling, the number of entries in use is reduced, and thus shortening of the time required for the table search and lowering of the entropy value due to the decrease in the number of entries in use can be achieved. The culling, in other words, the configuration of deleting the registered contents of a predetermined entry in a case in which the number of hits reaches the threshold value can be implemented separately from the entropy calculation.

### <Decompression Device>

The decompression device 300 according to the first embodiment can apply the entropy calculation, the entropy culling, and the proximity entry exchange described above as options. In a case in which the entropy calculation is applied, the bits of the compressed symbol reduced by the compression device 100A as a result of the entropy calculation are restored at the time of restoration in the decompression device 300, and the compressed symbol is brought into a state of being able to be used as an index of the table. Furthermore, in a case in which at least one of the entropy culling and the proximity entry exchange is applied, in a case in which it is applied to the compression device 100A, at least one of the entropy culling and the proximity entry exchange is also applied in the decompression device 300 in order to reproduce the table on the compression side on the decompression side.

Fig. 74A illustrates a configuration example of the decompression device 300 that performs the entropy calculation. In Fig. 74, among the entire configurations (Fig. 75) of the decompression device 300, the decompression units 310c and 310d are omitted, but these have the same configuration as the decompression units 310a and 310b illustrated in Fig. 74. The decompression device 300 according to the second embodiment includes a multiplexing unit (Multiplexer (MUX)) 304 in addition to the configuration described in the first embodiment. Further, each decompression unit 310 includes an entropy calculation unit 315. The entropy calculation unit 315 performs the entropy calculation and outputs the calculation result toward the MUX 304. The MUX 304 selects a calculation result corresponding to the CMark from the calculation results of the respective entropy calculation units 315, and outputs it as the number of read bits.

Fig. 74B is a flowchart representing a process example relating to the entropy calculation of the decompression device 300. In Step S131, the decompression device 300 reads a CMark from the compressed data stream and distributes it to the respective decompression units 310. In Step S132, the decompression unit 310 having a table matching the value of the CMark performs the calculation of the entropy value E = ceil(log₂(k)) using the number of used entries k in the table designated by the CMark. The entropy value E is output as the number of read bits through the MUX 304. In Step S133, the decompression device 300 reads E bits as a compressed symbol from the compressed data stream. In Step S134, the decompression device 300 pads 0 to the upper part of the compressed symbol and expands it to the index length (index width) of the table designated by the CMark. In accordance with this, the compressed symbol output to the bus 302 is obtained. The decompression device 300 inputs the compressed symbol to the DMUX 301, and the DMUX 301 outputs the compressed symbol to the bus 302 on the basis of the CMark. In Step S135, the decompression unit 310 having a table matching the value of the CMark acquires the compressed symbol from the bus 302 and performs a search using the compressed symbol as the index of the table, and the original symbol or original symbol string registered in an entry corresponding to the index is taken out.

Fig. 75 is a diagram illustrating an operation example of the decompression device 300 according to the second embodiment. In the drawings of the decompression device to which the entropy calculation is applied in Fig. 75 and subsequent drawings, the entropy calculation unit 315 and the MUX 304 are omitted. In Fig. 75, the decompression device 300 has the same configuration as the first embodiment. However, the decompression device 300 performs entropy calculation, entropy culling, and proximity entry exchange as options. These three options are employed in accordance with the types of options applied to the compression device 100A. In other words, the compression device 100A and the decompression device 300 are configured so that the same options are applied. The number of tables is four (T0 to T3), and the number of entries is four.

As an input to the decompression device 300, 13 pairs of compressed symbols and a CMark illustrated in Fig. 75 are input to the decompression device 300. Fig. 75 illustrates an operation performed in a case in which the 6th input (1, 1), that is, the compressed symbol "1" and CMark = 1 are input.

The decompression device 300 performs processes of S131 to S134 illustrated in Fig. 74B on the basis of CMark = 1. In other words, the decompression unit 310b having the table T1 calculates the entropy value E = 1 based on the number of entries k = 2 of the table T1 on the basis of CMark = 1, and the MUX 304 outputs the number of read bits 1. In accordance with this, 1 bit is read from the compressed data stream. The decompression device 300 pads "0" to the upper part of the read 1 bit in accordance with the number of bits (known) of the index of the table T1 and obtains a 2-bit compressed symbol "01". The compressed symbol "01" is input to the DMUX 301, and the DMUX 301 sends out the compressed symbol "01" to the bus 302 in accordance with CMark = 1 input to the control terminal thereof. Among the decompression units 310a to 310d, the decompression unit 310b having the table T1 operates in the first mode in accordance with CMark = 1, and the rest operate in the second mode. The decompression unit 310b obtains the compressed symbol "01" from the bus 302 and takes out the symbol string registered in the index "01" from the table T1 (Step S135).

The state of the table T1 at the end time point of the previous cycle is a state in which the symbol string "AB" is registered in the entry of the index "00", and the symbol string "CD" is registered in the entry of the index "01". For this reason, the symbol string "CD" is written to the FIFO 313.

Since the search result of the table T1 is a hit, the proximity entry exchange is performed. At this time, since there is no entry two levels above as a proximity entry exchange destination, the hit symbol "CD" is registered in the highest-level entry, and the symbol "AB" registered in the highest-level entry moves to an entry one level below. Furthermore, since the hit counter value becomes 2 (the threshold value), the entropy culling is performed, and the registered content (the symbol "AB") of the lowest-level entry in use is deleted. In accordance with this, the registered contents of the table T1 are in the state illustrated in Fig. 75.

As described above, in the decompression unit 310, operations relating to the options of the entropy calculation, the entropy culling, and the proximity entry exchange are performed. The operations except for the options of the decompression device 300 are similar to those of the first embodiment. Further, a table update method in a case in which the table search result is a miss is similar to that of the first embodiment.

Fig. 76 illustrates an operation performed in a case in which a last input (1, 11) is input to the decompression device 300. In accordance with the input of CMark = 1 and the compressed symbol "11", the symbol string "CD" of the table T1 is hit, and the symbols "C" and "D" are output from the FIFO 313 of the decompression unit 310b to the bus 303. Fig. 76 illustrates a state in which a symbol "D" is output to the bus 303. The output of the decompression device 300 becomes a symbol string "ABCDABCDABCABCABCD", and the symbol string input to the compression device 100A is restored.

According to the second embodiment, the size of the compressed symbol can be reduced by the entropy calculation. In addition, in accordance with the entropy culling, the number of entries in use can be reduced, and the table search time can be suppressed. By decreasing the number of entries in use, the entropy value can be suppressed to a low value. Furthermore, in accordance with the proximity entry exchange, the range of the table update can be made relatively small.

### [Third Embodiment]

Next, as a compression device and a decompression device according to a third embodiment, a compression device and a decompression device based on a decrement scheme will be described.

### <Compression Device>

Figs. 77 and 78 are diagrams illustrating a configuration example of a compression device 200 according to the third embodiment.

The compression device 200 includes a compression unit 10, a plurality of compression units 220, and an adjustment unit 30 having a plurality of latch adjustment units 31. In the present embodiment, stages L1 to L5 are formed by the compression unit 10, three compression units 220 (220a, 220b, 220c), and two latch adjustment units 31 (31a, 31b).

The compression unit 10 has a configuration similar to the compression unit 10 of the compression device 100. The compression unit 220 corresponds to the compression unit 20. Although the adjustment unit 30 has a plurality of the latch adjustment units 31, which is the same as the compression device 100, in the compression device 200, the number of latch adjustment units 31 (the number of stages) is smaller than that of the compression device 100. The output unit 40 is the same as the output unit 40 of the compression device 100.

When the number of tables in the compression device 200 is N (N is a positive integer; N = 4 in the present embodiment), 1 symbol is registered in one entry of the table T0. N symbols are registered in each entry of the table T1. (N-1) symbols are registered in each entry of the table T2. (N-2) symbols are registered in each entry of the table T3. In this way, the number of symbols registered in one entry in the tables T1 to T3 decreases by a predetermined offset number every time the stage progresses. In this point, the compression device 200 differs from the compression device 100. In the present embodiment, although the offset number = 1, it may be 2 or more. Furthermore, although the number of entries is arbitrary, in the present embodiment, the number of entries k is set as k = 4. The table update method corresponding to the table search results (hits and misses) of the tables T0 to T3 is the same as that of the first embodiment. Furthermore, the method of maintaining symbols in each matching register 21, and the point that the table search is performed in a case in which the matching register 21 becomes full are also the same as those of the first embodiment.

Similarly to the compression device 100, the compression device 200 includes a compressed symbol pipeline including a plurality of latches 26 (L1 to L5) and an original symbol pipeline including a plurality of latches 28 (L1 to L5). Similarly to the compression device 100, the latches 26 of the compressed symbol pipeline maintain compressed symbols and CMark. When the number of tables including the table T0 is n, the number of latches in each pipeline is n+1 (in other words, the number of latch adjustment units 31 (latches 26 and latches 28) included in the adjustment unit 30 becomes n+1-(n-1) = 2). It is sufficient that the delay of each stage is equal, and the output timings are matched. In this document, it is assumed that each stage can output with a delay of 1 clock.

The state of the latch 28 according to the third embodiment is managed using Valid (0 or 1), and the state of the latch 26 is managed using Valid (0 or 1) and Purged (0 or 1). This configuration is the same as that of the first embodiment. In addition, as illustrated in Fig. 78, the compression device 200 is also supplied with control signals of the latch 26 from the global latch control unit 50 and the like. However, there are three types as types of control signals including Latch, Hit, and Purge, and there is no Empty.

Fig. 79 is a diagram illustrating a configuration example of the compression unit 220. Fig. 79 illustrates a configuration example of the compression unit 220a. The compression unit 220a differs from the compression device 100 in that there is no input of the control signal Empty, and the number of symbols registered in each entry of the table T1 is 4. Furthermore, in the decrement scheme, there is no control signal Empty. For this reason, the compression unit 220 does not have the latch 27.

Fig. 80 is a table illustrating a hit/miss pattern of each table and patterns of control signals according to the third embodiment. Fig. 80 illustrates tables illustrating relations between a hit or miss state of a table search and inputs to each latch, which is applied to the compression device 200, in a case in which the number of tables including the table T0 is 2, 3, or 4. Since there is no Empty in the decrement scheme, the pattern of the control signals for the combination of hits or misses differs from that of the first embodiment (the increment scheme). Although Fig. 80 illustrates for up to N = 4, the tables may be similarly created also for a case in which N is 5 or more.

Fig. 81 is an explanatory diagram of a method of resolving a conflict in the latch control based on the decrement scheme. In the case of the decrement, a hit closest to the entrance of the pipeline is selected for the latch control. However, in a case in which the table T1 hits, there are cases in which a compressed symbol is maintained in the compression latches (latches 26) after the table T2. In such cases, unless the results of all the table searches are caused to be a miss, the compressed symbol maintained in the compression latch is purged, and there is concern that the original symbol flowing downstream thereof cannot be decompressed. Thus, in a case in which there is a compressed symbol (not the CMark of T0) between L2 and L(N-1) = 4 in the pipeline when the number of compression latches is N (5 in the example illustrated in Fig. 81), all the hit states of the tables of T1 to T(k-1) of the total number of tables K including T0 are caused to be a miss.

Fig. 82 is a flowchart illustrating a process example of resolving a conflict. The process illustrated in Fig. 82 is started in a case in which the result of the table search is a hit. In Step S141, the decompression device 300 determines whether or not there is a compressed symbol (not the CMark of T0) between L2 and L(N-1) in the compressed symbol pipeline in which the number of compression latches (latches 26) is N. In a case in which it is determined that there is a compressed symbol, the decompression device 300 changes all the hit states of the tables T1 to T(K-1) in the total number of tables K to a miss (Step S142). Thereafter, the process proceeds to Step S143. In a case in which the determination of Step S141 is No, the process proceeds to Step S143. In Step S143, the hit information (hit or miss) is sent to the global latch control unit 50. The global latch control unit 50 receives the hit information (hit/miss) from each compression unit 220 and supplies the control signal of a pattern corresponding to the hit information to the latches 26 (L1 to L5).

Figs. 83 to 105 are explanatory diagrams of an operation example of the compression device 200. The compression device 200 illustrated in Fig. 83 includes the configuration of the compression device 200 illustrated in Figs. 77 to 82. Before the start of the operation example, the compression device 200 causes each entry of the tables T0 to T3 to be in an empty state by performing initialization. In addition, the compression device 200 sets the states of all the latches to Invalid (invalidates them). As an example, the values of the CMark are set to T0 = 0, T1 = 1, T2 = 2, T3 = 3, and non-compression = 4. However, different values may be assigned to the respective tables as long as the values differ from each other. A symbol string such as ABCDABCD... illustrated in Fig. 83 is input as a plurality of symbols (symbol string) input to the compression device 200.

Fig. 83 illustrates an operation in a cycle in which a first symbol "A" is input. In this cycle, the table search result becomes a miss in the compression unit 10 (because no symbol is registered in the table T0). For this reason, the symbol "A" is registered in the highest-level entry (index "00") of the table T0. In the cycle illustrated in Fig. 83, the table search is not performed in any one of the compression units 20a, 20b, and 20c. For this reason, all the hit information of the compression units 20a, 20b, and 20c becomes a miss. In this case, the global latch control unit 50 sends the control signal Latch as a control signal for the latches 26 (L1 to L7) of the compressed symbol in the next cycle.

Fig. 84 illustrates an operation in a next cycle of the cycle illustrated in Fig. 83, and a next symbol "B" is input to the compression unit 10. Fig. 85 illustrates an operation in a next cycle of the cycle illustrated in Fig. 84, and a next symbol "C" is input to the compression unit 10. Fig. 86 illustrates an operation in a next cycle of the cycle illustrated in Fig. 85, and a next symbol "D" is input to the compression unit 10. These operations are similar to the operations illustrated using Fig. 83.

Fig. 87 illustrates an operation in a next cycle of the cycle illustrated in Fig. 86. In this cycle, a next symbol "A" is input to the compression unit 10. In the compression unit 10, since the search result of the table T0 becomes a hit, the symbol "A" is registered in the highest-level entry of the table T0, and the symbols "D", "C", and "B" move to respective entries one level above. In addition, the symbols "A", "B", "C", and "D" are shifted through the original symbol pipeline and are maintained in the latch 28 and the matching register 21 of the compression unit 20a in the next stage. At this time, since the matching register 21 of the compression unit 220a becomes full, the compression unit 220b performs a table search (matching) for the symbol string "ABCD". However, the table search result becomes a miss. As a result, the symbol string "ABCD" is registered in the highest-level entry of the table T1.

Further, the compression unit 220b takes the symbol "C" into the matching register 21. In accordance with this, since the matching register 21 becomes full, the table search of the table T2 is performed, but the result becomes a miss. For this reason, the symbol string "ABC" is registered in the highest-level entry of the table T2. A similar process is performed also in the compression unit 220c, and the symbol string "AB" is registered in the highest-level entry of the table T3. Since the hit information from the compression units 220a to 220c in this cycle is "miss, miss, miss", the global latch control unit 50 gives the control signal Latch to the latches 26 (L1 to L5) as a control signal of the next cycle.

Fig. 88 illustrates an operation in a next cycle of the cycle illustrated in Fig. 87. In this cycle, a next symbol "B" is input to the compression unit 10. The table search result in the compression unit 10 becomes a hit, and the registered contents of the table T0 are updated as illustrated in Fig. 88. In addition, the compressed symbol "11", which is the index of the entry in which the symbol "A" is registered, and CMark = 0 illustrating conversion in the table T0, are sent from the compression unit 10 to the compression unit 220a.

The symbol string "ABCDA" input prior to the symbol "B" is maintained in the latches 28 of L1 to L5 by being shifted. The table search result (hit information) in this cycle becomes "miss, miss, miss". For this reason, the global latch control unit 50 gives the control signal Latch to the latches 26 (L1 to L5) as a control signal of the next cycle.

In addition, the compression unit 220a takes the compressed symbol "11" and CMark = 0 from the compression unit 10 into the latch 26 in accordance with the control signal Latch. Furthermore, while the symbol "A" is maintained in the latch 28 present at the tail end of the original symbol pipeline, none is maintained in the latch 26 of L5. In other words, the value of Valid of the latch 28 (L5) is "1", the value of Valid of the latch 26 (L5) is "0", and the value of Purged is "0". For this reason, the output unit 40 outputs the symbol "A" and CMark = 4.

Fig. 89 illustrates an operation in a next cycle of the cycle illustrated in Fig. 88. In this cycle, a next symbol "C" is input to the compression unit 10. The result of the table search in the compression unit 10 becomes a hit. As a result, the table T0 is updated such that the symbol "C" is registered in the highest-level entry of the table T0. In addition, the compressed symbol "11", which is the index of the entry in which the symbol "C" is registered, and CMark = 0 illustrating conversion in the table T0, are sent from the compression unit 10 to the compression unit 220a. Each of the compression units 220a and 220b takes the compressed symbol and the CMark in the previous stage into the latch 26 in accordance with the control signal Latch.

In accordance with the shift of the symbol in the original symbol pipeline, in the compression unit 20c, the matching register 21 becomes full, and the table search is performed, but the result becomes a miss. The table T3 is updated as illustrated in Fig. 89. The table search result (hit information) in this cycle becomes "miss, miss, miss", and the global latch control unit 50 gives the control signal Latch to the latches 26 (L1 to L5) as a control signal of the next cycle.

While the symbol "B" is maintained in the latch 28 (L5), none is maintained in the latch 26 (L5). In other words, the value of Valid of the latch 28 (L5) is "1", the value of Valid of the latch 26 (L5) is "0", and the value of Purged is "0". For this reason, the output unit 40 outputs the symbol "B" and CMark = 4.

Fig. 90 illustrates an operation in a next cycle of the cycle illustrated in Fig. 89. The input to the compression unit 10 in this cycle is a symbol "D". In the compression unit 10, the table search result of the table T0 becomes a hit, the table T0 is updated, and the compressed symbol "11" and CMark = 0 are sent to the next stage. Furthermore, in each of the compression units 220a and 220c, the table search is not performed, and the result becomes a miss.

In the compression unit 220b, the table search is executed, but the result becomes a miss. Thus, the global latch control unit 50 gives the control signal Latch to the latches 26 (L1 to L5) as a control signal of the next cycle. The output unit 40 outputs the symbol "C" and CMark = 4 in accordance with the maintained contents of the latch 28 (L5) and the latch 26 (L5) and the states thereof.

Fig. 91 illustrates an operation in a next cycle of the cycle illustrated in Fig. 90. The input to the compression unit 10 in this cycle is a symbol "A". In this cycle, the table search result of the table T0 becomes a hit, the table T0 is updated, and the compressed symbol "11" and CMark = 0 are sent to the next stage.

In addition, in the compression unit 220a, the table search is performed, and the result becomes a hit. In this case, the compression unit 220a executes the process (conflict check) illustrated in Fig. 82. Here, in the latch 26 between L2 and L(N-1) = L4, there is no compressed symbol obtained other than T0 (the compression unit 10). For this reason, the result of the hit is not changed. The table search is also performed in the compression unit 220c, and since the result becomes a hit, the process illustrated in Fig. 82 is performed. Also in this case, the result of hits is not changed. The tables T1 and T3 are updated from the result of hits. In the compression unit 220b, the table search is not performed, and the hit information becomes "miss".

The pattern of the hit information sent to the global latch control unit 50 in this cycle becomes "hit, miss, hit". The global latch control unit 50 supplies "latch, hit, purge, purge, purge" as control signals for L1 to L5 in the next cycle in accordance with the pattern of the hit information (see the table illustrated in Fig. 80). Since the symbol string "ABCD" is hit in the compression unit 220a, this compressed symbol "00" and CMark = 1 are targets for output from the output unit 40. On the other hand, the output of the symbols "A", "B", "C", and "D" flowing through the original symbol pipeline needs to be avoided. By giving the control signal Hit to the compression unit 220b, the compressed symbol "00" and CMark = 1 are taken into the latch 26 of L2 in the next cycle, and Purged is set in the latches 26 of L3 to L5, whereby the outputs of the original symbols "A", "B", and "C" are blocked in accordance with Purged, and the output of the original symbol "D" is blocked by the output unit 40 selecting and outputting the compressed symbol "00" and CMark = 1 on the basis of the states of the latches 28 and 26 of L5.

Fig. 92 illustrates an operation in a next cycle of the cycle illustrated in Fig. 91. In this cycle, a next symbol "B" is input to the compression unit 10. In the original symbol pipeline, each original symbol (ABCDA) is maintained in each latch 28. The table search result in the compression unit 10 becomes a hit, and the table T0 is updated. In addition, the compressed symbol "11" and CMark = 0 are output to the next stage.

The compression unit 220a takes the compressed symbol "11" and CMark = 0 into the latch 26 in accordance with the control signal Latch received in the previous cycle. In the compression unit 220a, the table search is not performed, and the hit information becomes "miss". The compression unit 220b takes the compressed symbol "00" and CMark = 1 into the latch 26 in accordance with the control signal Hit received in the previous cycle. In the compression unit 220b, since the table search is not performed, the hit information becomes "miss".

The compression unit 220c sets Purged to the state of the latch 26 in accordance with the control signal Purge received in the previous cycle. Each of the latch adjustment units 31a and 31b also sets Purged to the state of the latch 26 in accordance with the control signal Purge. As a result, the output unit 40 does not perform an output in this cycle.

In each of the compression units 220a and 220b, the table search is not performed, and the hit information becomes "miss". Thus, all the control signals for the latches 26 (L1 to L5) in the next cycle are Latch.

Fig. 93 illustrates an operation in a next cycle of the cycle illustrated in Fig. 92. In this cycle, a next symbol "C" is input to the compression unit 10. In the original symbol pipeline, the original symbol string "BCDCB (in input order)" is maintained in respective latches 28 of L1 to L5. The table search result in the compression unit 10 becomes a hit, and the table T0 is updated. In addition, the compressed symbol "11" and CMark = 0 are output to a next stage.

The compression unit 220a takes the compressed symbol "11" and CMark = 0 into the latch 26 in accordance with the control signal Latch received in the previous cycle. In the compression unit 220a, the table search is not performed, and the hit information becomes "miss". The compression unit 220b takes the compressed symbol "11" and CMark = 0 of the previous stage into the latch 26 in accordance with the control signal Latch received in the previous cycle. The compression unit 220b performs the table search, but the result (hit information) becomes "miss".

The compression unit 220c takes the compressed symbol "00" and CMark = 1 into the latch 26 in accordance with the control signal Latch received in the previous cycle. The compression unit 220c performs the table search, and the result becomes a hit. Thus, the compression unit 220c performs the process (conflict check) illustrated in Fig. 63. Here, the compressed symbol obtained in the compression unit 220a is maintained in the latch 26 (L3) between L2 and L4. For this reason, the hit information is changed from "hit" to "miss". Thus, since all the hit information of the compression units 220a to 220c becomes a miss, all the control signals of the next cycle become Latch.

Fig. 94 illustrates an operation in a next cycle of the cycle illustrated in Fig. 93. In this cycle, a next symbol "A" is input to the compression unit 10. In the original symbol pipeline, the original symbol string "CDABC" is maintained in the latches 28 of L1 to L5 by being shifted. The table search result in the compression unit 10 becomes a hit, and the table T0 is updated. In addition, the compressed symbol "10" and CMark = 0 are output to the next stage.

The compression unit 220a takes the compressed symbol "11" and CMark = 0 into the latch 26 in accordance with the control signal Latch received in the previous cycle. In the compression unit 220a, the table search is not performed, and the hit information becomes "miss". The compression unit 220b takes the compressed symbol "11" and CMark = 0 into the latch 26 in accordance with the control signal Latch received in the previous cycle. The compression unit 220b does not perform the table search, and the result (hit information) becomes "miss".

The compression unit 220c takes the compressed symbol "11" and CMark = 0 into the latch 26 in accordance with the control signal Latch received in the previous cycle. The compression unit 220c does not perform the table search, and the result becomes a miss. The latch adjustment unit 31a takes the content (the compressed symbol "00" and CMark = 1) of the latch 26 of the previous stage into the latch 26 (L4). In addition, the latch adjustment unit 31b takes in the state "Purged" of the latch 26 of the previous stage and supplies it to the output unit 40. As a result, the output unit 40 does not perform output in this cycle.

Fig. 95 illustrates an operation in a next cycle of the cycle illustrated in Fig. 94. In this cycle, a next symbol "B" is input to the compression unit 10. In the original symbol pipeline, the original symbol string "DABCA" is maintained in respective latches 28 of L1 to L5. In the compression unit 10, the table search result of the symbol "B" becomes a hit, and the table T0 is updated.

The compression unit 220a takes the compressed symbol "10" and CMark = 0 into the latch 26 in accordance with the control signal Latch received in the previous cycle. In addition, the compression unit 220a performs the table search, but the result becomes a miss. After that, the table T1 is updated.

The compression unit 220b takes the compressed symbol "11" and CMark = 0 into the latch 26 in accordance with the control signal Latch received in the previous cycle. In the compression unit 220b, the table search is not performed, and the table search result becomes a miss. After that, the table T2 is updated.

The compression unit 220c takes the compressed symbol "11" and CMark = 0 into the latch 26 in accordance with the control signal Latch received in the previous cycle. In addition, the compression unit 20c performs a table search, and the result becomes a hit. In this cycle, the hit information becomes "miss, miss, hit". The control signals for L1 to L5 are supplied with a pattern "latch, latch, latch, hit, purge" of control signals according to this pattern. Further, the maintained contents of the latches 26 of the previous stage are taken into the respective latches 26 of L4 and L5. In this cycle, the output unit 40 outputs the compressed symbol "00" and CMark = 1 on the basis of the maintained contents and the states of the latches 28 and 26 of L5.

Fig. 96 illustrates an operation in a next cycle of the cycle illustrated in Fig. 95. In this cycle, a next symbol "C" is input to the compression unit 10. In the original symbol pipeline, the original symbol string "ABCAB" is maintained in respective latches 28 of L1 to L5. In the compression unit 10, the table search result of the symbol "C" becomes a hit, and the table T0 is updated.

The compression unit 220a takes the compressed symbol "10" and CMark = 0 into the latch 26 in accordance with the control signal Latch received in the previous cycle. In addition, the compression unit 220a does not perform a table search, and the result becomes a miss.

The compression unit 220b takes the compressed symbol "10" and CMark = 0 into the latch 26 in accordance with the control signal Latch received in the previous cycle. In the compression unit 220b, although the table search is performed, the table search result becomes a miss.

The compression unit 220c takes the compressed symbol "11" and CMark = 0 into the latch 26 in accordance with the control signal Latch received in the previous cycle. In addition, the compression unit 20c does not perform the table search, and the result becomes a miss. In this cycle, the hit information becomes "miss, miss, miss". For this reason, all the control signals for L1 to L5 in the next cycle become Latch.

The latch adjustment unit 31a takes the compressed symbol "01" and CMark = 3 from the compression unit 220c into the latch 26 (L4) in accordance with the control signal Hit received in the previous cycle. The latch adjustment unit 31b sets Purged as the state of the latch 26 (L5) in accordance with the control signal Purge received in the previous cycle. As a result, the output unit 40 does not perform an output in this cycle.

Fig. 97 illustrates an operation in a next cycle of the cycle illustrated in Fig. 96. In this cycle, the next symbol "A" is input to the compression unit 10. In the original symbol pipeline, the original symbol string "BCABC" is maintained in respective latches 28 of L1 to L5 by being shifted. In the compression unit 10, the table search result of the symbol "A" becomes a hit, and the table T0 is updated.

The compression unit 220a takes the compressed symbol "10" and CMark = 0 into the latch 26 in accordance with the control signal Latch received in the previous cycle. In addition, the compression unit 220a does not perform a table search, and the result becomes a miss. Thereafter, the table T1 is updated.

The compression unit 220b takes the compressed symbol "10" and CMark = 0 into the latch 26 in accordance with the control signal Latch received in the previous cycle. In the compression unit 220b, the table search is not performed, and the table search result becomes a miss. Thereafter, the table T2 is updated.

The compression unit 220c takes the compressed symbol "10" and CMark = 0 into the latch 26 in accordance with the control signal Latch received in the previous cycle. In addition, although the compression unit 220c performs a table search, the result becomes a miss. In this cycle, the hit information becomes "miss, miss, miss". For this reason, all the control signals for L1 to L5 in the next cycle become Latch.

The latch adjustment unit 31a takes the compressed symbol "11" and CMark = 0 from the compression unit 220c into the latch 26 (L4) in accordance with the control signal Latch received in the previous cycle. The latch adjustment unit 31b takes the compressed symbol "01" and CMark = 3 from the latch adjustment unit 31a into the latch 26 (L5) in accordance with the control signal Latch received in the previous cycle. The output unit 40 outputs the compressed symbol "01" and CMark = 3 on the basis of the maintained contents and the states of the latches 28 and 26 of L5.

Fig. 98 illustrates an operation in a next cycle of the cycle illustrated in Fig. 97. In this cycle, the next symbol "B" is input to the compression unit 10. In the original symbol pipeline, the original symbol string "CABCA" is maintained in respective latches 28 of L1 to L5 by being shifted. In the compression unit 10, the table search result of the symbol "B" becomes a hit, and the table T0 is updated.

The compression unit 220a takes the compressed symbol "10" and CMark = 0 into the latch 26 in accordance with the control signal Latch received in the previous cycle. In the compression unit 220a, the table search is not performed, and the result becomes a miss.

The compression unit 220b takes the compressed symbol "10" and CMark = 0 into the latch 26 in accordance with the control signal Latch received in the previous cycle. In the compression unit 220b, the table search is not performed, and the table search result becomes a miss.

The compression unit 220c takes the compressed symbol "10" and CMark = 0 into the latch 26 in accordance with the control signal Latch received in the previous cycle. Also in the compression unit 220c, the table search is not performed, and the result becomes a miss. In this cycle, the hit information becomes "miss, miss, miss". For this reason, all the control signals for L1 to L5 in the next cycle become Latch.

The latch adjustment unit 31a takes the compressed symbol "10" and CMark = 0 from the compression unit 220c into the latch 26 (L4) in accordance with the control signal Latch received in the previous cycle. The latch adjustment unit 31b takes the compressed symbol "11" and CMark = 0 from the latch adjustment unit 31a into the latch 26 (L5) in accordance with the control signal Latch received in the previous cycle. The output unit 40 outputs the compressed symbol "11" and CMark = 0 on the basis of the maintained contents and the states of the latches 28 and 26 of L5.

Fig. 99 illustrates an operation in a next cycle of the cycle illustrated in Fig. 98. In this cycle, a next symbol "C" is input to the compression unit 10. In the original symbol pipeline, the original symbol string "ABCAB" is maintained in respective latches 28 of L1 to L5 by being shifted. In the compression unit 10, the table search result of the symbol "C" becomes a hit, and the table T0 is updated.

The compression unit 220a takes the compressed symbol "10" and CMark = 0 into the latch 26 in accordance with the control signal Latch received in the previous cycle. In addition, although the compression unit 220a performs the table search, the result becomes a miss.

The compression unit 220b takes the compressed symbol "10" and CMark = 0 into the latch 26 in accordance with the control signal Latch received in the previous cycle. In the compression unit 220b, the table search is performed, and the table search result becomes a hit.

The compression unit 220c takes the compressed symbol "10" and CMark = 0 into the latch 26 in accordance with the control signal Latch received in the previous cycle. In the compression unit 220c, the table search is not performed, and the result becomes a miss. In this cycle, since a conflict has not occurred, the hit information becomes "miss, hit, miss". For this reason, the control signals for L1 to L5 in the next cycle become the pattern illustrated in Fig. 99.

The latch adjustment unit 31a takes the compressed symbol "10" and CMark = 0 from the compression unit 220c into the latch 26 (L4) in accordance with the control signal Latch received in the previous cycle. The latch adjustment unit 31b takes the compressed symbol "10" and CMark = 0 from the latch adjustment unit 31a into the latch 26 (L5) in accordance with the control signal Latch received in the previous cycle. The output unit 40 outputs the compressed symbol "10" and CMark = 0 on the basis of the maintained contents and the states of the latches 28 and 26 of L5.

Fig. 100 illustrates an operation in a next cycle of the cycle illustrated in Fig. 99. In this cycle, the last symbol "D" is input to the compression unit 10. In the original symbol pipeline, the original symbol string "BCABC" is maintained in respective latches 28 of L1 to L5. In the compression unit 10, the table search result of the symbol "D" becomes a hit, and the table T0 is updated.

The compression unit 220a takes the compressed symbol "10" and CMark = 0 into the latch 26 in accordance with the control signal Latch received in the previous cycle. In addition, the compression unit 220a does not perform the table search, and the result becomes a miss.

The compression unit 220b takes the compressed symbol "10" and CMark = 0 into the latch 26 in accordance with the control signal Latch received in the previous cycle. In the compression unit 220b, the table search is not performed, and the table search result becomes a miss.

The compression unit 220c takes the compressed symbol "00" and CMark = 2 into the latch 26 in accordance with the control signal Hit received in the previous cycle. In the compression unit 220c, the table search is not performed, and the result becomes a miss. In this cycle, the hit information becomes "miss, miss, miss". For this reason, all the control signals for L1 to L5 in the next cycle become Latch.

The latch adjustment unit 31a sets Purged to the state of the latch 26 (L4) in accordance with the control signal Purge received in the previous cycle. The latch adjustment unit 31b also sets Purged to the state of the latch 26 (L5). In accordance with this, the output unit 40 does not perform an output in this cycle.

Fig. 101 illustrates an operation in a next cycle of the cycle illustrated in Fig. 100. In this cycle, there is no input of a symbol to the compression unit 10. For this reason, the table search is not performed. In this case, the state Valid = 0 (in other words, empty) of the compression latch is output. The state Valid of the original latch also becomes "0".

The original symbol string "CABCD" is maintained in the latches 28 of L1 to L5. The compression unit 220a takes the compressed symbol "11" and CMark = 0 into the latch 26 in accordance with the control signal Latch received in the previous cycle. In addition, the compression unit 220a does not perform the table search, and the result becomes a miss.

The compression unit 220b takes the compressed symbol "10" and CMark = 0 into the latch 26 in accordance with the control signal Latch received in the previous cycle. Also in the compression unit 220b, the table search is not performed, and the table search result becomes a miss.

The compression unit 220c takes the compressed symbol "10" and CMark = 0 into the latch 26 in accordance with the control signal Latch received in the previous cycle. In the compression unit 220c, the table search is performed, and the result becomes a hit. Thus, the process illustrated in Fig. 82 is performed, and the hit is changed to a miss. Thus, the hit information in this cycle becomes "miss, miss, miss". For this reason, all the control signals for L1 to L5 in the next cycle become Latch.

The latch adjustment unit 31a takes the compressed symbol "00" and CMark = 2 into the latch 26 (L4) in accordance with the control signal Latch received in the previous cycle. The latch adjustment unit 31b takes in the state Purged of the latch 26 (L5) in accordance with the control signal Latch. In accordance with this, the output unit 40 does not perform an output in this cycle.

Fig. 102 illustrates an operation in a next cycle of the cycle illustrated in Fig. 101. In this cycle, there is no input of a symbol to the compression unit 10. For this reason, the table search result is not performed. In this case, the state Valid = 0 (that is, empty) of the compression latch is output.

The latch 28 of L1 becomes empty. The original symbols (ABCD) are maintained in the latches 28 of L2 to L5. The compression unit 220a receives Valid = 0 of the compression latch from the compression unit 10, and the latch 26 comes into an empty state. The compression unit 220a does not perform the table search, and the result becomes a miss.

The compression unit 220b takes the compressed symbol "11" and CMark = 0 into the latch 26 in accordance with the control signal Latch received in the previous cycle. In the compression unit 220b, although the table search is performed, the table search result becomes a miss.

The compression unit 220c takes the compressed symbol "10" and CMark = 0 into the latch 26 in accordance with the control signal Latch received in the previous cycle. In the compression unit 220c, the table search is not performed, and the result becomes a miss. Thus, the hit information in this cycle becomes "miss, miss, miss". For this reason, all the control signals for L1 to L5 in the next cycle become Latch.

The latch adjustment unit 31a takes the compressed symbol "10" and CMark = 0 into the latch 26 (L4) in accordance with the control signal Latch received in the previous cycle. The latch adjustment unit 31b takes the compressed symbol "00" and CMark = 2 into the latch 26 (L5) in accordance with the control signal Latch. The output unit 40 outputs the compressed symbol "00" and CMark = 2 on the basis of the maintained contents and states of the latches 28 and 26 of L5.

Fig. 103 is a diagram illustrating an operation in the next cycle of the cycle illustrated in Fig. 102. In this cycle, there is no input of a symbol to the compression unit 10, and the maintained contents of the latch 26 and the latch 28 of the compression units 20a and 20b become empty.

The compression unit 220c takes the compressed symbol "11" and CMark = 0 into the latch 26 according to the control signal Latch received in the previous cycle. The compression unit 220c performs a table search, and the result becomes a hit. Thus, the hit information in this cycle becomes "miss, miss, hit". For this reason, the control signals for L1 to L5 in the next cycle become Latch for L1 to L3, Hit for L4, and Purge for L5.

The latch adjustment unit 31a takes the compressed symbol "10" and CMark = 0 into the latch 26 (L4) in accordance with the control signal Latch. The latch adjustment unit 31b takes the compressed symbol "10" and CMark = 0 into the latch 26 (L5) in accordance with the control signal Latch. The output unit 40 outputs the compressed symbol "10" and CMark = 0 on the basis of the maintained contents and the states of the latches 28 and 26 of L5.

Fig. 104 is a diagram illustrating an operation in the next cycle of the cycle illustrated in Fig. 103. In this cycle, there is no input of a symbol to the compression unit 10, and the contents maintained in the latch 26 and the latch 28 of the compression units 20a, 20b, and 20c become empty.

The latch adjustment unit 31a takes the compressed symbol "11" and CMark = 3 into the latch 26 (L4) in accordance with the control signal Hit. The latch adjustment unit 31b sets the state of the latch 26 (L5) to Purged in accordance with the control signal Purge. The output unit 40 does not perform an output in this cycle in accordance with the state Purged. In addition, all the control signals for L1 to L5 in the next cycle become Latch.

Fig. 105 is a diagram illustrating an operation in the next cycle of the cycle illustrated in Fig. 104. In this cycle, there is no input of a symbol to the compression unit 10, and the maintained contents of the latches 26 and the latches 28 of the compression units 20a, 20b, and 20c, and the latch adjustment unit 31a become empty.

The latch adjustment unit 31b takes the compressed symbol "11" and CMark = 3 into the latch 26 (L5) in accordance with the control signal Latch. The output unit 40 outputs the compressed symbol "11" and CMark = 3 in accordance with the latches 28 and 26 of L5 and the states thereof.

In addition, in a case in which each symbol forming the symbol string used as the input to the compression device 200 in the above-described operation example is an 8-bit ASCII code, the number of bits of the symbol string is 144 bits. Here, in a case in which the CMark has 3 bits, the number of bits of the output of the compression device 200 is 79 bits. Thus, a compression ratio of 54% is achieved.

Here, the relation among the number of tables of the compression device based on the decrement scheme, the number of symbols handled by each table (the number of symbols registered in one entry), and the offset number will be described. An offset of the number of symbols, which are handled by each table, according to an increase in the number of tables is defined as offset. In addition, the sum of all tables including the table T0 is defined as N. Parameters of the decrement scheme in this case are as follows. The number of symbols S(0) = 1 (n = 0), S(n) = 1+(N-n)×offset (n > 0) handled by the table Tn (n = 0, 1, 2, 3 ..., N-1). The number of tables after a certain table is considered. The number of tables after the n-th (k = 0, 1, 2, ..., N-1) table Tn is Tdiff(n) = N-1-n. The relation between the number of symbols handled by T(n) and Tdiff(n) is S(0) = 1 and Tdiff(0) = N-1 when n = 0. Since S(0)- Tdiff(0) = 1-N+1 = 2-N, the number of symbols of T0 is 1, and when N > 1, it does not have any influence beyond the table at the subsequent stage. When n > 0, it the following is satisfied. S(n)-Tdiff(n) = 1+(N-n)*offset-(N-1-n) = 1+N*offset-n*offset-N+1+n = 1+(N-n)*offset-(N-n)+1 = 2+(N-n)*(offset-1). Therefore, since N > n, when offset > 1, S(n) > Tdiff(n), and it necessarily has an influence beyond the preceding table. Therefore, the total number Na of adjustment latches (latch adjustment units 31) is as follows. Na = max(2+(N-n)*(offset-1)), where 0 < n <= N-2. Since the values of N, n, and offset are statically determined when the pipeline configuration is determined, Na can be statically determined. For example, in the decrement scheme, when the number of tables is N = 4 and the offset number is 2, the number of symbols registered in one entry of the table T1 becomes 7, the number of symbols registered in one entry of the table T2 becomes 5, and the number of symbols registered in one entry of the table T3 becomes 3. At this time, in a case in which the conversion to the compressed symbol is performed in the table T1, 7 stages (latches 28) are required at a subsequent stage. Here, since the tables T2 and T3 (compression units 220b and 220c) are present at the subsequent stage to the table T1, the number of adjustment latches (latch adjustment units 31) becomes 5, which is obtained by subtracting 2 from 7.

### <Decompression Device>

Figs. 106 and 107 are diagrams illustrating a configuration example and an operation example of a decompression device 300A based on the decrement scheme. The decompression device 300A has substantially the same configuration as the decompression device 300. However, it is different from the decompression device 300 based on the increment scheme in that a decompression unit 310b has a table T3 (the number of registered entries = 2) and a decompression unit 310d has a table T1 (the number of registered entries = 4).

The operation of the decompression device 300A is substantially the same as that of the decompression device 300. In the examples illustrated in Figs. 106 and 107, 11 pairs of compressed symbols and CMarks are input as inputs to the decompression device 300A. Fig. 106 illustrates an operation performed in a case in which a pair of a first compressed symbol and CMark (4, A) is input. In addition, Fig. 107 illustrates an operation performed in a case in which a pair of a last compressed symbol and CMark (3, 11) is input. Since the operation is the same as that of the decompression device 300, a detailed description thereof will be omitted. For the input, an output of the symbol string "ABCDABCDABCABCABCD" is obtained. In other words, the input to the compression device 200 is restored.

According to the third embodiment, similarly to the increment scheme, the compression device 200 based on the decrement scheme can convert one or two or more original symbols into a compressed symbol having the number of bits or less. In addition, similarly to the increment scheme, the decompression device 300A based on the decrement scheme can restore a compressed symbol (bit string) input to the compression device 200 to the original symbol as the origin.

In addition, at least one of the entropy calculation, the entropy culling, and the proximity entry exchange can be applied to the compression device 200 and the decompression device 300A.

### [Fourth Embodiment]

Next, a compression device and a decompression device according to a fourth embodiment will be described.

### <Compression Device>

Figs. 108 and 109 are diagrams illustrating a configuration example of a compression device 200A according to the fourth embodiment. The compression device 200A has a configuration similar to the compression device 200. However, the following configuration is added. In other words, as illustrated in Fig. 108, for example, in a case in which the table search result of the table T1 becomes a hit, latches 28 after the hit table T1 (the latches 28 of L2 to L4 in the example of Fig. 108) are invalidated in a next cycle.

In other words, in a case in which the table search result is a hit, the original symbol or the original symbol string hit in the table is invalidated, and the registration of the original symbol in the table downstream of the hit table is avoided (prohibited). By employing the configuration, in a case in which the compression device 200A is implemented by software (a processor and a memory), the amount of calculation of registration and search in the table can be reduced, and high-speed of the process can be achieved. In addition, in a case in which the compression device 200A is implemented by hardware (a circuit), the number of active circuits is reduced, and a power saving effect can be expected.

As illustrated in Fig. 109, in the fourth embodiment, for example, an original latch control unit 60 that supplies a control signal for each latch 28 is prepared. The original latch control unit 60 receives the hit information described in the first embodiment from each compression unit 220 and sends a control signal Invalidate (invalidation) for a latch 28 selected from L1 to L5 in accordance with the pattern of the hit information.

Fig. 110 is a table illustrating a correspondence relation between a pattern of table hit/miss and an input to an original latch. In Fig. 110, the correspondence relation is illustrated for each of cases in which the numbers of tables are 2, 3, and 4. The original latch control unit 60 stores the data of a table, reads a pattern of the control signal according to the pattern of input (received) hit information from the table, and sends the pattern to the compression unit 220 and the latch adjustment unit 31.

Fig. 111A is a diagram illustrating an operation example of the compression device 200A according to the fourth embodiment. The operation of the compression device 200A is the same as the operation of the compression device 200 except for an operation relating to the control of the original latch (latch 28).

In the operation example, an original symbol string illustrated in Fig. 111A is input to the compression device 200A. Fig. 111A illustrates an operation in a cycle when a symbol "A" is input after a symbol string "ABCDABCD" is input. In this cycle, the result of the table search of the table T0 in the compression unit 10 becomes a hit, and the entropy calculation is performed. Since the number of entries in use is 4, the entropy value becomes ceil(log₂4) = 2. Since the hit count value reaches the threshold value = 2, culling is performed in the update of the table T0, and the table T0 is brought into a state in which "B", "A", and "C" are registered from the highest-level entry. In addition, the compressed symbol "11", CMark = 0, and the entropy value = 2 are output from the compression unit 10 to the next stage.

In the compression units 220a and 220c, the table search result becomes a hit, and in the compression unit 220b, the table search result becomes a miss. At this time, although the process illustrated in Fig. 82 is performed, the compressed symbols obtained in tables other than the table T0 are not maintained in the latches of L2 to L4, and thus the result of the hit in the compression unit 220c (the table T3) is not changed to a miss. The hit information sent to the global latch control unit 50 becomes "hit, miss, hit", and the global latch control unit 50 supplies a control signal in the pattern of "Latch, Hit, Purge, Purge, Purge" for L1 to L5. In addition, the entropy calculation is performed in each of the compression units 220a and 220c, and the entropy value = 0 and the entropy value = 1 are respectively calculated and are included in the output to the next stage. However, in neither of the compression units 220a and 220c, the hit count value reaches the threshold value, and thus the entropy culling is executed.

In addition, the pattern of the hit information sent from the compression units 220a to 220c to the original latch control unit 60 becomes "hit, miss, hit". In this case, the original latch control unit 60 sends the control signal Invalidate for the latches 28 of L2 to L5. In addition, Latch is sent to the latch 28 of L1.

Fig. 111B illustrates the state of the next cycle of the cycle illustrated in Fig. 111A. In the compression unit 10, the table search of the symbol "B" is performed, and the result becomes a miss. Thereafter, the table T0 is updated. In the compression unit 220a, the compressed symbol "11", CMark = 0, and the entropy value = 2 output from the compression unit 10 are taken into the latch 26 in accordance with the control signal Latch received in the previous cycle. In addition, a symbol "A" is taken into the latch 28 in accordance with the control signal Latch for the original latch. In the compression unit 220a, the table search is not performed, and the result becomes a miss. Thereafter, the table T1 is updated.

In the compression unit 220b, the compressed symbol "00", CMark = 1, and the entropy value = 0 from the previous stage are taken into the latch 26 in accordance with the control signal Hit received in the previous cycle. In addition, the latch 28 is invalidated in accordance with the control signal Invalidate for the original latch. In accordance with this, in the compression unit 220b, registration into the matching register 21, a table search, and table update are not performed. The hit information for the global latch control unit 50 and the original latch control unit 60 becomes a miss.

In the compression unit 220c, Purged is set in the state of the latch 26 in accordance with the control signal Purge received in the previous cycle. In addition, the latch 28 is invalidated in accordance with the control signal Invalidate for the original latch. In accordance with this, in the compression unit 220c, registration into the matching register 21, a table search, and table update are not performed. The hit information for the global latch control unit 50 and the original latch control unit 60 becomes a miss. In addition, all the patterns of the hit information in this cycle become a miss, and all the control signals for L1 to L5 from the global latch control unit 50 and the original latch control unit 60 become Latch.

The latches 28 (L4 and L5) of the latch adjustment units 31a and 31b are invalidated in accordance with the control signal Invalidate. In addition, the state of each latch 26 (L4 and L5) becomes Purged in accordance with the control signal Purge. In this way, the symbol string "ABCD" hit in the table T1 is invalidated on the original symbol pipeline. The output unit 40 does not perform an output on the basis of the maintained content and the state of the latch 26 in a cycle in which the maintained content of the latch 28 of L5 is invalidated. In accordance with such operations, the original symbol or the original symbol string converted into the compressed symbol is invalidated.

Fig. 112 is a flowchart illustrating a process example of the decompression device according to the fourth embodiment. The process of Fig. 112 is executed by the decompression device 300B (Fig. 113) according to the fourth embodiment.

In Step S161, for a pair of the compressed symbol and a CMark (inputs to the decompression device 300B), the decompression device 300B sets the table specified by the CMark among the N tables as Tk (0 < k < N). The length of the symbol string hit in a case in which Tk is searched using the compressed symbol is D = N-k+1.

In Step S162, the decompression device 300B distributes D symbol strings to the table Tp for which 0 ≤ p < k is satisfied. In Step S163, in a case in which p > k, only the leading (D-p+k) symbol strings among the D symbol strings are distributed. However, when k = 0, in other words, for the compressed symbol of T0, one symbol is distributed to Tp for which k < p (handled similarly to the original symbol).

### <Decompression Device>

Fig. 113 is a diagram illustrating a configuration example and an operation example of the decompression device 330B according to the fourth embodiment. The decompression device 300B has a configuration similar to that of the decompression device 300A. However, as options, the entropy calculation, the entropy culling, and the proximity entry exchange are applied. These can be omitted. 10 pairs of the compressed symbol and the CMark illustrated in Fig. 113 are input to the decompression device 300B.

Figs. 113, 114, 115, and 116 illustrate operations performed in a case in which an input "(1,)" having no compressed symbol is input to the decompression device 300B. In this case, since CMark = 1, the decompression unit 310d operates in a search mode (first mode) of the table T1. Prior to the search, the decompression unit 310d performs the entropy calculation and, when the calculation result becomes 0, reads 0 bit of the compressed symbol from the bus and expands it to the number of bits of the index of the table T1. In accordance with this, the index "00" is obtained. In accordance with the search for the index "00", the symbol string "ABCD" is hit, and this symbol string is written into the FIFO 313. In accordance with this, the first symbol "A" in the symbol string is sent out to the bus 303 and becomes the output of the decompression device 300B. The decompression units 310a to 310c take in the symbol "A".

Following the sending-out of the symbol "A", symbol "B" and symbol "C" are sent out to the bus 303. Here, the number of tables N = 4, the value of k specified from the CMark is k = 1, and the number of symbols D is D = 4. For this reason, 3 symbols from the head are distributed for the table T2, and 2 symbols from the head are distributed for the table T3.

In Fig. 114, the symbol "B" in the symbol string is sent out to the bus 303 and becomes the output of the decompression device 300B. The decompression units 310a to 310c take in the symbol "B". In the decompression unit 310a, since the table search result becomes a hit, the entropy culling and the proximity entry exchange are performed.

In Fig. 115, the symbol "C" in the symbol string is sent out to the bus 303 and becomes the output of the decompression device 300B. The decompression units 310a and 310c take in the symbol "C", but the decompression unit 310b does not take in the symbol "C" (the symbol "C" is not distributed). In this way, the decompression unit 310 having a table in which the number of symbols registered in the entry is smaller than the number of symbols sent out from the FIFO 313 (4 in this operation example) does not take in the symbol of a portion exceeding this number of symbols from the bus 303.

In Fig. 116, the symbol "D" in the symbol string is sent out to the bus 303 and becomes the output of the decompression device 300B. While the decompression unit 310a takes in the symbol "C", the decompression units 310b and 310c do not take in the symbol "D" (the symbol "D" is not distributed).

When the decompression process for all the inputs is completed in accordance with the operations described above, a symbol string "ABCDABCDABCABCABCD", which is the output of the compression device 200A, is obtained as the output of the decompression device 300B.

Also in the compression device and the decompression device according to the fourth embodiment, a plurality of symbol strings can be compressed into one compressed symbol, and the amount of the data of the output of the compression device can be reduced. Furthermore, the decompression device can restore the input to the compression device.

### [Fifth Embodiment]

As a fifth embodiment, a configuration (method) for reducing the number of bits of the CMark in the compression device and the decompression device described in the first to fourth embodiments will be described. When the number of tables is N, a CMark requires ceil(log_2(N+1)) bits. Furthermore, whether it is a compressed symbol or an original symbol, the bits of the symbol are necessarily included in the compressed data. For this reason, when the number of compressed symbols is S, ceil(log_2(N+1))×S bits are included as the Cmark in the compressed data. A large proportion of this number of bits in the compressed data becomes a problem in reducing the amount of data of the compressed data.

While the CMark maintains a number representing an original symbol (non-compression) or a number of a table used for compression, the table used at the time of compression is biased due to the entropy of data. Based on rough data, cases containing three or more consecutive symbol strings are rare. For this reason, by assigning a short bit string of the CMark to a small number of symbol strings, the total of the bit strings of CMarks included in the compressed data can be reduced.

Fig. 117 illustrates a configuration example of a compression and decompression system according to the fifth embodiment. In Fig. 117, the compression and decompression system includes a compression device 100, a decompression device 300, an encoder 110, and a decoder 120. The compression device and the decompression device may be a pair of the compression device and the decompression device described in the second to fourth embodiments. The encoder 110 may be a part of the compression device or a device independent of the compression device. In addition, the decoder 120 may be a part of the decompression device or a device independent of the decompression device.

The encoder 110 encodes the number of the CMark and converts it into a bit string. The Cmark may be either a big endian or a little endian, but the most significant bit (MSB) can be correctly recognized by determining in advance whether the compression device side and the decompression device side use the same endian. The decoder 120 converts the code of the CMark into the number of the CMark in accordance with the endian. The bit string converted by the encoder 110 is transmitted to the decoder as a compressed data stream. The number of the CMark obtained by the conversion in the decoder 120 is input to the decompression device 300.

Fig. 118 is an explanatory diagram of a method for reducing the number of bits of the CMark. In a case in which the number of tables is N, as illustrated in Fig. 118, codes of 1 to N bits can be assigned to CMark = 0 to 4. At this time, the correspondence relation between the CMark and the code is determined such that the number of the table and the corresponding number of the original symbol (non-compression) do not overlap.

There are the following two methods for assigning CMark and codes. One is static assignment. The static assignment is a method of assigning a code to the CMark in advance in compliance with a certain rule. A simple method in which a shorter code is assigned in order from the table T0, and a code of all 1's is assigned to the CMark of the original symbol may be used. Alternatively, a statistical method in which the characteristics of data are investigated in advance, and a shorter code is assigned in order from a highest appearance frequency of the CMark may be used. Another method is dynamic assignment. The dynamic assignment is a method in which the number of times of appearances of the CMark is monitored at the time of compression, and a shorter code is assigned to a CMark having a higher appearance frequency.

Fig. 119 is an explanatory diagram of a method of statically assigning codes (assigning in order) to the CMark. Fig. 119 illustrates an example in which a Huffman code is assigned to the CMark output together with a compressed symbol as compressed data. The correspondence relations between the CMark and a code in a case in which the number of tables is 2 to 6 are illustrated.

Fig. 120 is an explanatory diagram of a method of statically assigning codes to the CMark (on the basis of statistics). Fig. 120 illustrates an example in which a Huffman code is assigned to the CMark output as a compressed symbol on the basis of a statistical appearance ratio. For example, in a case in which the numbers of times of appearances of CMarks when the number of tables is 6 are contents illustrated in Fig. 120, it is conceivable to assign a minimum number of bits to the most frequent CMark, in other words, to assign a shorter code to a CMark with a higher appearance frequency. In this method, a configuration in which code assignment is dynamically changed by taking statistics of the numbers of appearances on the compression side and the decompression side may be employed.

Fig. 121 is a diagram illustrating an example of assignment of static CMark codes. In the example of the compressed data (a pair of a compressed symbol and a CMark, the number of tables: 4) illustrated in Fig. 121, the bit string of the compressed data is 77 bits. The bits of the CMark in this bit string are 30 bits. The number of appearances of each number of CMarks was 5 times for CMark = 4, 1 time for CMark = 1, 1 time for CMark = 3, 2 times for CMark = 2, and 1 time for CMark = 0.

Examples of assignments and the number of bits in the case of static assignment (assignment in order) and in the case of static assignment (based on statistics) are as illustrated in Fig. 121. The number of bits in the case of static assignment (assignment in order) becomes 22, which is reduced from the original number of bits. In addition, the number of bits in the case of static assignment (based on statistics) is 20 bits, and also in this case, is reduced from the original number of bits.

Fig. 122 is a diagram illustrating a method (complete method: first method) of dynamically assigning codes to CMarks. In the static assignment method, since the characteristics of data are not known in advance, the distribution of CMarks may be incorrect. Thus, while the statistical information is updated when the compressed symbol is output from the compression device, the correspondence between the number of the CMark and the code is adaptively determined.

On the compression side, after encoding is performed using the statistical information at the output timing, the encoder 110 updates the statistical information. Similarly, on the decompression side, the decoder 120 decodes using the statistical information at the input timing and updates the statistical information. By configuring as such, consistency of the CMark code can be obtained between the compression side and the decompression side.

More specifically, a configuration in which the compression side and the decompression side (for example, the encoder 110 and the decoder 120) include tables for managing statistical information as illustrated in Fig. 122 is employed. In the table, an assigned code and the number of appearances of the CMark are stored in an entry for each number of the CMark. For example, in a case in which CMark = 2 is output from the compression device 100, the encoder 110 converts CMark = 2 into a code "110" and outputs the code. At this time, the appearance count value of the entry of CMark = 2 in the table is incremented, and its rank moves to the highest level (the smallest bit "0" is assigned). When the code "110" is received, the decoder converts the code into CMark = 2 in accordance with the table and inputs it to the decompression device 300. At this time, the table included in the decoder 120 is updated similarly to the table included in the encoder. In this way, as the appearance count number increases, a code with a smaller number of bits is assigned to the CMark.

Figs. 123 and 124 illustrate a case in which the code assignment method (the first method) using the tables illustrated in Fig. 122 is applied to the compressed data illustrated in Fig. 121. The total value of the numbers of bits of the encoded CMarks is 25 bits, which is reduced when compared with the original number of bits = 30.

Fig. 125 is a diagram illustrating a method of dynamically assigning codes to CMarks (Lazy method: second method). In the first method, the rank of the CMark may change greatly. However, the calculation cost when this configuration is employed may become enormous. Thus, the count number is compared with that of the entry having the rank one level higher, and when this count number is larger than that, the ranks are exchanged.

As illustrated in Fig. 125, the format of the tables included on the compression side and the decompression side is the same as that according to the first method. However, it differs from the first method as follows. In a case in which CMark = 2 is converted into a code "111", the appearance count number of CMark = 2 is incremented. This appearance count number is compared with the appearance count number (= 0) of CMark = 1, the rank of which is one level higher than CMark = 2. In this case, since the appearance count number of CMark = 2 is larger than that of CMark = 1, the rank of CMark = 2 and the rank of CMark = 1 are interchanged, and the corresponding codes are changed. As a result, the number of bits of the code of CMark = 2 having a high appearance frequency becomes small. Also on the decompression side, a similar process is performed when the code "111" is converted to CMark = 2, and the content of the table is updated to the same content as that on the compression side.

In the second method, since the numerical value by which the appearance count number increases is +1, the rank (ranking) does not change by 2 or more. The same effect as that of sorting can be obtained by exchanging ranks with one level above. Although a little overhead occurs before the correct rank is obtained, if a large amount of compressed data flows, the state becomes the same as that of the sorting.

Figs. 126 and 127 illustrate a case in which the code assignment method (second method) using the tables illustrated in Fig. 125 is applied to the compressed data illustrated in Fig. 121. The total value of the number of bits of the encoded CMarks is 33 bits, which is increased from that of the first method, but gradually approaches the result of the first method as the amount of the compressed data increases.

Fig. 128 is an explanatory diagram of denomination of the appearance count number. In a case in which the appearance count is maintained by a computer, since the number of bits that can be maintained is finite, there is a possibility of overflow. Thus, denomination (reduction of unit) of the number of appearances is regularly performed. At this time, the entry having the top rank (appearance count number) may be monitored.

In Fig. 128, an example in which the denomination is performed in a case in which the appearance count number reaches 10000 is illustrated. In a case in which CMark = 4 is output on the compression side, the appearance count number reaches 1000. Then, the count numbers of the entire table are changed to numerical values after the denomination (1/10 in the example of Fig. 128). Also on the decompression side, similar denomination is executed triggered by an input of code "0" corresponding to CMark = 4.

### [Sixth Embodiment]

As a sixth embodiment, an exception symbol will be described. The "exception symbol" is a function of sending a message to a setting of the decompression device or a back end of the decompression device by giving a special meaning to the compressed symbol. The compression device can apply the exception symbol as an option. The exception symbol is notified from the compression device to the decompression device at a timing at which an exception is desired to occur. There are two methods for the exception symbol including a method using a CMark and a method using a table operation of the table T0.

In the method using the CMark, a CMark indicating an exception is used and is packed together with the compressed data. Since the exception can be multiplexed to the compressed data, the stream does not need to be stopped. In the method using the table operation of the table T0, the error state of the decompression unit having the table T0 is used. A dedicated cycle for inserting an exception symbol is generated. This method has an advantage that the number of bits of the CMark does not need to be increased.

By adding a number of an exception symbol to the Cmark included in the compressed data, the exception state can be notified to the decompression device. By preparing an Exception input in the compression device (Fig. 129) and causing this input to propagate through the compressed symbol pipeline, the compressed symbol at the timing at which the exception has occurred and a CMark indicating the exception symbol can be output.

As for the exception symbol, only the occurrence of an exception is transmitted to the decompression device. However, in a case in which a message accompanying the exception symbol is included, data stored in the exception message FIFO is output bypassing the compression device. When the decompression device receives an exception symbol, the decompression device activates an Exception output immediately after the decompression process for the compressed symbol corresponding to the exception symbol. On the other hand, in the decompression process in a case in which a message accompanies an exception symbol, after the Exception output becomes active, a message of a length determined in advance on the compression side by the CMark indicating the exception symbol is received and written to a message buffer. After that, the Exception output is made inactive.

As CMarks in a case in which e (e is a positive integer) types of exception symbols are supported, (N+1)+e*((N+1)+1) CMarks need to be defined in a compressor having N tables. An increase in the number of types e of exceptions means an increase in the number of bits of the CMark, which is not necessarily preferable. e is set to 1 as much as possible, and the type is determined using the exception message. For example, CMarks in a case in which the number of tables is 4 and the exception type is 1 are as follow.
- Original symbol (non-compression) 0
- T0 10
- T1 110
- T2 1110
- T3 11110
- Original (exception) 111110
- T1 (exception) 1111110
- T2 (exception) 11111110
- T3 (exception) 111111110
- NULL (exception) 111111111

Fig. 129 is a diagram illustrating a configuration example of the compression device 100C according to the sixth embodiment. The compression device 100C is a compression device based on the increment scheme, and a latch 70 maintaining a state Exception (the notation in the drawing is "Ex") is added to each of the compression units 20a to 20c and the latch adjustment units 31a to 31d included in the compression device 100C. In addition, a FIFO 71 for exception messages is provided.

An Exception input and an exception message input are added to the compression device 100C. The Exception input is caused to propagate through the pipeline of the latch 70. The exception message is input to the FIFO 71. After the exception message is written to the FIFO 71 first, the Exception input is activated for 1 cycle. In accordance with this, the timing of the exception symbol propagates through the pipeline. In a case in which the output unit 40 outputs the symbol maintained in the latch L7 in the cycle in which the Exception input has been received, the output unit 40 outputs the compressed symbol together with a CMark for the exception. In a case in which the state of the latch is Purged or Invalid, the output unit 40 outputs a CMark for NULL (see the table illustrated in Fig. 131).

Fig. 130 is a diagram illustrating a configuration example of the compression unit 20 according to the sixth embodiment. The latch 70 for Exceptions is added. The Exception is latched from the immediately preceding compression unit 10 or 20, and is caused to propagate to the immediately succeeding compression unit 20 or latch adjustment unit 31. The number of bits of the Exception maintained in the latch 70 changes in accordance with the type of the exception. In a case in which e types of exceptions are supported, the number of bits of the Exception becomes ceil(log_2(e))+1 bits. For example, in a case in which e = 3, 0xx is defined as exception invalidity, 1xx is defined as validity, and "100", "101", and "110" are assigned to three types of exceptions. Fig. 131 is a diagram illustrating a configuration example of the latch adjustment unit 31. An Exception input and an Exception output, an input from the exception message FIFO 71, and an output of the exception message are added. The Exception output is activated when the exception symbol is output. While the Exception output is activated, the output of the exception message input from the FIFO 71 becomes valid. In the implementation, the Exception output is activated at the output timing of the compressed symbol including the exception symbol, and the output of the exception message becomes valid from a cycle thereafter. As the value of the CMark when the Exception input is active, a value corresponding to the type of exception is selected.

Figs. 132A and 132B are explanatory diagrams of an exception symbol according to a table operation of the table T0. An exception is caused to occur by causing a contradiction (error) in the table operation of the table T0 provided in the decompression device (in other words, performing an error operation). The compressed symbol obtained in the table T0 is necessarily 1 symbol. For this reason, an exception occurs when this compressed symbol is processed in the decompression device. At the time of compression, an error is embedded in the original symbol. For example, as illustrated in Fig. 132A, it is conceivable to intentionally make a table search result for an original symbol, which has already been registered in the table T0, a miss.

In addition, as illustrated in Fig. 132B, it is conceivable to intentionally hit an unused entry in the table T0 and output the index of the entry as a compressed symbol. At this time, a false symbol is output to the original symbol pipeline. The false symbol may be Invalid. For example, the entry of the index "11" in Fig. 132B is in a reserved state in an unused state (a state not used for registration of a symbol), and this index "11" is used as an exception symbol.

Fig. 133 is an explanatory diagram of the exception symbol according to the operation of the table T0 and is a diagram explaining global latch control of the exception symbol (in the case of the increment scheme). In Fig. 133, each of the compression units 20a to 20c and the latch adjustment units 31a to 31c of the compression device 100C includes the latch 70 that maintains the Exception. The latch 70 forms an Exception pipeline, and the Exception signal (pulse) input to the compression unit 10 propagates. In a case in which the number of tables is n, the latch adjustment unit 31 of L(2n-1), that is, the latch adjustment unit 31d including the latches 28 and 26 of L7, does not need to include the latch 70. The state of the latch 70 is input to the global latch control unit 50. In a case in which the Exception is set in any one of the latches 70, the global latch control unit 50 sends a control signal (all Latch) for L1 to L7 in a case in which all the table search results of the tables T1 to T3 are misses.

The false symbol described with reference to Fig. 132B propagates through the original symbol pipeline and is taken into the latch 28. However, in the compression unit 20 or the latch adjustment unit 31 having the latch 28 that has taken in the false symbol, in a case in which the Exception is set in the latch 70, the latch 28 is not taken into the matching register 21. Accordingly, a table search and registration for the false symbol are not performed.

Fig. 134 is an explanatory diagram of the exception symbol according to the operation of the table T0 and is a diagram explaining the global latch control of the exception symbol (in the case of the decrement scheme). The compression units 20a to 20c and the latch adjustment unit 31a included in the compression device 100D include the latch 70 for the Exception. The signal (pulse) of the Exception input to the compression unit 10 propagates in the pipeline formed by the latch 70. In a case in which the number of tables is n, the latch adjustment unit 31 of L(n+1), that is, the latch adjustment unit 31b, does not need to have the latch 70. The state of each latch 70 is input to the global latch control unit 50. In a case in which the Exception is set in any one of the latches 70, the global latch control unit 50 determines that all the hit information of the compression units 20a to 20c is a miss and sends Latch for L1 to L5.

Fig. 135A is a flowchart illustrating a process example of the global latch control unit 50 in the increment scheme, and Fig. 135B is a flowchart illustrating a process example of the global latch control unit 50 in the decrement scheme. The processes illustrated in Figs. 135A and 135B start when the global latch control unit 50 receives hit information from each of the compression units 20a to 20c.

In Step S171 in Fig. 135A, the global latch control unit 50 determines whether or not an Exception is set in L1 to L(2n-1), that is, the latches 70 of L1 to L6. In a case in which it is determined that the Exception is set, all the hit information is changed to a miss (Step S172). In other words, when there is hit information representing a hit, the hit information is changed to a miss. On the other hand, in a case in which it is determined that no Exception is set, the hit information is not changed (Step S173). Thereafter, the global latch control unit 50 sends a control signal for L1 to L7 in accordance with the pattern of the hit information.

In Step S181 in Fig. 135B, the global latch control unit 50 determines whether or not an Exception is set in L1 to L(2n-1), that is, the latches 70 of L1 to L6. In a case in which it is determined that the Exception is set, all the hit information is changed to a miss (Step S182). In other words, hit information representing a hit is changed to hit information representing a miss. On the other hand, in a case in which it is determined that no Exception is set, the hit information is not changed (Step S183). Thereafter, the global latch control unit 50 sends a control signal for L1 to L7 in accordance with the pattern of the hit information.

Fig. 136 illustrates the decompression device 300B based on the increment scheme. In the compression device 100C, the exception symbol generated using the method illustrated in Fig. 132A is not compressed after the compression unit 20b and is output from the compression device 100C as an original symbol (for example, (4, C)). In the decompression device 300B, in a case in which the process for the exception symbol (4, C) has been performed, the decompression unit 310a takes the symbol "C" output from the DMUX 301 to the bus 303 into the register 312 and performs a table search. However, since the symbol "C" has already been registered, a contradiction occurs. At this time, the decompression unit 310a stops the registration of the symbol "C" (also deletes it from the register 312) and outputs an active exception occurrence signal. In this way, an exception is notified to the decompression device 300B. The exception occurrence signal is transmitted to the decompression units 310b to 310d. The decompression units 310b to 310d do not perform taking-in of the symbol from the bus 303 and registration thereof in the table while the exception occurrence signal is active. In addition, at a time point at which the symbol "C" is output from the DEMUX 301 to the bus 303, the output from the decompression device 300B is in the state of Valid = 0 (invalid). In a case in which the exception occurrence signal is output, Valid = 0 is maintained, and the symbol "C" is not output from the decompression device 300B.

Fig. 137 illustrates the decompression device 300C based on the increment scheme. In the compression device 100C, the exception symbol generated using the method illustrated in Fig. 132B is output from the compression device 100C as a compressed symbol (for example, (0, 11)). In the decompression device 300C, in a case in which the process for the exception symbol (0, 11) has been performed, a table search is performed in the decompression unit 310a, and an attempt is made to read the symbol registered in the entry of the index "11". However, since the index "11" is an exception symbol, an error occurs due to no symbol being registered in the corresponding entry. Triggered by this error, the exception occurrence signal is output. In this way, the decompression device 300C is notified of the exception on the compression side. The exception occurrence signal is transmitted to the decompression units 310b to 310d. The decompression units 310b to 310d do not perform taking-in of a symbol from the bus 303 and registration thereof into a table while the exception occurrence signal is active. In addition, while the exception occurrence signal is output, Valid = 0 (invalid, inactive) of the output of the decompression device 300C is maintained, and there is no output from the decompression device 300C.

In addition, the configuration illustrated in Fig. 136 or Fig. 137 can be applied also to the decompression device based on the decrement scheme. In addition, in a case in which it is desired to accompany data to the exception symbol (for example, in a case in which there is a parameter for the exception), when the format of the parameter is known in the decompression device, the corresponding data may be compressed (it can be restored by the decompression device).

### [Seventh Embodiment]

As a seventh embodiment, a serializer and a deserializer will be described. Fig. 138 illustrates a compression and decompression system according to a seventh embodiment. The output from the compression device 100 is connected to a certain information device 170. In this case, it is necessary to align the output to a data width supported by the information device 170. In addition, in the decompression device 300, it is necessary to convert the data output from the information device 170 into a data stream that can be interpreted by the decompression device 300.

The serializer 150 aligns the output of the compression device 100 into a data stream having a determined K-bit width. The deserializer 160 converts the K-bit data stream into a bit stream that can be input to the decompression device 300.

From the compression device 100, for example, a CMark, a compressed symbol, and a bit width (entropy) of the compressed symbol are output. The serializer 150 uses these to write only valid bits to a shift register 151 included in the serializer 150. The serializer 150 outputs a data stream in units of the leading K bits of the shift register 151. The deserializer 160 inputs the K-bit data stream to a shift register 161, takes out the CMark and the compressed symbol in accordance with CMark bits of the decompression device 300 and the number of bits of the compressed symbol according to entropy calculation, and sends them to the decompression device 300.

In Fig. 138, the serialization and deserialization using the compressed data as an example described until now are illustrated. Here, K = 8. It is assumed that a transmission path outside the compression device 100 is a big endian. The bit string of the compressed data is 77 bits, and CMarks in the bit string are 30 unencoded bits. In addition, the original data is an ASCII code. Furthermore, while the remaining bits are padded, an exception symbol representing the end may be inserted at the end of the compressed data stream such that the number of padded bits can be ignored.

Fig. 139 is a diagram illustrating an example of the compression and decompression system. Since the compressed data includes original symbols, it cannot be completely concealed. Thus, as illustrated in Fig. 139, the data is encrypted by combining XOR encryption immediately after the compression device 100. The encryption method may be other than the XOR encryption. Among the bit streams output from the compression device 100, encryption is performed in units of R bits. An R-bit encryption key is set, and data is obfuscated by taking an XOR of the compressed data and the encryption key. This encryption key may be shifted entirely after the XOR is executed in units of the R bits, and overflowed bits may be cyclically substituted to the opposite side. The decompression device 300 sets the same encryption key as that of the compression device 100 after reset. This can be handled using an exception symbol. By performing the same operation as that of the compression device 100 on the input compressed data in units of R bits, the compressed data can be restored to compressed data that can be interpreted by the decompression device 300.

In the increment scheme described in the embodiments, the number of symbols that can be registered in each entry of tables after T1 increases in accordance with the number of stages. On the other hand, in the decrement scheme, the number of symbols that can be registered in each entry of tables after T1 decreases in accordance with the number of stages (however, the minimum value of the number of symbols is 2). On the other hand, some stages among the plurality of stages may be configured based on the increment scheme, and a stage positioned before or after the stages may be configured based on the decrement scheme.

In addition, in the embodiments, in case of the increment scheme, a configuration in which the number of symbols that can be registered in the entries of the tables after T1 increases by one each time (offset number 1) is employed, and in case of the decrement scheme, a configuration in which the number of symbols that can be registered in the entries of tables after T1 decreases by one each time (offset number 1) is employed. However, the offset number may be 2 or more. In this case, the control pattern of the latch 26 is changed in accordance with the offset number.

### [Eighth Embodiment]

A compression device and a decompression device according to an eighth embodiment will be described. Fig. 140 is a diagram illustrating a configuration example of the compression device 100D according to the eighth embodiment. The compression device 100D is a modified example of the compression device 100 (Figs. 1 and 2) described in the first embodiment. The compression device 100D includes a compression unit 10, a latch adjustment unit 31 provided in a subsequent stage to the compression unit 10, and an output unit 40 provided in a subsequent stage to the latch adjustment unit 31. In other words, the compression device 100D has a configuration in which the compression units 20a to 20c and the latch adjustment units 31b to 31d are excluded from the compression device 100 according to the first embodiment. Similarly to the compression device 100, the compression device 100D also includes an original symbol pipeline and a compressed symbol pipeline, and a latch 26 of L1 latches a compressed symbol and a CMark, and a latch 28 latches an original symbol.

Since the configurations and operations of the compression unit 10, the latch adjustment unit 31, and the output unit 40 are the same as those according to the first embodiment, the descriptions thereof will be omitted. However, in each cycle, the latch adjustment unit 31 receives only Latch as a control signal for the next cycle from the global latch control unit 50 and, in a case in which there is an output of a compressed symbol and a CMark from the compression unit 10, takes them into the latch 26 in the next cycle. In addition, the latch adjustment unit 31 may be programmed to perform an operation similar to that in the case of receiving the control signal Latch for each cycle. In this case, the global latch control unit 50 is not necessary. The output unit 40 performs an operation (output) in accordance with the table illustrated in Fig. 10 on the basis of the maintained contents and the states of the latches 26 and 28 of L1. In addition, the number of latch adjustment units 31 may be 2 or more. In a case in which the number of latch adjustment units 31 has been obtained in accordance with the rule according to the increment scheme, the number of latch adjustment units 31 is 1, and in a case in which the number of latch adjustment units 31 has been obtained in accordance with the rule according to the decrement scheme, the number of latch adjustment units 31 is 2.

Fig. 141 is a diagram illustrating a configuration example of the decompression device 300C according to the eighth embodiment. The decompression device 300C can form a pair with the compression device 100D. The decompression device 300C is a modified example of the decompression device 300 (Fig. 43) described in the first embodiment. The decompression device 300C has a configuration obtained by excluding the decompression units 310b to 310d from the decompression device 300. Since the configurations and operations of the DMUX 301 and the decompression unit 310 in the decompression device 300C are the same as those according to the first embodiment, the descriptions thereof will be omitted.

Also in the compression device 100D according to the eighth embodiment, one or two or more original symbols can be compressed into a bit string (compressed symbol) of the number of bits of the original symbols or less. In addition, according to the decompression device 300C, the bit string (compressed symbol) obtained through the compression can be returned to the original symbol as the origin. In addition, the configurations described in the first to eighth embodiments can be combined in a range not departing from the object of the invention. For example, in the compression device 100D and the decompression device 300C according to the eighth embodiment, the configurations described in the other embodiments such as the entropy calculation, the entropy culling, and the proximity entry exchange described in the second embodiment, the exception symbol described in the sixth embodiment, and the obfuscation described in the seventh embodiment, can be appropriately combined.

The present disclosure discloses the following aspects (supplement notes) as embodiments.

(Supplement Note 1) A data compression device comprising:
a first pipeline having a plurality of stages in which each of a plurality of original symbols forming an original symbol string is capable of shifting to a next stage in a predetermined cycle while maintaining an input order;
a second pipeline in which a compressed symbol into which an original symbol is compressed shifts to a next stage in synchronization with the original symbol flowing through the first pipeline;
a first compression unit arranged at a first stage of or a preceding stage to the plurality of stages;
one or two or more second compression units arranged at a subsequent stage to the first compression unit;
an adjustment unit arranged at two or more stages subsequent to the one or two or more second compression units; and
an output unit arranged at a subsequent stage to the adjustment unit, wherein
the first compression unit has a first table having a predetermined number of entries in each of which one symbol is registered and executes:
   searching the first table using each of the plurality of original symbols input to the first pipeline one by one at a predetermined timing as a search target;
   converting an identical original symbol into the compressed symbol in a case in which the identical original symbol has been found from the first table;
   outputting the compressed symbol obtained by searching the first table and position information indicating a position at which compression information has been obtained to the second pipeline; and
   performing an update of the first table including registration of the original symbol that is a search target for each search of the first table,
   each of the one or two or more second compression units includes:
      a second table having a predetermined number of entries in which two or more symbols are registered;
      a first latch taking in an original symbol from a preceding stage;
      a second latch capable of taking in the compressed symbol and the position information; and
      a register capable of maintaining a predetermined number of original symbols taken into the first latch,
      each of the one or two or more second compression units, in each cycle, executes:
         controlling a maintained content or a state of the second latch in accordance with a control instruction for the second latch;
         searching the second table using a symbol string formed using the predetermined number of original symbols as a search target in a case in which the predetermined number of original symbols are stored in the register;
         converting the symbol string of the search target into a compressed symbol in a case in which the symbol string of the search target has been found;
         outputting the compressed symbol obtained by searching the second table and position information of the compressed symbol; and
         updating registered contents of the second table including registration of the symbol string of the search target in a case in which the search of the second table is performed,
         the number of the two or more symbols registered in the second table included in the one or two or more second compression units is a number obtained by adding a predetermined offset number to the number of symbols registered in the first table in a case in which the number of the second compression units is one and is in a state of increasing by a predetermined offset number or decreasing by a predetermined offset number as the stage advances in a case in which the number of the second compression units is two or more,
         the adjustment unit at least has the first latch and the second latch arranged at each stage of a number of stages equal to or greater than the number of symbols registered in each entry of the second table included in the second compression unit positioned at a final stage among the one or two or more second compression units and controls the maintained content or the state of each of the second latches included in the adjustment unit in accordance with the control instruction in each cycle, and
         the output unit outputs the original symbol and information indicating non-compression or the compressed symbol and the position information in accordance with the maintained content and the state of each of the first latch and the second latch included in the adjustment unit arranged at a final stage of the plurality of stages.

(Supplement Note 2) The data compression device described in Supplement Note 1, wherein the control instruction has a control pattern for each of the second latches according to a hit or miss state of a table search in the one or two or more second compression units in a previous cycle.

(Supplement Note 3) The data compression device described in Supplement Note 1, wherein the control instruction for each of the second latches included in the one or two or more second compression units and the adjustment unit is any one of the following (1) to (4) in a case in which the number of the two or more symbols registered in the second table included in the one or two or more second compression units is in a state of increasing by a predetermined offset number as the stage advances:
(1) taking the compressed symbol and the position information of the compressed symbol flowing through the second pipeline from an immediately preceding stage into the second latch;
(2) taking the compressed symbol and the position information of the compressed symbol obtained by the second compression unit present at an immediately preceding stage into the second latch;
(3) bringing the second latch into an invalidated state; or
(4) if the compressed symbol obtained by the first compression unit at the immediately preceding stage is valid, setting contents of the compressed symbol in the second latch and otherwise emptying the second latch in that cycle.

(Supplement Note 4) The data compression device described in Supplement Note 1, wherein the control instruction for each of the second latches included in the one or two or more second compression units (20) and the adjustment unit is any one of the following (1) to (3) in a case in which the number of the two or more symbols registered in the second table included in the one or two or more second compression units is in a state of decreasing by a predetermined offset number as the stage advances:
(1) taking the compressed symbol and position information of the compressed symbol flowing through the second pipeline from an immediately preceding stage into the second latch;
(2) taking the compressed symbol and position information of the compressed symbol obtained by the second compression unit at an immediately preceding stage into the second latch; or
(3) bringing the second latch into an invalidated state.

(Supplement Note 5) The data compression device described in Supplement Note 4, wherein, in each cycle, a first latch to be invalidated in a next cycle is determined among the first latches included in the one or two or more second compression units and the adjustment unit in accordance with a control instruction corresponding to a hit or miss status of a table search of the second table included in the one or two or more second compression units.

(Supplement Note 6) The data compression device described in Supplement Note 1, wherein, in a case in which there are two or more second compression units, the second compression unit in a second or subsequent stage changes a search result from a hit to a miss in a case in which a search result of the own second table is a hit and in a case in which a compressed symbol obtained by any one of the one or two or more second compression units is maintained in at least one of second latches other than the second latch positioned at a final stage among the second latches included in the second compression unit present at a third or subsequent stage and the second latch included in the adjustment unit.

(Supplement Note 7) The data compression device described in Supplement Note 1, wherein the compressed symbol is an index of an entry in which the symbol or the symbol string that is a search target is registered, and a size of the index is equal to or smaller than a size of the symbol or the symbol string that is the search target.

(Supplement Note 8) The data compression device described in Supplement Note 7, wherein each of the first compression unit and the one or two or more second compression units obtains an entropy value m from a following calculation equation using the number k of entries in use in the first table or the second table of its own and reduces the number of bits of the compressed symbol to m bits in a state in which a value of the compressed symbol is maintained: $m = ceil \left({log}_{2}k\right)$

(Supplement Note 9) The data compression device described in Supplement Note 1 or 8, wherein at least one of the first compression unit and the one or two or more second compression units deletes registered content of a predetermined entry in use in a case in which the number of times a result of a table search using the first table or the second table of its own becomes a hit reaches a predetermined number.

(Supplement Note 10) The data compression device described in Supplement Note 1, wherein each of the first compression unit and the one or two or more second compression units exchanges a position of an entry in which a hit symbol or a symbol string is registered with a position of an entry in use having a distance from the entry within a predetermined range in a case in which a result of a table search using the first table or the second table of its own becomes a hit.

(Supplement Note 11) The data compression device described in Supplement Note 1, further comprising a conversion unit that converts the position information and the information indicating non-compression into codes having smaller sizes on the basis of a conversion table.

(Supplement Note 12) The data compression device described in Supplement Note 11, wherein, in the conversion table, a correspondence relation between the position information and the information indicating non-compression, and the codes is statically set.

(Supplement Note 13) The data compression device described in Supplement Note 12, wherein the correspondence relation between the position information and the information indicating non-compression in the conversion table is updated in accordance with an appearance frequency such that a code with fewer bits is assigned as the appearance frequency of the position information and the information indicating non-compression increases.

(Supplement Note 14) The data compression device described in Supplement Note 1, wherein a bit string used as the position information or the information indicating non-compression is output as information indicating an exception.

(Supplement Note 15) The data compression device described in Supplement Note 1, wherein information generated by an error operation of the first table is output as information indicating an exception.

(Supplement Note 16) A data decompression device to which a pair of an original symbol and information indicating non-compression or a pair of a compressed symbol obtained by compressing one or two or more original symbols and position information indicating a position at which the compressed symbol has been obtained is input, the data decompression device comprising:
a first bus through which the compressed symbol flows;
a second bus through which the original symbol flows; and
a plurality of decompression units having a plurality of tables, which are used for generating the compressed symbol, having different numbers of symbols registered in one entry that include a first decompression unit having a first table in which the number of symbols registered in one entry is one and at least one second decompression unit having a second table in which the number of symbols registered in one entry is two or more, wherein
each of the plurality of decompression units:
   includes a first register and a second register;
   in a case in which an original symbol forming a pair on the basis of information indicating non-compression is sent out to the second bus, registers the original symbol in the first register;
   in a case in which the number of one or two or more original symbols maintained in the first register reaches the number of symbols registered in the one entry in the first or second table of its own, registers the one or two or more original symbols maintained in the first register in a predetermined entry of the first or second table; and
   in a case in which a compressed symbol forming a pair on the basis of the position information is sent out to the first bus and in a case in which the position information designates itself, specifies an entry using the compressed symbol flowing through the first bus as an index of the first or second table of its own, maintains one or two or more original symbols registered in the specified entry in the second register, and sends out the one or two or more original symbols maintained in the second register to the second bus one by one in an order of registration to the first register,
   the decompression unit not designated by the position information registers an original symbol sent out to the second bus from the designated decompression unit in the first register, and
   the original symbol sent out to the second bus becomes an output of the data decompression device.

(Supplement Note 17) The data decompression device described in Supplement Note 16, wherein, in a case in which the compressed symbol has a reduced number of bits in the data compression device, the decompression unit designated by the position information uses the number k of entries in use in a table indicated by the position information to perform calculation of E using the following calculation equation and uses a value obtained by expanding E bits which is the number of bits of the compressed symbol to an index width of the table in a state in which a value indicated by the compressed symbol is maintained as the index of the table. $E = ceil \left({log}_{2}k\right)$

(Supplement Note 18) The data decompression device described in Supplement Note 16 or 17, wherein at least one of the plurality of decompression units deletes registered contents of a predetermined entry in use in a case in which the number of times a result of a table search using the first table or the second table of its own becomes a hit reaches a predetermined number.

(Supplement Note 19) The data decompression device described in Supplement Note 16, wherein each of the plurality of decompression units moves one or two or more original symbols registered in a hit entry to an entry in use having a distance from the entry within a predetermined range in a case in which a search result of the first or second table of its own becomes a hit.

(Supplement Note 20) The data decompression device described in Supplement Note 16, further comprising a restoration unit that receives a code into which the position information or the information indicating non-compression is converted and restores the received code to the original position information or the information indicating non-compression in reverse order of a case in which the position information or the information indicating non-compression has been converted into the code.

(Supplement Note 21) The data decompression device described in Supplement Note 16, wherein a bit string usable as the position information or the information indicating non-compression is received as information indicating an exception in the data compression device.

(Supplement Note 22) The data decompression device described in Supplement Note 15, wherein an error occurring in accordance with an operation of the first table using information generated by an error operation of a table having a same configuration as the first table included in the data compression device is detected as an occurrence of an exception in the data compression device.

(Supplement Note 23) A data compression and decompression system comprising the data compression device described in Supplement Note 1 and the data decompression device described in Supplement Note 16.

(Supplement Note 24) A data compression method comprising:
by using a first compression unit having a first table in which the number of symbols registered in one entry is one, performing a search of the first table using a taken original symbol as a search target every time one original symbol flowing through an original symbol pipeline is taken in, conversion from the original symbol to a compressed symbol smaller in size than the original symbol in a case in which a search result of the first table is a hit, output of the compressed symbol, and an update of the first table including registration of the original symbol that is a search target;
by using one or two or more second compression units arranged at a subsequent stage to the first compression unit and having a second table in which the number of symbols registered in one entry is a predetermined number of two or more, performing a search of the second table using the predetermined number of original symbols as a search target in a case in which the number of original symbols reaches the predetermined number by consecutive taking-in of original symbols flowing through the original symbol pipeline, conversion from the predetermined number of original symbols to the compressed symbol in a case in which a search result of the second table is a hit, output of the compressed symbol, an update of the second table including registration of the predetermined number of original symbols as a search target, and taking-in of a compressed symbol output from a preceding stage into a compressed symbol pipeline;
by using the second compression unit and an adjustment unit arranged at a subsequent stage to the second compression unit, controlling a maintained content and a state of a latch capable of maintaining a compressed symbol flowing through the compressed symbol pipeline, and
by using an output unit arranged at a subsequent stage to the adjustment unit, outputting a pair of an original symbol and information indicating non-compression or a pair of a compressed symbol and position information indicating a position at which the compressed symbol has been obtained in accordance with a result of control of the maintained content and the state of the latch.

(Supplement Note 25) A data decompression method comprising:
by using each of a plurality of decompression units, which have a plurality of tables in which the number of original symbols registered in one entry differs from each of the others, having a first decompression unit having a first table in which the number of original symbols registered in one entry is one and a second decompression unit having a second table in which the number of original symbols registered in one entry is a predetermined number of two or more, taking in an original symbol in a case in which the original symbol and information indicating non-compression are input and registering one or a predetermined number of original symbols in the first or second table of its own in a case in which the number of the taken original symbols reaches one or a predetermined number to be registered in one entry of the first or second table of its own;
by using the first or second decompression unit designated by the position information in a case in which a pair of a compressed symbol and position information at which the compressed symbol has been obtained is input, performing a table search using the compressed symbol as an index of the first or second table of its own and sending out one or a predetermined number of original symbols registered in an entry corresponding to the index in original symbol units; and
by using the first or second decompression unit not designated by the position information, taking in an original symbol sent out from the first or second decompression unit designated by the position information and outputting an original symbol forming a pair with the information indicating non-compression and the original symbol, which is designated by the position information, sent out from the first or second decompression unit.

(Supplement Note 26) A data compression device comprising:
a first pipeline having one or two stages in which each of a plurality of original symbols forming an original symbol string is capable of shifting to an output side in a predetermined cycle while maintaining an input order;
a second pipeline in which a compressed symbol into which an original symbol is compressed shifts to an output side in synchronization with the original symbol flowing through the first pipeline;
a first compression unit arranged at a first stage or a preceding stage of the stages;
an adjustment unit arranged at one or two stages subsequent to the first compression unit; and
an output unit arranged at a subsequent stage to the adjustment unit, wherein
the first compression unit:
   has a first table having a predetermined number of entries in each of which one symbol is registered and executes:
   searching the first table (T0) using each of the plurality of original symbols input to the first pipeline one by one at a predetermined timing as a search target;
   converting an identical original symbol into the compressed symbol in a case in which the identical original symbol has been found from the first table;
   outputting the compressed symbol obtained by searching the first table and position information indicating a position at which compression information has been obtained to the second pipeline; and
   performing an update of the first table including registration of the original symbol that is a search target for each search of the first table,
   the adjustment unit has, for each stage, a first latch for taking in an original symbol flowing through the first pipeline and a second latch capable of taking in the compressed symbol and the position information output to the second pipeline, and
   the output unit outputs the original symbol and information indicating non-compression, or the compressed symbol and the position information in accordance with a maintained content and a state of each of the first latch and the second latch arranged at a final stage of the one or two stages.

(Supplement Note 27) A data decompression device to which a pair of an original symbol and information indicating non-compression or a pair of a compressed symbol obtained by compressing one or two or more original symbols and position information indicating a position at which the compressed symbol has been obtained is input, the data decompression device comprising:
a first bus through which the compressed symbol flows;
a second bus through which the original symbol flows; and
a decompression unit having a first table, used for generating the compressed symbol in which the number of symbols registered in one entry is one, wherein
the decompression unit:
   includes a first register and a second register;
   in a case in which an original symbol forming a pair on the basis of information indicating non-compression is sent out to the second bus, registers the original symbol in the first register;
   in a case in which the number of original symbols maintained in the first register reaches the number of symbols registered in one entry of the first table, registers the original symbol maintained in the first register in a predetermined entry of the first table; and
   in a case in which a compressed symbol forming a pair on the basis of the position information is sent out to the first bus, specifies an entry using the compressed symbol as an index of the first table, maintains an original symbol registered in the specified entry in the second register, and sends out the original symbol maintained in the second register to the second bus, and
   the original symbol sent out to the second bus becomes an output of the data decompression device.

The configurations according to the embodiments described above can be appropriately combined in a range not departing from the objective of the invention.

### [Reference Signs List]

- 10, 20: Compression unit
- 30: Adjustment unit
- 40: Output unit
- 100, 200: Compression device
- 300: Decompression device
- 310: Decompression unit

## Claims

1. A data compression device comprising:
a first pipeline having a plurality of stages in which each of a plurality of original symbols forming an original symbol string is capable of shifting to a next stage in a predetermined cycle while maintaining an input order;
a second pipeline in which a compressed symbol into which an original symbol is compressed shifts to a next stage in synchronization with the original symbol flowing through the first pipeline;
a first compression unit arranged at a first stage of or a preceding stage to the plurality of stages;
one or two or more second compression units arranged at a subsequent stage to the first compression unit;
an adjustment unit arranged at two or more stages subsequent to the one or two or more second compression units; and
an output unit arranged at a subsequent stage to the adjustment unit, wherein
the first compression unit has a first table having a predetermined number of entries in each of which one symbol is registered and executes:
searching the first table using each of the plurality of original symbols input to the first pipeline one by one at a predetermined timing as a search target;
converting an identical original symbol into the compressed symbol in a case in which the identical original symbol has been found from the first table;
outputting the compressed symbol obtained by searching the first table and position information indicating a position at which compression information has been obtained to the second pipeline; and
performing an update of the first table including registration of the original symbol that is a search target for each search of the first table,
each of the one or two or more second compression units includes:
a second table having a predetermined number of entries in which two or more symbols are registered;
a first latch taking in an original symbol from a preceding stage;
a second latch capable of taking in the compressed symbol and the position information; and
a register capable of maintaining a predetermined number of original symbols taken into the first latch,
each of the one or two or more second compression units, in each cycle, executes:
controlling a maintained content or a state of the second latch in accordance with a control instruction for the second latch;
searching the second table using a symbol string formed using the predetermined number of original symbols as a search target in a case in which the predetermined number of original symbols are stored in the register;
converting the symbol string of the search target into a compressed symbol in a case in which the symbol string of the search target has been found;
outputting the compressed symbol obtained by searching the second table and position information of the compressed symbol; and
updating registered contents of the second table including registration of the symbol string of the search target in a case in which the search of the second table is performed,
the number of the two or more symbols registered in the second table included in the one or two or more second compression units is a number obtained by adding a predetermined offset number to the number of symbols registered in the first table in a case in which the number of the second compression units is one and is in a state of increasing by a predetermined offset number or decreasing by a predetermined offset number as the stage advances in a case in which the number of the second compression units is two or more,
the adjustment unit at least has the first latch and the second latch arranged at each stage of a number of stages equal to or greater than the number of symbols registered in each entry of the second table included in the second compression unit positioned at a final stage among the one or two or more second compression units and controls the maintained content or the state of each of the second latches included in the adjustment unit in accordance with the control instruction in each cycle, and
the output unit outputs the original symbol and information indicating non-compression or the compressed symbol and the position information in accordance with the maintained content and the state of each of the first latch and the second latch included in the adjustment unit arranged at a final stage of the plurality of stages.

2. The data compression device according to claim 1, wherein the control instruction has a control pattern for each of the second latches according to a hit or miss state of a table search in the one or two or more second compression units in a previous cycle.

3. The data compression device according to claim 1, wherein the control instruction for each of the second latches included in the one or two or more second compression units and the adjustment unit is any one of the following (1) to (4) in a case in which the number of the two or more symbols registered in the second table included in the one or two or more second compression units is in a state of increasing by a predetermined offset number as the stage advances:
(1) taking the compressed symbol and the position information of the compressed symbol flowing through the second pipeline from an immediately preceding stage into the second latch;
(2) taking the compressed symbol and the position information of the compressed symbol obtained by the second compression unit present at an immediately preceding stage into the second latch;
(3) bringing the second latch into an invalidated state; or
(4) if the compressed symbol obtained by the first compression unit at the immediately preceding stage is valid, setting contents of the compressed symbol in the second latch and otherwise emptying the second latch in that cycle.

4. The data compression device according to claim 1, wherein the control instruction for each of the second latches included in the one or two or more second compression units and the adjustment unit is any one of the following (1) to (3) in a case in which the number of the two or more symbols registered in the second table included in the one or two or more second compression units is in a state of decreasing by a predetermined offset number as the stage advances:
(1) taking the compressed symbol and position information of the compressed symbol flowing through the second pipeline from the immediately preceding stage into the second latch;
(2) taking the compressed symbol and position information of the compressed symbol obtained by the second compression unit at the immediately preceding stage into the second latch; or
(3) bringing the second latch into an invalidated state.

5. The data compression device according to claim 4, wherein, in each cycle, a first latch to be invalidated in a next cycle is determined among the first latches included in the one or two or more second compression units and the adjustment unit in accordance with a control instruction corresponding to a hit or miss status of a table search of the second table included in the one or two or more second compression units.

6. The data compression device according to claim 1, wherein, in a case in which there are two or more second compression units, the second compression unit in a second or subsequent stage changes a search result from a hit to a miss in a case in which a search result of the own second table is a hit and in a case in which a compressed symbol obtained by any one of the one or two or more second compression units is maintained in at least one of second latches other than the second latch positioned at a final stage among the second latches included in the second compression unit present at a third or subsequent stage and the second latch included in the adjustment unit.

7. The data compression device according to claim 1, wherein
the compressed symbol is an index of an entry in which the symbol or the symbol string that is a search target is registered, and
a size of the index is equal to or smaller than a size of the symbol or the symbol string that is the search target.

8. The data compression device according to claim 7, wherein each of the first compression unit and the one or two or more second compression units obtains an entropy value m from a following calculation equation using the number k of entries in use in the first table or the second table of its own and reduces the number of bits of the compressed symbol to m bits in a state in which a value of the compressed symbol is maintained: $m = ceil \left({log}_{2}k\right)$

9. The data compression device according to claim 1 or 8, wherein at least one of the first compression unit and the one or two or more second compression units deletes registered content of a predetermined entry in use in a case in which the number of times a result of a table search using the first table or the second table of its own becomes a hit reaches a predetermined number.

10. The data compression device according to claim 1, wherein each of the first compression unit and the one or two or more second compression units exchanges a position of an entry in which a hit symbol or a symbol string is registered with a position of an entry in use having a distance from the entry within a predetermined range in a case in which a result of a table search using the first table or the second table of its own becomes a hit.

11. The data compression device according to claim 1, further comprising a conversion unit that converts the position information and the information indicating non-compression into codes having smaller sizes on the basis of a conversion table.

12. The data compression device according to claim 11, wherein, in the conversion table, a correspondence relation between the position information and the information indicating non-compression, and the codes is statically set.

13. The data compression device according to claim 12, wherein the correspondence relation between the position information and the information indicating non-compression in the conversion table is updated in accordance with an appearance frequency such that a code with fewer bits is assigned as the appearance frequency of the position information and the information indicating non-compression increases.

14. The data compression device according to claim 1, wherein a bit string used as the position information or the information indicating non-compression is output as information indicating an exception.

15. The data compression device according to claim 1, wherein information generated by an error operation of the first table is output as information indicating an exception.

16. A data decompression device to which a pair of an original symbol and information indicating non-compression or a pair of a compressed symbol obtained by compressing one or two or more original symbols and position information indicating a position at which the compressed symbol has been obtained is input, the data decompression device comprising:
a first bus through which the compressed symbol flows;
a second bus through which the original symbol flows; and
a plurality of decompression units having a plurality of tables, which are used for generating the compressed symbol, having different numbers of symbols registered in one entry that include a first decompression unit having a first table in which the number of symbols registered in one entry is one and at least one second decompression unit having a second table in which the number of symbols registered in one entry is two or more, wherein
each of the plurality of decompression units:
includes a first register and a second register;
in a case in which an original symbol forming a pair on the basis of the information indicating non-compression is sent out to the second bus, registers the original symbol in the first register;
in a case in which the number of one or two or more original symbols maintained in the first register reaches the number of symbols registered in the one entry in the first or second table of its own, registers the one or two or more original symbols maintained in the first register in a predetermined entry of the first or second table; and
in a case in which a compressed symbol forming a pair on the basis of the position information is sent out to the first bus and in a case in which the position information designates itself, specifies an entry using the compressed symbol flowing through the first bus as an index of the first or second table of its own, maintains one or two or more original symbols registered in the specified entry in the second register, and sends out the one or two or more original symbols maintained in the second register to the second bus one by one in an order of registration to the first register,
the decompression unit not designated by the position information registers an original symbol sent out to the second bus from the designated decompression unit in the first register, and
the original symbol sent out to the second bus becomes an output of the data decompression device.

17. The data decompression device according to claim 16, wherein, in a case in which the compressed symbol has a reduced number of bits in the data compression device, the decompression unit designated by the position information uses the number k of entries in use in a table indicated by the position information to perform calculation of E using the following calculation equation and uses a value obtained by expanding E bits which is the number of bits of the compressed symbol to an index width of the table in a state in which a value indicated by the compressed symbol is maintained as the index of the table. $E = ceil \left({log}_{2}k\right)$

18. The data decompression device according to claim 16 or 17, wherein at least one of the plurality of decompression units deletes registered contents of a predetermined entry in use in a case in which the number of times a result of a table search using the first table or the second table of its own becomes a hit reaches a predetermined number.

19. The data decompression device according to claim 16, wherein each of the plurality of decompression units moves one or two or more original symbols registered in a hit entry to an entry in use having a distance from the entry within a predetermined range in a case in which a search result of the first or second table of its own becomes a hit.

20. The data decompression device according to claim 16, further comprising a restoration unit that receives a code into which the position information or the information indicating non-compression is converted and restores the received code to the original position information or the information indicating non-compression in reverse order of a case in which the position information or the information indicating non-compression has been converted into the code.

21. The data decompression device according to claim 16, wherein a bit string usable as the position information or the information indicating non-compression is received as information indicating an exception in the data compression device.

22. The data decompression device according to claim 16, wherein an error occurring in accordance with an operation of the first table using information generated by an error operation of a table having a same configuration as the first table included in the data compression device is detected as an occurrence of an exception in the data compression device.

23. A data compression and decompression system comprising the data compression device according to claim 1 and the data decompression device according to claim 16.

24. A data compression method comprising:
by using a first compression unit having a first table in which the number of symbols registered in one entry is one, performing a search of the first table using a taken original symbol as a search target every time one original symbol flowing through an original symbol pipeline is taken in, conversion from the original symbol to a compressed symbol smaller in size than the original symbol in a case in which a search result of the first table is a hit, output of the compressed symbol, and an update of the first table including registration of the original symbol that is a search target;
by using one or two or more second compression units arranged at a subsequent stage to the first compression unit and having a second table in which the number of symbols registered in one entry is a predetermined number of two or more, performing a search of the second table using the predetermined number of original symbols as a search target in a case in which the number of original symbols reaches the predetermined number by consecutive taking-in of original symbols flowing through the original symbol pipeline, conversion from the predetermined number of original symbols to the compressed symbol in a case in which a search result of the second table is a hit, output of the compressed symbol, an update of the second table including registration of the predetermined number of original symbols as a search target, and taking-in of a compressed symbol output from a preceding stage into a compressed symbol pipeline;
by using the second compression unit and an adjustment unit arranged at a subsequent stage to the second compression unit, controlling a maintained content and a state of a latch capable of maintaining a compressed symbol flowing through the compressed symbol pipeline, and
by using an output unit arranged at a subsequent stage to the adjustment unit, outputting a pair of an original symbol and information indicating non-compression or a pair of a compressed symbol and position information indicating a position at which the compressed symbol has been obtained in accordance with a result of control of the maintained content and the state of the latch.

25. A data decompression method comprising:
by using each of a plurality of decompression units, which have a plurality of tables in which the number of original symbols registered in one entry differs from each of the others, having a first decompression unit having a first table in which the number of original symbols registered in one entry is one and a second decompression unit having a second table in which the number of original symbols registered in one entry is a predetermined number of two or more, taking in an original symbol in a case in which the original symbol and information indicating non-compression are input and registering one or a predetermined number of original symbols in the first or second table of its own in a case in which the number of the taken original symbols reaches one or a predetermined number to be registered in one entry of the first or second table of its own;
by using the first or second decompression unit designated by the position information in a case in which a pair of a compressed symbol and position information at which the compressed symbol has been obtained is input, performing a table search using the compressed symbol as an index of the first or second table of its own and sending out one or a predetermined number of original symbols registered in an entry corresponding to the index in original symbol units; and
by using the first or second decompression unit not designated by the position information, taking in an original symbol sent out from the first or second decompression unit designated by the position information and outputting an original symbol forming a pair with the information indicating non-compression and the original symbol, which is designated by the position information, sent out from the first or second decompression unit.

26. A data compression device comprising:
a first pipeline having one or two stages in which each of a plurality of original symbols forming an original symbol string is capable of shifting to an output side in a predetermined cycle while maintaining an input order;
a second pipeline in which a compressed symbol into which an original symbol is compressed shifts to an output side in synchronization with the original symbol flowing through the first pipeline;
a first compression unit arranged at a first stage or a preceding stage of the stages;
an adjustment unit arranged at one or two stages subsequent to the first compression unit; and
an output unit arranged at a subsequent stage to the adjustment unit, wherein
the first compression unit:
has a first table having a predetermined number of entries in each of which one symbol is registered and executes:
searching the first table using each of the plurality of original symbols input to the first pipeline one by one at a predetermined timing as a search target;
converting an identical original symbol into the compressed symbol in a case in which the identical original symbol has been found from the first table;
outputting the compressed symbol obtained by searching the first table and position information indicating a position at which compression information has been obtained to the second pipeline; and
performing an update of the first table including registration of the original symbol that is a search target for each search of the first table,
the adjustment unit has, for each stage, a first latch for taking in an original symbol flowing through the first pipeline and a second latch capable of taking in the compressed symbol and the position information output to the second pipeline, and
the output unit outputs the original symbol and information indicating non-compression, or the compressed symbol and the position information in accordance with a maintained content and a state of each of the first latch and the second latch arranged at a final stage of the one or two stages.

27. A data decompression device to which a pair of an original symbol and information indicating non-compression or a pair of a compressed symbol obtained by compressing one or two or more original symbols and position information indicating a position at which the compressed symbol has been obtained is input, the data decompression device comprising:
a first bus through which the compressed symbol flows;
a second bus through which the original symbol flows; and
a decompression unit having a first table, used for generating the compressed symbol in which the number of symbols registered in one entry is one, wherein
the decompression unit:
includes a first register and a second register;
in a case in which an original symbol forming a pair on the basis of the information indicating non-compression is sent out to the second bus, registers the original symbol in the first register;
in a case in which the number of original symbols maintained in the first register reaches the number of symbols registered in one entry of the first table, registers the original symbol maintained in the first register in a predetermined entry of the first table; and
in a case in which a compressed symbol forming a pair on the basis of the position information is sent out to the first bus, specifies an entry using the compressed symbol as an index of the first table, maintains an original symbol registered in the specified entry in the second register, and sends out the original symbol maintained in the second register to the second bus, and
the original symbol sent out to the second bus becomes an output of the data decompression device.
